# EUROPEAN PATENT APPLICATION

(11) **EP 4 734 730 A1**
(43) Date of publication of application: **29.04.2026**
(21) Application number: 25210974.9
(22) Date of filing: 24.10.2025
(51) Int. Cl.: H10K 85/60, H10K 50/11

(54) **LIGHT-EMITTING ELEMENT, CONDENSED POLYCYCLIC COMPOUND FOR THE SAME AND ELECTRONIC APPARATUS INCLUDING THE LIGHT-EMITTING ELEMENT**

(30) Priority: 24.10.2024 JP 2024187598
(71) Applicant: Samsung Display Co., Ltd., Yongin-si, Gyeonggi-Do (KR)
(72) Inventor: HOSHI, Keigo, Yokohama-shi, 220-0011 (JP); KIM, Jeongeun, Yongin-si (KR); YAMAMOTO, Makoto, Yokohama-shi, 220-0011 (JP)
(74) Representative: Marks & Clerk LLP

(57) **Abstract**

Provided is a light-emitting element including a first electrode, a second electrode disposed on the first electrode, and a light-emitting layer disposed between the first electrode and the second electrode, and including a first compound represented by Formula 1:

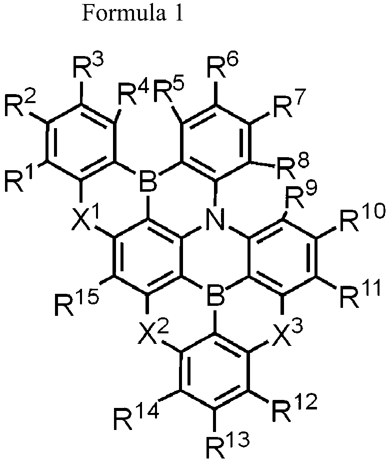

## Description

### BACKGROUND

The present disclosure herein relates to a light-emitting element, a condensed polycyclic compound used in the light-emitting element, and an electronic apparatus including the light-emitting element.

Recently, the demand for the development of an organic electroluminescence display device such as a video display device has increased. Unlike a liquid crystal display device, the organic electroluminescence display device is a self-luminous display device that displays images by recombining a light-emitting layer. The light-emitting layer includes holes and electrons injected from a first electrode and a second electrode, and emitting light from a light-emitting material. The light-emitting layer may include an organic compound.

When an organic electroluminescence element is incorporated into a display device, the organic electroluminescence element needs to exhibit low driving voltage, high luminous efficiency, and long lifespan in order for the display device to operate for commercial purposes. Additionally, these requirements need to be stable, thus, there is an ongoing need for development of a material for the organic electroluminescence element.

### SUMMARY

Ongoing needs exist to produce an organic electroluminescence element having high luminous efficiency. In particular, recently, in order to produce the organic electroluminescence element having the high luminous efficiency, technology is being developed for phosphorescence luminescence using energy of a triplet state, and fluorescence luminescence using a triplet-triplet annihilation (TTA), which is a phenomenon of generating a singlet exciton due to collision of the triplet excitons, and a material for thermally activated delayed fluorescence (TADF) using a delayed fluorescence phenomenon is also being developed.

The present disclosure provides a light-emitting element with improved luminous efficiency and element lifespan.

The present disclosure also provides a condensed polycyclic compound capable of improving luminous efficiency and element lifespan of a light-emitting element.

The present disclosure also provides a display device including a light-emitting element with improved luminous efficiency and lifespan to have excellent display quality.

An embodiment of the inventive concept provides a light-emitting element including a first electrode, a second electrode disposed on the first electrode, and a light-emitting layer disposed between the first electrode and the second electrode, and including a first compound represented by Formula 1:

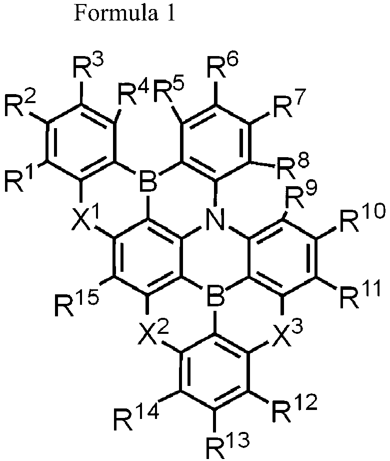

In Formula 1, X¹ to X³ are each independently O, S or NAr¹, Ar₁ is a saturated or unsaturated aryl group having a ring-forming carbon number of 6 to 30, or a saturated or unsaturated heteroaryl group having a ring-forming carbon number of 2 to 30, R¹ to R¹⁵ are each independently a hydrogen atom, a deuterium atom, a halogen atom, a cyano group, a nitro group, a saturated or unsaturated amine group, a saturated or unsaturated alkyl group having a carbon number of 1 to 20, a saturated or unsaturated aryl group having a ring-forming carbon number of 6 to 30, or a saturated or unsaturated heteroaryl group having a ring-forming carbon number of 2 to 30, provided that when R¹³ is a diphenylamine group or a carbazole group, (1) R¹⁰ is not a hydrogen atom or (2) R¹⁰ does not include a diphenylamine group.

In an embodiment, the first compound represented by Formula 1 includes a structure in which at least one hydrogen atom is substituted with a deuterium atom.

In an embodiment, the light-emitting layer may include a host and a dopant, and the dopant may include the first compound represented by Formula 1.

In an embodiment, the first compound represented by Formula 1 may be represented by any one of Formula 2-1 to Formula 2-4:

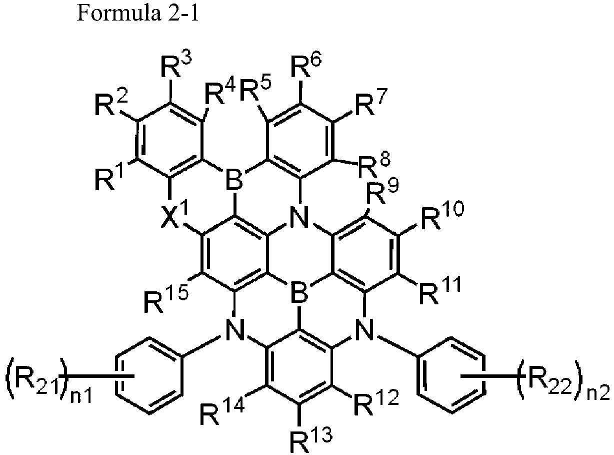

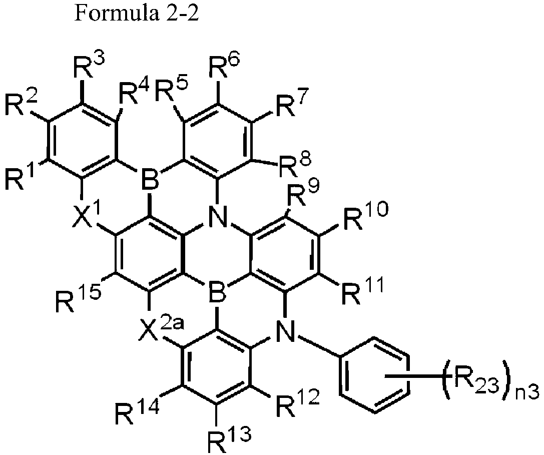

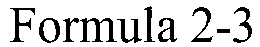

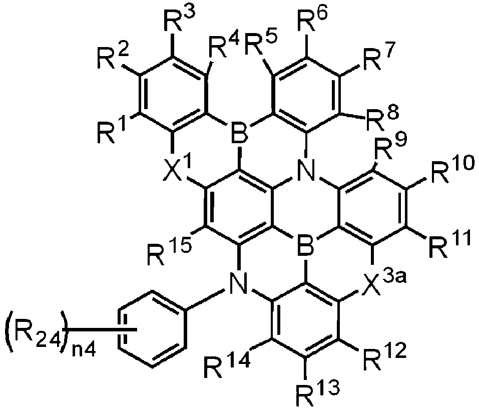

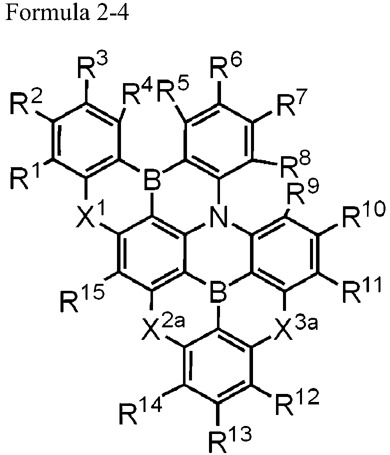

In Formula 2-1 to Formula 2-4, x^{2a} and X^{3a} are each independently O or S, R²¹ to R²⁴ are each independently a hydrogen atom, a deuterium atom, a halogen atom, a cyano group, a nitro group, a saturated or unsaturated amine group, a saturated or unsaturated alkyl group having a carbon number of 1 to 20, a saturated or unsaturated aryl group having a ring-forming carbon number of 6 to 30, or a saturated or unsaturated heteroaryl group having a ring-forming carbon number of 2 to 30, n1 to n4 are each independently an integer of 0 to 5.

In Formula 2-1 to Formula 2-4, X¹ and R¹ to R¹⁵ may be the same as what is defined in Formula 1.

In an embodiment, the first compound represented by Formula 1 may be represented by any one of Formula 3-1 to Formula 3-4:

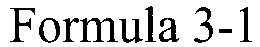

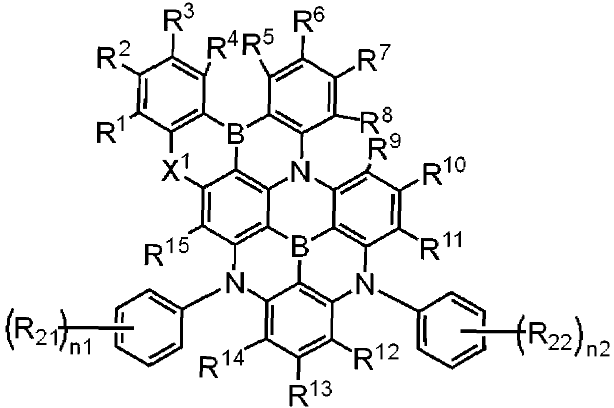

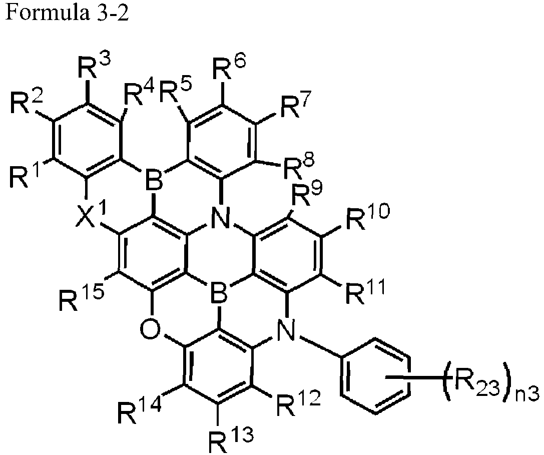

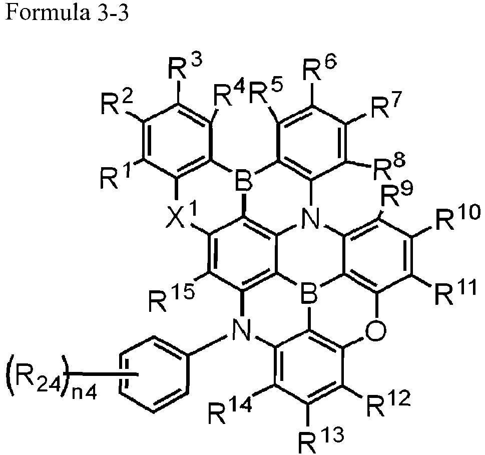

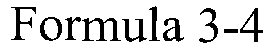

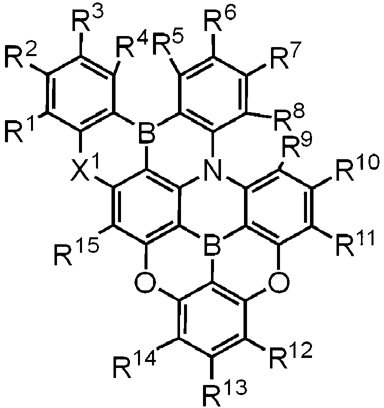

In Formula 3-1 to Formula 3-4, R²¹ to R²⁴ are each independently a hydrogen atom, a deuterium atom, a halogen atom, a cyano group, a nitro group, a saturated or unsaturated amine group, a saturated or unsaturated alkyl group having a carbon number of 1 to 20, a saturated or unsaturated aryl group having a ring-forming carbon number of 6 to 30, or a saturated or unsaturated heteroaryl group having a ring-forming carbon number of 2 to 30, n1 to n4 are each independently an integer of 0 to 5. In Formula 3-2, when R¹³ is a diphenylamine group or a carbazole group, (1) R¹⁰ is an unsubstituted alkyl group having a carbon number of 1 to 20, or (2) R¹⁰ an unsubstituted aryl group having a ring-forming carbon number of 6 to 20.

In Formula 3-1 to Formula 3-4, X¹ and R¹ to R¹⁵ may be the same as what is defined in Formula 1.

In an embodiment, the first compound represented by Formula 1 may be represented by any one of Formula 4-1 to Formula 4-4:

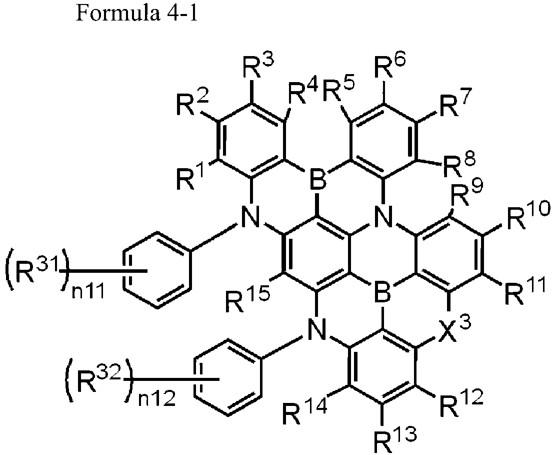

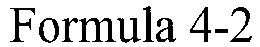

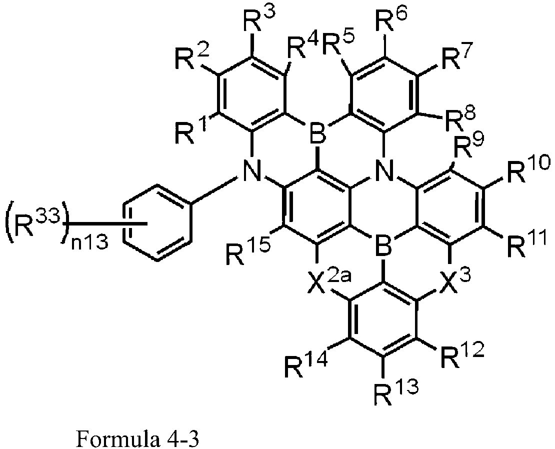

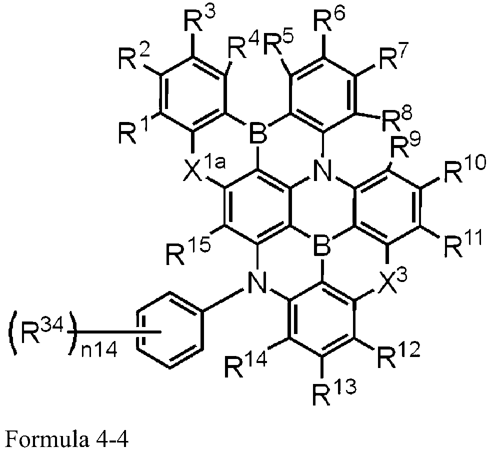

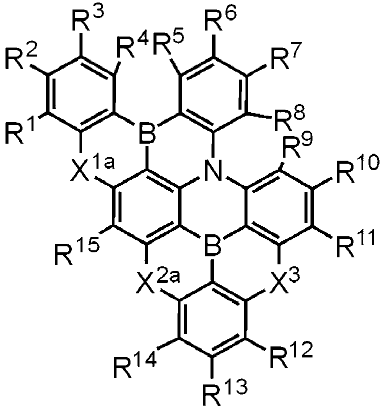

In Formula 4-1 to Formula 4-4, X^{1a} and x^{2a} are each independently O or S, R³¹ to R³⁴ are each independently a hydrogen atom, a deuterium atom, a halogen atom, a cyano group, a nitro group, a saturated or unsaturated amine group, a saturated or unsaturated alkyl group having a carbon number of 1 to 20, a saturated or unsaturated aryl group having a ring-forming carbon number of 6 to 30, or a saturated or unsaturated heteroaryl group having a ring-forming carbon number of 2 to 30, n11 to n14 are each independently an integer of 0 to 5.

In Formula 4-1 to Formula 4-4, X³, and R¹ to R¹⁵ may be the same as what is defined in Formula 1.

In an embodiment, the first compound represented by Formula 1 may be represented by Formula 5:

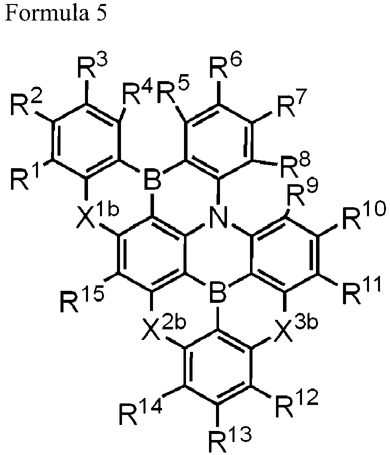

In Formula 5, at least one of X^{1b}, X^{2b} and X^{3b} is represented by Formula 6-1 or Formula 6-2, and the rest thereof are each independently O, S, or NAr², Ar² is a saturated or unsaturated aryl group having a ring-forming carbon number of 6 to 30, or a saturated or unsaturated heteroaryl group having a ring-forming carbon number of 2 to 30.

In Formula 5, R¹ to R¹⁵ may be the same as what is defined in Formula 1.

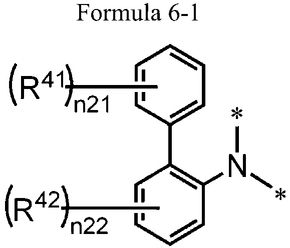

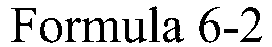

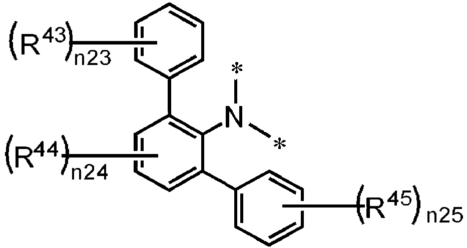

In Formula 6-1 and Formula 6-2, R⁴¹ to R⁴⁵ are each independently a hydrogen atom, a deuterium atom, a halogen atom, a cyano group, a nitro group, a saturated or unsaturated amine group, a saturated or unsaturated alkyl group having a carbon number of 1 to 20, a saturated or unsaturated aryl group having a ring-forming carbon number of 6 to 30, or a saturated or unsaturated heteroaryl group having a ring-forming carbon number of 2 to 30, n21, n23 and n25 are each independently an integer of 0 to 5, n22 is an integer of 0 to 4, n24 is an integer of 0 to 3, and - * is a position connected to Formula 5.

In an embodiment, X¹ to X³ may be each independently O or NAr³, and Ar³ may be a saturated or unsaturated aryl group having a ring-forming carbon number of 6 to 30.

In an embodiment, in Formula 1, when R¹³ is a diphenylamine group or a carbazole group, R¹⁰ may be a saturated or unsaturated alkyl group having a carbon number of 1 to 20, a saturated or unsaturated aryl group having a ring-forming carbon number of 6 to 30, or a saturated or unsaturated heteroaryl group having a carbon number of 2 to 30, and when R¹⁰ is substituted, a substituent may be a deuterium atom, a cyano group, an unsubstituted alkyl group having a carbon number of 1 to 10, an unsubstituted aryl group having a carbon number of 6 to 15, or an unsubstituted heteroaryl group having a carbon number of 2 to 15.

In an embodiment, the light-emitting layer may further include at least one of a second compound represented by Formula HT-1, a third compound represented by Formula ET-1, or a fourth compound represented by Formula D-1:

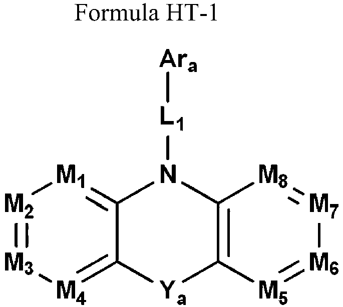

In Formula HT-1, M₁ to M₈ are each independently N or CR₅₁, L₁ is a direct linkage, a saturated or unsaturated arylene group having a ring-forming carbon number of 6 to 30, or a saturated or unsaturated heteroarylene group having a ring-forming carbon number of 2 to 30, Yₐ is a direct linkage, CR₅₂R₅₃, or SiR₅₄R₅₅, Arₐ is a saturated or unsaturated aryl group having a ring-forming carbon number of 6 to 30, or a saturated or unsaturated heteroaryl group having a ring-forming carbon number of 2 to 30, and R₅₁ to R₅₅ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having a carbon number of 1 to 20, a substituted or unsubstituted alkenyl group having a carbon number of 2 to 20, a substituted or unsubstituted aryl group having a ring-forming carbon number of 6 to 60, or a substituted or unsubstituted heteroaryl group having a ring-forming carbon number of 2 to 60, or combined with an adjacent group to form a ring.

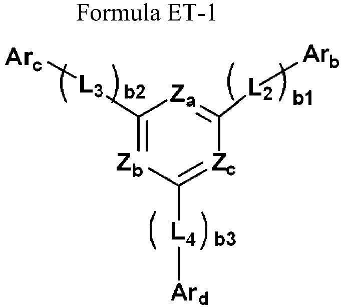

In Formula ET-1, at least one of Zₐ to Z_{c} is N, and the rest thereof is CR₅₆, R₅₆ is a hydrogen atom, a deuterium atom, a substituted or unsubstituted alkyl group having a carbon number of 1 to 20, a substituted or unsubstituted aryl group having a ring-forming carbon number of 6 to 60, or a substituted or unsubstituted heteroaryl group having a ring-forming carbon number of 2 to 60, b1 to b3 are each independently an integer of 0 to 10, Ar_{b} to Ar_{d} are each independently a hydrogen atom, a deuterium atom, a substituted or unsubstituted alkyl group having a carbon number of 1 to 20, a substituted or unsubstituted aryl group having a ring-forming carbon number of 6 to 30, or a substituted or unsubstituted heteroaryl group having a ring-forming carbon number of 2 to 30, and L₂ to L₄ are each independently a direct linkage, a substituted or unsubstituted arylene group having a ring-forming carbon number of 6 to 30, or a substituted or unsubstituted heteroarylene group having a ring-forming carbon number of 2 to 30.

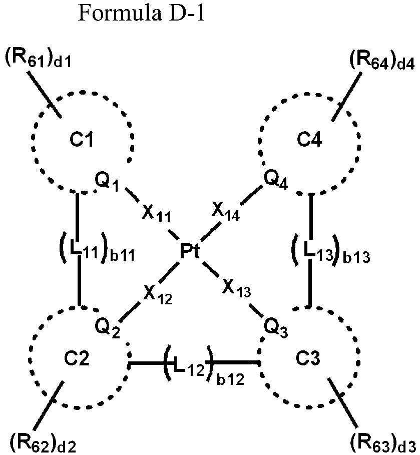

In Formula D-1, Q₁ to Q₄ are each independently C or N, C1 to C4 are each independently a hydrocarbon ring having a ring-forming carbon number of 5 to 30, a substituted or unsubstituted aryl group having a ring-forming carbon number of 6 to 30, or a substituted or unsubstituted heterocycle having a ring-forming carbon number of 2 to 30, X₁₁ to X₁₄ are each independently a direct linkage or ***-O-* ,** L₁₁ to L₁₃ are each independently a direct linkage, *-O-* , *-S-* , 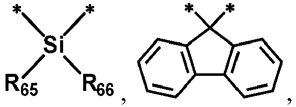 a substituted or unsubstituted divalent alkyl group having a carbon number of 1 to 20, a substituted or unsubstituted arylene group having a ring-forming carbon number of 6 to 30, or a substituted or unsubstituted heteroarylene group having a ring-forming carbon number of 2 to 30, b11 to b13 are each independently 0 or 1, and R₆₁ to R₆₆ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having a carbon number of 1 to 20, a substituted or unsubstituted alkenyl group having a carbon number of 2 to 20, a substituted or unsubstituted aryl group having a ring-forming carbon number of 6 to 60, or a substituted or unsubstituted heteroaryl group having a ring-forming carbon number of 2 to 60, and d1 to d4 are each independently an integer of 0 to 4.

In an embodiment of the inventive concept, an electronic device includes a base layer, a circuit layer disposed on the base layer, and a display element layer disposed on the circuit layer, and including a light-emitting element, wherein the light-emitting element includes a first electrode, a second electrode disposed on the first electrode, and a light-emitting layer disposed between the first electrode and the second electrode, and including a first compound represented by Formula 1.

In an embodiment, the light-emitting element may further include a capping layer disposed on the second electrode, and the capping layer may have a refractive index equal to or greater than about 1.6 with respect to light having a wavelength range of about 550 nm to about 660 nm.

In an embodiment, the electronic device may include an optical control layer disposed on the display element layer, and including a quantum dot, wherein the light-emitting element emits first light, the optical control layer includes a first optical control portion including a first quantum dot converting first light to second light in a longer wavelength region than the first light, a second optical control portion including a second quantum dot converting the first light to third light in a longer wavelength region than the first light and the second light and a third optical control portion transmitting the first light.

In an embodiment, the electronic device may further include a color filter layer disposed on the optical control layer, wherein the color filter layer includes a first filter transmitting the second light, a second filter transmitting the third light and a third filter transmitting the first light.

In an embodiment, the electronic device may be selected from a large display device such as a television, a monitor and an exterior billboard, and a small-and-medium display device such as a personal computer, a notebook computer, a personal digital terminal, a display device for a vehicle, a game console, a portable electronic device, and a camera.

In an embodiment of the inventive concept, a condensed polycyclic compound according to an embodiment of the inventive concept is represented by Formula 1.

At least some of the above and other features of the invention are set out in the claims.

### BRIEF DESCRIPTION OF THE FIGURES

The accompanying drawings are included to provide a further understanding of the inventive concept, and are incorporated in and constitute a part of this specification. The drawings illustrate embodiments of the inventive concept and, together with the description, serve to explain principles of the inventive concept. In the drawings:
FIG. 1 is a plan view of a display device according to an embodiment of the inventive concept;
FIG. 2 is a cross-sectional view of a display device according to an embodiment of the inventive concept;
FIG. 3 is a cross-sectional view schematically illustrating a light-emitting element according to an embodiment of the inventive concept;
FIG. 4 is a cross-sectional view schematically illustrating a light-emitting element according to an embodiment of the inventive concept;
FIG. 5 is a cross-sectional view schematically illustrating a light-emitting element according to an embodiment of the inventive concept;
FIG. 6 is a cross-sectional view schematically illustrating a light-emitting element according to an embodiment of the inventive concept;
FIGS. 7 and 8 are cross-sectional views of a display device according to an embodiment of the inventive concept;
FIG. 9 is a cross-sectional view illustrating a display device according to an embodiment of the inventive concept;
FIG. 10 is a cross-sectional view illustrating a display device according to an embodiment of the inventive concept; and
FIG. 11 is a diagram illustrating a vehicle in which a display device according to an embodiment is disposed.
FIG. 12 is a perspective view showing an electronic apparatus according to an embodiment;
FIG. 13 is an exploded perspective view showing an electronic apparatus according to an embodiment;
FIG. 14 is a block diagram of an electronic apparatus according to an embodiment;
FIG. 15 is a diagram showing an electronic apparatus according to an embodiment; and
FIG. 16 is a diagram showing an electronic apparatus according to an embodiment.

### DETAILED DESCRIPTION

The inventive concept may have various modifications and may be embodied in different forms, and example embodiments will be explained in detail with reference to the accompany drawings. The inventive concept may, however, be embodied in different forms and should not be construed as limited to the embodiments set forth herein. Rather, all modifications, equivalents, and substituents which are included in the technical scope of the inventive concept should be included in the inventive concept.

Like reference numerals refer to like elements throughout. In the drawings, the dimensions of structures are exaggerated for clarity of illustration. It will be understood that, although the terms first, second, etc. may be used herein to describe various elements, these elements should not be limited by these terms. These terms are only used to distinguish one element from another element. Thus, a first element could be termed a second element without departing from the teachings of the present invention. Similarly, a second element could be termed a first element. As used herein, the singular forms are intended to include the plural forms as well, unless the context clearly indicates otherwise.

In the present specification, it will be further understood that the terms "comprises" and/or "comprising," when used in this specification, specify the presence of stated features, numerals, steps, operations, elements, parts, or the combination thereof, but do not preclude the presence or addition of one or more other features, numerals, steps, operations, elements, parts, or the combination thereof.

In the present specification, when a layer, a film, a region, a plate, etc. is referred to as being "on" or "above" another part, it can be "directly on" the other part, or intervening layers may also be present. On the contrary, when a layer, a film, a region, a plate, etc. is referred to as being "under" or "below" another part, it can be "directly under" the other part, or intervening layers may also be present. Also, when an element is referred to as being disposed "on" another element, it can be disposed under the other element.

In the present specification, the term "substituted or unsubstituted" corresponds to substituted or unsubstituted with at least one substituent selected from the group consisting of a deuterium atom, a halogen atom, a cyano group, a nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group. In addition, each of the exemplified substituents may be substituted or unsubstituted. For example, a biphenyl group may be interpreted as an aryl group or a phenyl group substituted with a phenyl group.

In the present specification, the term "forming a ring via the combination with an adjacent group" may mean forming a substituted or unsubstituted hydrocarbon ring, or a substituted or unsubstituted heterocycle via the combination with an adjacent group. The hydrocarbon ring includes an aliphatic hydrocarbon ring and an aromatic hydrocarbon ring. The heterocycle includes an aliphatic heterocycle and an aromatic heterocycle. The hydrocarbon ring and the heterocycle may be monocycles or polycycles. In addition, the ring formed via the combination with each other may be combined with another ring to form a spiro structure.

In the present specification, the term "an adjacent group" may mean a substituent substituted for an atom which is directly connected to an atom substituted with a corresponding substituent, another substituent substituted for an atom which is substituted with a corresponding substituent, or a substituent sterically positioned at the nearest position to a corresponding substituent. For example, in 1,2-dimethylbenzene, two methyl groups may be interpreted as "adjacent groups" to each other, and in 1,1-diethylcyclopentane, two ethyl groups may be interpreted as "adjacent groups" to each other. In addition, in 4,5-dimethylphenanthrene, two methyl groups may be interpreted as "adjacent groups" to each other.

In the present specification, examples of a halogen atom may be a fluorine atom, a chlorine atom, a bromine atom, or an iodine atom.

In the present specification, an alkyl group may be linear, branched, or cyclic. The carbon number of the alkyl group may be 1 to 50, 1 to 30, 1 to 20, 1 to 10, or 1 to 6. Examples of the alkyl group may include methyl, ethyl, n-propyl, isopropyl, n-butyl, s-butyl, t-butyl, i-butyl, 2-ethylbutyl, 3,3-dimethylbutyl, n-pentyl, i-pentyl, neopentyl, t-pentyl, cyclopentyl, 1-methylpentyl, 3-methylpentyl, 2-ethylpentyl, 4-methyl-2-pentyl, n-hexyl, 1-methylhexyl, 2-ethylhexyl, 2-butylhexyl, cyclohexyl, 4-methylcyclohexyl, 4-t-butylcyclohexyl, n-heptyl, 1-methylheptyl, 2,2-dimethylheptyl, 2-ethylheptyl, 2-butylheptyl, n-octyl, t-octyl, 2-ethyloctyl, 2-butyloctyl, 2-hexyloctyl, 3,7-dimethyloctyl, cyclooctyl, n-nonyl, n-decyl, adamantyl, 2-ethyldecyl, 2-butyldecyl, 2-hexyldecyl, 2-octyldecyl, n-undecyl, n-dodecyl, 2-ethyldodecyl, 2-butyldodecyl, 2-hexyldocecyl, 2-octyldodecyl, n-tridecyl, n-tetradecyl, n-pentadecyl, n-hexadecyl, 2-ethylhexadecyl, 2-butylhexadecyl, 2-hexylhexadecyl, 2-octylhexadecyl, n-heptadecyl, n-octadecyl, n-nonadecyl, n-eicosyl, 2-ethyleicosyl, 2-butyleicosyl, 2-hexyleicosyl, 2-octyleicosyl, n-henicosyl, n-docosyl, n-tricosyl, n-tetracosyl, n-pentacosyl, n-hexacosyl, n-heptacosyl, n-octacosyl, n-nonacosyl, n-triacontyl, cyclopropyl, cyclobutyl, cyclopentyl, cyclohexyl, 4-methylcyclohexyl, 4-t-butylcyclohexyl, cycloheptyl, cyclooctyl, cyclononyl, cyclodecyl, norbornyl, 1-adamantyl, 2-adamantyl, isobornyl, bicycloheptyl, etc., without limitation.

In the present specification, an alkenyl group means a hydrocarbon group including one or more carbon double bonds in the middle or at the terminal of an alkyl group having a carbon number of 2 or more. The alkenyl group may be linear chain or branched. The carbon number is not specifically limited, but may be 2 to 30, 2 to 20, or 2 to 10. Examples of the alkenyl group include a vinyl group, a 1-butenyl group, a 1-pentenyl group, a 1,3-butadienyl aryl group, a styrenyl group, a styrylvinyl group, etc., without limitation.

In the present specification, an alkynyl group means a hydrocarbon group including one or more carbon triple bonds in the middle or at the terminal of an alkyl group having a carbon number of 2 or more. The alkynyl group may be linear chain or branched. The carbon number is not specifically limited, but may be 2 to 30, 2 to 20, or 2 to 10. Specific examples of the alkynyl group include an ethynyl group, a propynyl group, etc., without limitation.

In the present specification, a hydrocarbon ring group means an arbitrary functional group or substituent derived from an aliphatic hydrocarbon ring. The hydrocarbon ring group may be a saturated hydrocarbon ring group of 5 to 20 ring-forming carbon atoms.

In the present specification, an aryl group means an arbitrary functional group or substituent derived from an aromatic hydrocarbon ring. The aryl group may be a monocyclic aryl group or a polycyclic aryl group. The ring-forming carbon number of the aryl group may be 6 to 36, 6 to 30, 6 to 20, or 6 to 15. Examples of the aryl group may include phenyl, naphthyl, fluorenyl, anthracenyl, phenanthrenyl, biphenylyl, terphenylyl, quaterphenyl, quinquephenyl, sexiphenyl, triphenylenyl, pyrenyl, benzofluoranthene, chrysene, etc., without limitation.

In the present specification, a fluorenyl group may be substituted, and two substituents may be combined with each other to form a spiro structure. Examples in which the fluorenyl group is substituted are as follows, but an embodiment of the inventive concept is not limited thereto.

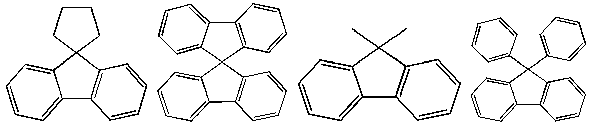

In the present specification, a heterocyclic group means an arbitrary functional group or substituent derived from a ring including one or more among B, O, N, P, Si and S as a heteroatom. The heterocyclic group includes an aliphatic heterocyclic group and an aromatic heterocyclic group. The aromatic heterocyclic group may be a heteroaryl group. The aliphatic heterocyclic group and the aromatic heterocyclic group may be a monocycle or a polycycle.

In the present specification, a heterocyclic group may include one or more among B, O, N, P, Si, and S as a heteroatom. When the heterocyclic group includes two or more heteroatoms, the two or more heteroatoms may be the same as or different from each other. The heterocyclic group may be a monocyclic heterocyclic group or a polycyclic heterocyclic group, and is a concept including a heteroaryl group. The ring-forming carbon number of the heterocyclic group may be 2 to 30, 2 to 20, or 2 to 10.

In the present specification, an aliphatic heterocyclic group may include one or more among B, O, N, P, Si and S as a heteroatom. The ring-forming carbon number of the aliphatic heterocyclic group may be 2 to 30, 2 to 20, or 2 to 10. Examples of the aliphatic heterocyclic group may include an oxirane group, a thiirane group, a pyrrolidine group, a piperidine group, a tetrahydrofuran group, a tetrahydrothiophene group, a thiane group, a tetrahydropyran group, a 1,4-dioxane group, etc., without limitation.

In the present specification, a heteroaryl group may include one or more among B, O, N, P, Si, and S as a heteroatom. When the heteroaryl group includes two or more heteroatoms, the two or more heteroatoms may be the same as or different from each other. The heteroaryl group may be a monocyclic heterocyclic group or polycyclic heterocyclic group. The ring-forming carbon number of the heteroaryl group may be 2 to 30, 2 to 20, or 2 to 10. Examples of the heteroaryl group may include thienyl, furyl, pyrrolyl, imidazolyl, pyridyl, bipyridinyl, and bipyridinyl groups, triazolyl, acridinyl, pyridazinyl, pyrazinyl, quinolyl, and quinazolinyl, quinoxalinyl, phenoxazinyl, phthalazinyl, and pyridopyrimidinyl, pyridopyrazinyl, pyrazinopyrazinyl, isoquinolinyl, indolyl, carbazolyl, N-arylcarbazolyl group, N-heteroarylcarbazolyl group, N-alkylcarbazolyl group, benzoxazolyl group, benzoxazolyl group, benzoimidazolyl, benzothiazolyl, benzocarbazolyl, benzothiophenyl, and dibenzothiophenyl, thienothiophenyl, benzofuranyl, phenanthrolinyl, thiazolyl, isoxazolyl, and oxazolyl, oxadiazolyl, thiadiazolyl, phenothiazinyl, dibenzosilolyl, dibenzofuranyl, dibenzofuranyl, etc., without limitation.

In the present specification, the description on the aryl group may be applied to an arylene group except that the arylene group is a divalent group. The description on the heteroaryl group may be applied to a heteroarylene group except that the heteroarylene group is a divalent group.

In the present specification, a silyl group includes an alkyl silyl group and an aryl silyl group. Examples of the silyl group include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, etc., without limitation.

In the present specification, the carbon number of a carbonyl group is not specifically limited, but the carbon number may be 1 to 40, 1 to 30, or 1 to 20. For example, the carbonyl group may have the structures depicted below, but is not limited thereto.

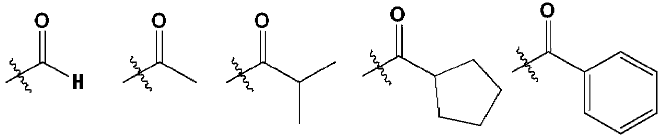

In the present specification, the carbon number of a sulfinyl group and sulfonyl group is not specifically limited, but may be 1 to 30. The sulfinyl group may include an alkyl sulfinyl group and an aryl sulfinyl group. The sulfonyl group may include an alkyl sulfonyl group and an aryl sulfonyl group.

In the present specification, a thio group may include an alkyl thio group and an aryl thio group. The thio group may mean any of the previously defined alkyl group or aryl group combined with a sulfur atom. Examples of the thio group are a methylthio group, an ethylthio group, a propylthio group, a pentylthio group, a hexylthio group, an octylthio group, a dodecylthio group, a cyclopentylthio group, a cyclohexylthio group, a phenylthio group, a naphthylthio group, etc., without limitation.

In the present specification, an oxy group may mean any of the previously defined alkyl group or aryl group which is combined with an oxygen atom. The oxy group may include an alkoxy group and an aryl oxy group. The alkoxy group may be linear, branched, or cyclic. The carbon number of the alkoxy group is not specifically limited but may be, for example, 1 to 20 or 1 to 10. Examples of the oxy group may include methoxy, ethoxy, n-propoxy, isopropoxy, butoxy, pentyloxy, hexyloxy, octyloxy, nonyloxy, decyloxy, benzyloxy, etc., without limitation.

In the present specification, a boron group may mean any of the previously defined alkyl group or aryl group which is combined with a boron atom. The boron group includes an alkyl boron group and an aryl boron group. Examples of the boron group include a trimethylboron group, a triethylboron group, a t-butyldimethylboron group, a triphenylboron group, a diphenylboron group, a phenylboron group, etc., without limitation.

In the present specification, the carbon number of an amine group is not specifically limited, but may be 1 to 30. The amine group may include an alkyl amine group and an aryl amine group. Examples of the amine group include a methylamine group, a dimethylamine group, a phenylamine group, a diphenylamine group, a naphthylamine group, a 9-methyl-anthracenylamine group, etc., without limitation.

In the present specification, the alkyl group in the alkylthio group, alkylsulfoxy group, alkylaryl group, alkylamino group, alkylboron group, alkyl silyl group, and alkyl amine group is the same as the examples of any of the previously described alkyl group.

In the present specification, the aryl group in the aryloxy group, arylthio group, arylsulfoxy group, aryl amino group, arylboron group, aryl silyl group and aryl amine group are the same as the examples of any of the previously described aryl group.

In the present specification, the phosphine oxide group may be substituted with, for example, at least one of the alkyl groups or aryl groups described above.

In the present specification, the phosphine sulfide group may be substituted with, for example, at least one of the alkyl groups or aryl groups described above

In the present specification, a direct linkage may mean a single bond.

In the present specification, 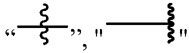 and " -* " mean positions to be connected.

Hereinafter, embodiments of the inventive concept will be described referring to the drawings.

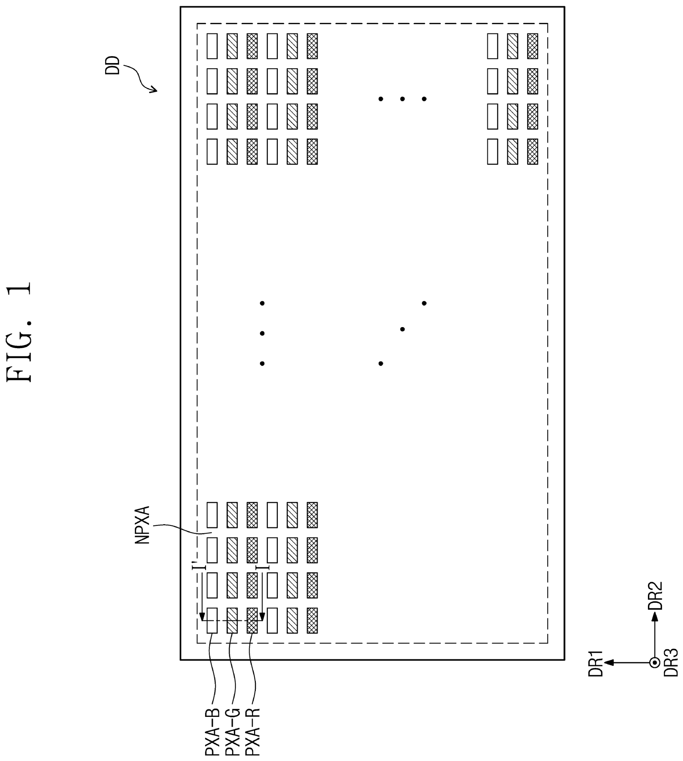

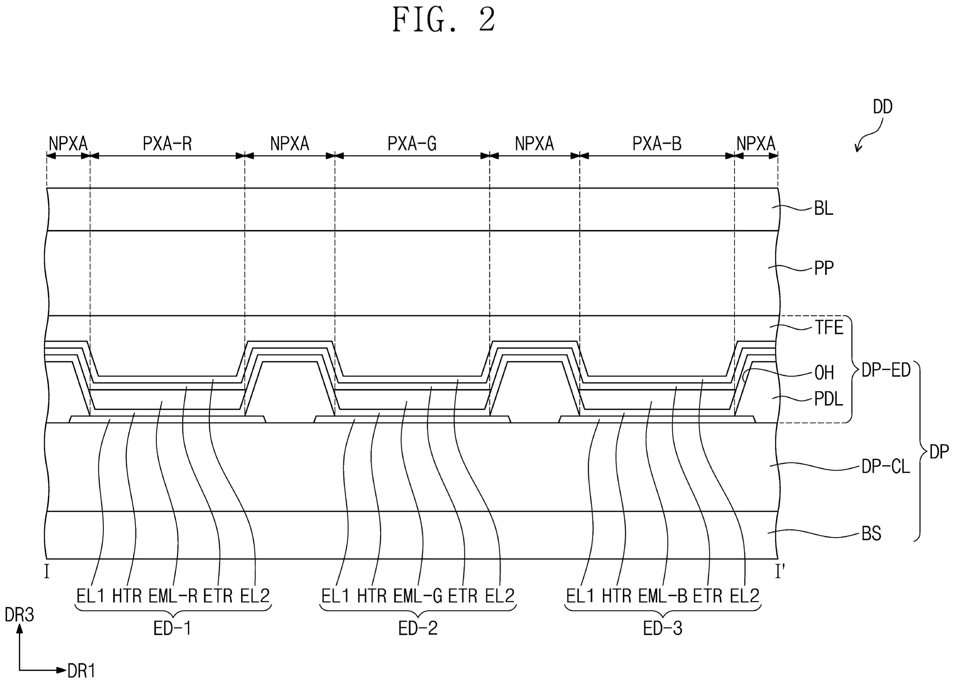

FIG. 1 is a plan view illustrating an embodiment of a display device DD. FIG. 2 is a cross-sectional view of a display device DD of an embodiment. FIG. 2 is a cross-sectional view showing a part corresponding to line I-I' in FIG. 1.

The display device DD may include a display panel DP and an optical layer PP disposed on the display panel DP. The display panel DP includes light-emitting elements ED-1, ED-2, and ED-3. The display device DD may include a plurality of light-emitting elements ED-1, ED-2, and ED-3. The optical layer PP may be disposed on the display panel DP to control reflected light by external light at the display panel DP. The optical layer PP may include, for example, a polarization layer or a color filter layer. Unlike what is illustrated, the optical layer PP may be omitted in the display device DD according to an embodiment.

On the optical layer PP, a base substrate BL may be disposed. The base substrate BL may be a member providing a base surface where the optical layer PP is disposed. The base substrate BL may be a glass substrate, a metal substrate, a plastic substrate, etc. However, an embodiment of the inventive concept is not limited thereto, and the base substrate BL may be an inorganic layer, an organic layer, or a composite material layer. In addition, unlike what is illustrated, the base substrate BL may be omitted in an embodiment.

The display device DD according to an embodiment may further include a plugging layer (not shown). The plugging layer (not shown) may be disposed between a display element layer DP-ED and the base substrate BL. The plugging layer (not shown) may be an organic layer. The plugging layer (not shown) may include at least one among an acrylic resin, a silicon-based resin, and an epoxy-based resin.

The display panel DP may include a base layer BS, a circuit layer DP-CL provided on the base layer BS and the display element layer DP-ED. The display element layer DP-ED may include a pixel-defining film PDL, light-emitting elements ED-1, ED-2 and ED-3 disposed between the pixel-defining films PDL, and an encapsulation layer TFE disposed on the light-emitting elements ED-1, ED-2, and ED-3.

The base layer BS may be a member providing a base surface where the display element layer DP-ED is disposed. The base layer BS may be a glass substrate, a metal substrate, a plastic substrate, etc. However, an embodiment is not limited thereto, and the base layer BS may be an inorganic layer, an organic layer, or a composite material layer.

According to an embodiment, the circuit layer DP-CL may be disposed on the base layer BS, and may include a plurality of transistors (not shown). Each of the transistors (not shown) may include a control electrode, an input electrode, and an output electrode. For example, the circuit layer DP-CL may include a switching transistor and a driving transistor for driving the light-emitting elements ED-1, ED-2, and ED-3 of the display element layer DP-ED.

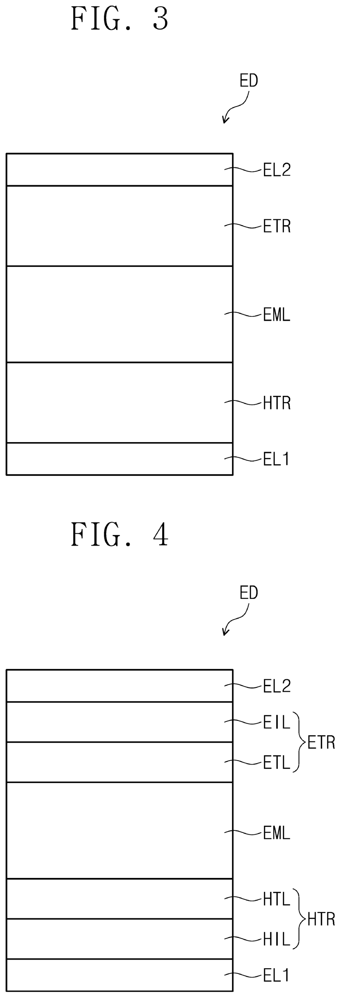

Each of the light-emitting elements ED-1, ED-2 and ED-3 may have the structures of light-emitting elements ED of embodiments according to FIG. 3 to FIG. 6 to be described later. Each of the light-emitting elements ED-1, ED-2 and ED-3 may include a first electrode EL1, a hole transport region HTR, light-emitting layers EML-R, EML-G and EML-B, an electron transport region ETR, and a second electrode EL2.

FIG. 2 shows an illustration of an embodiment in which the light-emitting layers EML-R, EML-G and EML-B of the light-emitting elements ED-1, ED-2 and ED-3 are disposed in openings OH defined in a pixel-defining film PDL, and the hole transport region HTR, the electron transport region ETR and the second electrode EL2 are provided as common layers in all light-emitting elements ED-1, ED-2 and ED-3. However, an embodiment is not limited thereto. Unlike what is illustrated in FIG. 2, according to an embodiment, the hole transport region HTR and the electron transport region ETR may be patterned and provided in the openings OH defined in the pixel-defining film PDL. For example, according to an embodiment, the hole transport region HTR, the light-emitting layers EML-R, EML-G and EML-B, and the electron transport region ETR of the light-emitting elements ED-1, ED-2 and ED-3 may be patterned in an ink jet printing process and provided.

An encapsulation layer TFE may cover the light-emitting elements ED-1, ED-2, and ED-3. The encapsulation layer TFE may encapsulate the display element layer DP-ED. The encapsulation layer TFE may be a thin film encapsulation layer. The encapsulation layer TFE may be one layer or a plurality of stacked layers. The encapsulation layer TFE includes at least one insulating layer. The encapsulation layer TFE according to an embodiment may include at least one inorganic layer (hereinafter, an inorganic encapsulation layer). In addition, the encapsulation layer TFE according to an embodiment may include at least one organic layer (hereinafter, an organic encapsulation layer) and at least one inorganic encapsulation layer.

The inorganic encapsulation layer protects the display element layer DP-ED from moisture/oxygen, and the organic encapsulation layer protects the display element layer DP-ED from foreign materials such as dust particles. The inorganic encapsulation layer may include silicon nitride, silicon oxynitride, silicon oxide, titanium oxide, or aluminium oxide, without specific limitation. The organic encapsulation layer may include an acrylic compound, an epoxy-based compound, etc. The organic encapsulation layer may include a photopolymerizable organic material, without specific limitation.

The encapsulation layer TFE may be disposed on the second electrode EL2 and may be disposed while filling the opening OH.

Referring to FIG. 1 and FIG. 2, the display device DD may include a non-luminous area NPXA and luminous areas PXA-R, PXA-G and PXA-B. The luminous areas PXA-R, PXA-G and PXA-B may be areas that emit light generated by the light-emitting elements ED-1, ED-2, and ED-3, respectively. The luminous areas PXA-R, PXA-G and PXA-B may be spaced apart from each other on a plane.

The luminous areas PXA-R, PXA-G and PXA-B may be areas separated by the pixel-defining film PDL. The non-luminous areas NPXA may be areas between neighboring luminous areas PXA-R, PXA-G and PXA-B and may be areas corresponding to the pixel-defining film PDL. In the present specification, each of the luminous areas PXA-R, PXA-G and PXA-B may correspond to a pixel. The pixel-defining film PDL may divide the light-emitting elements ED-1, ED-2, and ED-3. The light-emitting layers EML-R, EML-G and EML-B of the light-emitting elements ED-1, ED-2 and ED-3 may be disposed and divided in the openings OH defined in the pixel-defining film PDL.

The luminous areas PXA-R, PXA-G and PXA-B may be divided into a plurality of groups according to the color of light generated by the light-emitting elements ED-1, ED-2, and ED-3. In the display device DD according to an embodiment and shown in FIG. 1 and FIG. 2, three luminous areas PXA-R, PXA-G and PXA-B that emit red light, green light and blue light are exemplarily illustrated. For example, the display device DD according to an embodiment may include a red luminous area PXA-R, a green luminous area PXA-G and a blue luminous area PXA-B, which are separated from each other.

In the display device DD according to an embodiment, the plurality of light-emitting elements ED-1, ED-2 and ED-3 may emit light having different wavelength regions. For example, according to an embodiment, the display device DD may include a first light-emitting element ED-1 emitting red light, a second light-emitting element ED-2 emitting green light, and a third light-emitting element ED-3 emitting blue light. That is, the red luminous area PXA-R, the green luminous area PXA-G, and the blue luminous area PXA-B of the display device DD may respectively correspond to the first light-emitting element ED-1, the second light-emitting element ED-2, and the third light-emitting element ED-3. A third directional axis DR3 may be perpendicular to a plane defined by the first directional axis DR1 and the second directional axis DR2.

However, an embodiment of the inventive concept is not limited thereto, and the first to third light-emitting elements ED-1, ED-2 and ED-3 may emit light having the same wavelength region as each other, or at least one thereof may emit light having a different wavelength region. For example, all of the first to third light-emitting elements ED-1, ED-2 and ED-3 may emit blue light.

The luminous areas PXA-R, PXA-G and PXA-B in the display device DD according to an embodiment may be arranged in a stripe shape. Referring to FIG. 1, a plurality of red luminous areas PXA-R, a plurality of green luminous areas PXA-G and a plurality of blue luminous areas PXA-B may be arranged along a second directional axis DR2. In addition, the red luminous area PXA-R, the green luminous area PXA-G, and the blue luminous area PXA-B may be sequentially alternately arranged along a first directional axis DR1.

FIGS. 1 and 2 show illustrations of the luminous areas PXA-R, PXA-G and PXA-B, which are similar to each other, but an embodiment of the inventive concept is not limited thereto. The areas of the luminous areas PXA-R, PXA-G and PXA-B may be different from each other according to the wavelength region of light emitted thereby. The areas of the luminous areas PXA-R, PXA-G and PXA-B may mean areas on a plane defined by the first directional axis DR1 and the second directional axis DR2.

An arrangement type of the luminous areas PXA-R, PXA-G and PXA-B is not limited to what is illustrated in FIG. 1, and an arrangement order of the red luminous areas PXA-R, the green luminous areas PXA-G and the blue luminous areas PXA-B may be provided in various combinations according to characteristics of display quality required for the display device DD. For example, the arrangement type of the luminous areas PXA-R, PXA-G and PXA-B may be a pentile (PENTILE^{™}) arrangement type, or a diamond (Diamond Pixel^{™}) arrangement type.

In addition, the areas of the luminous areas PXA-R, PXA-G and PXA-B may be different from each other. For example, according to an embodiment, the area of the green luminous area PXA-G may be smaller than the area of the blue luminous area PXA-B, but an embodiment of the inventive concept is not limited thereto.

Hereinafter, FIGS. 3 to 6 are cross-sectional views schematically illustrating a light-emitting element ED according to an embodiment. The light-emitting element ED according to an embodiment may include the first electrode EL1, the second electrode EL2 facing the first electrode EL1, and at least one functional layer disposed between the first electrode EL1 and the second electrode EL2. The light-emitting element ED according to an embodiment may include a condensed polycyclic compound according to an embodiment to be described later in the at least one functional layer.

The light-emitting element ED may include, as the at least one functional layer, the hole transport region HTR, the light-emitting layer EML, the electron transport region ETR and the like sequentially stacked. That is, the light-emitting element ED according to an embodiment may include the first electrode EL1, the hole transport region HTR, the light-emitting layer EML, the electron transport region ETR and the second electrode EL2 sequentially stacked.

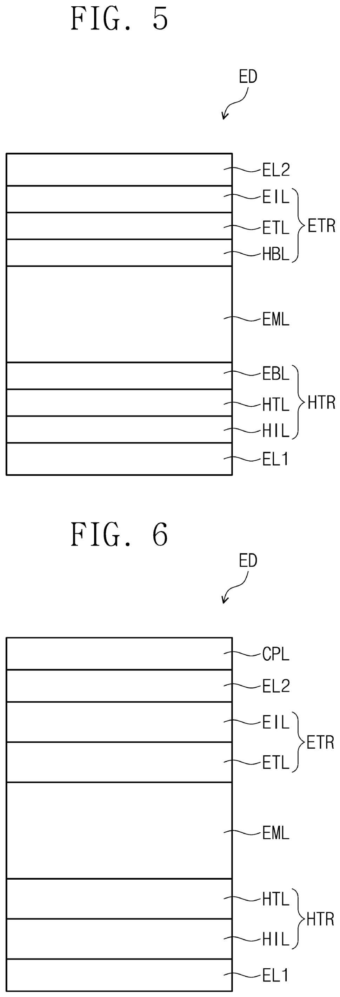

When compared with FIG. 3, FIG. 4 shows an illustration of the cross-sectional view of the light-emitting element ED according to an embodiment, wherein the hole transport region HTR includes a hole injection layer HIL and a hole transport layer HTL, and the electron transport region ETR includes an electron injection layer EIL and an electron transport layer ETL. In addition, when compared with FIG. 3, FIG. 5 shows an illustration of the cross-sectional view of the light-emitting element ED according to an embodiment, wherein the hole transport region HTR includes a hole injection layer HIL, a hole transport layer HTL, and an electron blocking layer EBL, and the electron transport region ETR includes an electron injection layer EIL, an electron transport layer ETL, and a hole blocking layer HBL. When compared with FIG. 4, FIG. 6 shows an illustration of the cross-sectional view of the light-emitting element ED according to an embodiment, including a capping layer CPL disposed on the second electrode EL2.

The light-emitting element ED according to an embodiment may include the condensed polycyclic compound according to an embodiment to be described later in the at least one functional layer included in the light-emitting element ED. The light-emitting element ED according to an embodiment may include the condensed polycyclic compound according to an embodiment in at least one among the hole transport region HTR, the light-emitting layer EML, and the electron transport region ETR. For example, the light-emitting layer EML in the light-emitting element ED according to an embodiment may include the condensed polycyclic compound according to an embodiment.

The first electrode EL1 may be conductive. The first electrode EL1 may be formed of a metal material, a metal alloy, or a conductive compound. The first electrode EL1 may be a cathode or an anode, but an embodiment of the inventive concept is not limited thereto. In addition, the first electrode EL1 may be a pixel electrode. The first electrode EL1 may be a transmissive electrode, a semi-transmissive electrode, or a reflective electrode. The first electrode EL1 may include at least one selected from Ag, Mg, Cu, Al, Pt, Pd, Au, Ni, Nd, Ir, Cr, Li, Ca, LiF, Mo, Ti, W, In, Sn, and Zn, a compound of at least two selected therefrom, a mixture of at least two selected therefrom, or an oxide thereof.

When the first electrode EL1 is a transmissive electrode, the first electrode EL1 may include a transparent metal oxide, for example, indium-tin oxide (ITO), indium-zinc oxide (IZO), zinc oxide (ZnO), indium-tin-zinc oxide (ITZO), or the like. When the first electrode EL1 is a semi-transmissive electrode or a reflective electrode, the first electrode EL1 may include Ag, Mg, Cu, Al, Pt, Pd, Au, Ni, Nd, Ir, Cr, Li, Ca, LiF/Ca (a stack structure of LiF and Ca), LiF/Al (a stack structure of LiF and Al), Mo, Ti, W, or a compound or a mixture thereof (e.g., a mixture of Ag and Mg). Alternatively, the first electrode EL1 may have a multi-layered structure including the reflective film or the semi-transmissive film formed of any of the previously described material, and a transparent conductive film formed of indium-tin oxide (ITO), indium-zinc oxide (IZO), zinc oxide (ZnO), indium-tin-zinc oxide (ITZO), or the like. For example, the first electrode EL1 may have a three-layered structure of an ITO/Ag/ITO, but an embodiment of the inventive concept is not limited thereto. In addition, the first electrode EL1 may include any of the previously described metal material, a combination of at least two metal materials selected from the any of the previously described metal materials, an oxide of the any of the previously described metal materials, or the like. The first electrode EL1 may have a thickness of about 700 Å to about 10000 Å. For example, the first electrode EL1 may have a thickness of about 1000 Å to about 3000 Å.

The hole transport region HTR is provided on the first electrode EL1. The hole transport region HTR may include at least one of the hole injection layer HIL, the hole transport layer HTL, a buffer layer or an auxiliary light-emitting layer (not shown), or the electron blocking layer EBL. The hole transport region HTR may have a thickness of about 50 Å to about 15,000 Å.

The hole transport region HTR may have a single layer formed of a single material, a single layer formed of a plurality of different materials, or a multi-layered structure including a plurality of layers formed of a plurality of different materials.

For example, the hole transport region HTR may have the structure of a single layer of the hole injection layer HIL or the hole transport layer HTL, and may have a structure of a single layer formed of a hole injection material and a hole transport material. In addition, the hole transport region HTR may have a structure of a single layer formed of a plurality of different materials, or a structure of the hole injection layer HIL/the hole transport layer HTL, the hole injection layer HIL/the hole transport layer HTL/the buffer layer (not shown), the hole injection layer HIL/the buffer layer (not shown), the hole transport layer HTL/the buffer layer (not shown), or the hole injection layer HIL/the hole transport layer HTL/the electron blocking layer EBL, which are stacked from the first electrode EL1, without limitation.

The hole transport region HTR may be formed in various processes such as vacuum deposition, spin coating, casting, a Langmuir-Blodgett (LB) process, inkjet printing, laser printing, and laser induced thermal imaging (LITI).

The hole transport region HTR may include a compound represented by Formula H-1:

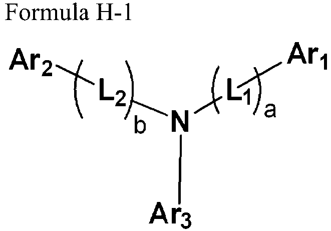

In Formula H-1, L₁ and L₂ may be each independently a direct linkage, a substituted or unsubstituted arylene group having a ring-forming carbon number of 6 to 30 or a substituted or unsubstituted heteroarylene group having a ring-forming carbon number of 2 to 30. "a" and "b" may be each independently an integer of 0 to 10. When "a" or "b" is an integer of 2 or more, a plurality of L₁ and L₂ may be each independently a substituted or unsubstituted arylene group having a ring-forming carbon number of 6 to 30, or a substituted or unsubstituted heteroarylene group having a ring-forming carbon number of 2 to 30.

In Formula H-1, Ar₁ and Ar₂ may be each independently a substituted or unsubstituted aryl group of 6 to 30 ring-forming carbon atoms, or a substituted or unsubstituted heteroaryl group of 2 to 30 ring-forming carbon atoms. In addition, in Formula H-1, Ar₃ may be a substituted or unsubstituted aryl group of 6 to 30 ring-forming carbon atoms, or a substituted or unsubstituted heteroaryl group of 2 to 30 ring-forming carbon atoms.

The compound represented by Formula H-1 may be a monoamine compound. Otherwise, the compound represented by Formula H-1 may be a diamine compound in which at least one among Ar₁ to Ar³ includes an amine group as a substituent. In addition, the compound represented by Formula H-1 may be a carbazole-based compound in which at least one of Ar₁ or Ar₂ includes a substituted or unsubstituted carbazole group, or a fluorene-based compound in which at least one of Ar₁ or Ar₂ includes a substituted or unsubstituted fluorene group.

The compound represented by Formula H-1 may be represented by any one among compounds in Compound Group H. However, the compounds listed in Compound Group H are examples, and the compound represented by Formula H-1 is not limited to the compounds represented in Compound Group H:

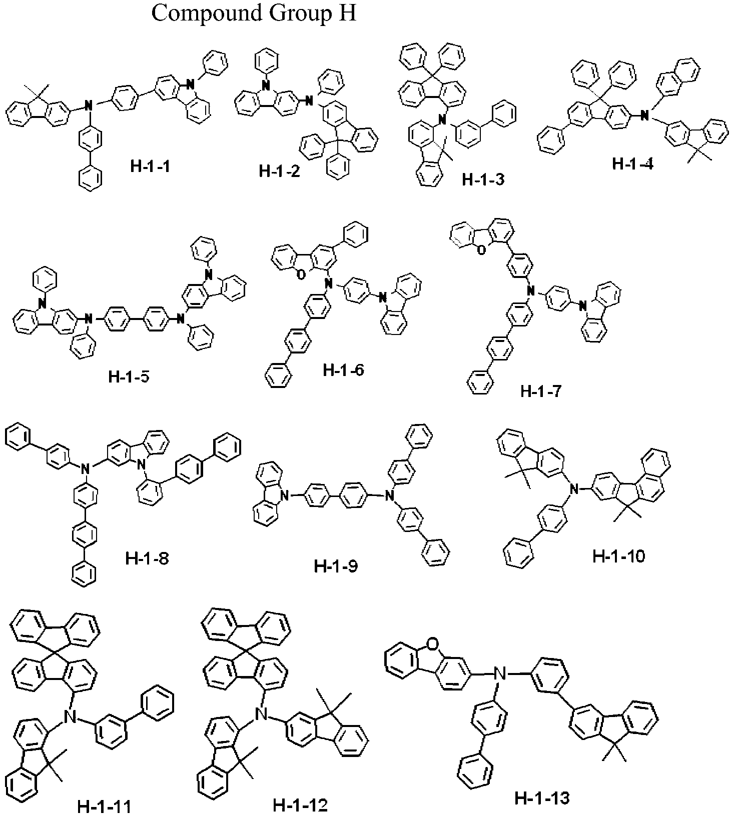

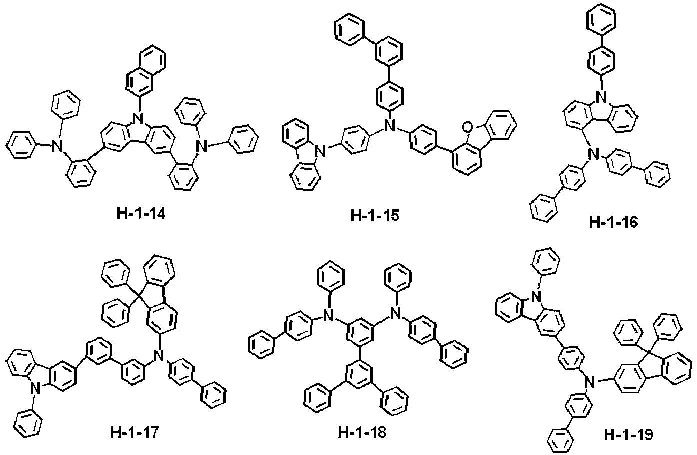

The hole transport region HTR may include a phthalocyanine compound such as copper phthalocyanine, N1,N1'-([1,1'-biphenyl]-4,4'-diyl)bis(N1-phenyl-N4,N4-di-m-tolylbenzene-1,4-diamine) (DNTPD), 4,4',4"-[tris(3-methylphenyl)phenylamino] triphenylamine (m-MTDATA), 4,4',4"-tris(N,N-diphenylamino)triphenylamine (TDATA), 4,4',4"-tris[N(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(1-naphthalene-1-yl)-N,N'-diphenyl-benzidine (NPB), triphenylamine-containing polyetherketone (TPAPEK), 4-isopropyl-4'-methyldiphenyliodonium [tetrakis(pentafluorophenyl)borate], and dipyrazino[2,3-f:2',3'-h] quinoxaline-2,3,6,7,10,11-hexacarbonitrile (HATCN).

The hole transport region HTR may include carbazole derivatives such as N-phenyl carbazole and polyvinyl carbazole, fluorene-based derivatives, N,N'-bis(3-methylphenyl)-N,N'-diphenyl-[1,1'-biphenyl]-4,4'-diamine (TPD), triphenylamine-based derivatives such as 4,4',4"-tris(N-carbazolyl)triphenylamine (TCTA), N,N'-di(1-naphthalene-1-yl)-N,N'-diphenyl-benzidine (NPB), 4,4'-cyclohexylidene bis[N,N-bis(4-methylphenyl)benzeneamine] (TAPC), 4,4'-bis[N,N'-(3-tolyl)amino]-3,3'-dimethylbiphenyl (HMTPD), 1,3-bis(N-carbazolyl)benzene (mCP), etc.

In addition, the hole transport region HTR may include 9-(4-tert-butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), etc.

According to an embodiment, the hole transport region HTR may include any one among the compounds of Compound Group 2.

The hole transport region HTR may include the compounds of the hole transport region previously described in at least one among the hole injection layer HIL, the hole transport layer HTL, and the electron blocking layer EBL.

The hole transport region HTR may have a thickness of about 100 Å to about 10,000 Å, for example, of about 100 Å to about 5,000 Å. In a case where the hole transport region HTR includes the hole injection layer HIL, the hole injection layer HIL may have a thickness of, for example, about 30 Å to about 1,000 Å. In a case where the hole transport region HTR includes the hole transport layer HTL, the hole transport layer HTL may have a thickness of about 30 Å to about 1,000 Å. For example, in a case where the hole transport region HTR includes the electron blocking layer, the electron blocking layer EBL may have a thickness of about 10 Å to about 1,000 Å. When the thicknesses of the hole transport region HTR, the hole injection layer HIL, the hole transport layer HTL and the electron blocking layer EBL satisfy any of the previously described ranges, satisfactory hole transport characteristics may be obtained without substantial increase of a driving voltage.

The hole transport region HTR may further include a charge generation material so as to increase conductivity in addition to any of the previously described materials. The charge generation material may be dispersed uniformly or non-uniformly in the hole transport region HTR. The charge generation material may be, for example, a p-dopant. The p-dopant may include at least one of a metal halide compound, a quinone derivative, a metal oxide, and a cyano group-containing compound, without limitation. For example, the p-dopant may include the metal halide compound such as CuI and RbI, the quinone derivative such as tetracyanoquinodimethane (TCNQ) and 2,3,5,6-tetrafluoro-7,7',8,8-tetracyanoquinodimethane (F4-TCNQ), the metal oxide such as tungsten oxide and molybdenum oxide, the cyano group-containing compound such as dipyrazino[2,3-f: 2',3'-h] quinoxaline-2,3,6,7,10,11-hexacarbonitrile (HATCN) and 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), etc., without limitation.

As previously described, the hole transport region HTR may further include at least one among the buffer layer (not shown) and the electron blocking layer EBL in addition to the hole injection layer HIL and the hole transport layer HTL. The buffer layer (not shown) may compensate a resonance distance according to the wavelength of light emitted by a light-emitting layer EML and may increase light emission efficiency. As a material included in the buffer layer (not shown), a material which may be included in the hole transport region HTR may be used. The electron blocking layer EBL is a layer serving to prevent injection of electrons from the electron transport region ETR to the hole transport region HTR.

The light-emitting layer EML is provided on the hole transport region HTR. The light-emitting layer EML may have a thickness of, for example, about 100 Å to about 1,000 Å, or about 100 Å to about 300 Å. The light-emitting layer EML may have a single layer formed of a single material, a single layer formed of a plurality of different materials, or a multi-layered structure having a plurality of layers formed of a plurality of different materials.

The light-emitting element ED according to an embodiment includes the condensed polycyclic compound represented by Formula 1 in at least one functional layer disposed between the first electrode EL1 and the second electrode EL2. In the light-emitting element ED according to an embodiment, the light-emitting layer EML includes the condensed polycyclic compound according to an embodiment. According to an embodiment, the light-emitting layer EML may include the condensed polycyclic compound according to an embodiment as a dopant. The condensed polycyclic compound according to an embodiment may be a dopant material of the light-emitting layer EML. In the present specification, the condensed polycyclic compound according to an embodiment may be referred to as a first compound.

Each of the condensed polycyclic compounds according to an embodiment includes first and second condensed cores which include a boron-centered condensed skeleton. In the condensed polycyclic compound according to an embodiment, the first condensed core and the second condensed core may have a form in which one benzene ring and one nitrogen atom are shared and connected to each other. The condensed polycyclic compound according to the inventive concept may have a structure that includes a connection structure in which the first condensed core and the second condensed core are specified to show a small full width of half maximum and stokes-shift characteristics, and to show high luminous quantum efficiency.

According to an embodiment, the first condensed core may have a structure in which six rings are condensed around a first boron atom, a first nitrogen atom, a first heteroatom and a second heteroatom. Since three substituted or unsubstituted benzene rings are connected through the first boron atom, the first nitrogen atom, the first heteroatom and the second heteroatom, the first condensed core may form the six condensed rings. More specifically, in three benzene rings included in the first condensed core, the three benzene rings may be connected around the first boron atom, a first benzene ring and a second benzene ring of the three benzene rings may be connected through the first nitrogen atom, the first benzene ring and a third benzene ring may be connected through the first heteroatom, and the second benzene ring and the third benzene ring may be connected through the second heteroatom. The first condensed core may share the first benzene ring and the first nitrogen atom with the second condensed core previously described. The first condensed core and the second condensed core may be connected to each other by sharing the first benzene ring and the first nitrogen atom.

According to an embodiment, the second condensed core may have a structure in which five rings are condensed around a second boron atom, the first nitrogen atom and a third heteroatom. Since substituted or unsubstituted benzene rings are connected through the second boron atom, the first nitrogen atom and the third heteroatom, the second condensed core may form the five condensed rings. More specifically, in the three benzene rings included in the second condensed core, three benzene rings may be connected around the second boron atom, a first benzene ring and a fourth benzene ring of the three benzene rings may be connected through the first nitrogen atom, and the first benzene ring and a fifth benzene ring may be connected through the third heteroatom. A heteroatom except for a boron atom may not be disposed between the fourth benzene ring and the fifth benzene ring. The first benzene ring and the first nitrogen atom in the second condensed core may be shared by the first condensed core previously described.

In the condensed polycyclic compound according to an embodiment, the first condensed core may be represented by structure S1, and the second condensed core may be represented by structure S2. For convenience of description, it is illustrated that substituents connected to benzene rings are omitted in each of structures S1 and S2:

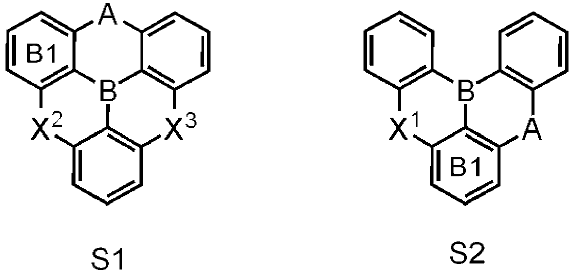

In structure S1, A may correspond to the first nitrogen atom previously described, and the B1 ring may correspond to the first benzene ring previously described. In structure S1, A is 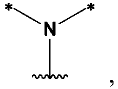 and X² and X³ are each independently *-O-* , *-S-* , or

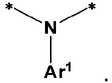

In structure S2, A may correspond to the first nitrogen atom previously described, and the B1 ring may correspond to the first benzene ring previously described. In structure S2, A is 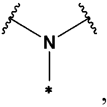 and X¹ is

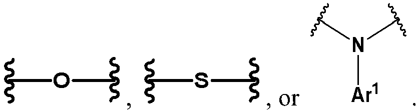

In structures S1 and S2, Ar¹ is a substituted or unsubstituted aryl group having a ring-forming carbon number of 6 to 30, or a substituted or unsubstituted heteroaryl group having a ring-forming carbon number of 2 to 30.

In structures S1 and S2, "-* " means a position connected to structure S1, and 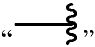 means a position connected to structure S2.

In the condensed polycyclic compound according to an embodiment, the first condensed core represented by structure S1 and the second condensed core represented by structure S2 may be connected to each other by sharing the first benzene ring (B1) and the first nitrogen atom (N). In the condensed polycyclic compound according to an embodiment, the first condensed core and the second condensed core may be connected to each other so as to share the first benzene ring (B1) and the first nitrogen atom (N) to form a condensed ring having ten rings such as structure S3:

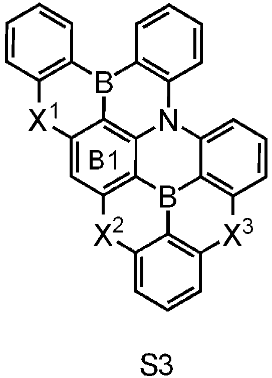

In structure S3, the B1 ring may correspond to the first benzene ring (B1) previously described, and the nitrogen atom (N) may correspond to the first nitrogen atom previously described.

In structure S3, description made in structures S1 and S2 may be identically applied to X¹ to X³.

Due to a narrow full width of half maximum and high luminous quantum efficiency, the thermally activated delayed fluorescence material having a boron-centered condensed ring skeleton is attracting attention as a material of an organic light-emitting element. In a diboron-based thermally activated delayed fluorescence material, improvement in element lifespan and element efficiency is expected through high absorbance and fast inverse crossing. However, in general, compared with a single boron-based condensed skeleton, the diboron-based condensed skeleton has great full width of half maximum and stokes-shift due to a structural relaxation effect between an excited state and a ground state to be still insufficient as a material for high quality display.

Since the condensed polycyclic compound according to the inventive concept has a structure in which the first condensed core and the second condensed core are combined through a specific connection structure, the condensed polycyclic compound according to the inventive concept may show a small full width of half maximum and small stokes-shift characteristics, and high luminous quantum efficiency.

In the condensed polycyclic compound according to an embodiment, the first condensed core has a structure in which three benzene rings are connected around a boron atom, and in particular, has a structure in which all of ortho position carbons with respect to the boron atom in the three benzene rings are connected through a heteroatom such as N, O and S to form a condensed ring. Therefore, structural relaxation between the excited state and the ground state of a molecule may be suppressed to show a smaller full width of half maximum and smaller stokes-shift characteristics than a typical condensed skeleton.

In addition, the condensed polycyclic compound according to an embodiment may include a structure in which the second condensed core is combined with the first condensed core to weaken molecular symmetry, and thus may show improved photoluminescence quantum yield (PLQY). In general, the thermally activated delayed fluorescence material including the boron-centered condensed ring skeleton has a limitation of remarkably deteriorating photoluminescence quantum yield due to the molecular symmetry. For example, when as in the first condensed core, all of the ortho position carbons of the boron atom form the condensed ring skeleton, the molecular symmetry may increase to deteriorate luminous quantum yield. However, since the condensed polycyclic compound according to the inventive concept has the structure in which the second condensed core is combined with the first condensed core, the condensed polycyclic compound according to the inventive concept may maintain the first condensed core-derived full width of half maximum and excellent stokes-shift characteristics and may simultaneously suppress the molecular symmetry to show improved photoluminescence quantum yield characteristics.

The condensed polycyclic compound according to an embodiment is represented by Formula 1:

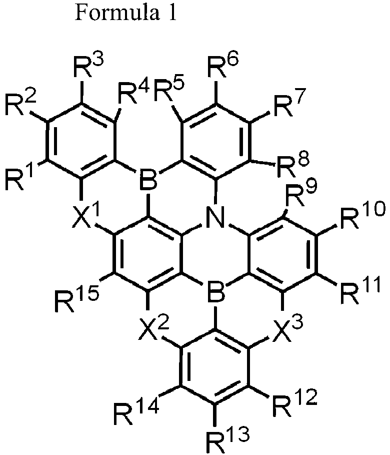

The condensed polycyclic compound according to an embodiment represented by Formula 1 includes the first and second condensed cores each including a boron-centered condensed skeleton. In the condensed polycyclic compound according to an embodiment, the first condensed core and the second condensed core may have a form that shares one benzene ring and one nitrogen atom and are connected to each other.

In the present specification, in Formula 1, a benzene ring in which a substituent represented by R¹⁵ is substituted may correspond to a first benzene ring, a benzene ring in which substituents represented by R⁹ to R¹¹ are substituted may correspond to a second benzene ring, a benzene ring in which substituents represented by R¹² to R¹⁴ are substituted may correspond to a third benzene ring, a benzene ring in which substituents represented by R⁵ to R⁸ are substituted may correspond to a fourth benzene ring, and a benzene ring in which substituents represented by R¹ to R⁴ are substituted may correspond to a fifth benzene ring. A nitrogen atom (N) in Formula 1 may correspond to the first nitrogen atom previously described.

In Formula 1, X¹ to X³ are each independently O, S or NAr¹. For example, X¹ to X³ may be each independently O or NAr¹.

In Formula 1, Ar¹ is a substituted or unsubstituted aryl group having a ring-forming carbon number of 6 to 30, or a substituted or unsubstituted heteroaryl group having a ring-forming carbon number of 2 to 30. According to an embodiment, Ar¹ may be a substituted or unsubstituted aryl group having a ring-forming carbon number of 6 to 30. For example, Ar¹ may be a substituted or unsubstituted phenyl group, a substituted or unsubstituted biphenyl group, a substituted or unsubstituted terphenyl group, a substituted or unsubstituted quaterphenyl group, or a substituted or unsubstituted quinquephenyl group.

In Formula 1, R¹ to R¹⁵ are each independently a hydrogen atom, a deuterium atom, a halogen atom, a cyano group, a nitro group, a substituted or unsubstituted amine group, a substituted or unsubstituted alkyl group having a carbon number of 1 to 20, a substituted or unsubstituted aryl group having a ring-forming carbon number of 6 to 30, or a substituted or unsubstituted heteroaryl group having a ring-forming carbon number of 2 to 30. For example, R¹ to R¹⁵ may be each independently a hydrogen atom, a deuterium atom, a cyano group, a substituted or unsubstituted diphenylamine group, a substituted or unsubstituted methyl group, a substituted or unsubstituted isopropyl group, a substituted or unsubstituted t-butyl group, a substituted or unsubstituted phenyl group, a substituted or unsubstituted biphenyl group, a substituted or unsubstituted terphenyl group, a substituted or unsubstituted quaterphenyl group, a substituted or unsubstituted quinquephenyl group, or a substituted or unsubstituted carbazole group. A case in which in the condensed polycyclic compound according to an embodiment, when R¹³ is a diphenylamine group or a carbazole group, (1) R¹⁰ is not a hydrogen atom, or (2) R¹⁰ does not include a diphenylamine group. That is, all cases in which, in the condensed polycyclic compound according to an embodiment, when R¹³ is the diphenylamine group or the carbazole group, R¹⁰ is a hydrogen atom, or includes the diphenylamine group (e.g., R¹⁰ is a diphenylamine group) as a substituent are excluded. For example, when R¹³ is a diphenylamine group or a carbazole group, (1) R¹⁰ is not a hydrogen atom, or (2) R¹⁰ is not 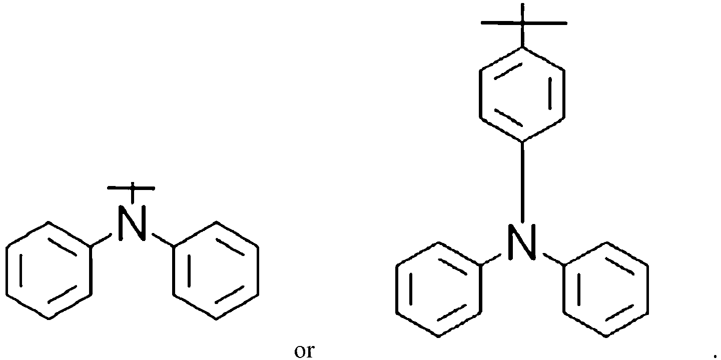 For example, the condensed polycyclic compound according to Formula 1 is not any one of Compounds X-2, X-4, and X-5. The structures of Compounds X-2, X-4, and X-5 are provided later in this specification.

The condensed polycyclic compound according to an embodiment represented by Formula 1 may include a structure in which at least one hydrogen atom is substituted with a deuterium atom.

According to an embodiment, the first compound represented by Formula 1 may be represented by any one among Formula 2-1 to Formula 2-4:

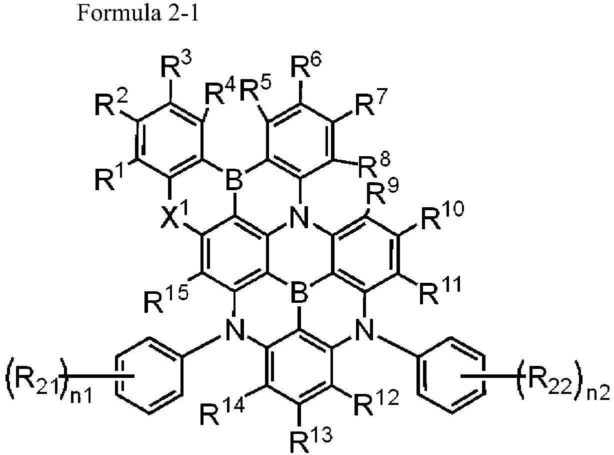

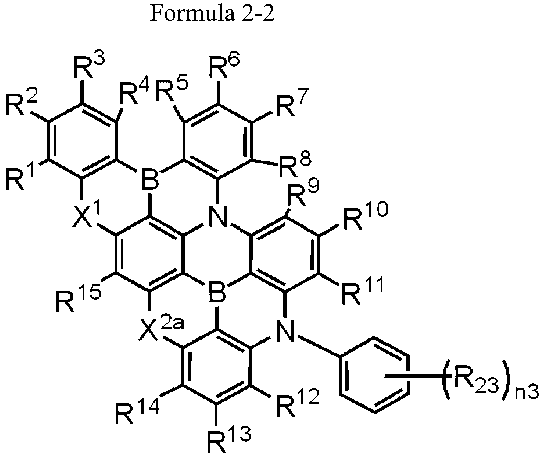

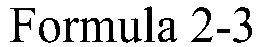

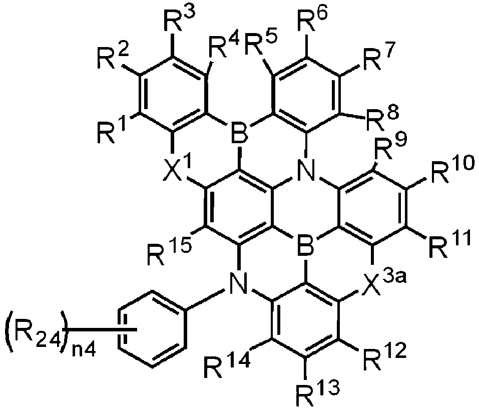

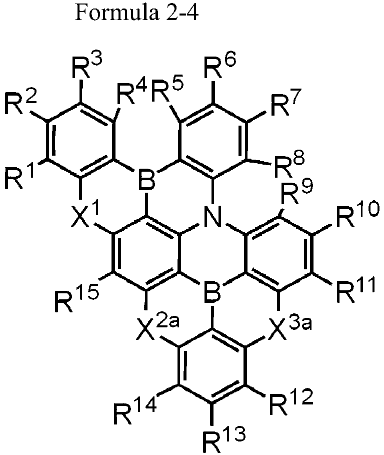

In Formula 2-2 to Formula 2-4, X^{2a} and X^{3a} may be each independently O or S.

In Formula 2-1 to Formula 2-3, R²¹ to R²⁴ may be each independently a hydrogen atom, a deuterium atom, a halogen atom, a cyano group, a nitro group, a substituted or unsubstituted amine group, a substituted or unsubstituted alkyl group having a carbon number of 1 to 20, a substituted or unsubstituted aryl group having a ring-forming carbon number of 6 to 30, or a substituted or unsubstituted heteroaryl group having a ring-forming carbon number of 2 to 30. For example, R²¹ to R²⁴ may be each independently a hydrogen atom, a substituted or unsubstituted methyl group, a substituted or unsubstituted t-butyl group, a substituted or unsubstituted phenyl group, a substituted or unsubstituted biphenyl group, a substituted or unsubstituted terphenyl group, or a substituted or unsubstituted carbazole group.

In Formula 2-1 to Formula 2-3, n1 to n4 are each independently an integer of 0 to 5. In Formula 2-1 to Formula 2-3, when each of n1 to n4 is 0, the condensed polycyclic compound according to an embodiment may not be substituted with each of R²¹ to R²⁴. A case in which in Formula 2-1 to Formula 2-3, when each of n1 to n4 is 5, all of R²¹ to R²⁴ is a hydrogen atom. A case in which in Formula 2-1 to Formula 2-3, when each of n1 to n4 is 0, all of R²¹ to R²⁴ is a hydrogen atom. When each of n1 to n4 is an integer of 2 or more, all of R²¹ to R²⁴ provided in plurality may be the same as each other, or at least one of a plurality of R²¹ to R²⁴ is different from the other (or others).

In Formula 2-1 to Formula 2-4, the same description made in Formula 1 may be applied to X¹, R¹ to R¹⁵

According to an embodiment, the first compound represented by Formula 1 may be represented by any one among Formula 3-1 to Formula 3-4 :

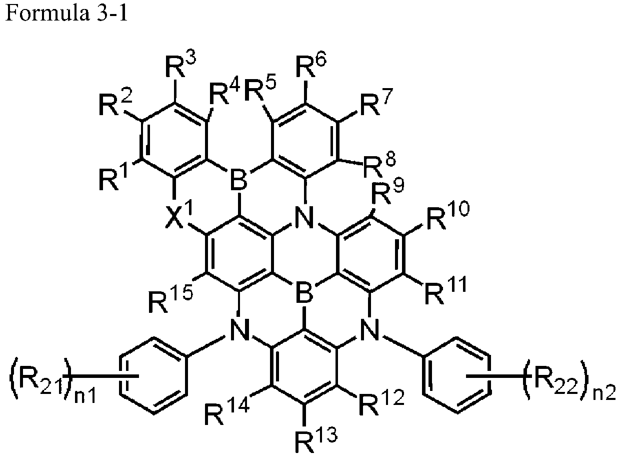

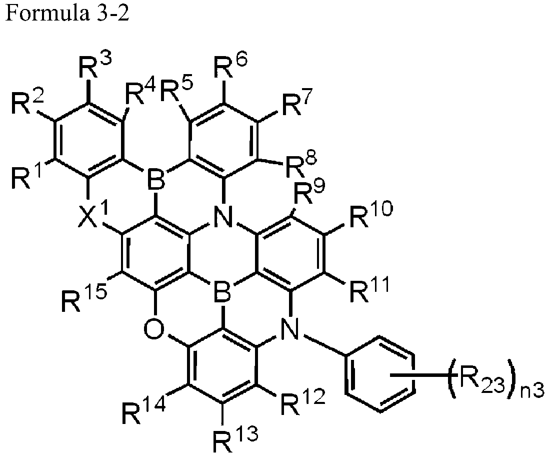

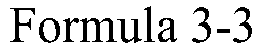

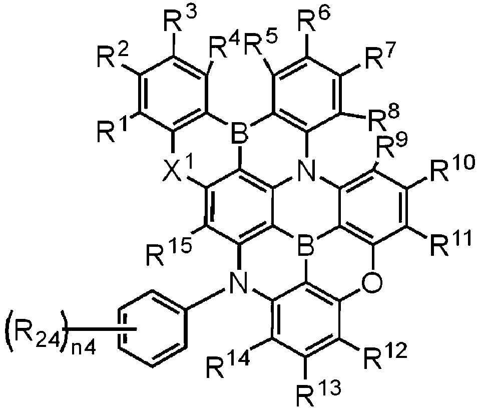

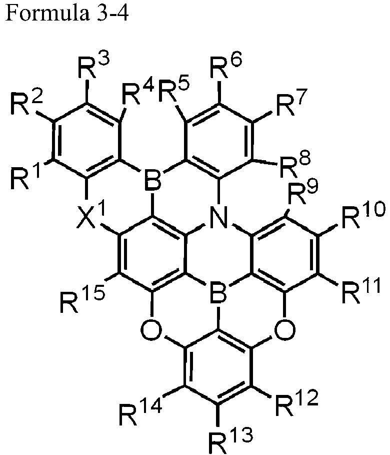

In Formula 3-1 to Formula 3-3, the same description made in Formula 2-1 to Formula 2-3 may be applied to R²¹ to R²⁴, and n1 to n4.

However, in Formula 3-2, when R¹³ is a diphenylamine group or a carbazole group, (1) R¹⁰ may be a substituted or unsubstituted alkyl group having a carbon number of 1 to 20, or (2) R¹⁰ is a substituted or unsubstituted aryl group having a ring-forming carbon number of 6 to 20. For example, in Formula 3-2, when R¹³ is a diphenylamine group or a carbazole group, R¹⁰ may be an unsubstituted t-butyl group, an unsubstituted phenyl group or an unsubstituted biphenyl group.

In Formula 3-1 to Formula 3-4, the same description made in Formula 1 may be applied to X¹, and R¹ to R¹⁵.

The first compound represented by Formula 1 may be represented by any one among Formula 4-1 to Formula 4-4.

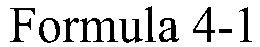

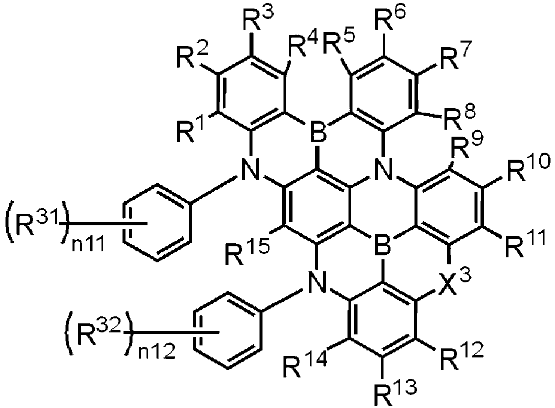

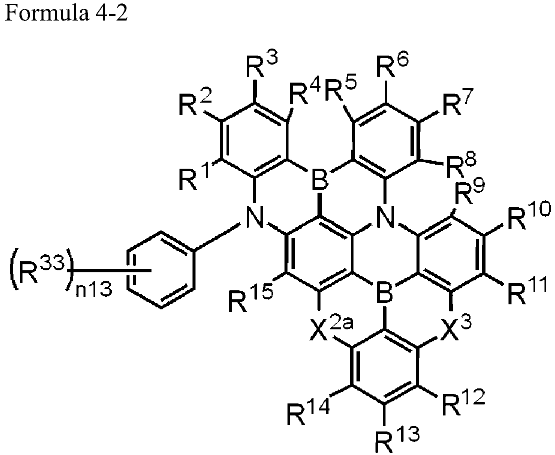

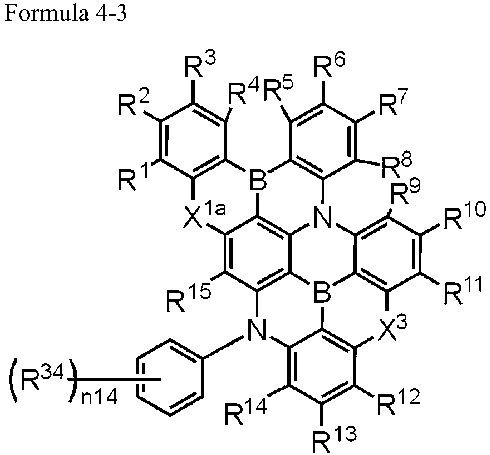

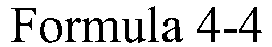

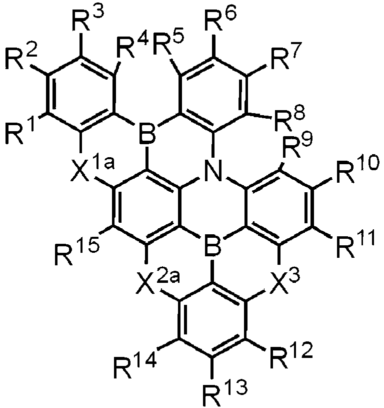

In Formula 4-2 to Formula 4-4, X^{1a} and X^{2a} may be each independently O, or S.

In Formula 4-1 to Formula 4-3, R³¹ to R³⁴ may be each independently a hydrogen atom, a deuterium atom, a halogen atom, a cyano group, a nitro group, a substituted or unsubstituted amine group, a substituted or unsubstituted alkyl group having a carbon number of 1 to 20, a substituted or unsubstituted aryl group having a ring-forming carbon number of 6 to 30, or a substituted or unsubstituted heteroaryl group having a ring-forming carbon number of 2 to 30. For example, R³¹ to R³⁴ may be each independently a hydrogen atom, a substituted or unsubstituted methyl group, a substituted or unsubstituted t-butyl group, a substituted or unsubstituted phenyl group, a substituted or unsubstituted biphenyl group, a substituted or unsubstituted terphenyl group, or a substituted or unsubstituted carbazole group.

In Formula 4-1 to Formula 4-3, n11 to n14 are each independently an integer of 0 to 5. In Formula 4-1 to Formula 4-3, when each of n11 to n14 is 0, the condensed polycyclic compound according to an embodiment may not be substituted with each of R³¹ to R³⁴. A case in which, in Formula 4-1 to Formula 4-3, when each of n11 to n14 is 5, all of R³¹ to R³⁴ is a hydrogen atom. A case in which in Formula 4-1 to Formula 4-3, when each of n11 to n14 is 0 is a hydrogen atom. When each of n11 to n14 is an integer of 2 or more, all of R³¹ to R³⁴ provided in plurality may be the same as each other, or at least one of a plurality of R³¹ to R³⁴ is different from the other (or others).

In Formula 4-1 to Formula 4-4, the same description made in Formula 1 may be applied to X³, R¹ to R¹⁵*.*

In the condensed polycyclic compound according to an embodiment, at least one among the first to third heteroatoms may be a second nitrogen atom substituted with a first substituent. According to an embodiment, the first substituent may include a first benzene moiety, and may include a first sub-substituent substituted for a carbon, present at a specific position, of the first benzene moiety. For example, the first substituent may include a structure in which the first benzene moiety connected to the second nitrogen atom is connected, and in which the first sub-substituent is connected to one ortho position with respect to the second nitrogen atom. In addition, the first substituent may include a structure in which the first benzene moiety connected to the second nitrogen atom is connected, and in which the first sub-substituent is connected to each of two ortho positions with respect to the second nitrogen atom. The first sub-substituent may be a substituted or unsubstituted phenyl group. In the present specification, the second nitrogen atom substituted with the first substituent may be represented by Formula 6-1 or Formula 6-2:

The condensed polycyclic compound according to an embodiment may effectively maintain a trigonal planar structure of a boron atom through a stereoscopic disruption effect caused by the first substituent. Since a boron atom has electron-deficient characteristics due to a vacant p-orbital, the boron atom may be combined with another nucleophile to change to a tetrahedral structure, and this may be a cause of element degradation. According to the inventive concept, since the condensed polycyclic compound according to an embodiment includes the first substituent having a stereoscopic disruption structure, the vacant p-orbital of the boron atom may be effectively protected to prevent the degradation phenomenon caused by structural deformation.

In addition, in the condensed polycyclic compound according to an embodiment, intermolecular interaction may be suppressed due to introduction of the first substituent to control formation of excimer or exciplex, and thus to increase luminous efficiency. In addition, in the condensed polycyclic compound according to an embodiment represented by Formula 1, the first substituent is included to increase an intermolecular distance, and thus to reduce dexter energy transfer. The dexter energy transfer is a phenomenon in which a triplet exciton between molecules moves, increases when an intermolecular distance is short, and may be a cause of increasing a quenching phenomenon caused by increase in a triplet concentration. According to the inventive concept, in the condensed polycyclic compound according to an embodiment, the intermolecular distance may increase, due to great stereoscopic disruption, to suppress the dexter energy transfer, and thus to suppress lifespan degradation caused by an increased triplet concentration. Accordingly, when the condensed polycyclic compound according to an embodiment is applied to the light-emitting layer EML of the light-emitting element ED, the luminous efficiency may be increased, and the element lifespan may be improved as well.

According to an embodiment, the first compound represented by Formula 1 may be represented by Formula 5:

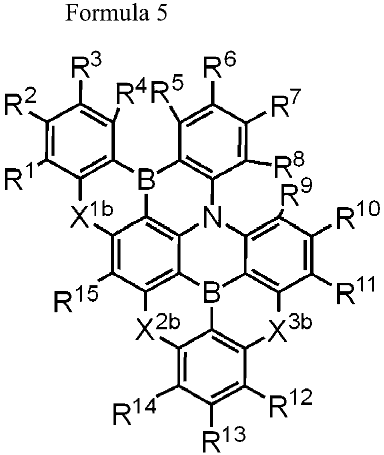

In Formula 5, at least one of X^{1b}, X^{2b}, and X^{3b} may be represented by Formula 6-1 or Formula 6-2, and the rest thereof may be each independently O, S, or NAr².

In Formula 5, Ar² may be a substituted or unsubstituted aryl group having a ring-forming carbon number of 6 to 30, or a substituted or unsubstituted heteroaryl group having a ring-forming carbon number of 2 to 30. According to an embodiment, Ar² may be a substituted or unsubstituted aryl group having a ring-forming carbon number of 6 to 30. For example, Ar² may be a substituted or unsubstituted phenyl group, a substituted or unsubstituted biphenyl group or a substituted or unsubstituted terphenyl group.

In Formula 5, the same description made in Formula 1 may be applied to R¹ to R¹⁵.

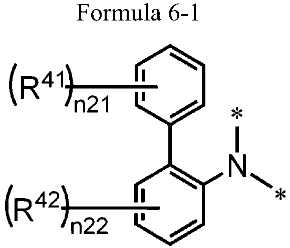

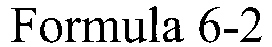

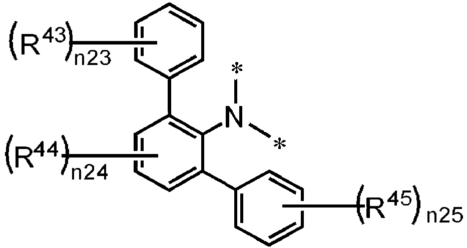

In Formula 6-1 and Formula 6-2, R⁴¹ to R⁴⁵ may be each independently a hydrogen atom, a deuterium atom, a halogen atom, a cyano group, a nitro group, a saturated or unsaturated amine group, a saturated or unsaturated alkyl group having a carbon number of 1 to 20, a saturated or unsaturated aryl group having a ring-forming carbon number of 6 to 30, or a saturated or unsaturated heteroaryl group having a ring-forming carbon number of 2 to 30. For example, R⁴¹ to R⁴⁵ may be each independently a hydrogen atom, a substituted or unsubstituted t-butyl group, or a substituted or unsubstituted phenyl group.

In Formula 6-1 and Formula 6-2, n21, n23 and n25 are each independently an integer of 0 to 5. In Formula 6-1 and Formula 6-2, when each of n21, n23 and n25 is 0, the condensed polycyclic compound according to an embodiment may not be substituted with each of R⁴¹, R¹³ and R⁴⁵. A case in which in Formula 6-1 and Formula 6-2, each of n21, n23 and n25 is 5, all of R⁴¹, R⁴³ and R⁴⁵ is a hydrogen atom. A case in which in Formula 6-1 and Formula 6-2, when each of n21, n23 and n25 is 0, all of R⁴¹, R⁴³ and R⁴⁵ is a hydrogen atom. When each of n21, n23 and n25 is an integer of 2 or more, all of R⁴¹, R⁴³ and R⁴⁵ provided in plurality may be the same as each other, or at least one of a plurality of R⁴¹, R⁴³ and R⁴⁵ is different from the other (or others).

In Formula 6-1, n22 is an integer of 0 to 4. In Formula 6-1, when n22 is 0, the condensed polycyclic compound according to an embodiment may not be substituted with R⁴². A case in which in Formula 6-1, when n22 is 4, R⁴² is a hydrogen atom. A case in which in Formula 6-1, when n22 is 0, R⁴² is a hydrogen atom. When n22 is an integer of 2 or more, all of R⁴² provided in plurality may be the same as each other, or at least one of a plurality of R⁴² is different from the other (or others).

In Formula 6-2, n24 is an integer of 0 to 3. In Formula 6-2, when n24 is 0, the condensed polycyclic compound according to an embodiment may not be substituted with R⁴⁴. A case in which in Formula 6-2, when n24 is 3, R⁴⁴ is a hydrogen atom. A case in which in Formula 6-2, when n24 is 0, R⁴⁴ is a hydrogen atom. When n24 is an integer of 2 or more, all of R⁴⁴ provided in plurality may be the same as each other, or at least one of a plurality of R⁴⁴ is different from the other (or others).

In Formula 6-1 and Formula 6-2, - * is a position connected to Formula 5.

According to an embodiment, the condensed polycyclic compound according to an embodiment represented by Formula 1 may include at least one deuterium atom as a substituent. The condensed polycyclic compound according to an embodiment represented by Formula 1 may include a structure in which at least one hydrogen atom is substituted with a deuterium atom.

The condensed polycyclic compound according to an embodiment may be any one among compounds represented by Compound Group 1. At least one functional layer included in the light-emitting element ED according to an embodiment may include at least one condensed polycyclic compound among the compounds represented by Compound Group 1. The light-emitting element ED according to an embodiment may include, in the light-emitting layer EML, at least one condensed polycyclic compound among the compounds represented by Compound Group 1.

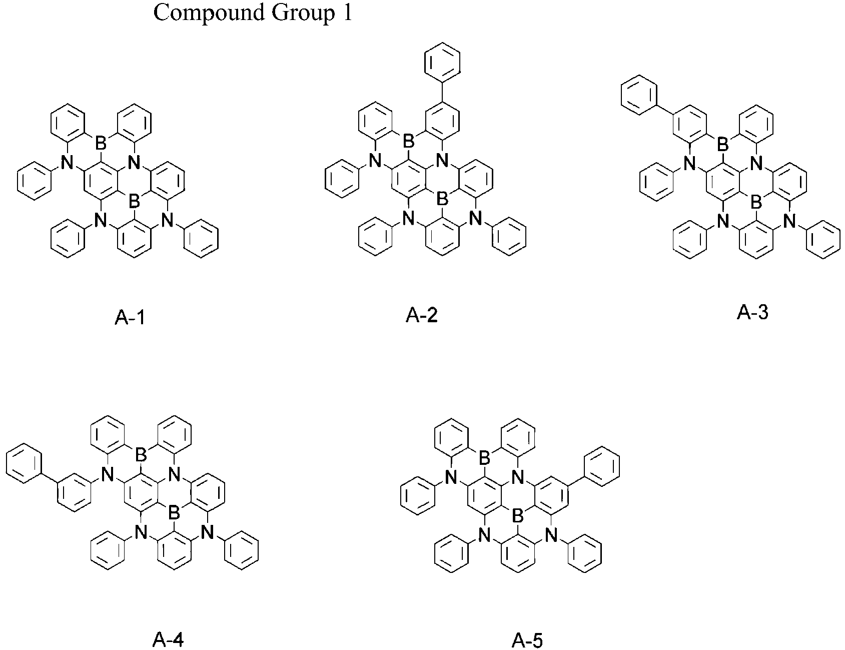

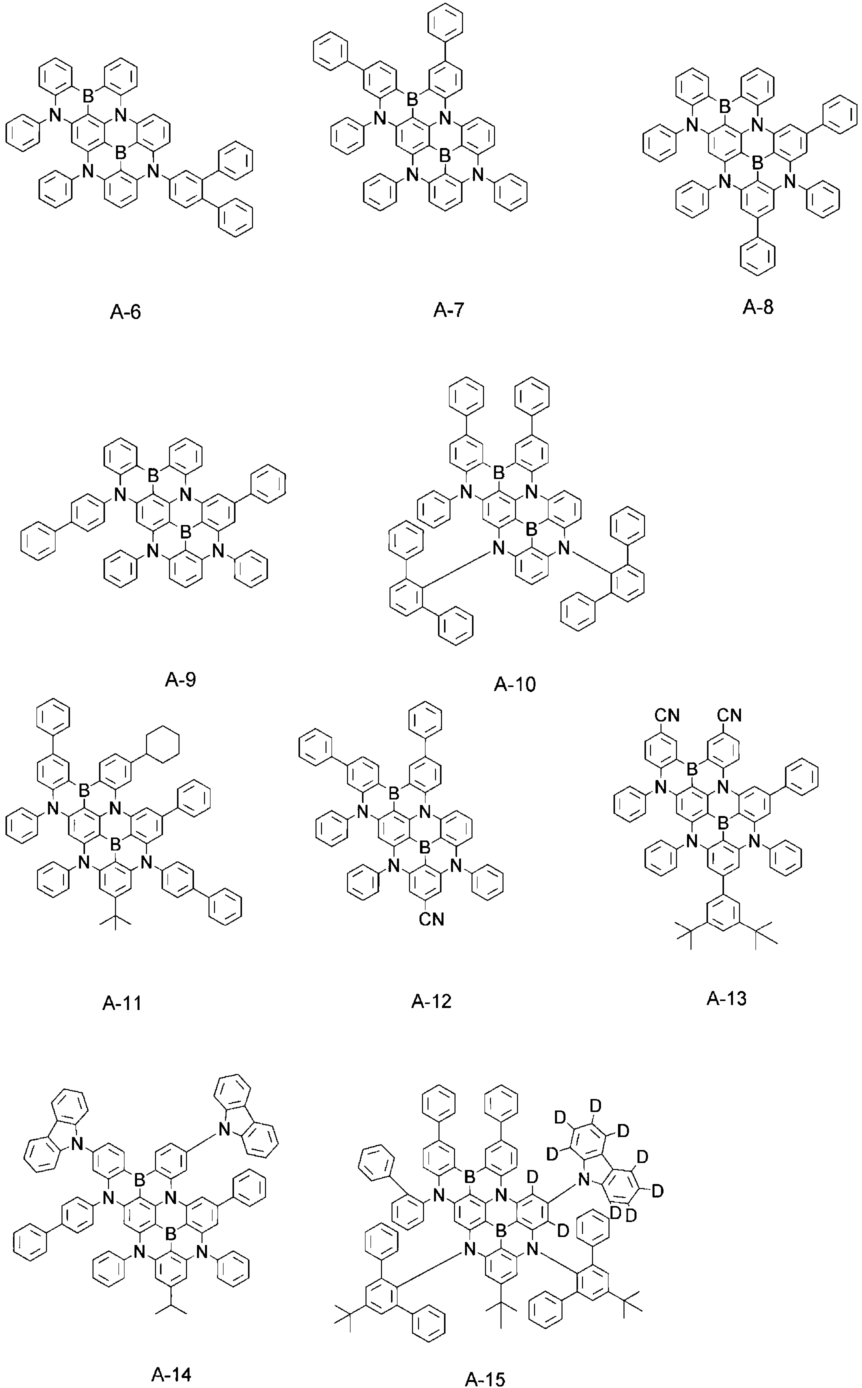

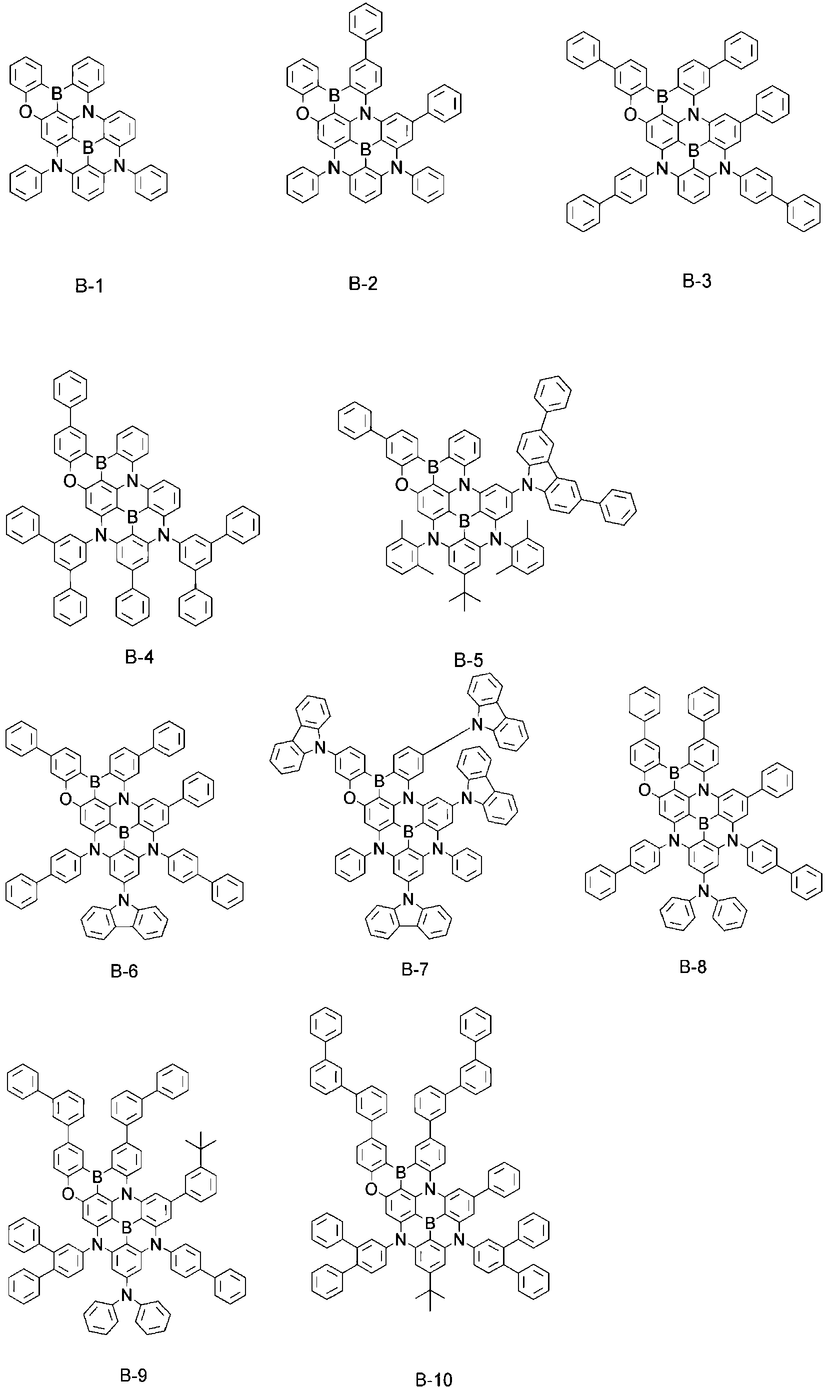

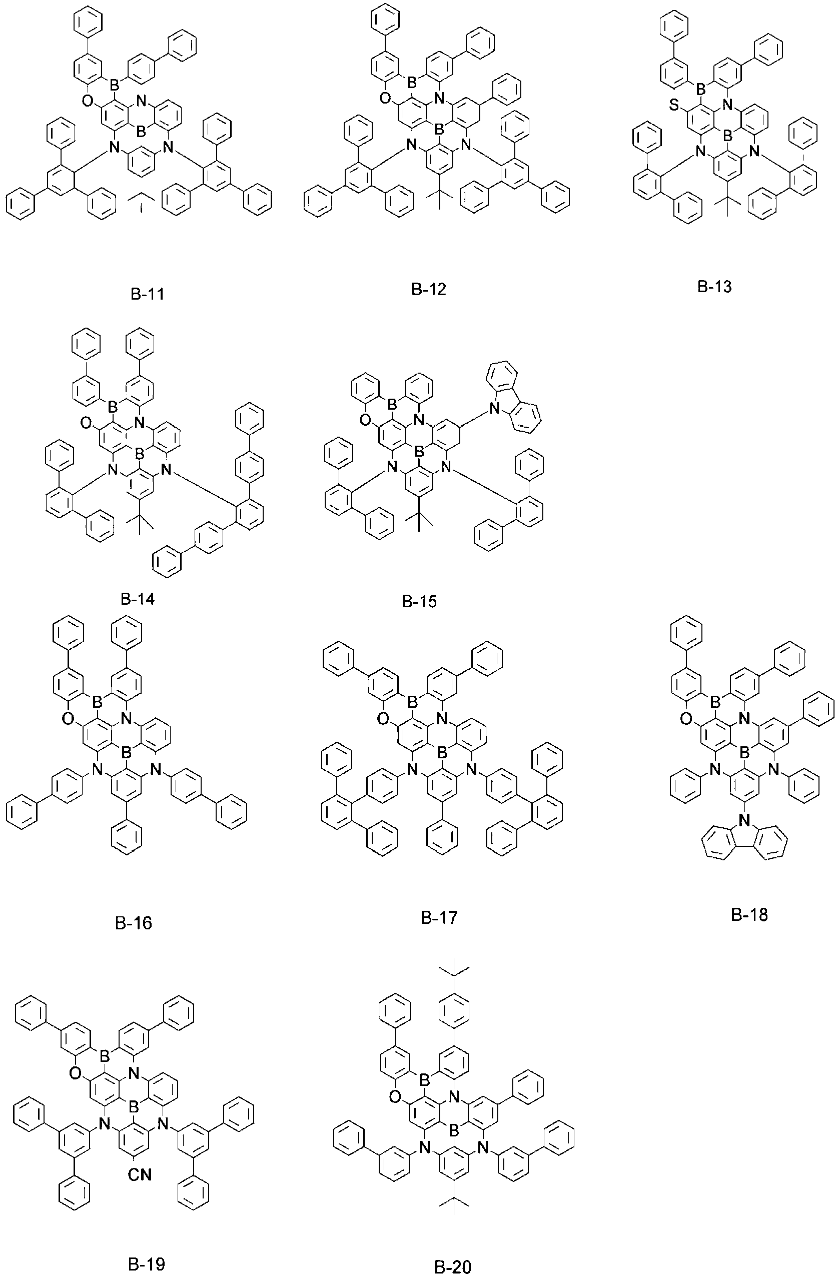

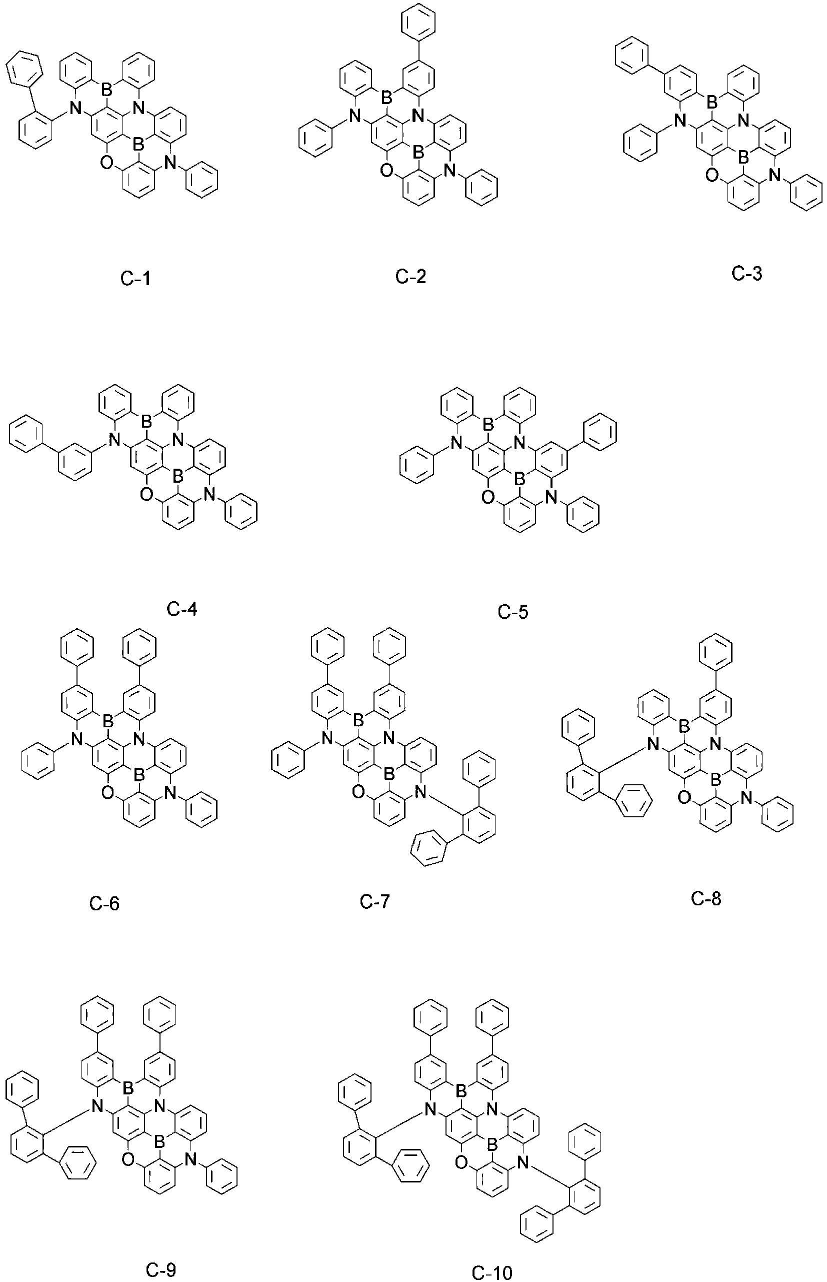

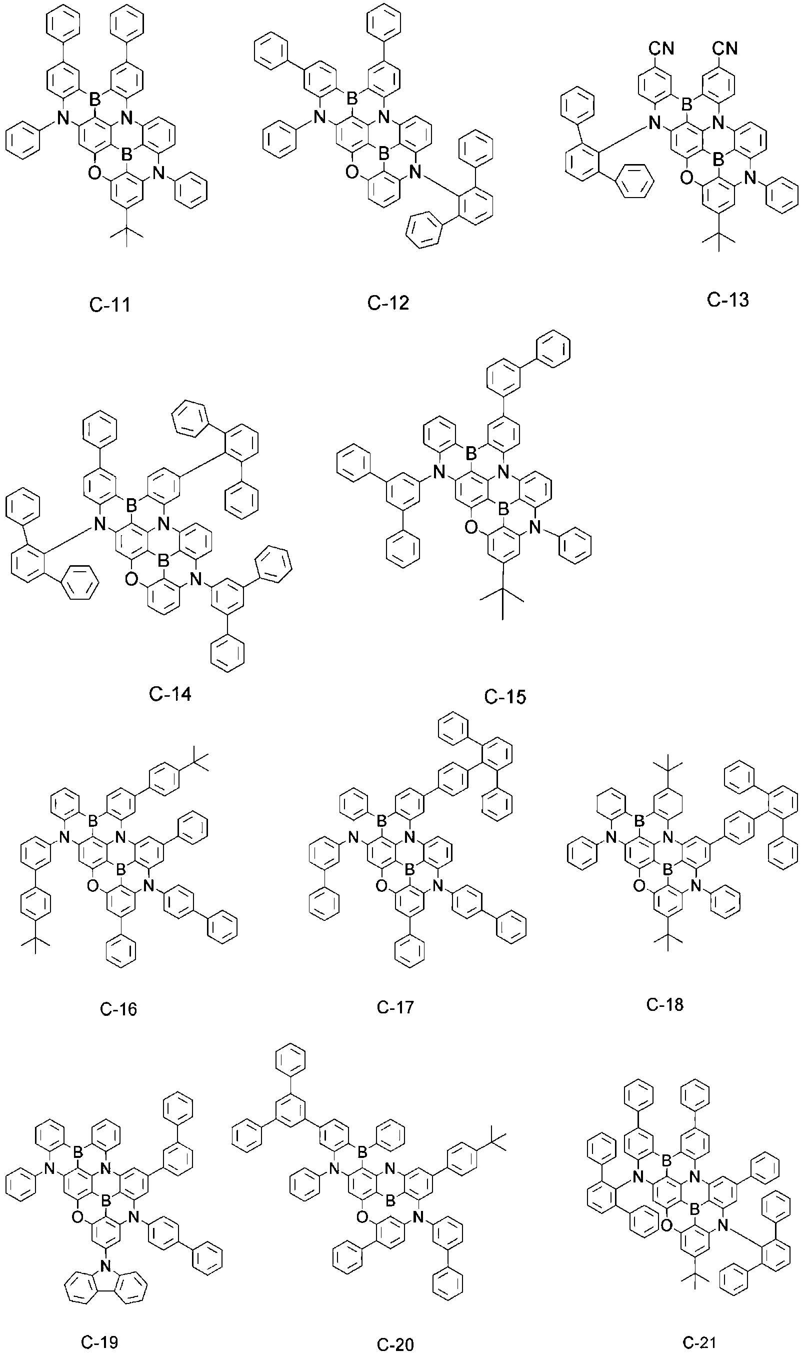

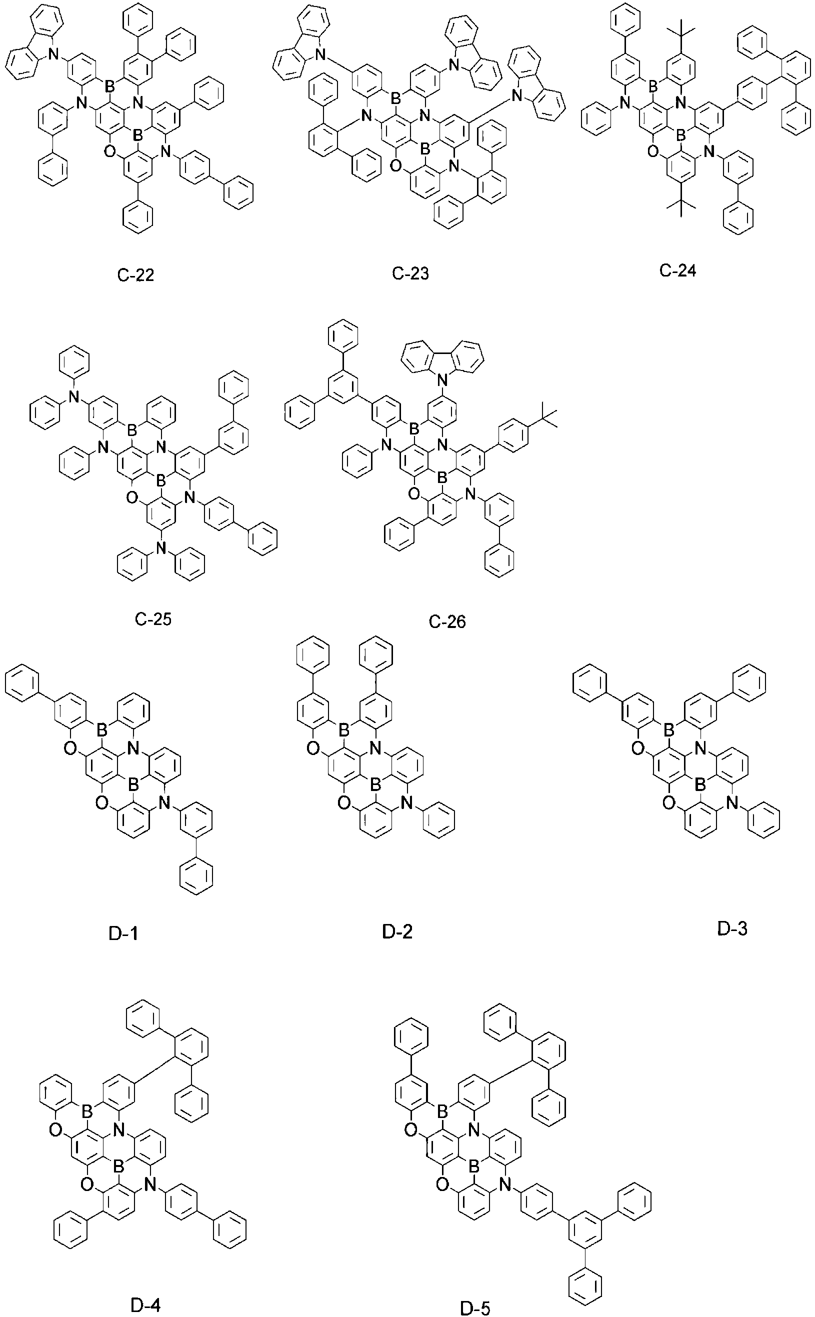

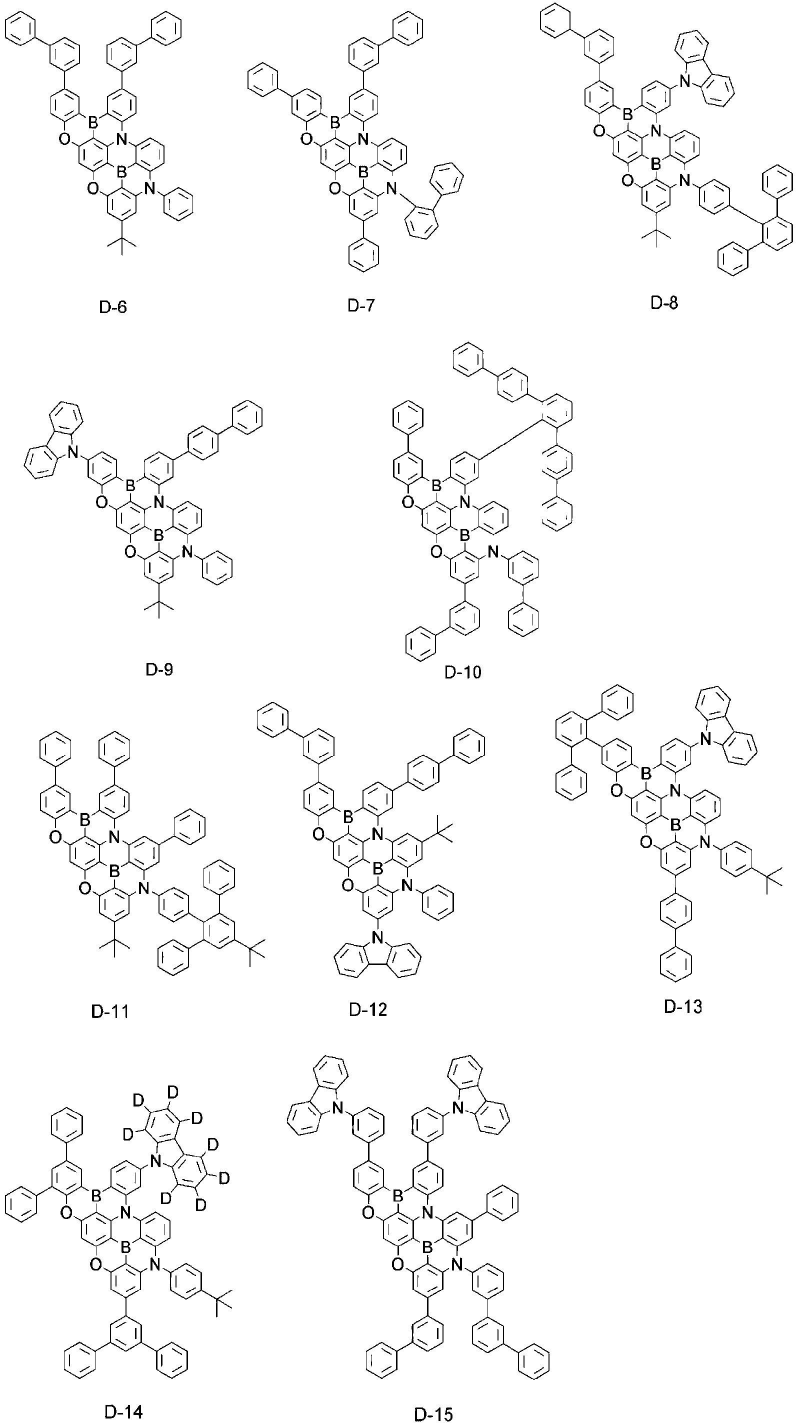

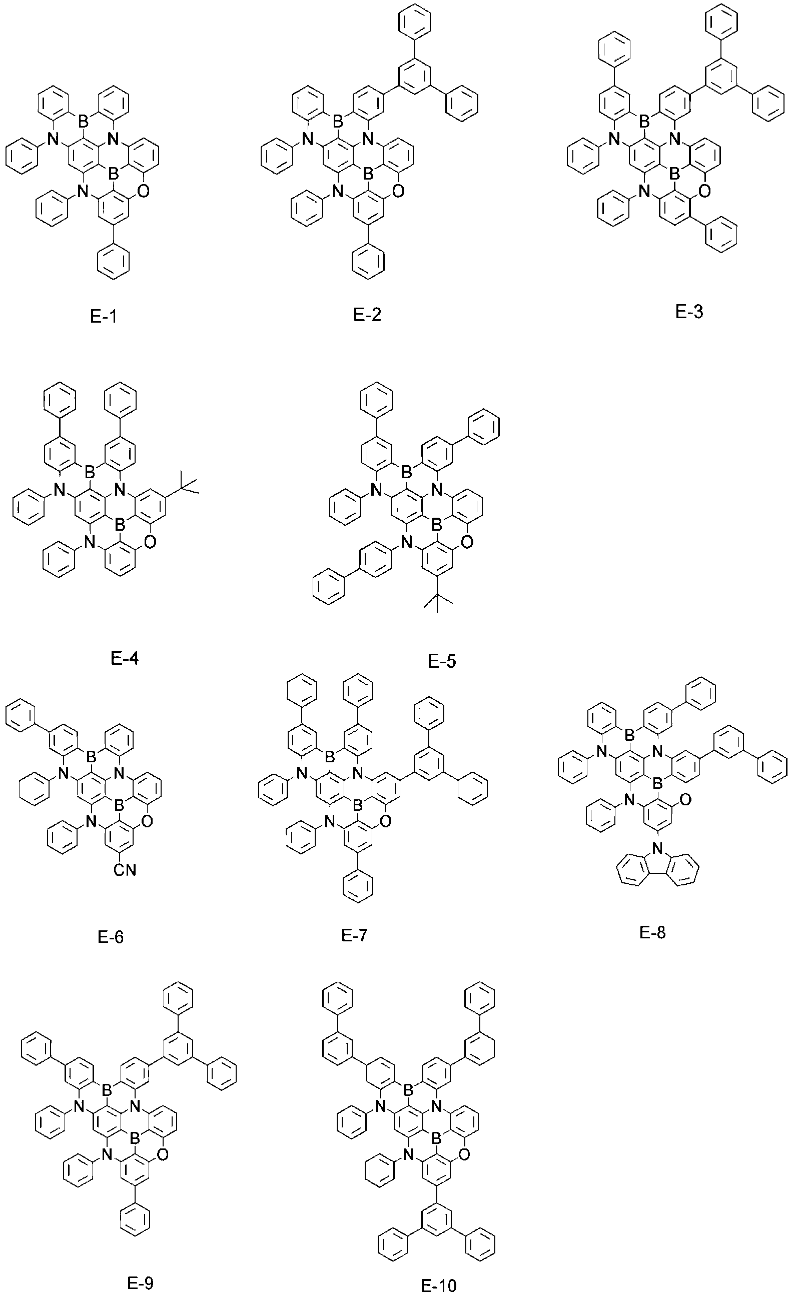

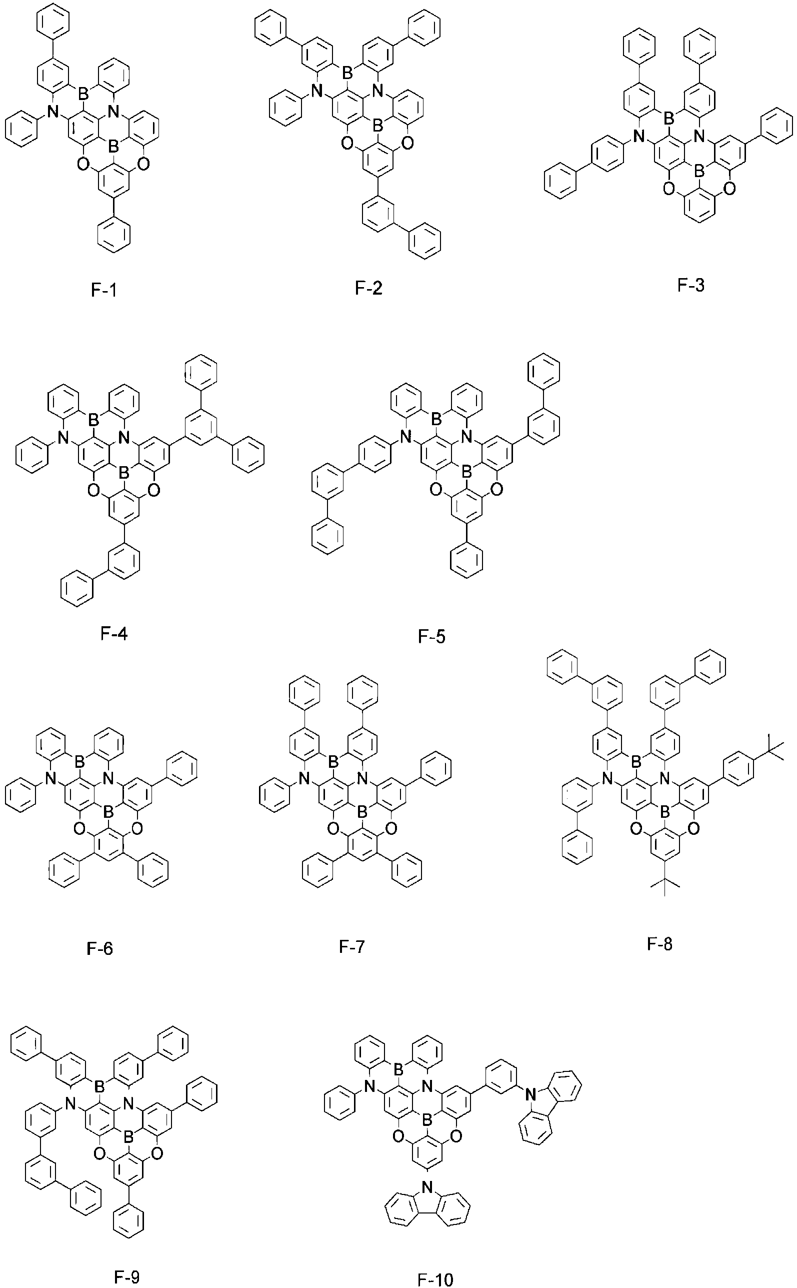

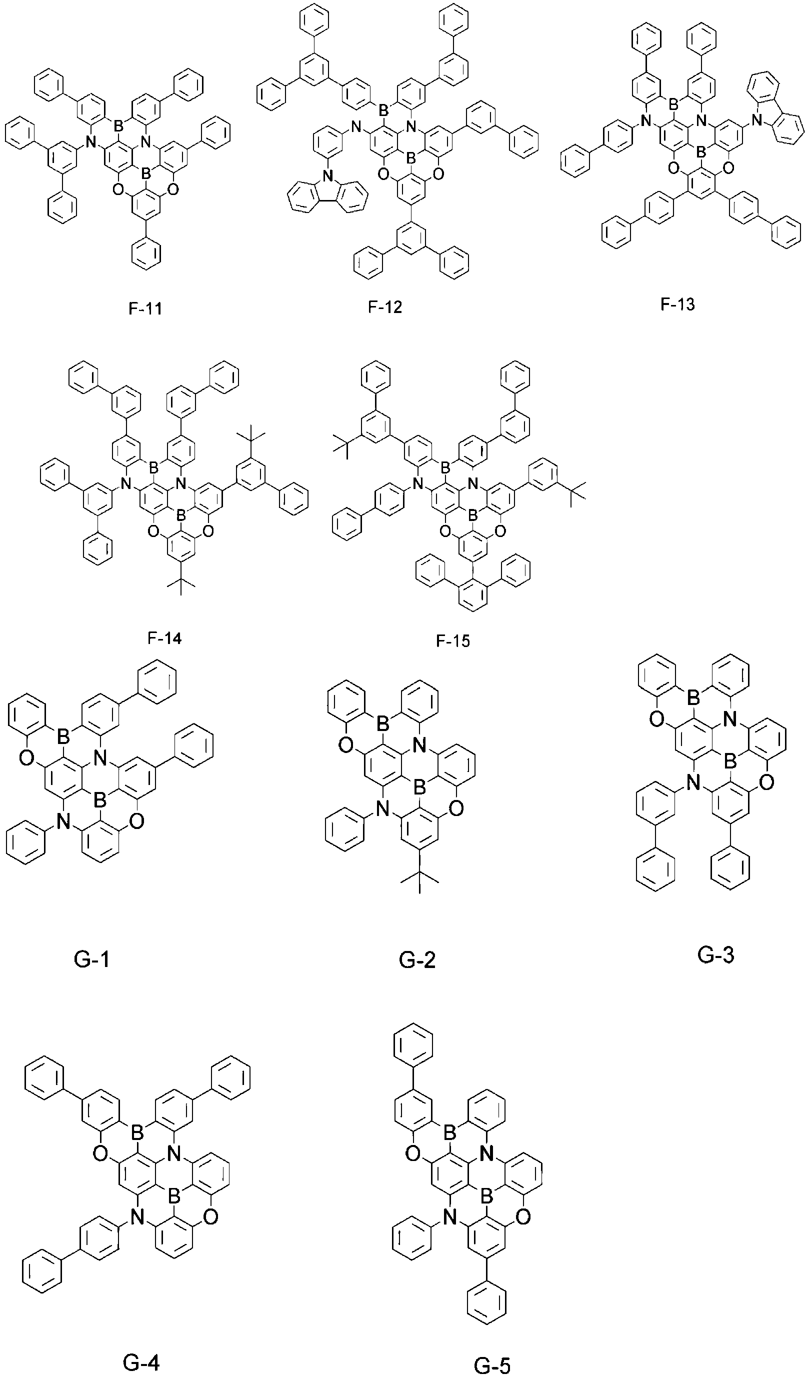

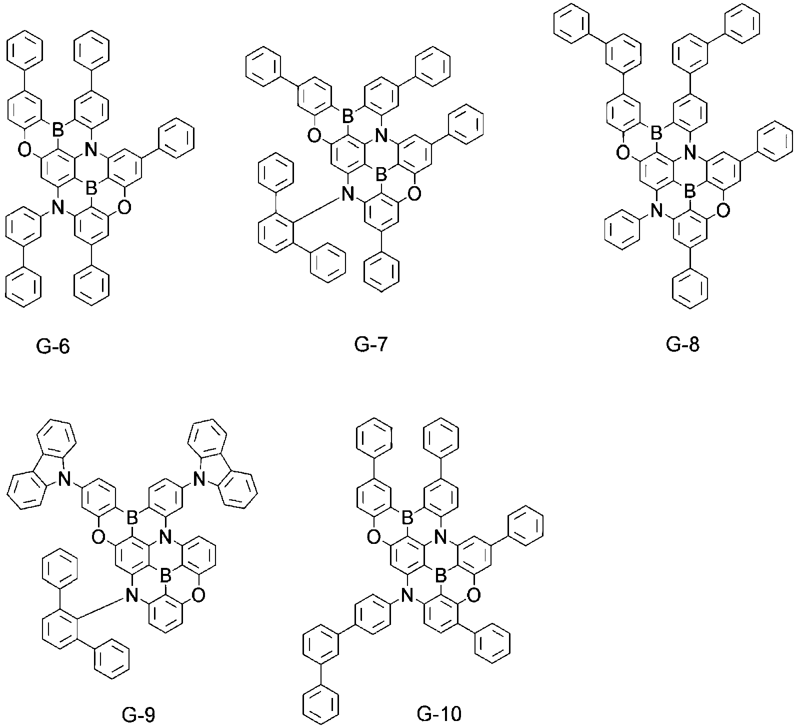

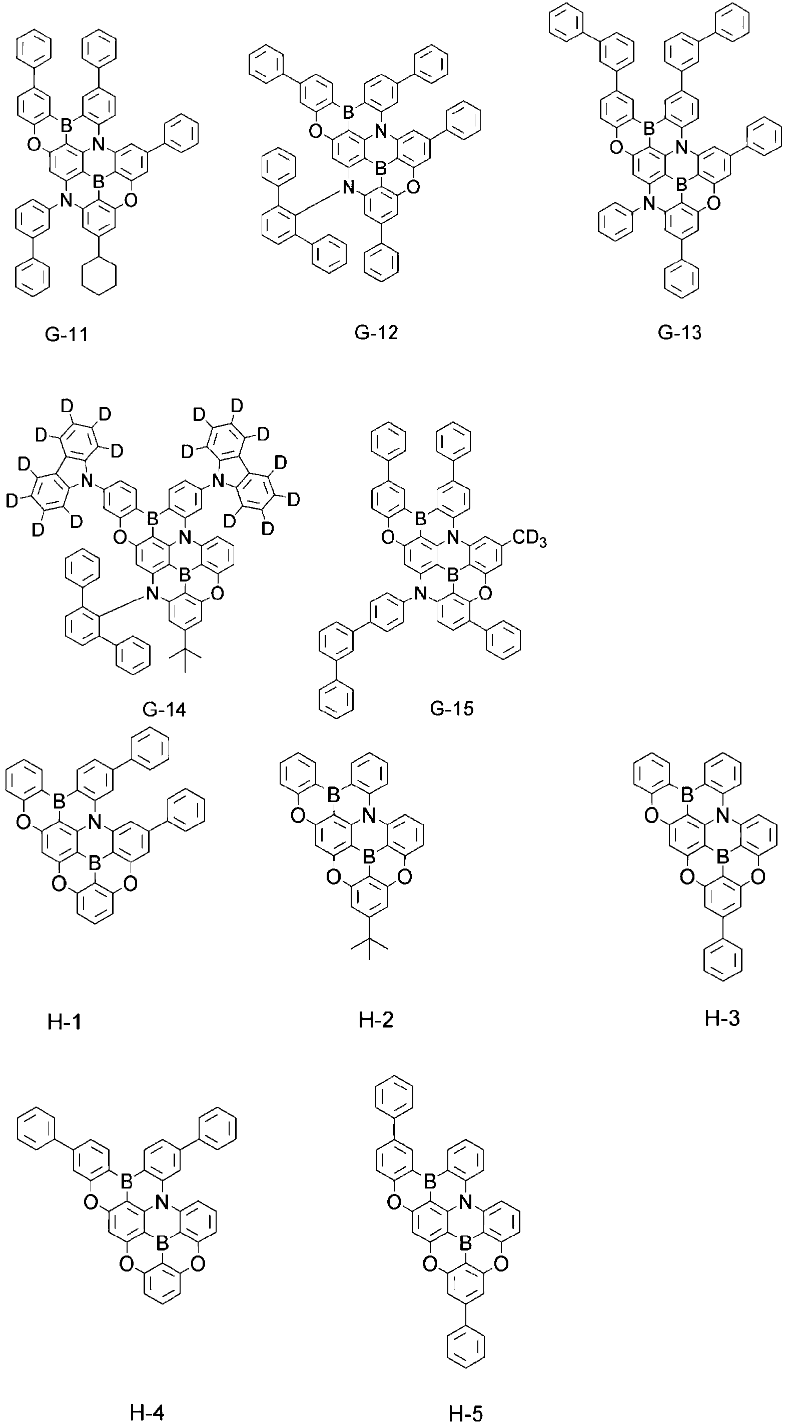

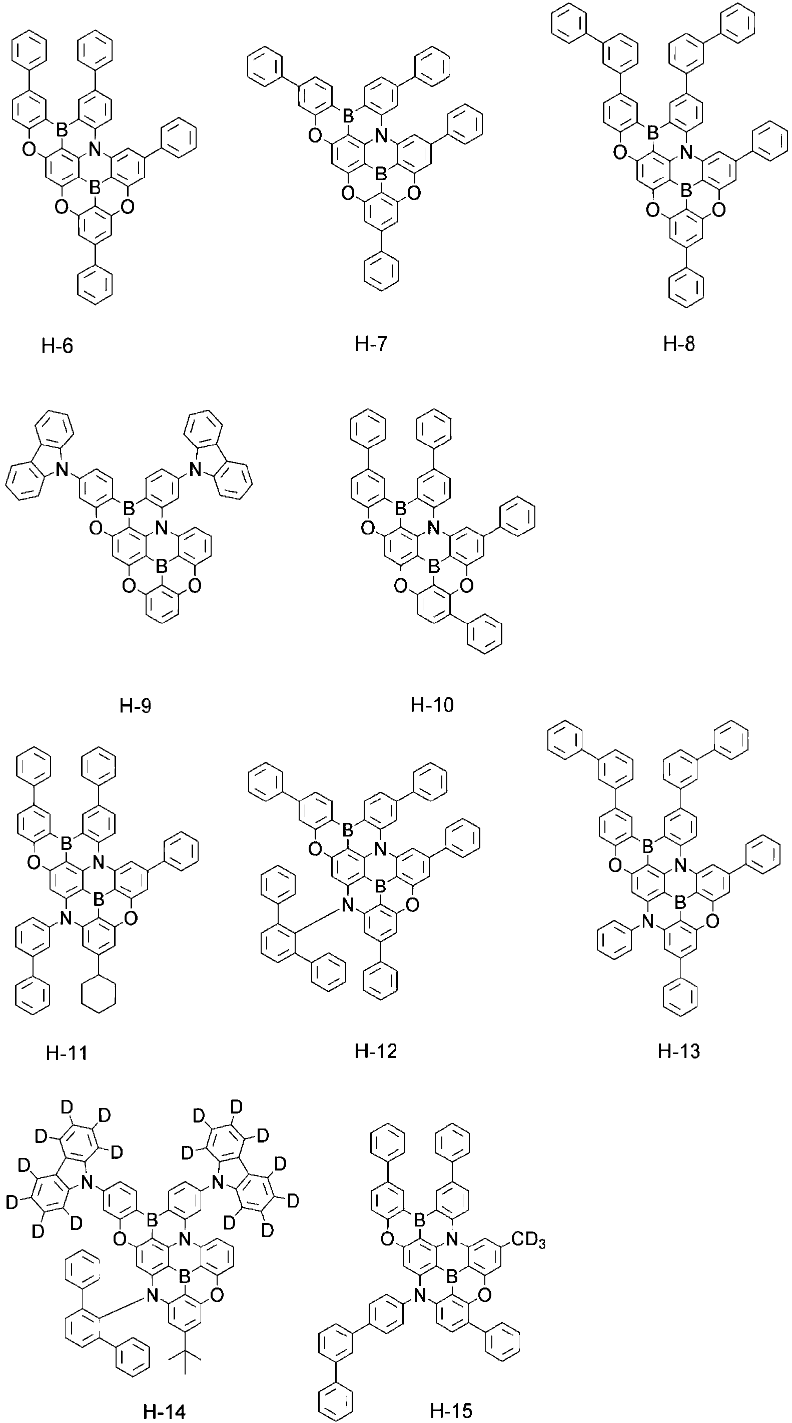

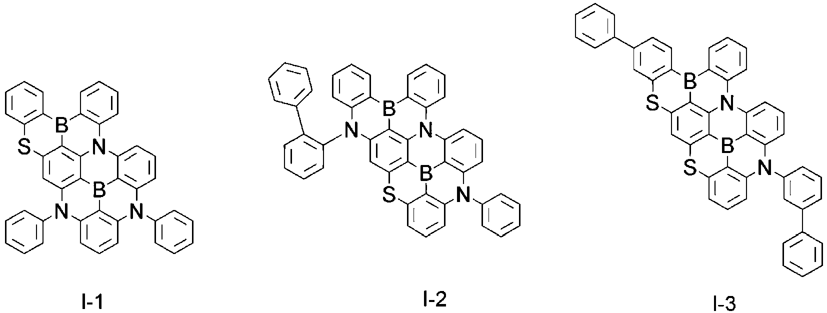

The condensed polycyclic compound according to an embodiment represented by Formula 1 shows luminescence spectrum having a full width of half maximum of about 10 nm to about 50 nm, preferably, about 20 nm to about 40 nm. When the condensed polycyclic compound according to an embodiment represented by Formula 1 showing the luminescence spectrum having the full width of half maximum of the range is applied to an element, luminous efficiency may be improved. In addition, when the condensed polycyclic compound according to an embodiment represented by Formula 1 is used as a blue light-emitting element material for a light-emitting element, element lifespan may be improved.

According to an embodiment, the condensed polycyclic compound according to an embodiment represented by Formula 1 may be a thermally activated delayed fluorescence material. In addition, the condensed polycyclic compound according to an embodiment represented by Formula 1 may be a thermally activated delayed fluorescence dopant of which a difference (ΔE_{ST}) between a lowest triplet excited energy level (T1 level) and a lowest singlet excited energy level (S1 level) is equal to or less than about 0.6 eV. The condensed polycyclic compound according to an embodiment represented by Formula 1 may be a thermally activated delayed fluorescence dopant of which a difference (ΔE_{ST}) between a lowest triplet excited energy level (T1 level) and a lowest singlet excited energy level (S1 level) is equal to or less than about 0.2 eV, but an embodiment of the inventive concept is not limited thereto.

The condensed polycyclic compound according to an embodiment of the inventive concept represented by Formula 1 may have a structure in which the first condensed core and the second condensed core are combined with each other through a specific connection structure to maintain an excellent full width of half maximum and stokes-shift and to suppress molecular symmetry, and thus to show improved photoluminescence quantum yield characteristics. Accordingly, the condensed polycyclic compound according to an embodiment of the inventive concept may exhibit improved photoluminescence quantum yield characteristics.

The condensed polycyclic compound according to an embodiment represented by Formula 1 may be a light-emitting material having a light-emitting center wavelength in a wavelength region of about 430 nm to about 490 nm. For example, the condensed polycyclic compound according to an embodiment represented by Formula 1 may be a blue thermally activated delayed fluorescence (TADF) dopant, but an embodiment of the inventive concept is not limited thereto. When the condensed polycyclic compound according to an embodiment is used as a light-emitting material, the first dopant may be used as a dopant material that emits light having various wavelength region, such as a red light-emitting dopant, or a green light-emitting dopant.

In the light-emitting element ED according to an embodiment, the light-emitting layer EML may emit delayed fluorescence. For example, the light-emitting layer EML may emit the thermally activated delayed fluorescence (TADF).

In addition, the light-emitting layer EML of the light-emitting element ED may emit blue light. For example, the light-emitting layer EML of the organic electroluminescence element ED according to an embodiment may emit the blue light having a wavelength region equal to or less than about 490 nm, but an embodiment of the inventive concept is not limited thereto. The light-emitting layer EML may emit green light or red light.

The condensed polycyclic compound according to an embodiment is included in the light-emitting layer EML. The condensed polycyclic compound according to an embodiment may be included in the light-emitting layer EML as a dopant material. The condensed polycyclic compound according to an embodiment may be the thermally activated delayed fluorescence material. The condensed polycyclic compound according to an embodiment may be used as the thermally activated delayed fluorescence dopant. For example, the light-emitting layer EML in the light-emitting element ED according to an embodiment may include, as the thermally activated delayed fluorescence dopant, at least one among the condensed polycyclic compounds represented by Compound Group 1 previously described. However, use of the condensed polycyclic compound according to an embodiment is not limited thereto.

According to an embodiment, the light-emitting layer EML may include a plurality of compounds. The light-emitting layer EML according to an embodiment includes the condensed polycyclic compound represented by Formula 1, that is, the first compound, and may additionally include at least one among a second compound represented by Formula HT-1, a third compound represented by Formula ET-1, and a fourth compound represented by Formula D-1.

According to an embodiment, the light-emitting layer EML includes the first compound represented by Formula 1, and may additionally include at least any one of the second compound represented by Formula HT-1 or the third compound represented by Formula ET-1.

According to an embodiment, the light-emitting layer EML may include the second compound represented by Formula HT-1. According to an embodiment, the second compound may be used as a hole-transporting host material.

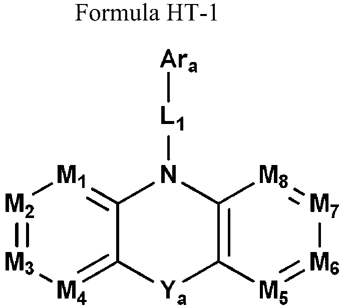

In Formula HT-1, M₁ to M₈ may be N or CR₅₁. For example, M₁ to M₈ may be all CR₅₁. Alternatively, any one of M₁ to M₈ may be N, and the rest thereof may be CR₅₁.

In Formula HT-1, L₁ may be a direct linkage, a substituted or unsubstituted arylene group having a ring-forming carbon number of 6 to 30, or a substituted or unsubstituted heteroarylene group having a ring-forming carbon number of 2 to 30. For example, L₁ may be a direct linkage, a substituted or unsubstituted phenylene group, a substituted or unsubstituted divalent biphenyl group, or a substituted or unsubstituted divalent carbazole group, but an embodiment of the inventive concept is not limited thereto.

In Formula HT-1, Yₐ may be a direct linkage, CR₅₂R₅₃ or SiR₅₄R₅₅. That is, two benzene rings connected to a nitrogen atom of Formula HT-1 may be connected through a direct linkage, 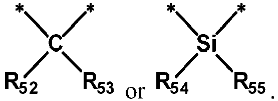 In Formula HT-1, when Yₐ is a direct linkage, the second compound represented by Formula HT-1 may include a carbazole moiety.

In Formula HT-1, Arₐ may be a substituted or unsubstituted aryl group having a ring-forming carbon number of 6 to 30, or a substituted or unsubstituted heteroaryl group having a ring-forming carbon number of 2 to 30. For example, Arₐ may be a substituted or unsubstituted carbazole group, a substituted or unsubstituted dibenzofuran group, a substituted or unsubstituted dibenzothiophene group, or a substituted or unsubstituted biphenyl group, but an embodiment of the inventive concept is not limited thereto.

In Formula HT-1, R₅₁ to R₅₅ may be each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having a carbon number of 1 to 20, a substituted or unsubstituted alkenyl group having a carbon number of 2 to 20, a substituted or unsubstituted aryl group having a ring-forming carbon number of 6 to 60, or a substituted or unsubstituted heteroaryl group having a ring-forming carbon number of 2 to 60. Alternatively, each of R₅₁ to R₅₅ may be combined with an adjacent group to form a ring. For example, R₅₁ to R₅₅ may be each independently a hydrogen atom or a deuterium atom. R₅₁ to R₅₅ may be each independently an unsubstituted methyl group or an unsubstituted phenyl group.

The second compound represented by Formula HT-1 according to an embodiment may be represented by any one among compounds represented by Compound Group 2. The light-emitting layer EML may include, as the hole-transporting host material, at least one among compounds represented by Compound Group 2:

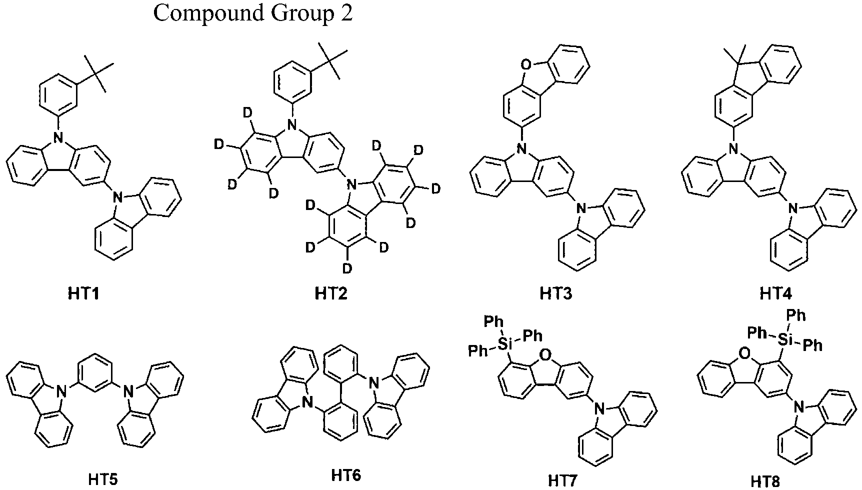

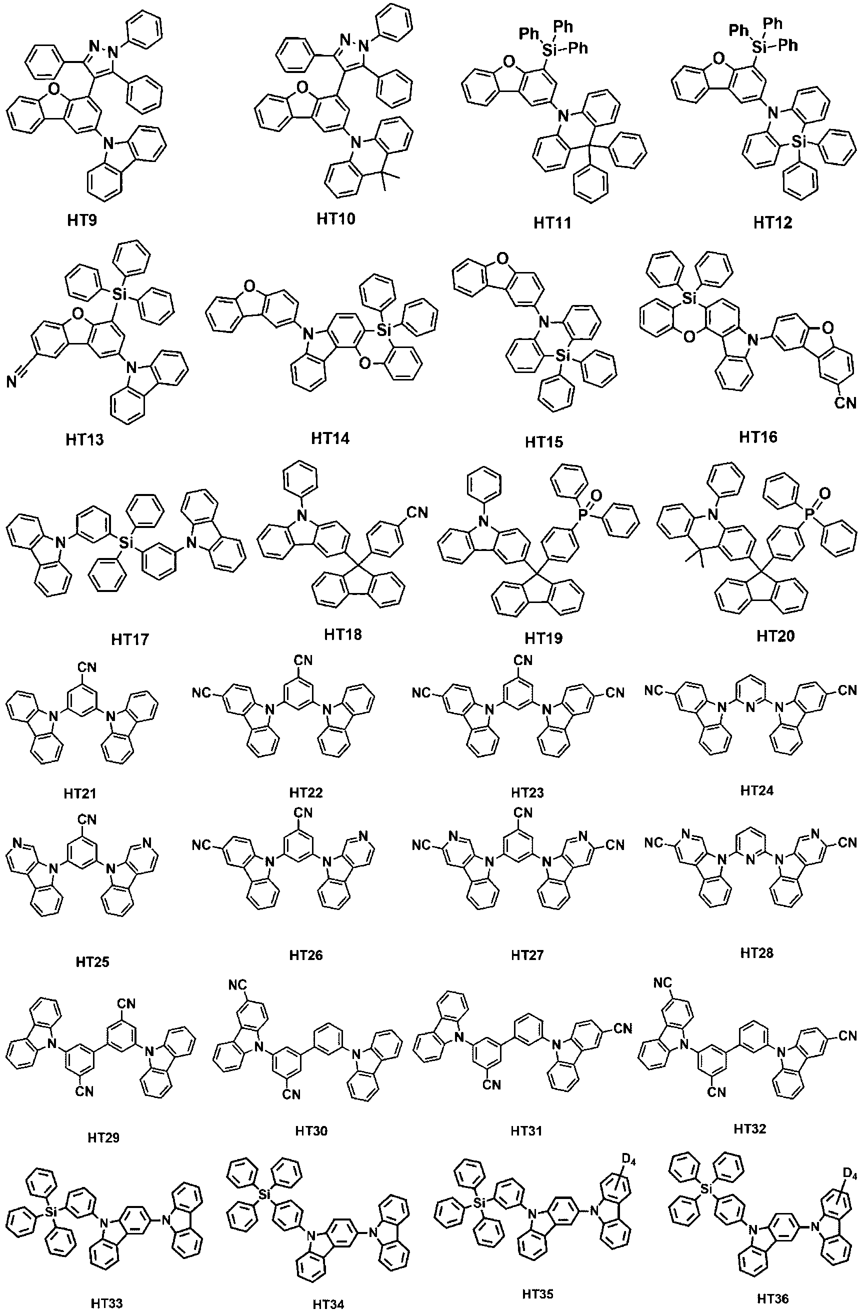

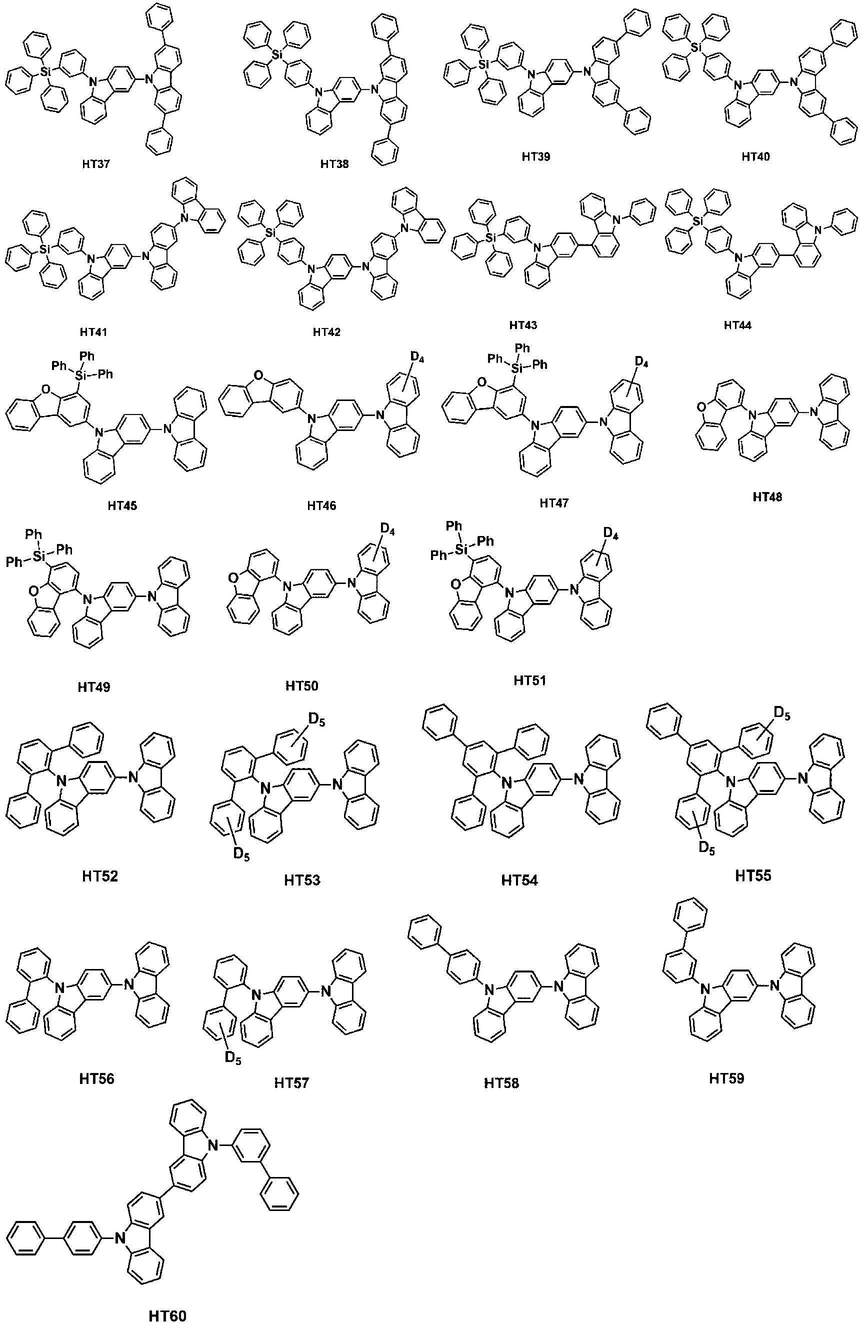

In compounds suggested in Compound Group 2, "D" may mean a deuterium atom, and "Ph" may be an unsubstituted phenyl group.

According to an embodiment, the light-emitting layer EML may include a third compound represented by Formula ET-1. For example, the third compound may be used as an electron-transporting host material of the light-emitting layer EML.

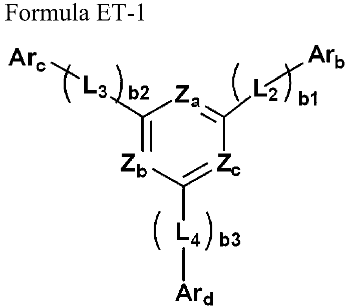

In Formula ET-1, at least one Zₐ to Z_{c} is N, and the rest thereof CR₅₆. For example, any one of Zₐ to Z_{c} may be N, and the remaining two may be each independently CR₅₆. In this case, the third compound represented by Formula ET-1 may include a pyridine moiety. Alternatively, two of Zₐ to Z_{c} may be N, and the remaining one may be CR₅₆. In this case, the third compound represented by Formula ET-1 may include a pyrimidine moiety. Alternatively, all of Zₐ to Z_{c} may be N. In this case, the third compound represented by Formula ET-1 may include a triazine moiety.

In Formula ET-1, R₅₆ may be a hydrogen atom, a deuterium atom, a substituted or unsubstituted alkyl group having a carbon number of 1 to 20, a substituted or unsubstituted aryl group having a ring-forming carbon number of 6 to 60, or a substituted or unsubstituted heteroaryl group having a ring-forming carbon number of 2 to 60.

In Formula ET-1, b1 to b3 may be each independently an integer of 0 to 10.

In Formula ET-1, Ar_{b} to Ar_{d} may be each independently a hydrogen atom, a deuterium atom, a substituted or unsubstituted alkyl group having a carbon number of 1 to 20, a substituted or unsubstituted aryl group having a ring-forming carbon number of 6 to 30, or a substituted or unsubstituted heteroaryl group having a ring-forming carbon number of 2 to 30. For example, Ar_{b} to Ar_{d} may be a substituted or unsubstituted phenyl group, or a substituted or unsubstituted carbazole group.

In Formula ET-1, L₂ to L₄ may be each independently a direct linkage, a substituted or unsubstituted arylene group having a ring-forming carbon number of 6 to 30, or a substituted or unsubstituted heteroarylene group having a ring-forming carbon number of 2 to 30. When b1 to b3 are an integer of 2 or more, L₂ to L₄ may be each independently a substituted or unsubstituted arylene group having a ring-forming carbon number of 6 to 30, or a substituted or unsubstituted heteroarylene group having a ring-forming carbon number of 2 to 30.

According to an embodiment, the third compound may be represented by any one among compounds of Compound Group 3. The light-emitting element ED according to an embodiment may include any one among compounds of Compound Group 3:

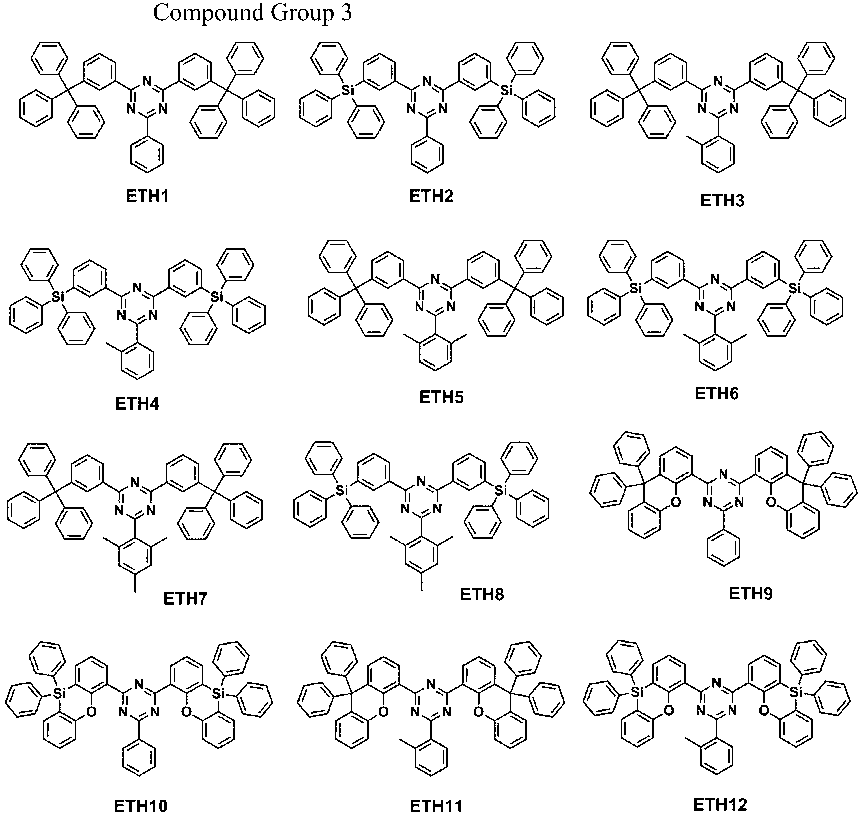

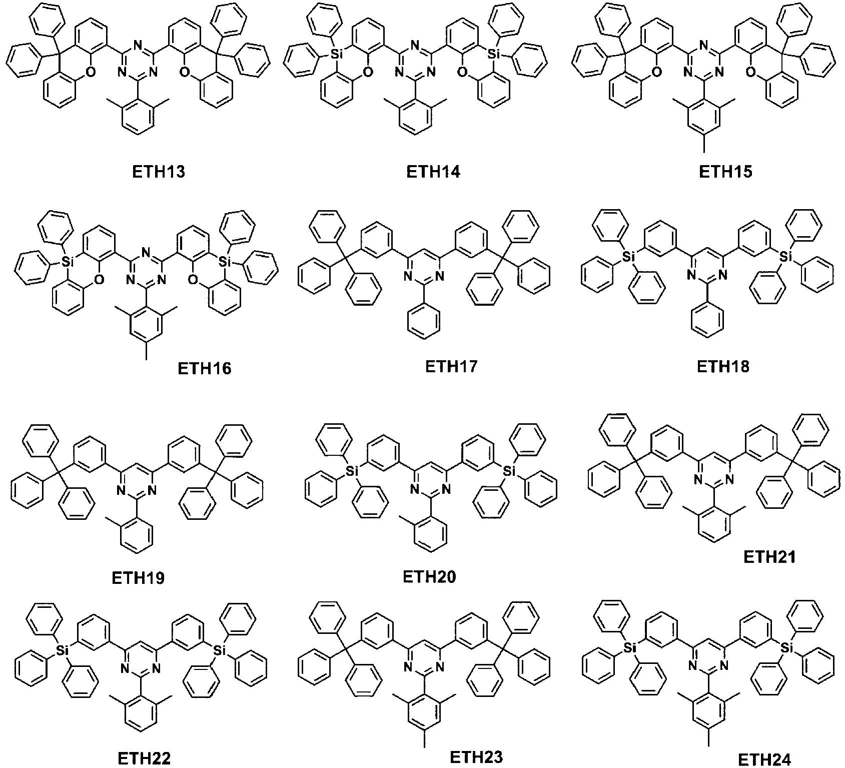

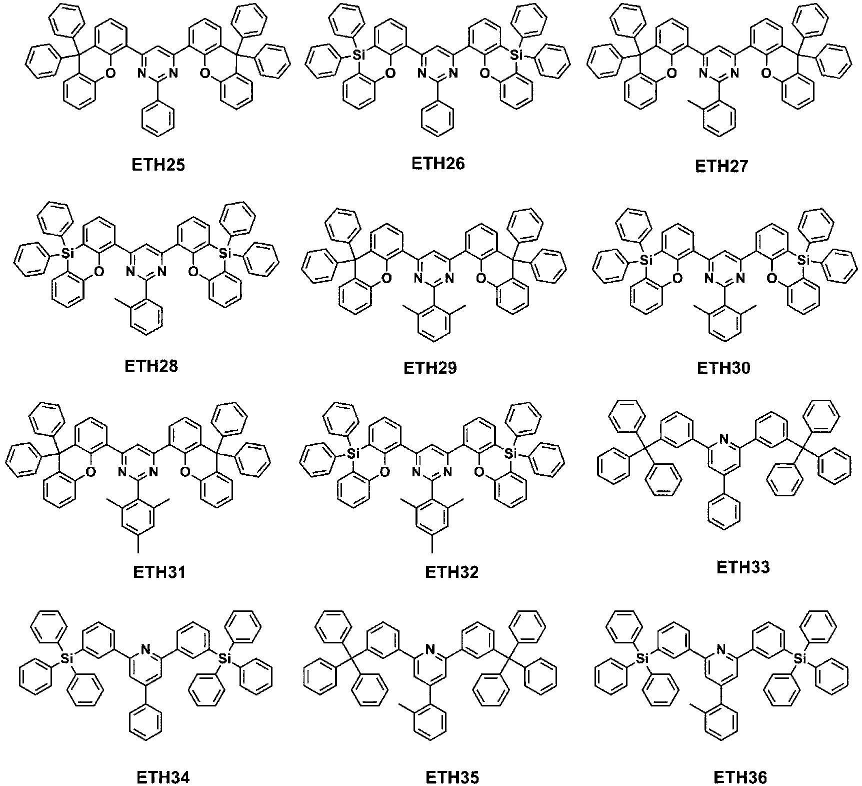

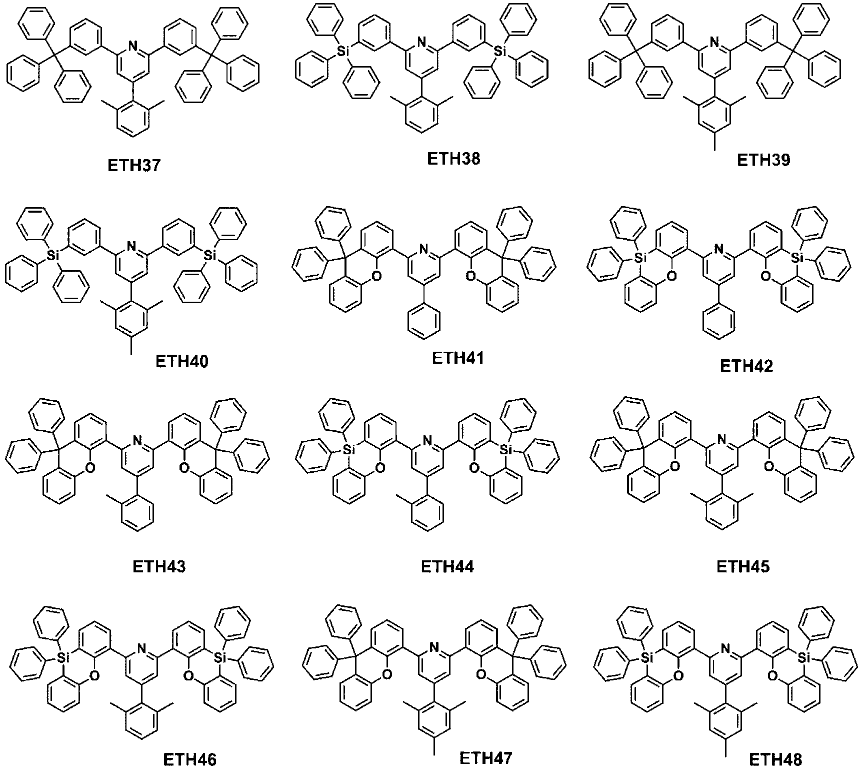

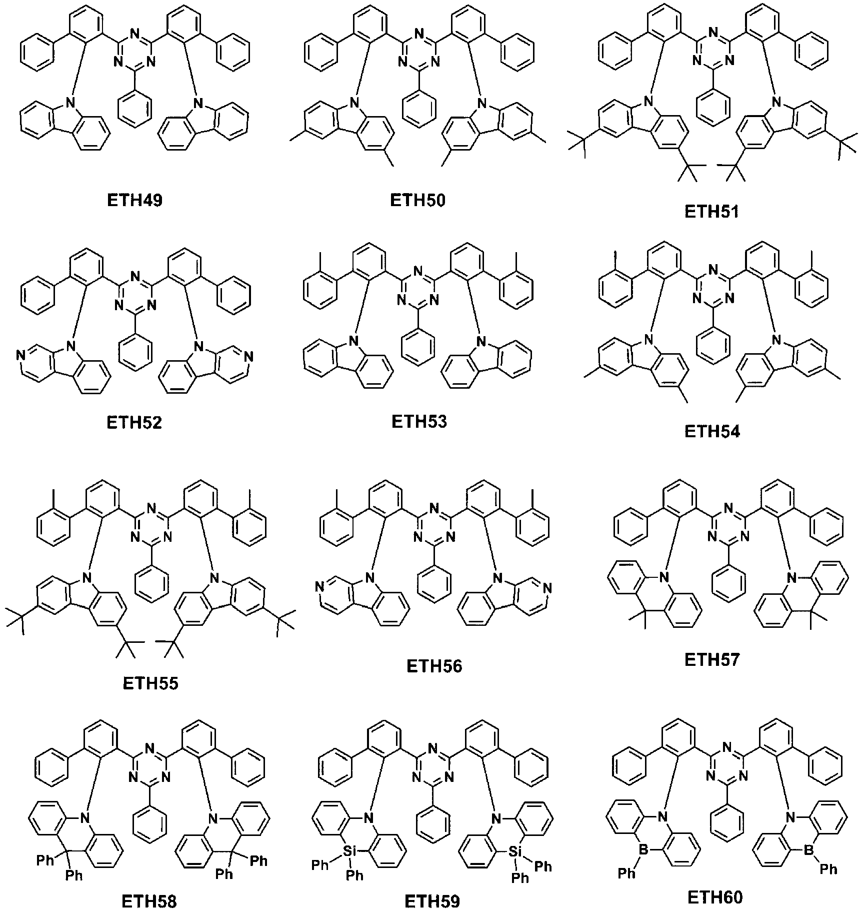

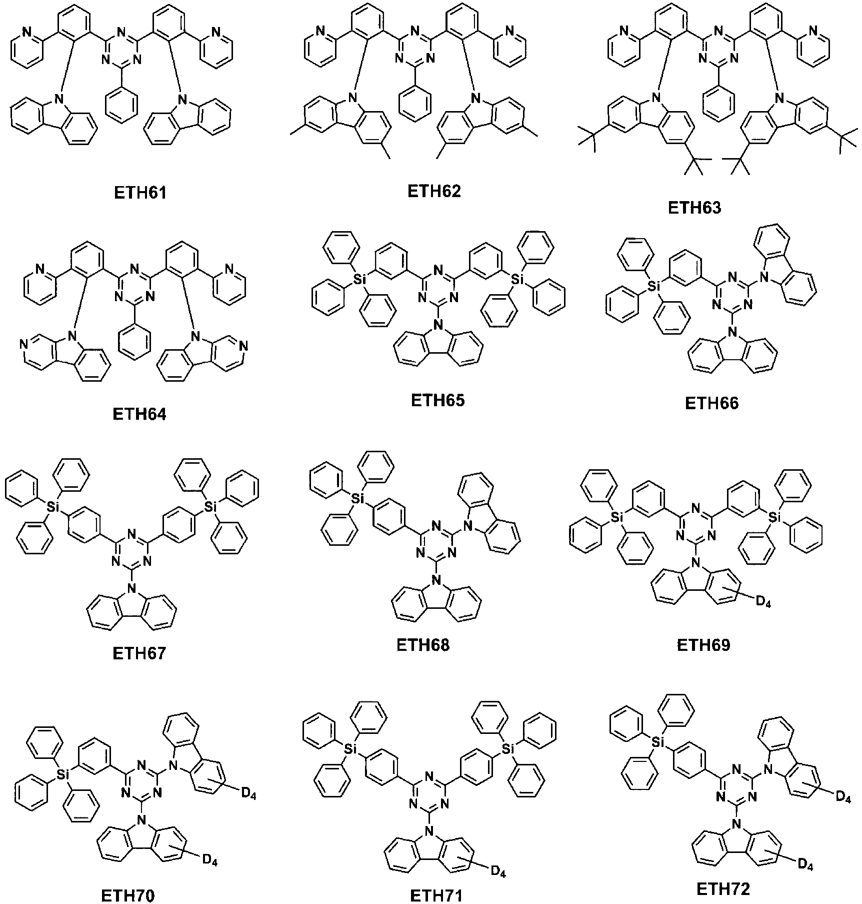

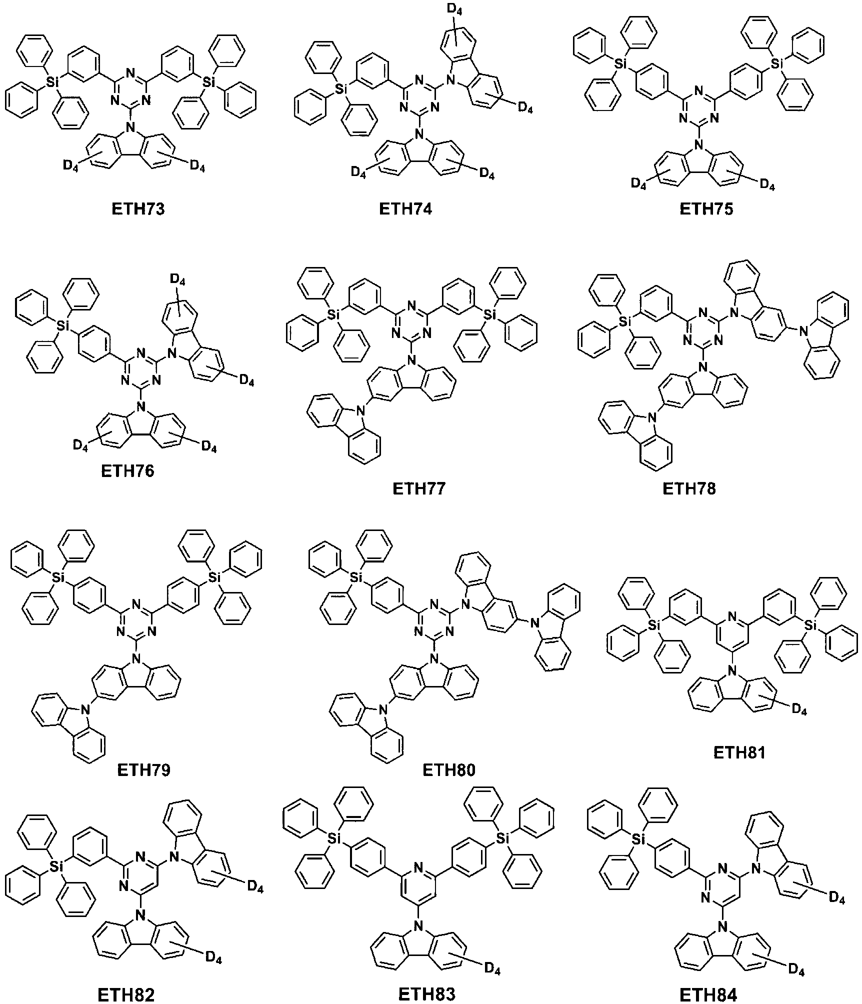

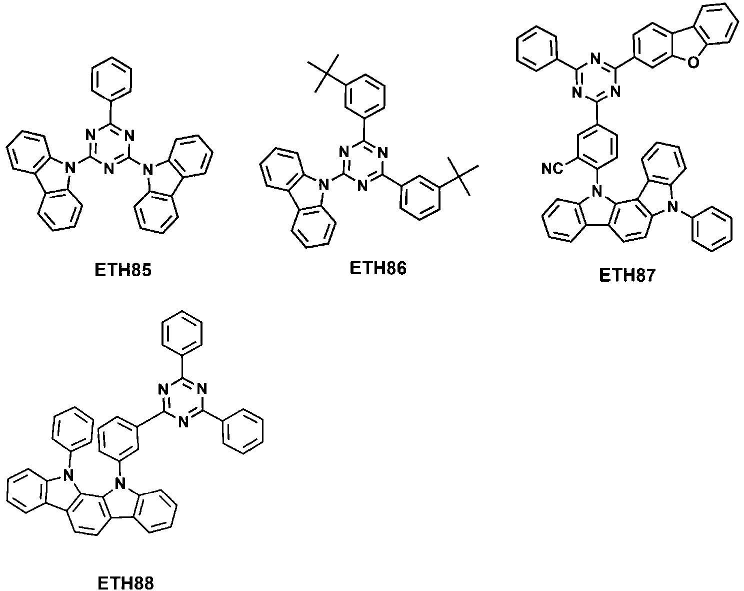

In compounds suggested in Compound Group 3, "D" means a deuterium atom, and "Ph" means an unsubstituted phenyl group.

The light-emitting layer EML may include the second compound and the third compound, and the second compound and the third compound may form an exciplex. The exciplex may be formed in the light-emitting layer EML by a hole-transporting host and an electron-transporting host. In this case, a triplet energy of the exciplex formed by the hole-transporting host and the electron-transporting host may correspond to a difference between a lowest unoccupied molecular orbital (LUMO) energy level of the electron-transporting host and a highest occupied molecular orbital (HOMO) energy level of the hole-transporting host.

For example, an absolute value of the triplet energy level (T1) of the exciplex formed by the hole-transporting host and the electron-transporting host may be about 2.4 eV to about 3.0 eV. In addition, the triplet energy of the exciplex may be smaller than an energy gap of each host material. The exciplex may have the triple energy equal to or less than about 3.0 eV, which is an energy gap between the hole-transporting host and the electron-transporting host.

According to an embodiment, the light-emitting layer EML may include a fourth compound as well as the first compound to the third compound previously described. The fourth compound may be used as a phosphorescence sensitizer of the light-emitting layer EML. Luminescence may occur by transferring energy from the fourth compound to the first compound.

For example, the light-emitting layer EML may include, as the fourth compound, an organometallic complex including platinum (Pt) as a central metal atom, and including ligands combined with the central metal atom. The light-emitting layer EML may include a compound represented by Formula D-1 as the fourth compound in the light-emitting element ED according to an embodiment.

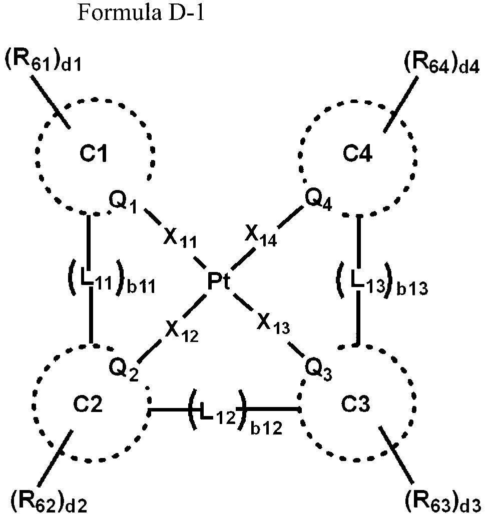

In Formula D-1, Q₁ to Q₄ may be each independently C or N.

In Formula D-1, C1 to C4 may be each independently a substituted or unsubstituted hydrocarbon ring having a carbon number of 5 to 30, a substituted or unsubstituted aryl group having a ring-forming carbon number of 6 to 30, or a substituted or unsubstituted heterocycle having a ring-forming carbon number of 2 to 30.

X₁₁ to X₁₄ may be each independently a direct linkage or *-O- * . For example, any one of X₁₁ to X₁₄ may be *-O-* , and the rest thereof may be a direct linkage.

In Formula D-1, L₁₁ to L₁₃ may be each independently a direct linkage, *-O-*, *-S-*, 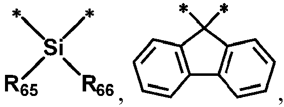 a substituted or unsubstituted alkyl group having a carbon number of 1 to 20, a substituted or unsubstituted arylene group having a ring-forming carbon number of 6 to 30, or a substituted or unsubstituted heteroarylene group having a ring-forming carbon number of 2 to 30. In L₁₁ to L₁₃, " * " means a position connected to Cy1 to Cy4.

In Formula D-1, b11 to b13 may be each independently 0 or 1. When b11 is 0, C1 and C2 may not be connected to each other. When b12 is 0, C2 and C3 may not be connected to each other. When b13 is 0, C3 and C4 may not be connected to each other.

In Formula D-1, R₆₁ to R₆₆ may be each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having a carbon number of 1 to 20, a substituted or unsubstituted alkenyl group having a carbon number of 2 to 20, a substituted or unsubstituted aryl group having a ring-forming carbon number of 6 to 60, or a substituted or unsubstituted heteroaryl group having a ring-forming carbon number of 2 to 60. Alternatively, each of R₆₁ to R₆₆ may be combined with an adjacent group to form a ring. R₆₁ to R₆₆ may be each independently a substituted or unsubstituted methyl group or a substituted or unsubstituted t-butyl group.

In Formula D-1, d1 to d4 are each independently an integer of 0 to 4. In Formula D-1, when each of d1 to d4 is 0, the fourth compound may not be substituted with R₆₁ to R₆₄. A case in which, when each of d1 to d4 is 4, each of R₆₁ to R₆₄ is a hydrogen atom. A case in which, when each of d1 to d4 is 0, R₆₁ to R₆₄ is a hydrogen atom. When each of d1 to d4 is an integer of 2 or more, all of R₆₁ to R₆₄ provided in plurality may be the same as each other, or at least one of a plurality of R₆₁ to R₆₄ is different from the other (or others).

In Formula D-1, C1 to C4 may be each independently a substituted or unsubstituted heterocycle or a substituted or unsubstituted hydrocarbon ring represented by any one of C-1 to C-5:

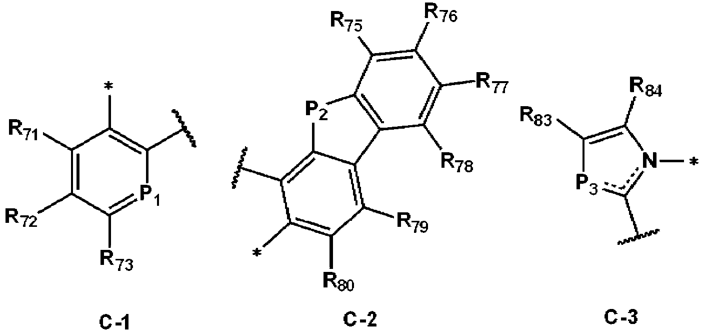

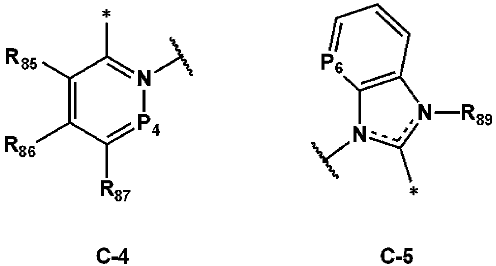

In C-1 to C-5, P₁ may be **C-*** or CR₇₄, P₂ may be N-* or NR₈₁, P₃ may be N-* or NR₈₂, P₄ may be C-* or CR₈₈, P₆ may be C-* or CR₉₀. R₇₁ to R₉₀ may be each independently a substituted or unsubstituted alkyl group having a carbon number of 1 to 20, a substituted or unsubstituted aryl group having a ring-forming carbon number of 6 to 30, or a substituted or unsubstituted heteroaryl group having a ring-forming carbon number of 2 to 30, or may be combined with an adjacent group to form a ring.

In addition, in C-1 to C-5, " 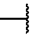 " is a part connected to Pt which is a central metal atom, and "-*" corresponds to a part connected to an adjacent ring group (C1 to C4) or a linker (L₁₁ to L₁₃).

The light-emitting layer EML according to an embodiment may include at least one among the first compound and the second to fourth compounds, which are the condensed polycyclic compound. For example, the light-emitting layer EML may include the first compound, the second compound and the third compound. The second compound and the third compound may form the exciplex in the light-emitting layer EML, and energy may be transferred to the first compound in the exciplex so that luminescence may occur.

In addition, the light-emitting layer EML may include the first compound, the second compound, the third compound and the fourth compound. The second compound and the third compound may form the exciplex in the light-emitting layer EML, and the energy may be transferred to the fourth compound and the first compound in the exciplex so that luminescence may occur. According to an embodiment, the fourth compound may be a sensitizer. The fourth compound included in the light-emitting layer EML may function as the sensitizer in the light-emitting element ED according to an embodiment to serve to transfer the energy from a host to the first compound which is a light-emitting dopant. That is, the fourth compound that serves as an auxiliary dopant may accelerate energy transfer to the first compound which is the light-emitting dopant to increase luminous ratio of the first compound. Accordingly, the light-emitting layer EML according to an embodiment may improve the luminous efficiency. In addition, when the energy transfer to the first compound increases, an exciton formed in the light-emitting layer EML may not be accumulated inside the light-emitting layer EML, and may emit light rapidly to reduce element degradation. Accordingly, the light-emitting element ED according to an embodiment may have increased lifespan.

Since the light-emitting element ED according to an embodiment includes all of the first compound, the second compound, the third compound and the fourth compound, the light-emitting layer EML may include a combination of two host materials and two dopant materials. Since the light-emitting layer EML in the light-emitting element ED according to an embodiment simultaneously includes the second compound and the third compound which are two different hosts, the first compound that emits delayed fluorescence, and the fourth compound that includes the organometallic complex, excellent luminous efficiency characteristics may be exhibited.

The fourth compound represented by Formula D-1 according to an embodiment may be represented by at least one among compounds represented by Compound Group 4. The light-emitting layer EML may include, as a sensitizer material, at least one among compounds represented by Compound Group 4:

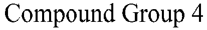

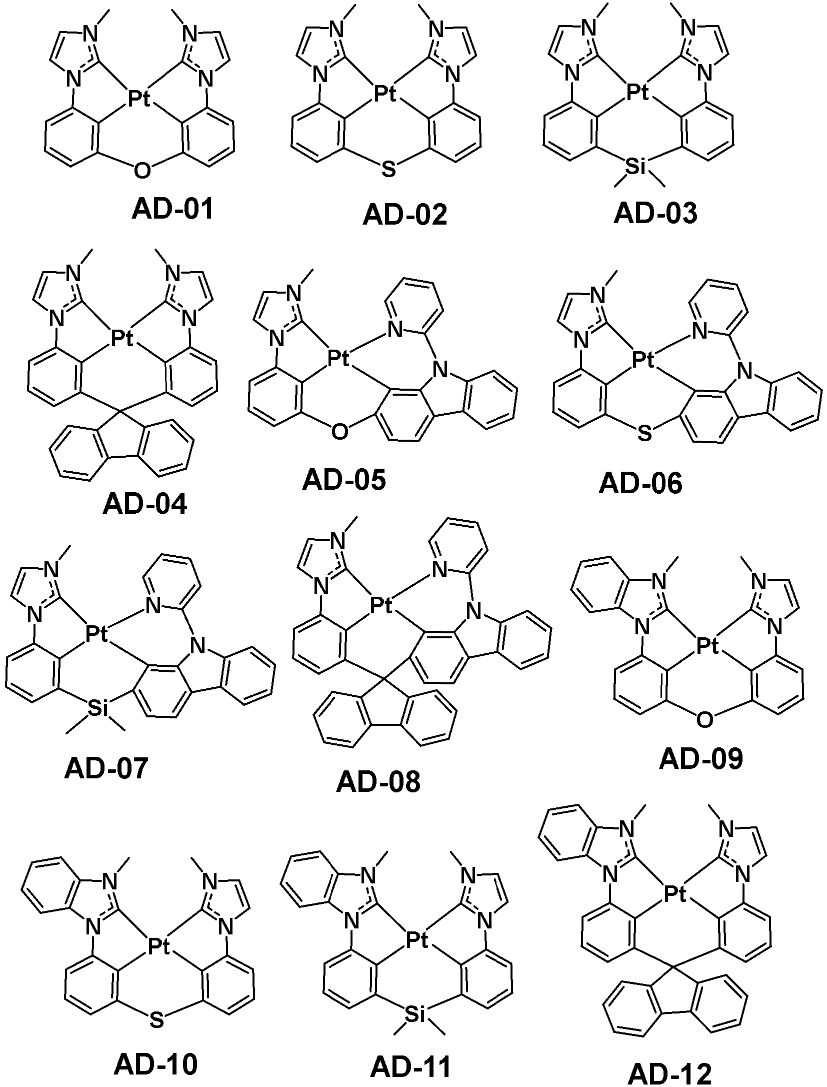

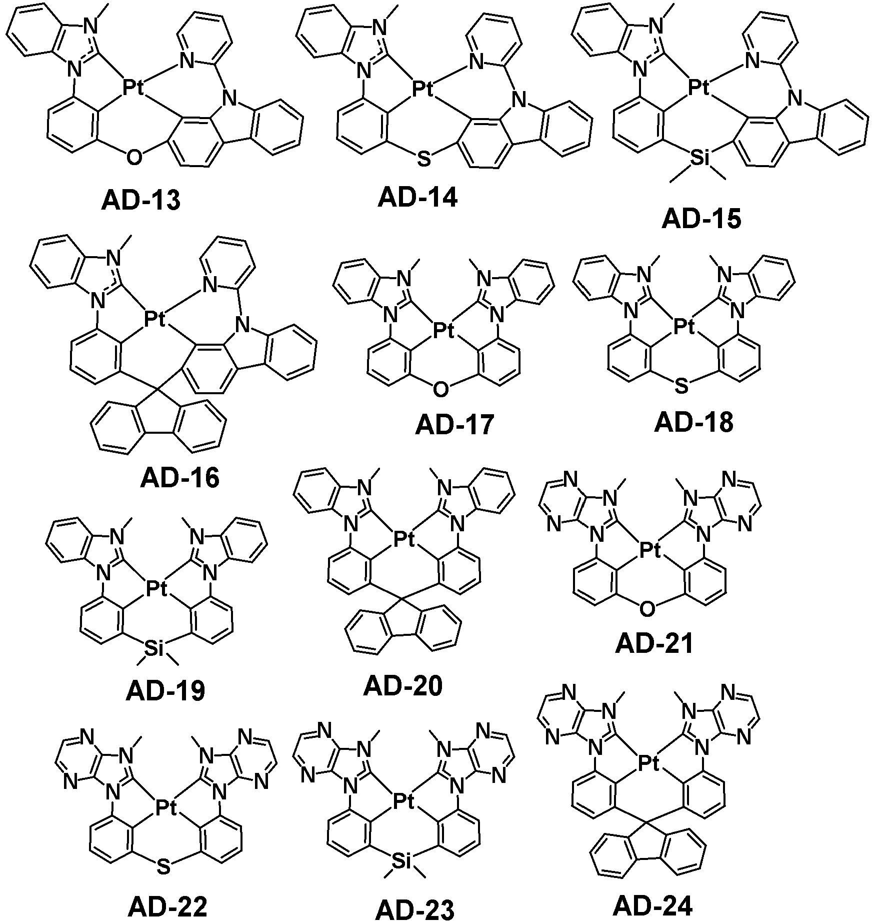

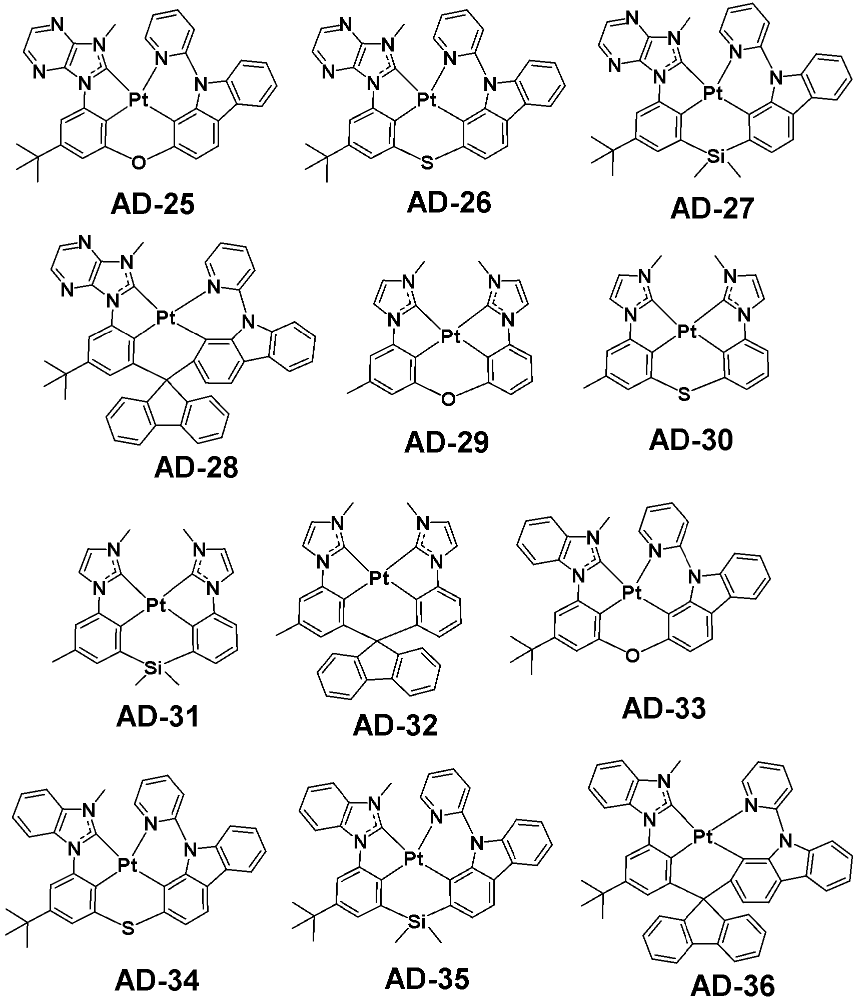

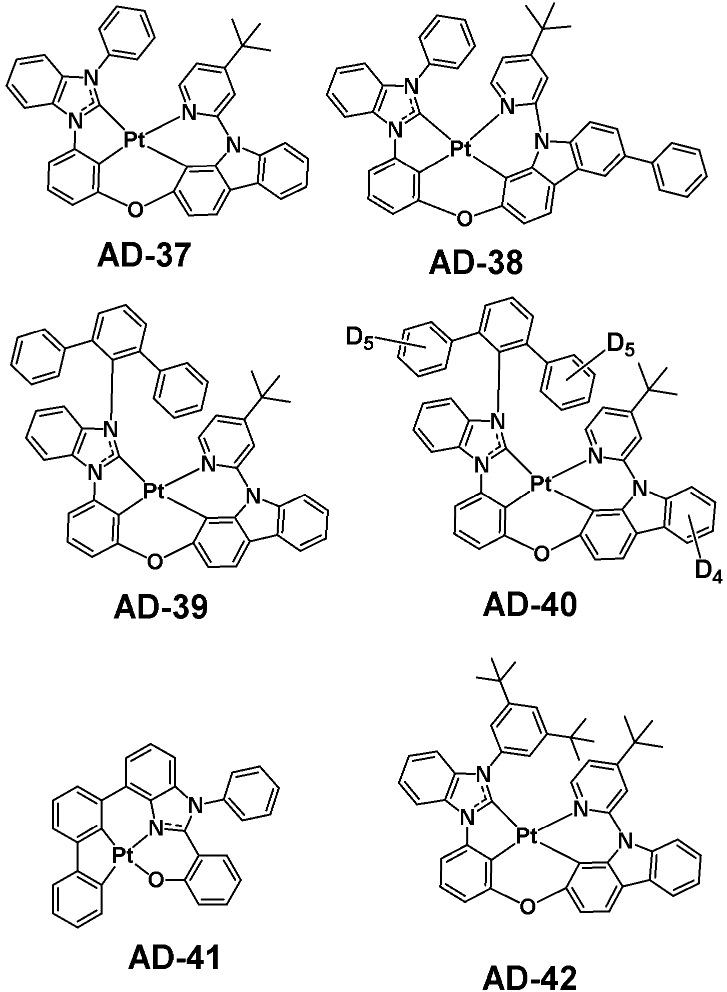

In compounds suggested in Compound Group 4, "D" means a deuterium atom.

The light-emitting element ED according to an embodiment may include a plurality of light-emitting layers. The plurality of light-emitting layers may be sequentially stacked and may be provided, and for example, the light-emitting element ED including the plurality of light-emitting layers may emit white light. The light-emitting element including the plurality of light-emitting layers may be a light-emitting element having a tandem structure. When the light-emitting element ED includes the plurality of light-emitting layers, at least one light-emitting layer EML may include the first compound represented by Formula 1 according to an embodiment. In addition, when the light-emitting element ED includes the plurality of light-emitting layers, at least one light-emitting layer EML may include all of the first compound, the second compound, the third compound and the fourth compound as previously described.

When the light-emitting layer EML includes all of the first compound, the second compound, the third compound, and the fourth compound previously described in the light-emitting element ED according to an embodiment, a content of the first compound may be about 0.1 wt% to about 5 wt% with respect to the total weight of the first compound, the second compound, the third compound, and the fourth compound, but an embodiment of the inventive concept is not limited thereto. When the content of the first compound satisfies the ratio previously described, energy transfer from the second compound and the third compound to the first compound may increase, and thus luminous efficiency and element lifespan may increase.

The contents of the second compound and the third compound in the light-emitting layer EML may be the rest except for the weight of the first compound and the fourth compound previously described. For example, the contents of the second compound and the third compound in the light-emitting layer EML may be about 65 wt% to about 95 wt% with respect to the total weight of the first compound, the second compound, the third compound, and the fourth compound.

A weight ratio of the second compound and the third compound in the total weight of the second compound and the third compound may be about 3:7 to about 7:3.

When the contents of the second compound and the third compound satisfy the ratio previously described, charge balance characteristics in the light-emitting layer EML may be improved to increase luminous efficiency and element lifespan. When the contents of the second compound and the third compound do not satisfy the ratio range previously described, the charge balance in the light-emitting layer EML may be broken to deteriorate the luminous efficiency and to easily degrade the element.

When the light-emitting layer EML includes the fourth compound, a content of the fourth compound may be about 4 wt% to about 30 wt% with respect to the total weight of the first compound, the second compound, the third compound and the fourth compound in the light-emitting layer EML, but an embodiment of the inventive concept is not limited thereto. When the content of the fourth compound satisfies the content previously described, energy transfer from the host to the first compound which is a light-emitting dopant may increase to improve the luminous efficiency, and thus to improve the luminous efficiency of the light-emitting layer EML. When the first compound, the second compound, the third compound and the fourth compound included in the light-emitting layer EML satisfy the content ratio range previously described, excellent luminous efficiency and long lifespan may be achieved.

The light-emitting layer EML in the light-emitting element ED according to an embodiment may include an anthracene derivative, a pyrene derivative, a fluoranthene derivative, a chrysene derivative, a dihydrobenzanthracene derivative, or a triphenylene derivative. Specifically, the light-emitting layer EML may include an anthracene derivative or a pyrene derivative.

The light-emitting layer EML in the light-emitting element ED according to an embodiment illustrated in FIGS. 3 to 6 may further include a well-known host and dopant as well as the host and dopant previously described, and for example, may include a compound represented by Formula E-1. The compound represented by Formula E-1 may be used as a fluorescence host material.

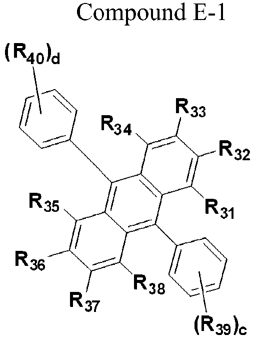

In Formula E-1, R₃₁ to R₄₀ may be each independently a hydrogen atom, a deuterium atom, a halogen atom, a substituted or unsubstituted silyl group, a substituted or unsubstituted thio group, a substituted or unsubstituted oxy group, a substituted or unsubstituted alkyl group having a carbon number of 1 to 10, a substituted or unsubstituted alkenyl group having a carbon number of 2 to 10, a substituted or unsubstituted aryl group having a ring-forming carbon number of 6 to 30, or a substituted or unsubstituted heteroaryl group having a ring-forming carbon number of 2 to 30, or may be combined with an adjacent group to form a ring. R₃₁ to R₄₀ may be combined with an adjacent group to form a saturated hydrocarbon ring, an unsaturated hydrocarbon ring, a saturated heterocycle, or an unsaturated heterocycle.

In Formula E-1, c and d may be each independently an integer of 0 to 5.

Formula E-1 may be represented by any one among Compound E1 to Compound E21:

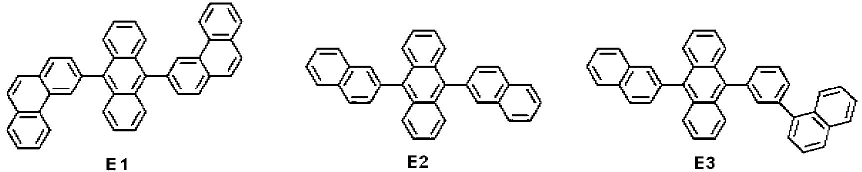

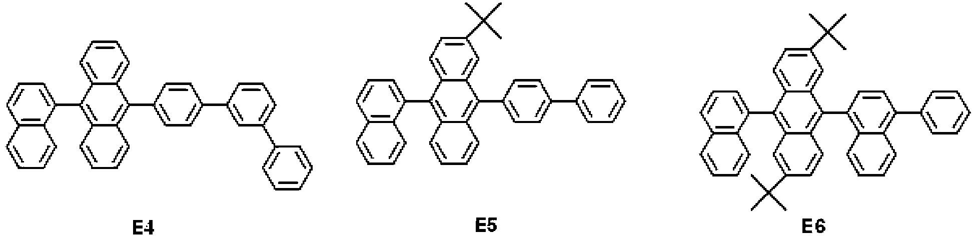

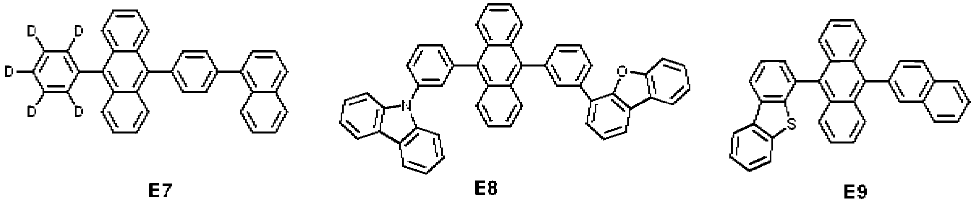

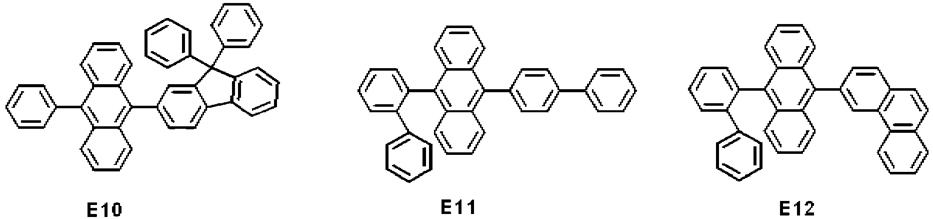

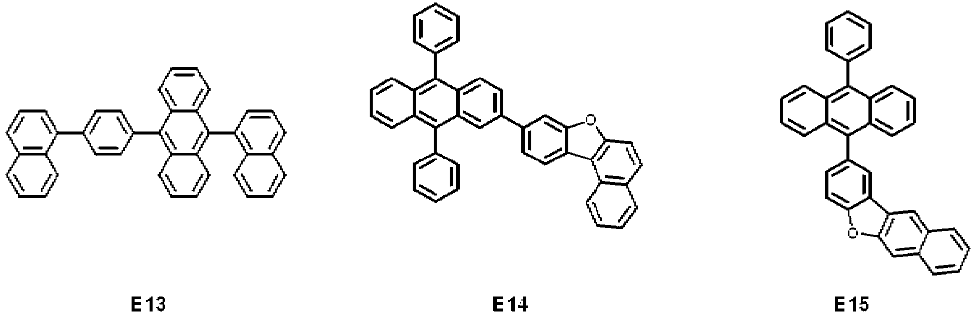

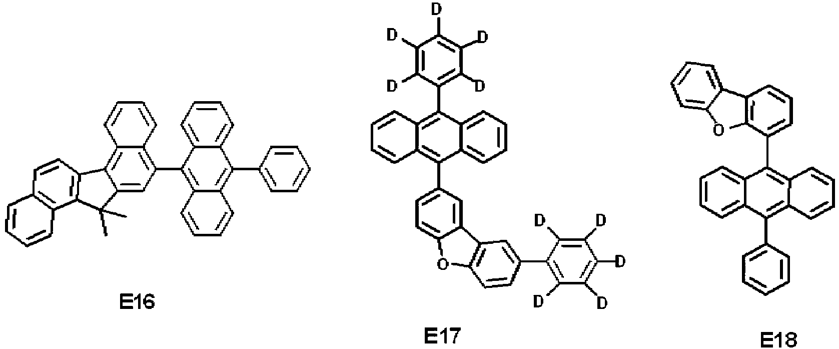

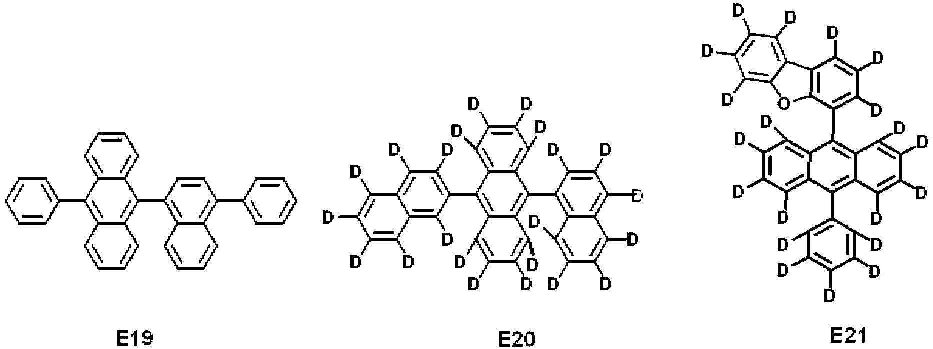

The light-emitting layer EML according to an embodiment may include a compound represented by Formula E-2a or Formula E-2b. The compound represented by Formula E-2a or Formula E-2b may be used as a host material for phosphorescent emission layer.

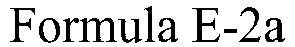

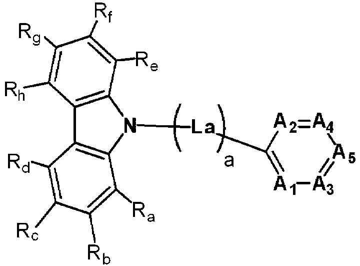

In Formula E-2a, a may be an integer of 0 to 10, and La may be a direct linkage, a substituted or unsubstituted arylene group having a ring-forming carbon number of 6 to 30, or a substituted or unsubstituted heteroarylene group having a ring-forming carbon number of 2 to 30. When a is an integer of 2 or more, a plurality of La may be each independently a substituted or unsubstituted arylene group having a ring-forming carbon number of 6 to 30, or a substituted or unsubstituted heteroarylene group having a ring-forming carbon number of 2 to 30.

In addition, in Formula E-2a, A₁ to A₅ may be each independently N or CRᵢ. Rₐ to Rᵢ may be each independently a hydrogen atom, a deuterium atom, a substituted or unsubstituted amine group, a substituted or unsubstituted thio group, a substituted or unsubstituted oxy group, a substituted or unsubstituted alkyl group having a carbon number of 1 to 20, a substituted or unsubstituted alkenyl group having a carbon number of 2 to 20, a substituted or unsubstituted aryl group having a ring-forming carbon number of 6 to 30, or a substituted or unsubstituted heteroaryl group having a ring-forming carbon number of 2 to 30, or may be combined with an adjacent group to form a ring. Rₐ to Rᵢ may be combined with an adjacent group to form a hydrocarbon ring or a heterocycle including N, O, S, or the like as a ring-forming atom.

In Formula E-2a, two or three selected from A₁ to A₅ may be N, and the rest thereof may be CRᵢ.

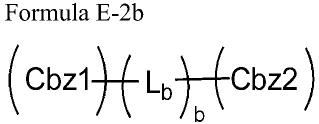

In Formula E-2b, Cbzl and Cbz2 may be each independently an unsubstituted carbazole group, or a carbazole group substituted with an aryl group having a ring-forming carbon number of 6 to 30. L_{b} may be a direct linkage, a substituted or unsubstituted arylene group having a ring-forming carbon number of 6 to 30, or a substituted or unsubstituted heteroarylene group having a ring-forming carbon number of 2 to 30. b may be an integer of 0 to 10, and when b is an integer of 2 or more, a plurality of L_{b} may be each independently a substituted or unsubstituted arylene group having a ring-forming carbon number of 6 to 30, or a substituted or unsubstituted heteroarylene group having a ring-forming carbon number of 2 to 30.

A compound represented by Formula E-2a or Formula E-2b may be represented by any one among compounds of Compound Group E-2. However, the compounds listed in Compound Group E-2 are non-limiting examples. A compound represented by Formula E-2a or Formula E-2b is not limited to the specific examples in Compound Group E-2:

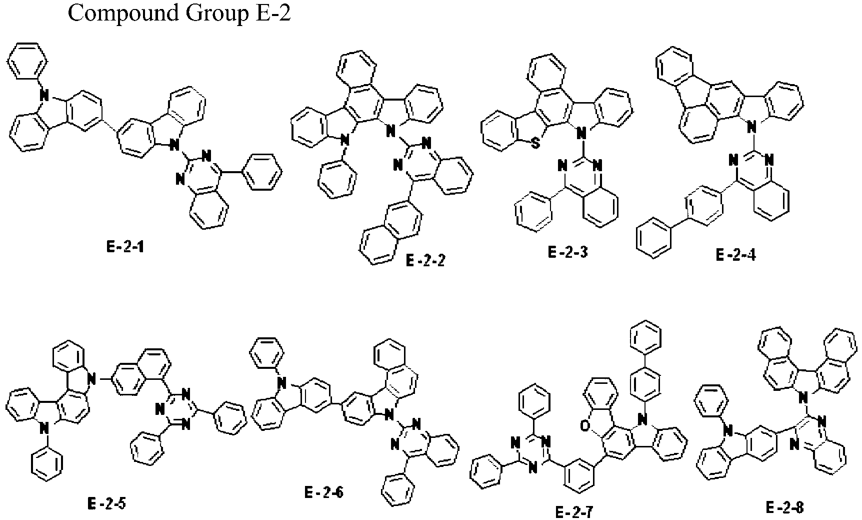

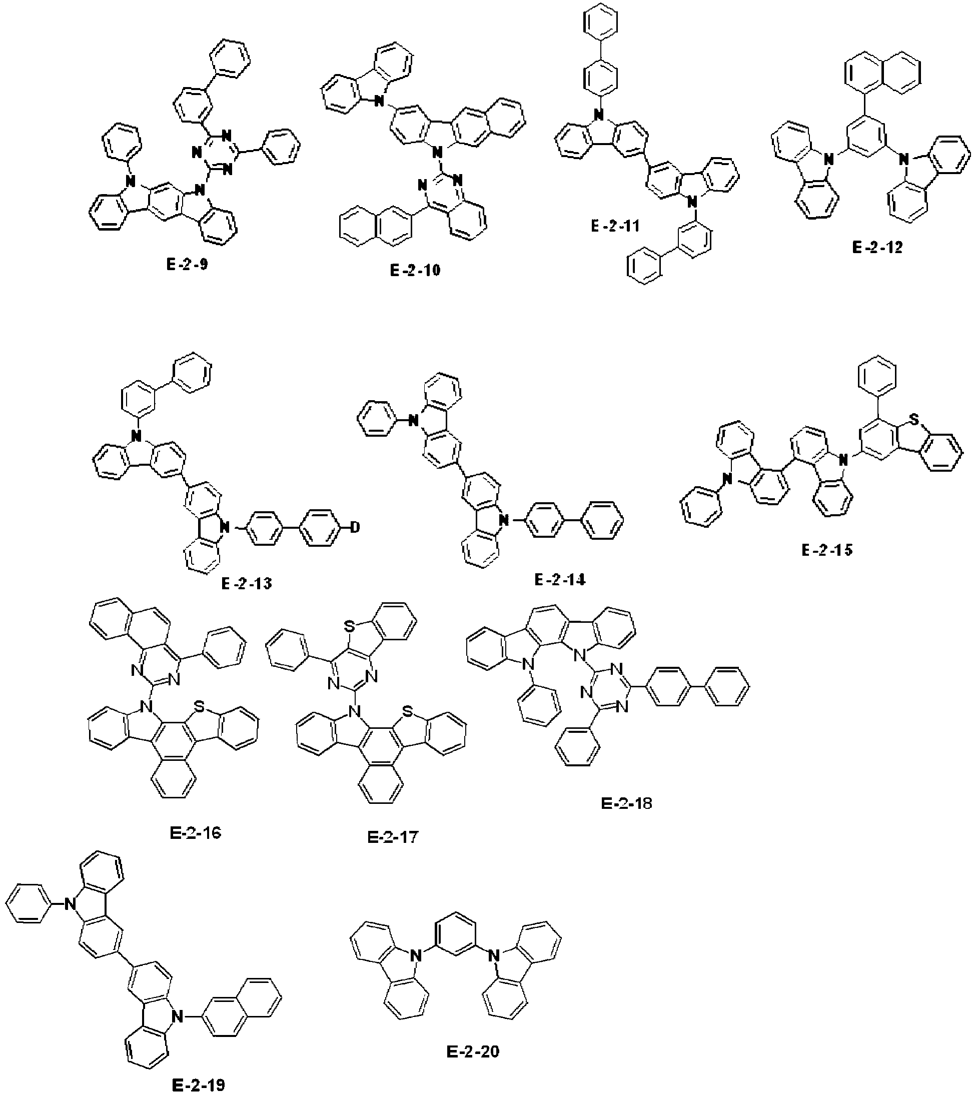

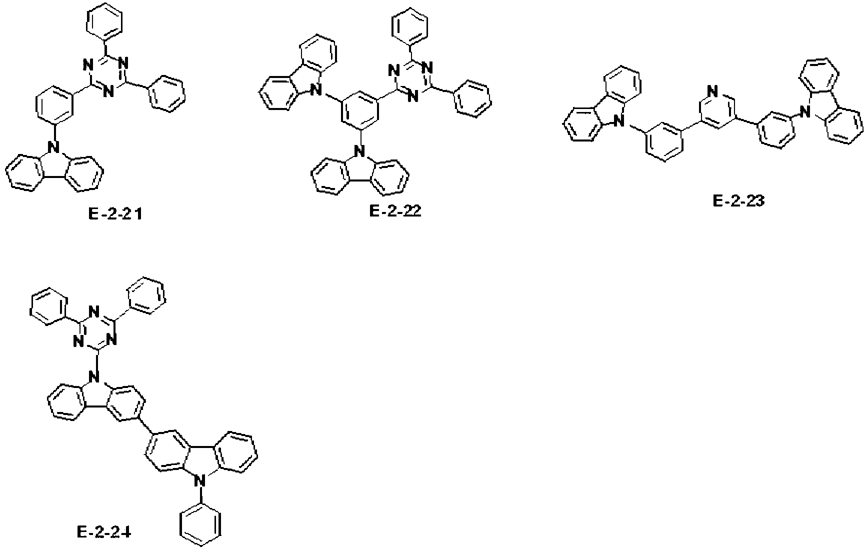

The light-emitting layer EML may further include a general material well-known in the art as a host material. For example, the light-emitting layer EML may include, as a host material, at least one of bis (4-(9H-carbazol-9-yl) phenyl) diphenylsilane (BCPDS), (4-(1-(4-(diphenylamino) phenyl) cyclohexyl) phenyl) diphenyl-phosphine oxide (POPCPA), bis[2-(diphenylphosphino)phenyl] ether oxide (DPEPO), 4,4'-bis(carbazol-9-yl)biphenyl (CBP), 1,3-bis(carbazol-9-yl)benzene (mCP), 2,8-bis(diphenylphosphoryl)dibenzo[b,d]furan (PPF), 4,4',4"-tris(carbazol-9-yl)-triphenylamine (TCTA), or 1,3,5-tris(1-phenyl-1H-benzo[d]imidazole-2-yl)benzene (TPBi). However, an embodiment of the inventive concept is not limited thereto. For example, tris(8-hydroxyquinolino)aluminium (Alq3), 9,10-di(naphthalene-2-yl)anthracene (ADN), 2-tert-butyl-9,10-di(naphth-2-yl)anthracene (TBADN), distyrylarylene (DSA), 4,4'-bis(9-carbazolyl)-2,2'-dimethyl-biphenyl (CDBP), 2-methyl-9,10-bis(naphthalen-2-yl)anthracene (MADN), hexaphenyl cyclotriphosphazene (CP1), 1,4-bis(triphenylsilyl)benzene (UGH2), hexaphenylcyclotrisiloxane (DPSiO3), octaphenylcyclotetra siloxane (DPSiO4), etc. may be used as the host material.

The light-emitting layer EML may include a compound represented by Formula M-a. The compound represented by Formula M-a may be used as a phosphorescence dopant material.

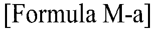

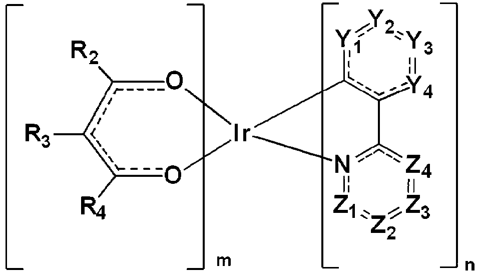

In Formula M-a, Y₁ to Y₄, and Z₁ to Z₄ may be each independently CR₁ or N, and R₁ to R₄ may be each independently a hydrogen atom, a deuterium atom, a substituted or unsubstituted amine group, a substituted or unsubstituted thio group, a substituted or unsubstituted oxy group, a substituted or unsubstituted alkyl group of 1 to 20 carbon atoms, a substituted or unsubstituted alkenyl group of 2 to 20 carbon atoms, a substituted or unsubstituted aryl group of 6 to 30 ring-forming carbon atoms, or a substituted or unsubstituted heteroaryl group of 2 to 30 ring-forming carbon atoms, or may be combined with an adjacent group to form a ring. In Formula M-a, m is 0 or 1, and n is 2 or 3. In Formula M-a, when m is 0, n is 3, and when m is 1, n is 2.

The compound represented by Formula M-a may be used as a phosphorescence dopant.

The compound represented by Formula M-a may be represented by any one among Compounds M-a1 to M-a25. However, Compounds M-al to M-a25 are non-limiting examples. A compound represented by Formula M-a is not limited to the compounds represented by Compounds M-a1 to M-a25:

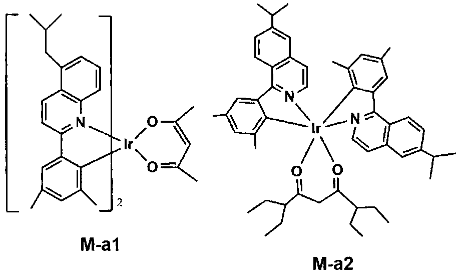

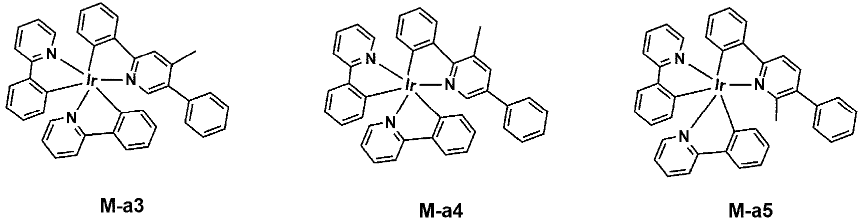

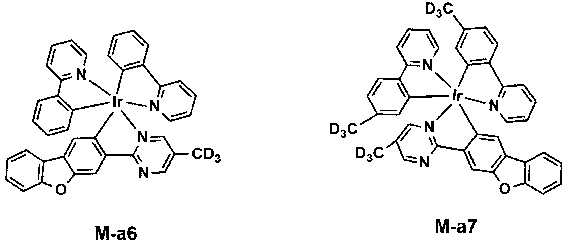

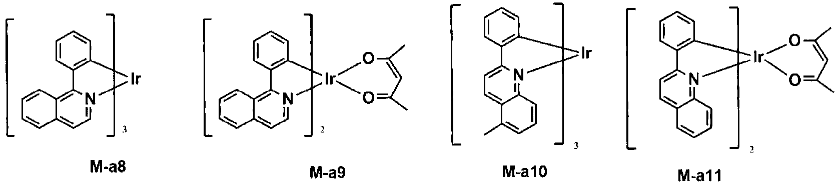

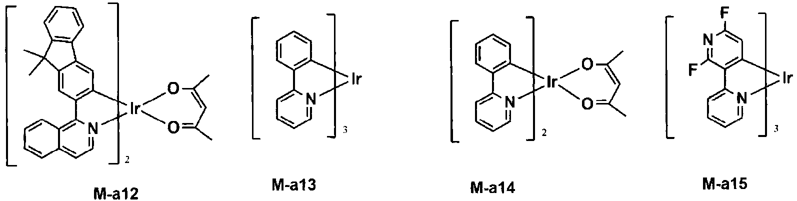

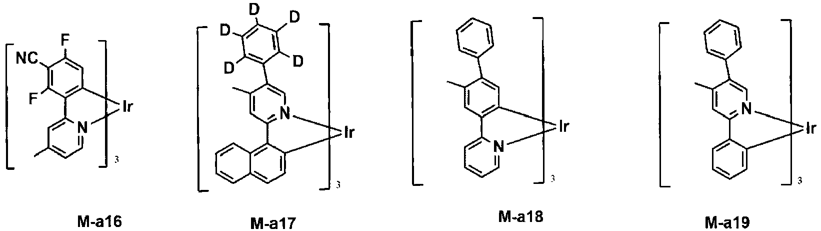

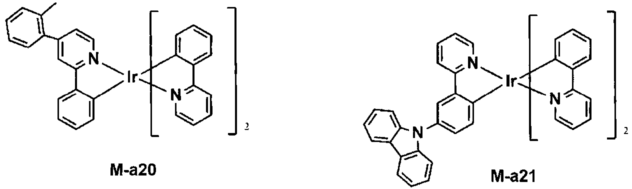

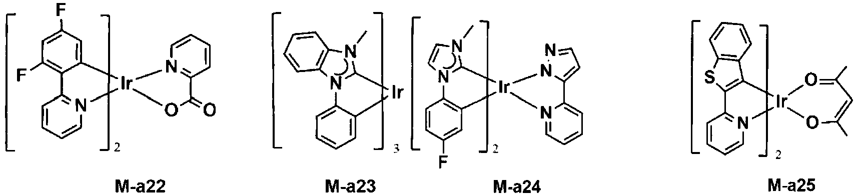

The light-emitting layer EML may include a compound represented by any one among Formula F-a to Formula F-c. The compound represented by Formula F-a to Formula F-c may be used as a fluorescence dopant material.

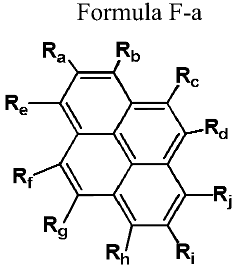

In Formula F-a, two selected from Rₐ to Rⱼ may be each independently substituted with *-NAr₁Ar₂. The rest not substituted with * -NAr₁Ar₂ among Rₐ to Rⱼ may be each independently a hydrogen atom, a deuterium atom, a halogen atom, a cyano group, a substituted or unsubstituted amine group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms. In *-NAr₁Ar₂, Ar₁ and Ar₂ may be each independently a substituted or unsubstituted aryl group of 6 to 30 ring-forming carbon atoms, or a substituted or unsubstituted heteroaryl group of 2 to 30 ring-forming carbon atoms. For example, at least one of Ar₁ or Ar₂ may be a heteroaryl group including O or S as a ring-forming atom.

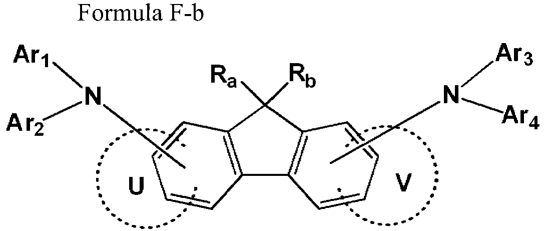

In Formula F-b, Rₐ and R_{b} may be each independently a hydrogen atom, a deuterium atom, a substituted or unsubstituted alkyl group of 1 to 20 carbon atoms, a substituted or unsubstituted alkenyl group of 2 to 20 carbon atoms, a substituted or unsubstituted aryl group of 6 to 30 ring-forming carbon atoms, or a substituted or unsubstituted heteroaryl group of 2 to 30 ring-forming carbon atoms, or may be combined with an adjacent group to form a ring. Ar₁ to Ar₄ may be each independently a substituted or unsubstituted aryl group of 6 to 30 ring-forming carbon atoms, or a substituted or unsubstituted heteroaryl group of 2 to 30 ring-forming carbon atoms.

In Formula F-b, U and V may be each independently a substituted or unsubstituted hydrocarbon ring of 5 to 30 ring-forming carbon atoms, or a substituted or unsubstituted heterocycle of 2 to 30 ring-forming carbon atoms. At least one among Ar₁ to Ar₄ may be a heteroaryl group including O or S as a ring-forming atom.

In Formula F-b, the number of rings represented by U and V may be each independently 0 or 1. For example, in Formula F-b, when the number of U or V is 1, one ring forms a condensed ring at a part designated by U or V, and when the number of U or V is 0, a ring is not present at the part designated by U or V. Specifically, when the number of U is 0, and the number of V is 1, or when the number of U is 1, and the number of V is 0, a condensed ring having a fluorene core of Formula F-b may be a ring compound having four rings. In addition, when the numbers of both U and V are all 0, the condensed ring of Formula F-b may be a ring compound having three rings. In addition, when the numbers of both U and V are all 1, a condensed ring having the fluorene core of Formula F-b may be a ring compound having five rings.

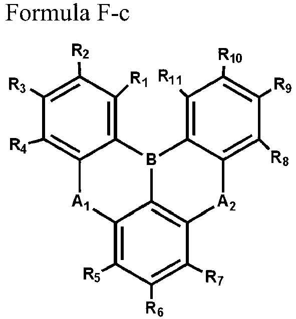

In Formula F-c, A₁ and A₂ may be each independently O, S, Se, or NRₘ, and Rₘ may be a hydrogen atom, a deuterium atom, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms. R₁ to R₁₁ are each independently a hydrogen atom, a deuterium atom, a halogen atom, a cyano group, a substituted or unsubstituted amine group, a substituted or unsubstituted boryl group, a substituted or unsubstituted oxy group, a substituted or unsubstituted thio group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, or may be combined with an adjacent group to form a ring.

In Formula F-c, A₁ and A₂ may be each independently combined with an adjacent ring substituent to form a condensed ring. For example, when A₁ and A₂ are each independently NRₘ, A₁ may be combined with R₄ or R₅ to form a ring. In addition, A₂ may be combined with R₇ or R₈ to form a ring.

According to an embodiment, the light-emitting layer EML may include, as a well-known dopant material, styryl derivatives (for example, 1,4-bis[2-(3-N-ethylcarbazoryl)vinyl]benzene (BCzVB), 4-(di-p-tolylamino)-4'-[(di-p-tolylamino)styryl]stilbene (DPAVB), N-(4-((E)-2-(6-((E)-4-(diphenylamino)styryl)naphthalen-2-yl)vinyl)phenyl)-N-phenylbenzenamine (N-BDAVBi), and 4,4'-bis[2-(4-(N,N-diphenylamino)phenyl)vinyl]biphenyl (DPAVBi)), perylene and the derivatives thereof (for example, 2,5,8,11-tetra-t-butylperylene (TBP)), pyrene and the derivatives thereof (for example, 1,1-dipyrene, 1,4-dipyrenylbenzene, and 1,4-bis(N,N-diphenylamino)pyrene), etc.

The light-emitting layer EML may further include a well-known phosphorescence dopant material. For example, a metal complex including iridium (Ir), platinum (Pt), osmium (Os), gold (Au), titanium (Ti), zirconium (Zr), hafnium (Hf), europium (Eu), terbium (Tb) or thulium (Tm) may be used as the phosphorescence dopant. Specifically, iridium(III) bis(4,6-difluorophenylpyridinato-N,C2')picolinate (FIrpic), bis(2,4-difluorophenylpyridinato)-tetrakis(1-pyrazolyl)borate iridium(III) (Fir6), or platinum octaethyl porphyrin (PtOEP) may be used as the phosphorescence dopant. However, an embodiment of the inventive concept is not limited thereto.

The light-emitting layer may include a quantum dot.

In the present specification, the quantum dot means a crystal of a semiconductor compound. The quantum dot may emit light having various wavelengths according to a crystal size thereof. The quantum dot may also emit light having various wavelengths by controlling a ratio of elements in the quantum dot compound.

The quantum dot may have a diameter of, for example, about 1 nm to about 10 nm.

The quantum dot may be synthesized in a wet chemical process, a metal organic chemical vapor deposition process, a molecular beam epitaxy process, or a process similar thereto.

The wet chemical process is a process of mixing an organic solvent and a precursor material, and then growing a quantum dot particle crystal. When the crystal is grown, an organic solvent may naturally serve as a dispersant coordinated to a quantum dot crystal surface, and may control growth of the crystal. Accordingly, the wet chemical process may control growth of the quantum dot particle as a process easier and cheaper than a vapor deposition process such as the metal organic chemical vapor deposition (MOCVD), or the molecular beam epitaxy (MBE).

The light-emitting layer EML according to the inventive concept may include a quantum dot material. A core of the quantum dot may be selected from a II-VI group compound, a III-VI group compound, a III-VI group compound, a I-III-VI group compound, a IV-VI group compound, a IV group element, a IV group compound, and a combination thereof.

The II-VI group compound may be selected from the group consisting of a binary compound selected from the group consisting of CdSe, CdTe, CdS, ZnS, ZnSe, ZnTe, ZnO, HgS, HgSe, HgTe, MgSe, MgS, and a mixture thereof, a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof, and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and a mixture thereof. The II-VI group semiconductor compound may further include a group I metal and/or a group IV element. The I-II-VI group compound may be selected from CuSnS or CuZnS, and the II-IV-VI group compound may be selected from ZnSnS or the like. The I-II-IV-VI group compound may be selected from a quaternary compound selected from the group consisting of Cu₂ZnSnS₂, Cu₂ZnSnS₄, Cu₂ZnSnSe₄, Ag₂ZnSnS₂ and a mixture thereof.

The III-VI group compound may include a binary compound such as In₂S₃, and In₂Se₃, a ternary compound such as InGaS₃, and InGaSe₃, or an arbitrary combination thereof.

The I-III-VI group compound may be selected from a ternary compound selected from the group consisting of AgInS, AgInS₂, CuInS, CuInS₂, AgGaS₂, CuGaS₂, CuGaO₂, AgGaO₂, AgAlO₂ and a mixture thereof, or a quaternary compound such as AgInGaS₂, and CuInGaS₂.

The III-V group compound may be selected from the group consisting of a binary compound selected from the group consisting of GaN, GaP, GaAs, GaSb, AlN, AlP, AlAs, AlSb, InN, InP, InAs, InSb, and a mixture thereof, a ternary compound selected from the group consisting of GaNP, GaNAs, GaNSb, GaPAs, GaPSb, AlNP, AlNAs, AlNSb, AlPAs, AlPSb, InGaP, InAlP, InNP, InNAs, InNSb, InPAs, InPSb, and a mixture thereof, and a quaternary compound selected from the group consisting of GaAlNP, GaAINAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a mixture thereof. The III-V group compound may further include a group II metal. For example, InZnP, etc. may be selected as a III-II-V group compound.

The IV-VI group compound may be selected from the group consisting of a binary compound selected from the group consisting of SnS, SnSe, SnTe, PbS, PbSe, PbTe, and a mixture thereof, a ternary compound selected from the group consisting of SnSeS, SnSeTe, SnSTe, PbSeS, PbSeTe, PbSTe, SnPbS, SnPbSe, SnPbTe, and a mixture thereof, and a quaternary compound selected from the group consisting of SnPbSSe, SnPbSeTe, SnPbSTe, and a mixture thereof.

Examples of the II-IV-V group semiconductor compound may be a ternary compound selected from the group consisting of ZnSnP, ZnSnP₂, ZnSnAs₂, ZnGeP₂, ZnGeAs₂, CdSnP₂, CdGeP₂ and a mixture thereof.

The group IV element may be selected from the group consisting of Si, Ge, and a mixture thereof. The IV group compound may be a binary compound selected from the group consisting of SiC, SiGe, or a mixture thereof.

Each of the elements included in the multi-element compound such as the binary compound, the ternary compound and the quaternary compound may be present at a uniform or non-uniform concentration. That is, the formulas previously described mean a kind of elements included in the compound, and a ratio of the elements in the compound may be different. For example, AgInGaS₂ may mean AgInₓGa₁₋ₓS₂ (where x is a real number between 0 and 1).

In this case, the binary compound, the ternary compound, or the quaternary compound may be present at a uniform concentration in a particle, or may be present in a partially different concentration distribution state in the same particle. In addition, there may be a core/shell structure in which one quantum dot wraps another quantum dot. The core/shell structure may have a concentration gradient in which a concentration of an element present in the shell decreases in a direction getting closer to the core.

In some embodiments, the quantum dot may have the core-shell structure, described above, including a core including a nanocrystal and a shell wrapping the core. The shell of the quantum dot may serve as a protection layer for preventing a chemical change of the core to maintain semiconductor characteristics and/or a charging layer for imparting the quantum dot with electrophoretic characteristics. The shell may have a single layer or a multilayer. Examples of the shell of the quantum dot may include a metal or non-metal oxide, a semiconductor compound, or a combination thereof.

For example, the metal or non-metal oxide may include a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄ and NiO, or a ternary compound such as MgAl₂O₄, CoFe₂O₄, NiFe₂O₄ and CoMn₂O₄, but an embodiment of the inventive concept is not limited thereto.

Also, the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, etc., but an embodiment of the inventive concept is not limited thereto.

The quantum dot may have a full width of half maximum (FWHM) of luminescence wavelength spectrum of about 45 nm or less, preferably, about 40 nm or less, more preferably, about 30 nm or less. Within this range, color purity or color reproducibility may be improved. In addition, light emitted through such a quantum dot is emitted in all directions, and a light view angle may be improved.

In addition, a shape of the quantum dot may have a generally-used shape in the art, without specific limitation. More specifically, the quantum dot having a shape of a sphere, a pyramid, a multi-arm, or a cubic nanoparticle, a nanotube, a nanowire, a nanofiber, a nanoplate-like particle, etc. may be used.

An energy bandgap of the quantum dot may be controlled by controlling a quantum dot size or a ratio of elements in the quantum dot compound to obtain light having various wavelength range in a quantum dot light-emitting layer. Accordingly, a light-emitting element that emits light having various wavelengths may be performed by using the quantum dot (using the quantum dot having different sizes and differing the ratios of the elements in the quantum dot compound). Specifically, the quantum dot size or the ratio of the elements in the quantum dot compound may be selected so as to emit red, green, and/or blue light. In addition, the quantum dots may be configured so as to emit white light by combining various light.

In the light-emitting element ED according to an embodiment illustrated in FIGS. 3 to 6, the electron transport region ETR is provided on the light-emitting layer EML. The electron transport region ETR may include at least one of an hole blocking layer HBL, an electron transport layer ETL or an electron injection layer EIL. However, an embodiment of the inventive concept is not limited thereto.

The electron transport region ETR may have a single layer formed of a single material, a single layer formed of a plurality of different materials, or a multi-layered structure having a plurality of layers formed of a plurality of different materials.

For example, the electron transport region ETR may have a single-layered structure of an electron injection layer EIL or an electron transport layer ETL, or a single-layered structure formed of an electron injection material and an electron transport material. In addition, the electron transport region ETR may have a single-layered structure formed of a plurality of different materials, or a structure of an electron transport layer ETL/an electron injection layer EIL, or a hole blocking layer HBL/an electron transport layer ETL/an electron injection layer EIL stacked from the light-emitting layer EML, without limitation. For example, the electron transport region ETR may have a thickness of about 1000 Å to about 1500 Å.

The electron transport region ETR may be formed using various processes such as vacuum deposition, spin coating, casting, a Langmuir-Blodgett (LB) process, inkjet printing, laser printing, and laser induced thermal imaging (LITI).

The electron transport region ETR may include a compound represented by Formula ET-2:

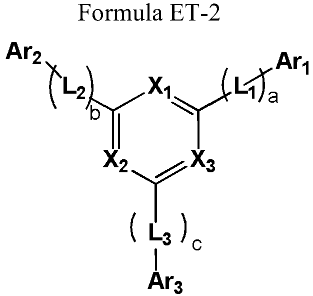

In Formula ET-2, at least one among X₁ to X₃ is N, and the rest thereof is CRₐ. Rₐ may be a hydrogen atom, a deuterium atom, a substituted or unsubstituted alkyl of 1 to 20 carbon atoms, a substituted or unsubstituted aryl group of 6 to 30 ring-forming carbon atoms, or a substituted or unsubstituted heteroaryl group of 2 to 30 ring-forming carbon atoms. Ar₁ to Ar₃ may be each independently a hydrogen atom, a deuterium atom, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms.

In Formula ET-2, a to c may be each independently an integer of 0 to 10. In Formula ET-2, L₁ to L₃ may be each independently a direct linkage, a substituted or unsubstituted arylene group of 6 to 30 ring-forming carbon atoms, or a substituted or unsubstituted heteroarylene group of 2 to 30 ring-forming carbon atoms. When a to c are integers of 2 or more, L₁ to L₃ may be each independently a substituted or unsubstituted arylene group of 6 to 30 ring-forming carbon atoms, or a substituted or unsubstituted heteroarylene group of 2 to 30 ring-forming carbon atoms.

The electron transport region ETR may include an anthracene-based compound. However, an embodiment of the inventive concept is not limited thereto, and the electron transport region ETR may include, for example, tris(8-hydroxyquinolinato)aluminium (Alq3), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazolyl-1-ylphenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), 2-(4-biphenylyl)-5-(4-tert-butylphenyl)-1,3,4-oxadiazole (tBu-PBD), bis(2-methyl-8-quinolinolato-N1,08)-(1,1'-biphenyl-4-olato)aluminium (BAlq), berylliumbis(benzoquinolin-10-olate (Bebq2), 9,10-di(naphthalene-2-yl)anthracene (ADN), 1,3-bis[3,5-di(pyridin-3-yl)phenyl]benzene (BmPyPhB), 4'-(4-(4-(4,6-diphenyl-1,3,5-triazin-2-yl)phenyl)naphthalen-1-yl)-[1,1'-biphenyl]-4-carbonitrile (CNNPTRZ) and a mixture thereof.

According to an embodiment, the electron transport region ETR may include any one among compounds of Compound Group 3.

The electron transport region ETR may include at least one among Compounds ET1 to ET36:

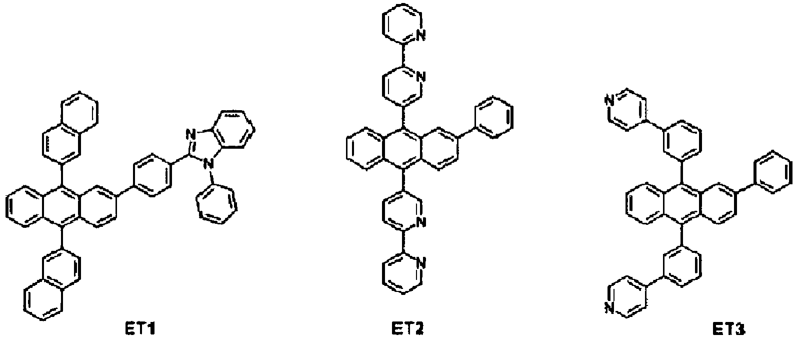

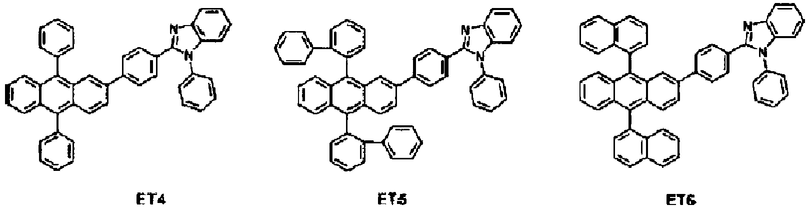

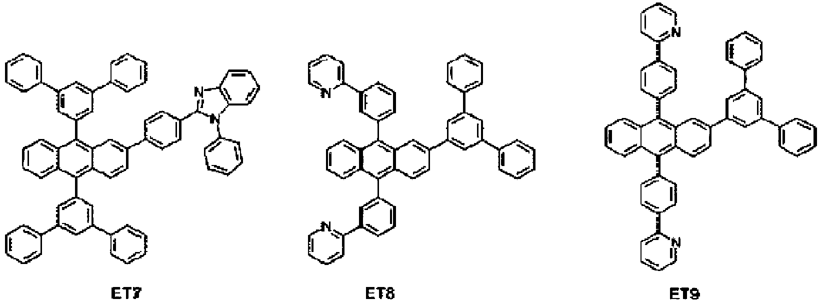

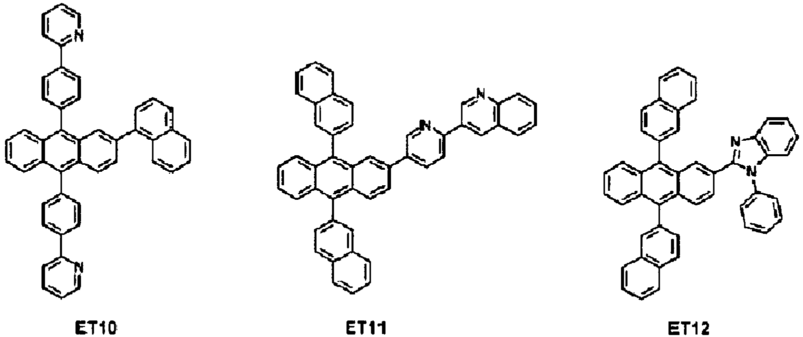

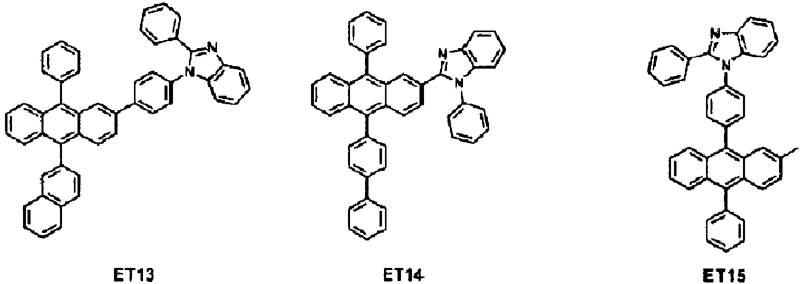

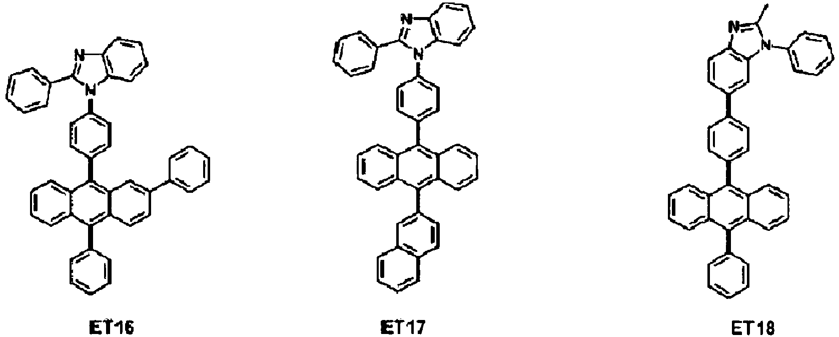

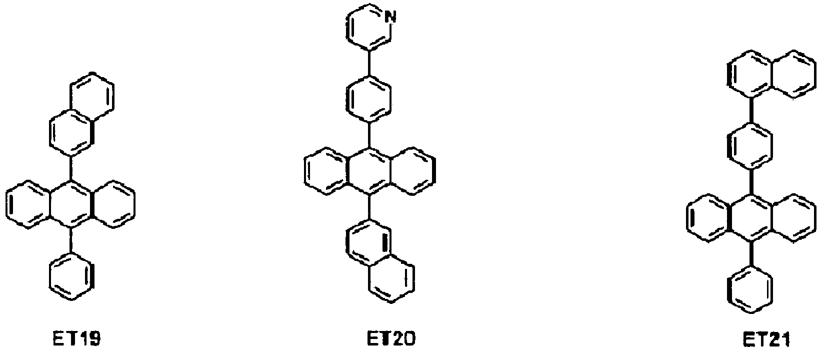

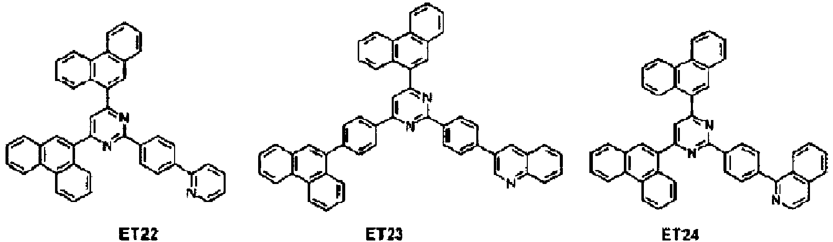

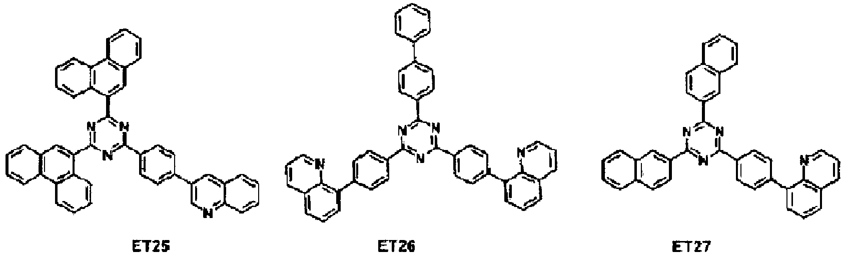

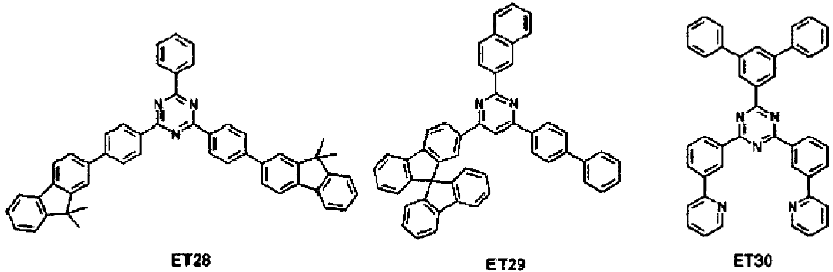

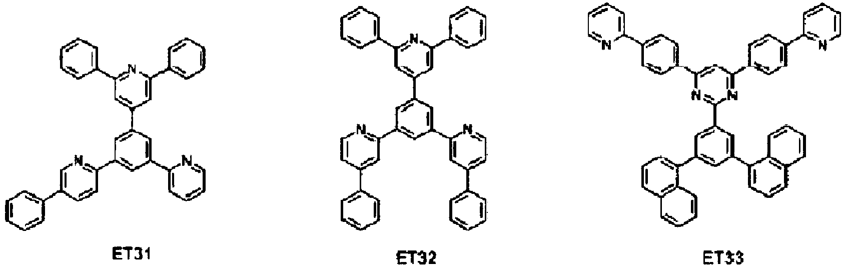

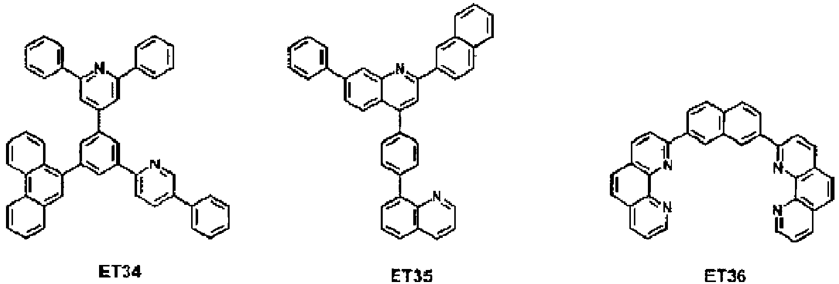

In addition, the electron transport region ETR may include a metal halide such as LiF, NaCl, CsF, RbCl, RbI, CuI and KI, a lanthanum group metal such as Yb, or a co-depositing material of the metal halide and the lanthanum group metal. For example, the electron transport region ETR may include KI:Yb, RbI:Yb, etc., as the co-depositing material. The electron transport region ETR may use a metal oxide such as Li₂O and BaO, 8-hydroxy-lithium quinolate (Liq) or the like, but an embodiment of the inventive concept is not limited thereto. The electron transport region ETR may be also formed of a material in which an electron transport material and an insulating organo metal salt are mixed. The organo metal salt may be a material having an energy band gap of about 4 eV or more. Specifically, for example, the organo metal salt may include metal acetate, metal benzoate, metal acetoacetate, metal acetylacetonate, or metal stearate.

The electron transport region ETR may further include at least one of 2,9-dimethyl-4,7-diphenyl-1,10-phenanthroline (BCP), diphenyl(4-(triphenylsilyl)phenyl)phosphine oxide (TSPO1) or 4,7-diphenyl-1,10-phenanthroline (Bphen) as well as the aforementioned materials, but an embodiment of the inventive concept is not limited thereto.

The electron transport region ETR may include the compounds of the electron transport region previously described in at least one among an electron injection layer EIL, an electron transport layer ETL, and a hole blocking layer HBL.

When the electron transport region ETR includes the electron transport layer ETL, the thickness of the electron transport layer ETL may be from about 100 Å to about 1000 Å, for example, from about 150 Å to about 500 Å. When the thickness of the electron transport layer ETL satisfies the previously described range, satisfactory electron transport characteristics may be obtained without substantial increase of a driving voltage. When the electron transport region ETR includes the electron injection layer EIL, the thickness of the electron injection layer EIL may be from about 1 Å to about 100 Å, or from about 3 Å to about 90 Å. When the thickness of the electron injection layer EIL satisfies the previously described range, satisfactory electron injection properties may be obtained without inducing substantial increase of a driving voltage.

The second electrode EL2 is provided on the electron transport region ETR. The second electrode EL2 may be a common electrode. The second electrode EL2 may be a cathode or an anode, but an embodiment of the inventive concept is not limited thereto. For example, when the first electrode EL1 is an anode, the second electrode EL2 may be a cathode, and when the first electrode EL1 is a cathode, the second electrode EL2 may be an anode.

The second electrode EL2 may be a transmissive electrode, a semi-transmissive electrode, or a reflective electrode. When the second electrode EL2 is the transmissive electrode, the second electrode EL2 may be formed of a transparent metal oxide, for example, indium-tin oxide (ITO), indium-zinc oxide (IZO), zinc oxide (ZnO) indium-tin-zinc oxide (ITZO) or the like.

When the second electrode EL2 is the semi-transmissive electrode or the reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, a compound including the same, or a mixture thereof (for example, AgMg, AgYb, or MgAg). Alternatively, the second electrode EL2 may have a multi-layered structure including the reflective layer or the semi-transmissive layer formed of the previously described material, and a transparent conductive layer formed of indium-tin oxide (ITO), indium-zinc oxide (IZO), zinc oxide (ZnO) indium-tin-zinc oxide (ITZO) or the like. For example, the second electrode EL2 may include the aforementioned metal material, a combination of two or more metal materials selected from the aforementioned metal materials, or an oxide of the aforementioned metal materials.

Although not shown, the second electrode EL2 may be connected to an auxiliary electrode. When the second electrode EL2 is connected to the auxiliary electrode, resistance of the second electrode EL2 may decrease.

A capping layer CPL may be further disposed on the second electrode EL2 of the light-emitting element ED according to an embodiment. The capping layer CPL may be multi-layered or single-layered.

According to an embodiment, the capping layer CPL may be an organic layer or an inorganic layer. For example, when the capping layer CPL includes an inorganic material, the inorganic material may include an alkali metal compound such as LiF, an alkaline earth metal compound such as MgF₂, SiON, SiNₓ, SiO_{y}, etc.

For example, when the capping layer CPL may include an organic material, the organic material may include α-NPD, NPB, TPD, m-MTDATA, Alq3, CuPc, N4,N4,N4',N4'-tetra(biphenyl-4-yl) biphenyl-4,4'-diamine (TPD15), 4,4',4"-tris(carbazol sol-9-yl) triphenylamine (TCTA), etc., or may include an epoxy resin, or acrylate such as methacrylate, but an embodiment of the inventive concept is not limited thereto. The capping layer CPL may include at least one among Compounds P1 to P5:

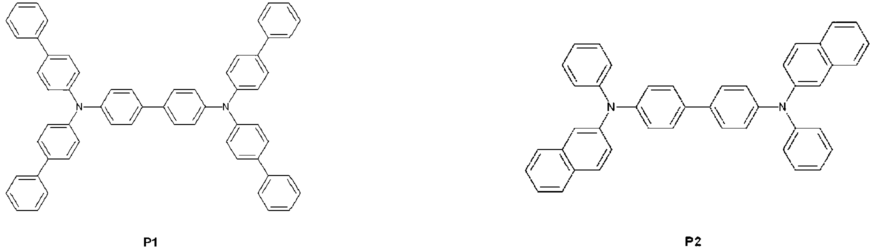

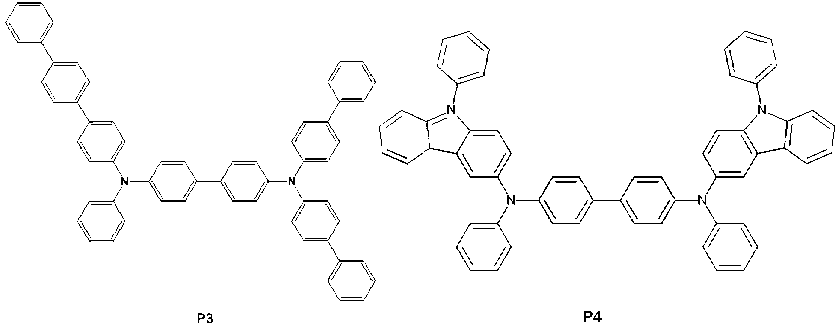

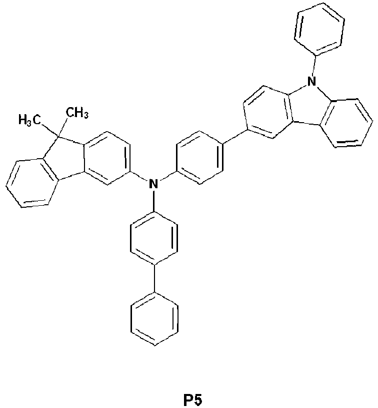

The refractive index of the capping layer CPL may be about 1.6 or more. Specifically, the refractive index of the capping layer CPL with respect to light having a wavelength range of about 550 nm to about 660 nm may be about 1.6 or more.

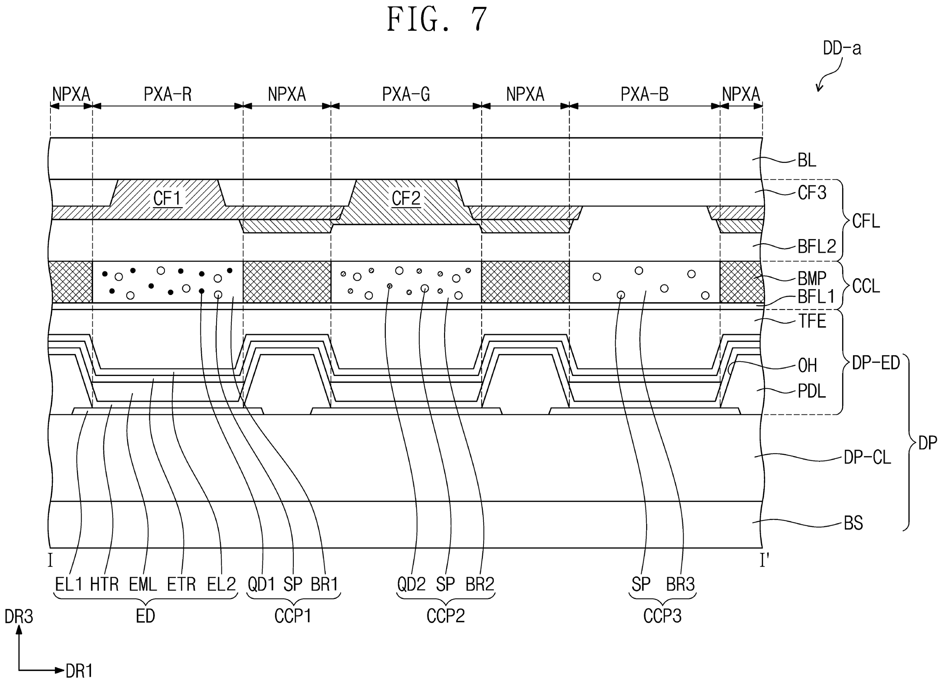

FIG. 7 to FIG. 10 are cross-sectional views on display devices according to embodiments, respectively. Hereinafter, when description is made with reference to FIGS. 7 to 10, duplicate description made in FIGS. 1 to 6 will not be made again, and a difference will be mainly described.

Referring to FIG. 7, a display device DD-a according to an embodiment may include a display panel DP including a display element layer DP-ED, an optical control layer CCL disposed on the display panel DP and a color filter layer CFL. According to an embodiment illustrated in FIG. 7, the display panel DP may include a base layer BS, a circuit layer DP-CL provided on the base layer BS and a display element layer DP-ED, and the display element layer DP-ED may include a light-emitting element ED.

The light-emitting element ED may include a first electrode EL1, a hole transport region HTR disposed on the first electrode EL1, a light-emitting layer EML disposed on the hole transport region HTR, an electron transport region ETR disposed on the light-emitting layer EML, and a second electrode EL2 disposed on the electron transport region ETR. The same structures of the light-emitting elements of FIG. 3 to FIG. 6 may be applied to the structure of the light-emitting element ED illustrated in FIG. 7.

The light-emitting layer EML of the light-emitting element ED included in the display device DD-a according to an embodiment includes the condensed polycyclic compound according to an embodiment previously described.

Referring to FIG. 7, the light-emitting layer EML may be disposed in an opening OH defined in a pixel-defining film PDL. For example, the light-emitting layer EML divided by the pixel-defining film PDL and provided corresponding to each of luminous areas PXA-R, PXA-G and PXA-B may emit light having the same wavelength region. In the display device DD-a according to an embodiment, the light-emitting layer EML may emit blue light. Unlike what is illustrated, according to an embodiment, the light-emitting layer EML may be provided as a common layer for all luminous areas PXA-R, PXA-G and PXA-B.

The optical control layer CCL may be disposed on the display panel DP. The optical control layer CCL may include an optical converter. The optical converter may be a quantum dot or a phosphor. The optical converter may change a wavelength of provided light, and then emit light having a changed wavelength. That is, the optical control layer CCL may be a layer including the quantum dot or the phosphor.

The optical control layer CCL may include a plurality of optical control portions CCP1, CCP2 and CCP3. The optical control portions CCP1, CCP2 and CCP3 may be spaced apart from one another.

Referring to FIG.7, a partition pattern BMP may be disposed between the optical control portions CCP1, CCP2 and CCP3 spaced apart from one another, but an embodiment of the inventive concept is not limited thereto. FIG. 7 shows an illustration of the partition pattern BMP does not overlap the optical control portions CCP1, CCP2 and CCP3, but edges of the optical control portions CCP1, CCP2 and CCP3 may at least partially overlap the partition pattern BMP.

The optical control layer CCL may include a first optical control portion CCP1 including a first quantum dot QD1 converting first light provided from the light-emitting element ED into second light, a second optical control portion CCP2 including a second quantum dot QD2 converting first light into third light, and a third optical control portion CCP3 transmitting first light. According to an embodiment, the first optical control portion CCP1 may provide red light which is the second light, and the second optical control portion CCP2 may provide green light which is the third light. The third optical control portion CCP3 may transmit and provide blue light which is the first light provided from the light-emitting element ED. For example, the first quantum dot QD1 may be a red quantum dot, and the second quantum dot QD2 may be a green quantum dot. On the quantum dots QD1 and QD2, the same contents as those previously described may be applied.

In addition, the optical control layer CCL may further include a scatterer SP. The first optical control portion CCP1 may include the first quantum dot QD1 and the scatterer SP, the second optical control portion CCP2 may include the second quantum dot QD2 and the scatterer SP, and the third optical control portion CCP3 may not include a quantum dot but may include the scatterer SP.

The scatterer SP may be an inorganic particle. For example, the scatterer SP may include at least one among TiO₂, ZnO, Al₂O₃, SiO₂, and hollow silica. The scatterer SP may include any one among TiO₂, ZnO, Al₂O₃, SiO₂, and hollow silica, or may be a mixture of two or more materials selected from TiO₂, ZnO, Al₂O₃, SiO₂, and hollow silica.

Each of the first optical control portion CCP1, the second optical control portion CCP2, and the third optical control portion CCP3 may include base resins BR1, BR2 and BR3 dispersing the quantum dots QD1 and QD2 and the scatterer SP. According to an embodiment, the first optical control portion CCP1 may include the first quantum dot QD1 and the scatterer SP dispersed in the first base resin BR1, the second optical control portion CCP2 may include the second quantum dot QD2 and the scatterer SP dispersed in the second base resin BR2, and the third optical control portion CCP3 may include the scatterer SP dispersed in the third base resin BR3.

The base resins BR1, BR2 and BR3 are mediums in which the quantum dots QD1 and QD2 and the scatterer SP are dispersed, and may be composed of various resin compositions which may be generally referred to as binders. For example, the base resins BR1, BR2 and BR3 may be acrylic resins, urethane-based resins, silicone-based resins, epoxy-based resins, etc. The base resins BR1, BR2 and BR3 may be transparent resins. According to an embodiment, the first base resin BR1, the second base resin BR2 and the third base resin BR3 may be the same as or different from each other.

The optical control layer CCL may include a barrier layer BFL1. The barrier layer BFL1 may serve to block penetration of moisture and/or oxygen (hereinafter, will be referred to as 'humidity/oxygen'). The barrier layer BFL1 may block the optical control portions CCP1, CCP2 and CCP3 from being exposed to humidity/oxygen. The barrier layer BFL1 may cover the optical control portions CCP1, CCP2 and CCP3. In addition, a barrier layer BFL2 may be provided between the optical control portions CCP1, CCP2 and CCP3 and the color filter layer CFL.

The barrier layers BFL1 and BFL2 may include at least one inorganic layer. That is, the barrier layers BFL1 and BFL2 may be formed by including an inorganic material. For example, the barrier layers BFL1 and BFL2 may be formed by including silicon nitride, aluminium nitride, zirconium nitride, titanium nitride, hafnium nitride, tantalum nitride, silicon oxide, aluminium oxide, titanium oxide, tin oxide, cerium oxide and silicon oxynitride or a metal thin film securing light transmittance. The barrier layers BFL1 and BFL2 may further include an organic layer. The barrier layers BFL1 and BFL2 may be composed of a single layer of a plurality of layers.

In the display device DD-a according to an embodiment, the color filter layer CFL may be disposed on the optical control layer CCL. For example, the color filter layer CFL may be disposed directly on the optical control layer CCL. In this case, the barrier layer BFL2 may be omitted.

The color filter layer CFL may include filters CF1, CF2 and CF3. Each of the first to third filters CF1, CF2, and CF3 may be disposed corresponding to each of the red luminous area PXA-R, the green luminous area PXA-G, and the blue luminous area PXA-B.

The color filter layer CFL may include the first filter CF1 transmitting second light, the second filter CF2 transmitting third light, and the third filter CF3 transmitting first light. For example, the first filter CF1 may be a red filter, the second filter CF2 may be a green filter, and the third filter CF3 may be a blue filter. Each of the filters CF1, CF2 and CF3 may include a polymer photosensitive resin and a pigment or dye. The first filter CF1 may include a red pigment or dye, the second filter CF2 may include a green pigment or dye, and the third filter CF3 may include a blue pigment or dye.

An embodiment of the inventive concept is not limited thereto, and the third filter CF3 may not include the pigment or dye. The third filter CF3 may include a polymer photosensitive resin and may not include a pigment or dye. The third filter CF3 may be transparent. The third filter CF3 may be formed of a transparent photosensitive resin.

In addition, according to an embodiment, the first filter CF1 and the second filter CF2 may be yellow filters. The first filter CF1 and the second filter CF2 may be integrally provided without distinction.

Although not shown, the color filter layer CFL may further include a light-blocking portion (not shown). The light-blocking portion may be a black matrix. The light-blocking portion may be formed including an organic light-blocking material or an inorganic light-blocking material including a black pigment or black dye. The light-blocking portion may prevent a light-leak phenomenon, and may demarcate boundaries between adjacent filters CF1, CF2, and CF3.

A base substrate BL may be disposed on the color filter layer CFL. The base substrate BL may be a member providing a base surface on which the color filter layer CFL, the optical control layer CCL, etc., are disposed. The base substrate BL may be a glass substrate, a metal substrate, a plastic substrate, or the like. However, an embodiment of the inventive concept is not limited thereto, and the base substrate BL may be an inorganic layer, an organic layer, or a composite material layer. In addition, unlike what is illustrated, according to an embodiment, the base substrate BL may be omitted.

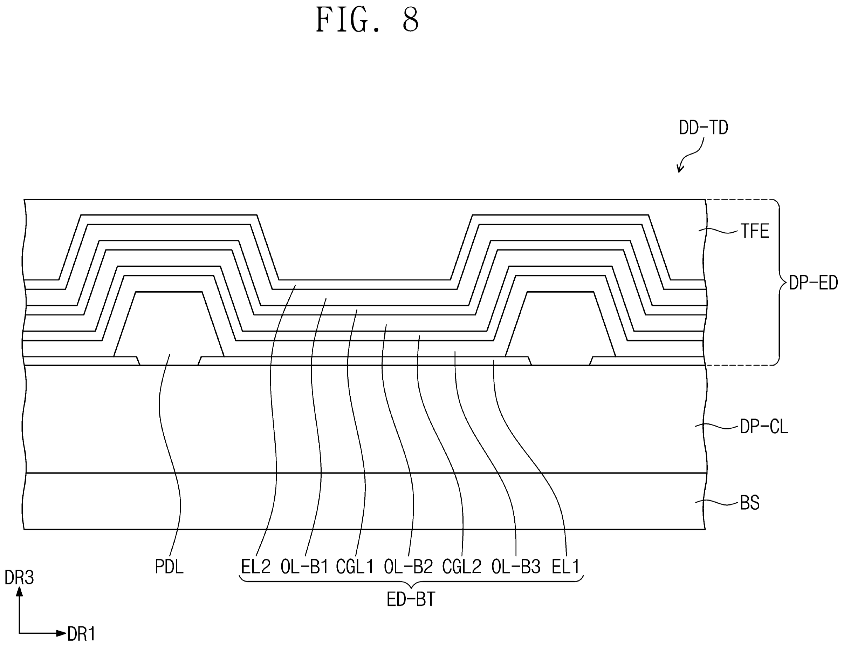

FIG. 8 is a cross-sectional view partially illustrating a display device according to an embodiment. In a display device DD-TD according to an embodiment, a light-emitting element ED-BT may include a plurality of light-emitting structures OL-B1, OL-B2 and OL-B3. The light-emitting element ED-BT may include the first electrode EL1 and the second electrode EL2 facing each other, and a plurality of light-emitting structures OL-B1, OL-B2 and OL-B3 sequentially stacked between the first electrode EL1 and the second electrode EL2 in a thickness direction and provided. Each of the light-emitting structures OL-B1, OL-B2 and OL-B3 may include the light-emitting layer EML (see FIG. 7), and the hole transport region HTR and the electron transport region ETR disposed with the light-emitting layer EML (see FIG. 7) therebetween.

That is, the light-emitting element ED-BT included in the display device DD-TD according to an embodiment may be a light-emitting element having a tandem structure including a plurality of light-emitting layers.

According to an embodiment illustrated in FIG. 8, light emitted by each of the light-emitting structures OL-B1, OL-B2 and OL-B3 may be all blue light. However, an embodiment of the inventive concept is not limited thereto, the light emitted by each of the light-emitting structures OL-B1, OL-B2 and OL-B3 may have different wavelength regions. For example, the light-emitting element ED-BT including the plurality of light-emitting structures OL-B1, OL-B2 and OL-B3 that emit light having the different wavelength regions may emit white light.

Charge generation layers CGL1 and CGL2 may be disposed between the light-emitting structures OL-B1, OL-B2 and OL-B3 next to each other. The charge generation layers CGL1 and CGL2 may include a P-type charge generation layer and/or an N-type charge generation layer.

At least one among the light-emitting structures OL-B1, OL-B2 and OL-B3 included in the display device DD-TD according to an embodiment includes the condensed polycyclic compound according to an embodiment previously described. That is, at least one among the plurality of light-emitting layers included in the light-emitting element ED-BT includes the condensed polycyclic compound according to an embodiment.

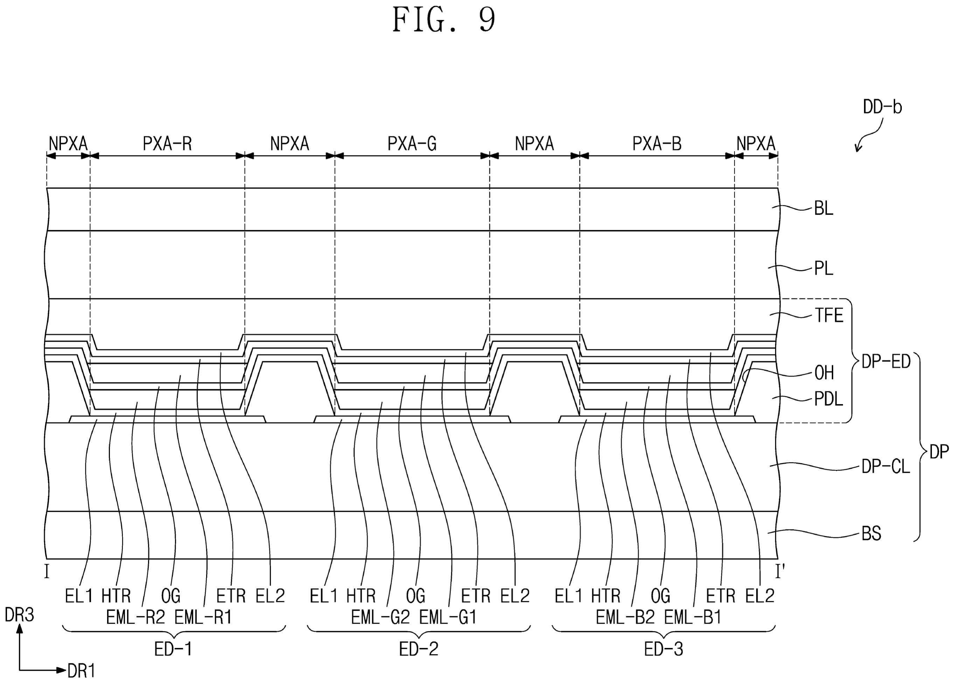

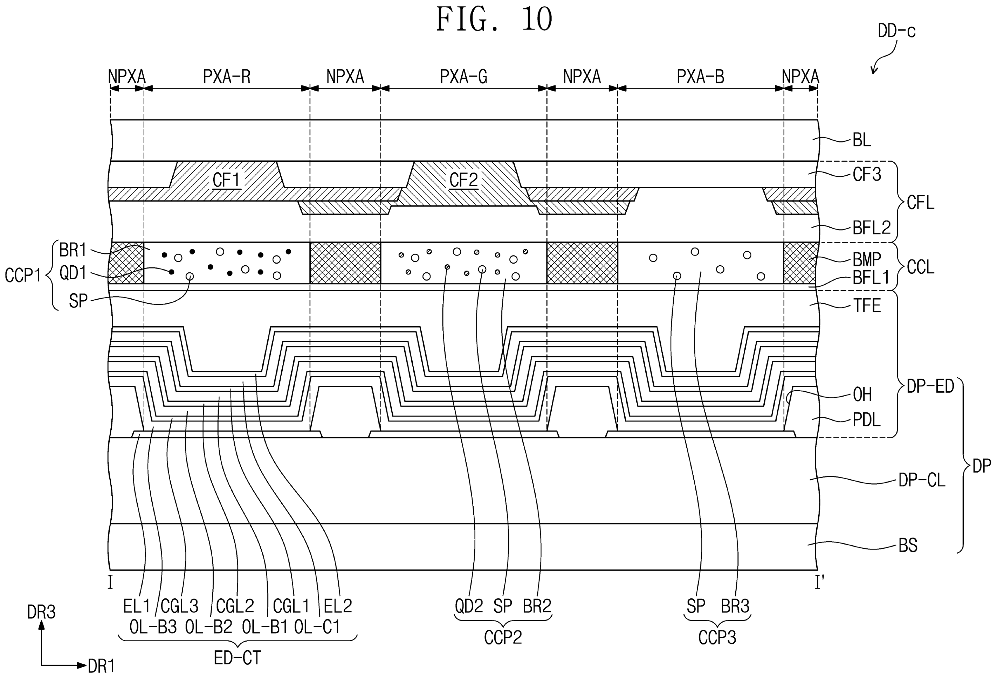

FIG. 9 is a cross-sectional view illustrating a display device according to an embodiment of the inventive concept. FIG. 10 is a cross-sectional view illustrating a display device according to an embodiment of the inventive concept.

Referring to FIG. 9, a display device DD-b according to an embodiment may include light-emitting elements ED-1, ED-2, and ED-3 in which two light-emitting layers are stacked. The display device according to an embodiment illustrated in FIG. 9 has a difference that each of the first to third light-emitting elements ED-1, ED-2, and ED-3 include two light-emitting layers stacked in a thickness direction, compared with the display device DD according to an embodiment illustrated in FIG. 2. The two light-emitting layers of each of the first to third light-emitting elements ED-1, ED-2, and ED-3 may emit light having the same wavelength region as each other.

The first light-emitting element ED-1 may include a first red light-emitting layer EML-R1 and a second red light-emitting layer EML-R2. The second light-emitting element ED-2 may include a first green light-emitting layer EML-G1 and a second green light-emitting layer EML-G2. In addition, the third light-emitting element ED-3 may include a first blue light-emitting layer EML-B1 and a second blue light-emitting layer EML-B2. An auxiliary light-emitting portion OG may be disposed between the first red light-emitting layer EML-R1 and the second red light-emitting layer EML-R2, between the first green light-emitting layer EML-G1 and the second green light-emitting layer EML-G2, and between the first blue light-emitting layer EML-B1 and the second blue light-emitting layer EML-B2.

The auxiliary light-emitting portion OG may include a single layer or a plurality of layers. The auxiliary light-emitting portion OG may include a charge generation layer. More specifically, the auxiliary light-emitting portion OG may include an electron transport region, a charge generation layer and a hole transport region sequentially stacked. The auxiliary light-emitting portion OG may be provided as a common layer in all first to third light-emitting elements ED-1, ED-2, and ED-3. However, an embodiment of the inventive concept is not limited thereto, and the auxiliary light-emitting portion OG may be patterned in the opening OH defined in the pixel-defining film PDL and may be provided.

The first red light-emitting layer EML-R1, the first green light-emitting layer EML-G1 and the first blue light-emitting layer EML-B1 may be disposed between the auxiliary light-emitting portion OG and the electron transport region ETR. The second red light-emitting layer EML-R2, the second green light-emitting layer EML-G2 and the second blue light-emitting layer EML-B2 may be disposed between the hole transport region HTR and the auxiliary light-emitting portion OG.

That is, the first light-emitting element ED-1 may include the first electrode EL1, the hole transport region HTR, the second red light-emitting layer EML-R2, the auxiliary light-emitting portion OG, the first red light-emitting layer EML-R1, the electron transport region ETR and the second electrode EL2 sequentially stacked. The second light-emitting element ED-2 may include the first electrode EL1, the hole transport region HTR, the second green light-emitting layer EML-G2, the auxiliary light-emitting portion OG, the first green light-emitting layer EML-G1, the electron transport region ETR and the second electrode EL2 sequentially stacked. The third light-emitting element ED-3 may include the first electrode EL1, the hole transport region HTR, the second blue light-emitting layer EML-B2, the auxiliary light-emitting portion OG, the first blue light-emitting layer EML-B1, the electron transport region ETR and the second electrode EL2 sequentially stacked.

An optical auxiliary layer PL may be disposed on the display element layer DP-ED. The optical auxiliary layer PL may include a polarization layer. The optical auxiliary layer PL may be disposed on the display panel DP to control reflected light in the display panel DP by external light. Unlike what is illustrated, the optical auxiliary layer PL may be omitted in the display device according to an embodiment.

At least one light-emitting layer included in a display device DD-b according to an embodiment illustrated in FIG. 9 may include the condensed polycyclic compound according to an embodiment previously described. For example, according to an embodiment, at least one of the first blue light-emitting layer EML-B1 or the second blue light-emitting layer EML-B2 may include the condensed polycyclic compound according to an embodiment.

Unlike FIGS. 8 and 9, FIG. 10 shows an illustration of a display device DD-c that includes four light-emitting structures OL-B1, OL-B2, OL-B3 and OL-C1. A light-emitting element ED-CT may include the first electrode EL1 and the second electrode EL2 facing each other, and the first to fourth light-emitting structures OL-B1, OL-B2, OL-B3 and OL-C1 sequentially stacked between the first electrode EL1 and the second electrode EL2 in a thickness direction. Charge generation layers CGL1, CGL2 and CGL3 may be disposed between the first to fourth light-emitting structures OL-B1, OL-B2, OL-B3 and OL-C1. The first to third light-emitting structures OL-B1, OL-B2 and OL-B3 among the four light-emitting structures may emit blue light, and the fourth light-emitting structure OL-C1 may emit green light. However, an embodiment of the inventive concept is not limited thereto, and the first to fourth light-emitting structures OL-B1, OL-B2, OL-B3 and OL-C1 may emit light having different wavelength regions.

The charge generation layers CGL1, CGL2 and CGL3 disposed between the light-emitting structures OL-B1, OL-B2, OL-B3 and OL-C1 next to each other may include a P-type charge generation layer and/or an N-type charge generation layer.

The light-emitting structures OL-B1, OL-B2, OL-B3 and OL-C1 included in the display device DD-c according to an embodiment may include the condensed polycyclic compound according to an embodiment previously described. For example, at least one among the first to third light-emitting structures OL-B1, OL-B2 and OL-B3 according to an embodiment may include the condensed polycyclic compound according to an embodiment previously described.

The light-emitting element ED according to an embodiment of the inventive concept includes the polycyclic compound according to an embodiment represented by Formula 1 previously described in at least one functional layer disposed between the first electrode EL1 and the second electrode EL2 to show excellent luminous efficiency and improved lifespan characteristics. For example, the polycyclic compound according to an embodiment is included in the light-emitting layer EML of the light-emitting element ED according to an embodiment, and thus the light-emitting element according to an embodiment may show long lifespan characteristics.

According to an embodiment, an electronic apparatus may include a display device including a plurality of light-emitting elements, and a control portion that controls the display device. The electronic apparatus according to an embodiment may be an apparatus activated in response to an electrical signal. The electronic apparatus may include display devices according to various embodiments. For example, the electronic apparatus may include not only a large display device such as a television, a monitor, or an exterior billboard, but also a small-and-medium display device such as a personal computer, a notebook computer, a personal digital terminal, a display device for a vehicle, a game console, a portable electronic device, and a camera.

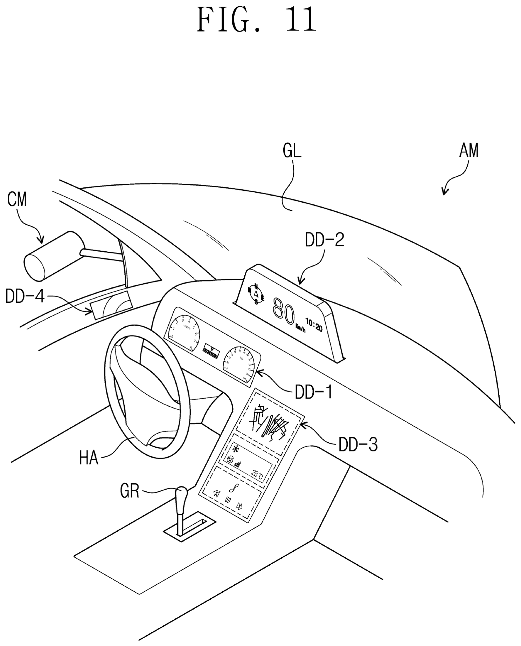

FIG. 11 is a diagram illustrating a vehicle AM in which first to fourth display devices DD-1, DD-2, DD-3, and DD-4 are disposed. At least one among the first to fourth display devices DD-1, DD-2, DD-3, and DD-4 may include the same configuration as the display device DD, DD-TD, DD-a, DD-b or DD-c according to an embodiment described with reference to FIGS. 1, 2, and 7 to 10.

FIG. 11 illustrates a car as the vehicle AM, but this is an example, and the first to fourth display devices DD-1, DD-2, DD-3, and DD-4 may be disposed on another transportation means such as a bicycle, a motor cycle, a train, a ship, or an airplane. In addition, at least one among the first to fourth display devices DD-1, DD-2, DD-3, and DD-4 identically including configuration of the display devices DD, DD-TD, DD-a, DD-b and DD-c according to an embodiment may be adopted in a personal computer, a notebook computer, a personal digital terminal, a game console, a portable electronic device, a television, a monitor, an exterior billboard, and the like. In addition, these are suggested as embodiments, and may be display devices adopted in another electronic apparatus as long as not departing from the inventive concept.

At least one among the first to fourth display devices DD-1, DD-2, DD-3, and DD-4 includes the light-emitting element ED according to an embodiment described with reference to FIGS. 3 to 6. The light-emitting element ED according to an embodiment may include the condensed polycyclic compound according to an embodiment. At least one among the first to fourth display devices DD-1, DD-2, DD-3, and DD-4 may include the light-emitting element ED including the condensed polycyclic compound according to an embodiment to improve display lifespan.

Referring to FIG. 11, the vehicle AM may include a gear GR and a handle HA for operating the vehicle AM. In addition, the vehicle AM may include a front window GL disposed toward a driver.

The first display device DD-1 may be disposed in a first region overlapping the handle HA. For example, the first display device DD-1 may be a digital cluster that displays first information of the vehicle AM. The first information may include a first scale showing a driving speed of the vehicle AM, a second scale showing a revolution of an engine (that is, revolutions per minute (RPM)), and an image showing a fuel status. The first scale and the second scale may be displayed as digital images.

The second display device DD-2 may be disposed in a second region facing a driver's seat and overlapping the front window GL. The driver's seat may be a seat in which the handle HA is disposed. For example, the second display device DD-2 may be a head up display (HUD) that displays second information of the vehicle AM. The second display device DD-2 may be optically transparent. The second information may include a digital number that shows the driving speed of the vehicle AM, and may further include information such as current time. Unlike what is illustrated, the second information of the second display device DD-2 may be projected onto the front window GL and may be displayed.

The third display device DD-3 may be disposed in a third region adjacent to the gear GR. For example, the third display device DD-3 may be a center information display (CID) for a vehicle disposed between the driver's seat and a passenger's seat, and displaying third information. The passenger's seat may be a seat spaced apart from the driver's seat with the gear GR therebetween. The third information may include a road status (for example, navigation information), playing music or a radio, playing a dynamic video (or an image), information on a temperature or the like inside the vehicle AM.

The fourth display device DD-4 may be disposed in a fourth region spaced apart from the handle HA and the gear GR, and adjacent to a side portion of the vehicle AM. For example, the fourth display device DD-4 may be a digital side-mirror that displays fourth information. The fourth display device DD-4 may display an exterior video of the vehicle AM captured by a camera module CM disposed outside the vehicle AM. The fourth information may include the exterior video of the vehicle AM.

The first to fourth information previously described are examples, and the first to fourth display devices DD-1, DD-2, DD-3, and DD-4 may further display information inside and outside the vehicle AM. The first to fourth information may include different information. However, an embodiment of the inventive concept is not limited thereto, and some of the first to fourth information may include the same information as each other.

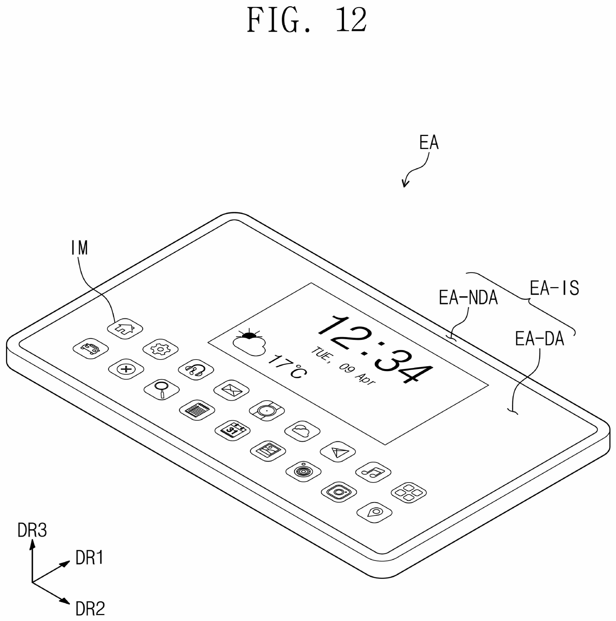

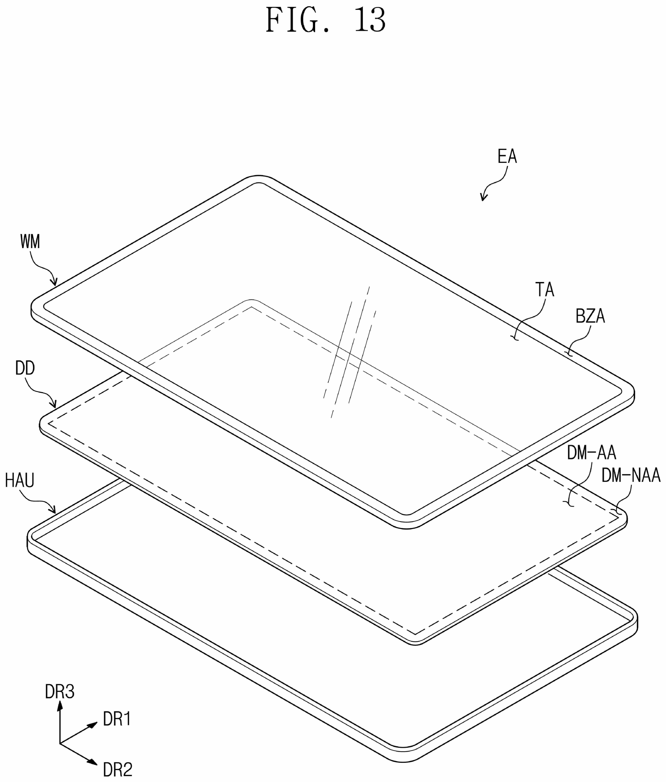

FIG. 12 is a perspective view showing an electronic apparatus of an embodiment. FIG. 13 is an exploded perspective view showing an electronic apparatus of an embodiment.

The electronic apparatus EA may display an image IM through a display surface EA-IS. The image IM may include a dynamic image as well as a static image. The display surface EA-IS may be parallel to a plane defined by a first direction axis DR1 and a second direction axis DR2. FIG. 12 illustrates an electronic apparatus EA having a flat display surface EA-IS, but an embodiment of the inventive concept is not limited thereto. For example, the electronic apparatus EA may include a curved display surface or a three-dimensional display surface. The three-dimensional display surface may include a plurality of display areas indicating different directions from each other.

The display surface EA-IS may include a display area EA-DA and a non-display area EA-NDA. The electronic apparatus EA may display an image IM through the display area EA-DA.

The non-display area EA-NDA may have a predetermined color. The non-display area EA-NDA may be adjacent to the display area EA-DA. The non-display area EA-NDA may surround the display area EA-DA. Accordingly, the shape of the display area EA-DA may be substantially defined by the non-display area EA-NDA. However, FIG. 12 is an illustration, and the non-display area EA-NDA may be disposed adjacent to only one side of the display area EA-DA or may be omitted.

Referring to FIG. 13, the electronic apparatus EA may include a display device DD. In addition, the electronic apparatus EA may further include a window member WM and a housing HAU.

The window member WM may cover the entire outer side of the electronic apparatus EA. The window member WM may include a transparent area TA and a bezel area BZA. The front surface of the window member WM including the transparent area TA and the bezel area BZA may correspond to the front surface of the electronic apparatus EA. The transparent area TA may correspond to the display area EA-DA of the electronic apparatus EA illustrated in FIG. 12, and the bezel area BZA may correspond to the non-display area EA-NDA of the electronic apparatus EA illustrated in FIG. 12.

The transparent area TA may be an optically transparent area. The bezel area BZA may be an area having a relatively low light transmittance compared to the transparent area TA. The bezel area BZA may have a predetermined color. The bezel area BZA may be adjacent to the transparent area TA and may surround the transparent area TA. The bezel area BZA may define the shape of the transparent area TA. However, an embodiment of the inventive concept is not limited thereto, and the bezel area BZA may be disposed adjacent to only one side of the transparent area TA, or a portion thereof may be omitted.

The housing HAU may include a material having relatively high rigidity. For example, the housing HAU may include a frame and/or a plate made of glass, plastic, or metal. The frames and/or plates may be provided in multiple pieces. The housing HAU may provide a predetermined receiving space. The display device DD may be accommodated in the receiving space and protected from external impact.

The display device DD may include the same configurations as those of at least one of the display devices DD, DD-TD, DD-a, DD-b, and DD-c of the embodiments described with reference to FIGS. 1, 2, and 7 to 10. The display device DD may include the light emitting element ED described with reference to FIGS. 3 to 6. Accordingly, the electronic apparatus EA including the display device DD according to an embodiment may exhibit excellent reliability.

An active area DM-AA and a peripheral area DM-NAA may be defined in the display device DD. The active area DM-AA may overlap the display area EA-DA illustrated in FIG. 12, and the peripheral area DM-NAA may overlap the non-display area EA-NDA illustrated in FIG. 12.

The active area DM-AA may be an area activated according to an electrical signal. The peripheral area DM-NAA may be an area positioned adjacent to at least one side of the active area DM-AA. The active area DM-AA may include the non-light emitting area NPXA and light emitting areas PXA-R, PXA-G and PXA-B, illustrated in FIG. 1. The peripheral area DM-NAA may be disposed to surround the active area DM-AA. However, an embodiment of the inventive concept is not limited thereto, and unlike what is shown, some of the peripheral areas DM-NAA may be omitted. A driving circuit or driving wiring for driving the active area DM-AA may be disposed in the peripheral area DM-NAA.

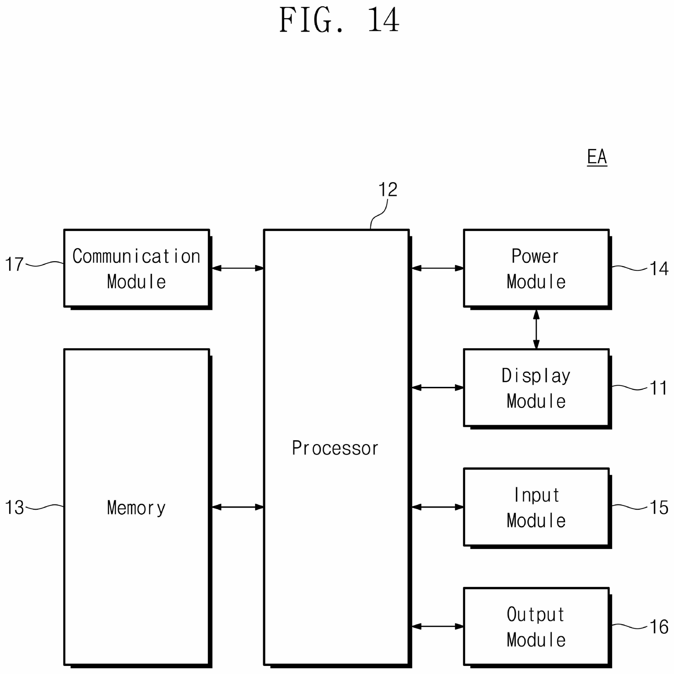

The electronic apparatus EA according to an embodiment includes the display device previously described, and may further include a module or device having an additional function, in addition to the display device. FIG. 14 is a block diagram of an electronic apparatus according to an embodiment. Referring to FIG. 14, an electronic apparatus EA according to an embodiment may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), and a controller. Data information necessary for the operation of the processor 12 or the display module 11 may be stored in the memory 13. If the processor 12 executes an application stored in the memory 13, an image data signal and/or an input control signal are transmitted to the display module 11, and the display module 11 may process the received signal and output image information through a display screen.

The power module 14 may include a power supply module such as a power adapter or a battery device, and a power conversion module that converts the power supplied by the power supply module to generate power necessary for the operation of the electronic apparatus EA.

The display module 11 may include at least some configurations of the display devices DD, DD-TD, DD-a, DD-b, and DD-c, described with reference to FIGS. 1, 2, and 7 to 10. For example, the display module 11 may include a base layer BS, a circuit layer DP-CL, and a display element layer DP-ED among the configurations of the display devices DD, DD-TD, DD-a, DD-b, and DD-c, described with reference to FIGS. 1, 2, and 7 to 10. In addition, the display module 11 may further include at least one of an optical layer PP (FIG. 2), a optical control layer CCL (FIGS. 7 and 10), a color filter layer CFL (FIGS. 7 and 10), and an optical auxiliary layer PL (FIG. 9).

The electronic apparatus EA may further include an input module 15, a non-image output module 16, and/or a communication module 17.

The input module 15 may provide input information to the processor 12 and/or the display module 11. The input module 15 may include various sensor modules as well as physical buttons, a keyboard, and a microphone. Examples of sensor module include touch sensors, pressure sensors, distance sensors, position sensors, digitizers, motion recognition sensors, camera sensors, photodetector, photoelectric conversion sensors, temperature sensors, and biosensors such as blood pressure sensors, blood sugar sensors, electrocardiogram sensors, and heart rate sensors.

The non-image output module 16 may receive information other than images transmitted from the processor 12 and provide the information to the user. Examples of the non-image output module 16 include an audio module, a haptic module, a light emitting module, and the like, and may include other electronic device-specific functional modules (e.g., a cooling module of a refrigerator, and the like).

The communication module 17 is a module responsible for transmitting and receiving information between the electronic apparatus EA and an external device, and may include a receiving part and a transmitting part. The communication module 17 may include various wireless communication modules such as a mobile communication module, a Wi-Fi module, and a Bluetooth module, or various wired communication modules.

At least one of the configurations of the electronic apparatus EA previously described may be included in the previously described display device (at least one of DD, DD-TD, DD-a, DD-b, and DD-c, FIGS. 1, 2, and 7 to 10) according to an embodiment. In addition, some of the individual modules functionally included in one module may be included in the display device, and other modules may be provided separately from the display device. For example, the display device may include the display module 11, and the processor 12, the memory 13, and the power module 14 may be provided in the form of other devices within the electronic apparatus EA other than the display device.

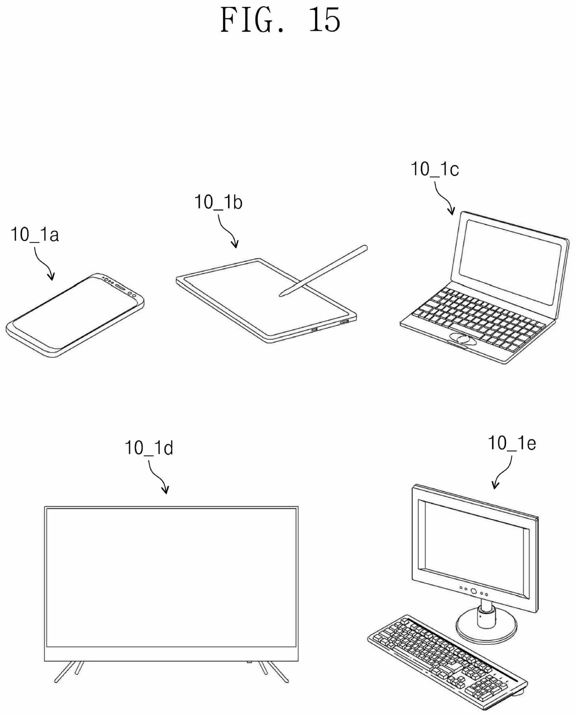

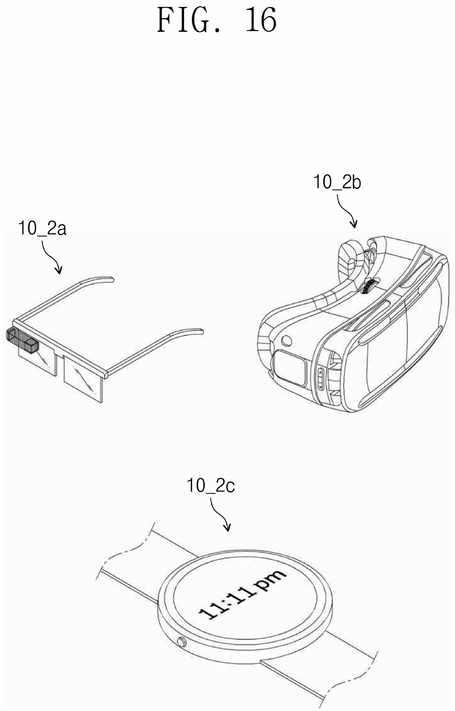

FIGS. 15 and 16 are schematic diagrams showing electronic apparatuses according to various embodiments. Referring to FIGS. 15 and 16, various electronic apparatuses to which a display device (at least one of DD, DD-TD, DD-a, DD-b, and DD-c, FIGS. 1, 2, and 7 to 10) according to an embodiment is applied may include not only image display electronic apparatuses such as a smart phone 10_1a, a tablet PC 10_1b, a laptop 10_1c, a TV 10_1d, and a monitor for a desk 10_1e, but also wearable electronic apparatuses including display modules such as smart glasses 10_2a, a head-mounted display 10_2b, and a smart watch 10_2c. However, these are embodiments, and the electronic apparatus according to an embodiment is not limited thereto.

Hereinafter, the condensed polycyclic compound according to an embodiment of the inventive concept and the light-emitting element according to an embodiment will be specifically described referring to Examples and Comparative Examples. addition, Examples below are only examples helping understand the inventive concept, and the scope of the inventive concept is not limited thereto.

### Examples

### 1. Synthesis of Condensed Polycyclic Compound

First, a synthetic method of the condensed polycyclic compound according to an embodiment will be specifically described by exemplifying the synthetic methods of Compound B-11, Compound G-7, Compound C-21, Compound C-16, Compound C-19, and Compound 1-3. In addition, the synthetic methods of the condensed polycyclic compounds described below are non-limiting embodiments.

### (1) Synthesis of Compound B-11

For example, Condensed Polycyclic Compound B-11 according to an embodiment may be synthesized by the following reaction.

### (Synthesis of Intermediate B-11-6)

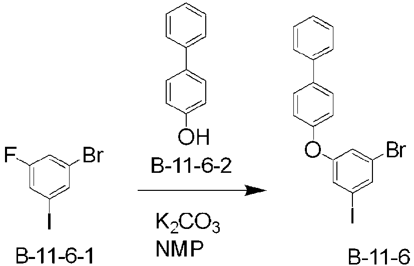

Intermediate B-11-6-1 (200 mmol), Intermediate B-11-6-2 (220 mmol), and K₂CO₃ (350 mmol) were added to a three-necked flask to Ar-substitution, 200 ml of N-methyl-2-pyrrolidone (NMP) was added and the flask was stirred at 150 °C for 6 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 154 mmol (77% yield) of the white solid. It was confirmed that Intermediate B-11-6 was obtained by confirming a molecular weight of 451 through FAB-MS measurement of an obtained purified material.

### (Synthesis of Intermediate B-11-3)

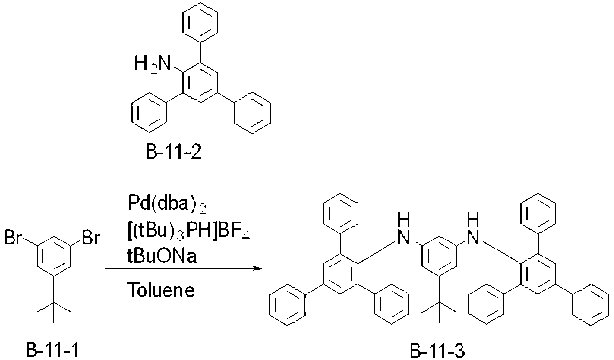

Intermediate B-11-1 (150 mmol), Intermediate B-11-2 (300 mmol), tBuONa (600 mmol), Pd(dba)₂ (15 mmol), and [(tBu)₃PH]BF₄ (30 mmol) were added to a three-necked flask to Ar-substitution, 1000 ml of toluene was added and the flask was stirred at 100 °C for 3 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 145 mmol (97% yield) of the white solid. It was confirmed that Intermediate B-11-3 was obtained by confirming a molecular weight of 773 through FAB-MS measurement of an obtained purified material.

### (Synthesis of Intermediate B-11-5)

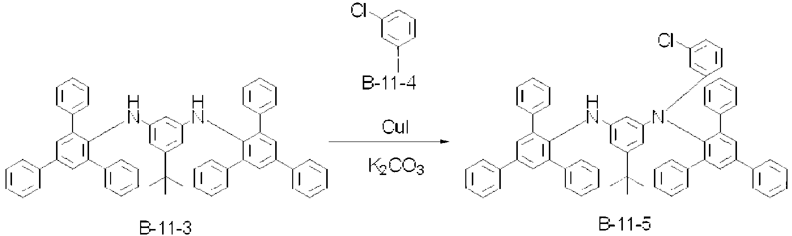

Successively, Intermediate B-11-3 (145 mmol), Intermediate B-11-4 (435 mmol), K₂CO₃ (1015 mmol) and CuI (145 mmol) were added to a three-necked flask to Ar-substitution, and the flask was stirred at 210 °C for 24 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 80 mmol (55% yield) of the white solid. It was confirmed that Intermediate B-11-5 was obtained by confirming a molecular weight of 883 through FAB-MS measurement of an obtained purified material.

### (Synthesis of Intermediate B-11-7)

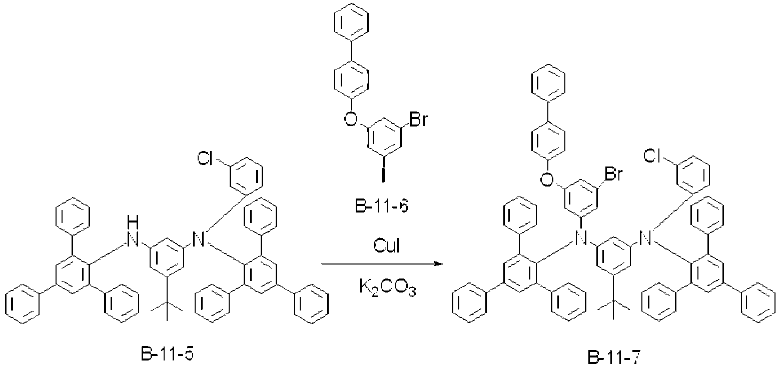

Intermediate B-11-5 (80 mmol), Intermediate B-11-6 (154 mmol), K₂CO₃ (240 mmol) and CuI (80 mmol) were added to a three-necked flask to Ar-substitution, and the flask was stirred at 210 °C for 5 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 61 mmol (76% yield) of the white solid. It was confirmed that Intermediate B-11-7 was obtained by confirming a molecular weight of 1207 through FAB-MS measurement of an obtained purified material.

### (Synthesis of Intermediate B-11-9)

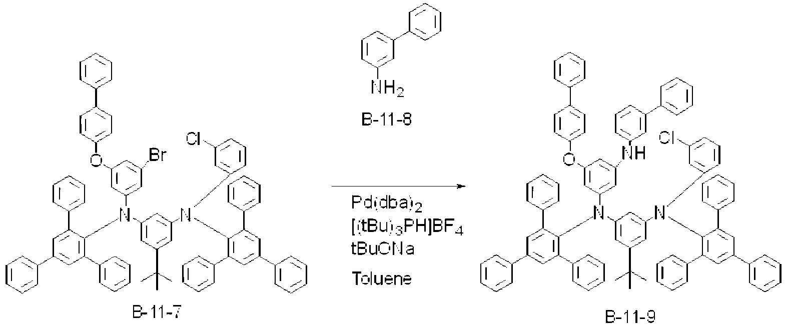

Intermediate B-11-7 (61 mmol), Intermediate B-11-8 (65 mmol), tBuONa (65 mmol), Pd(dba)₂ (6 mmol), and [(tBu)₃PH]BF₄ (12 mmol) were added to a three-necked flask to Ar-substitution, 200 ml of toluene was added and the flask was stirred at 100 °C for 6 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 58 mmol (95% yield) of the white solid. It was confirmed that Intermediate B-11-9 was obtained by confirming a molecular weight of 1295 through FAB-MS measurement of an obtained purified material.

### (Synthesis of Intermediate B-11-10)

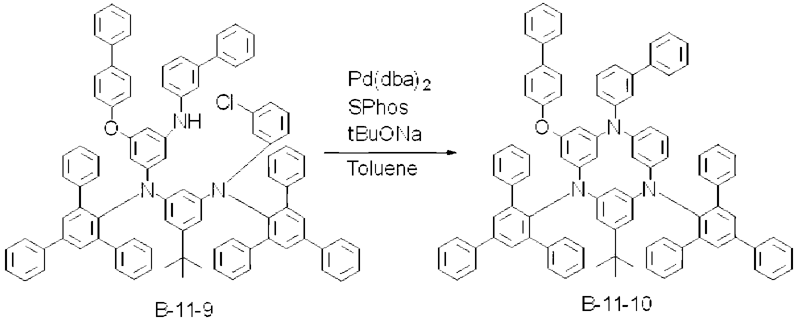

tBuONa (87 mmol), Pd(dba)₂ (8 mmol), and SPhos (16 mmol) were added to a three-necked flask to Ar-substitution, 1000 ml of toluene was added and the flask was stirred at 100 °C. A solution in which Intermediate B-11-9 (58 mmol) was dissolved in 200 ml of toluene was dropwise added to the stirred solution, and then was stirred for 4 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 22 mmol (38% yield) of the white solid. It was confirmed that Intermediate B-11-10 was obtained by confirming a molecular weight of 1259 through FAB-MS measurement of an obtained purified material.

### (Synthesis of Compound B-11)

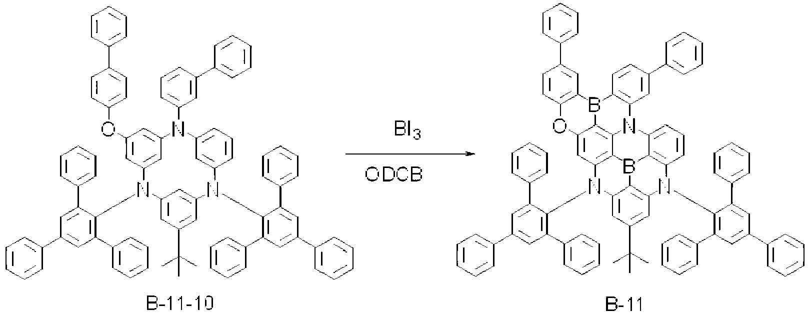

Intermediate B-11-10 (22 mmol) was added to a three-necked flask to Ar-substitution, 20 ml of 1,2-dichlorobenzene (ODCB) was added and dissolved, BI₃ (88 mmol) was added and the flask was stirred at 140 °C for 2 hours. The reaction solution was dispersed and cleaned using a large amount of acetonitrile, and the solid was recovered by filtration. The obtained crude product was purified by silica gel column chromatography (a hexane/dichloromethane mixed solvent) and recrystallization (an ethanol/toluene mixed solvent) to obtain 15 mmol (68% yield) of the yellow solid. It was confirmed that Compound B-11 was obtained by confirming a molecular weight of 1247 through FAB-MS measurement of an obtained purified material.

### (2) Synthesis of Compound G-7

For example, Condensed Polycyclic Compound G-7 according to an embodiment may be synthesized by the following reaction.

### (Synthesis of Intermediate a)

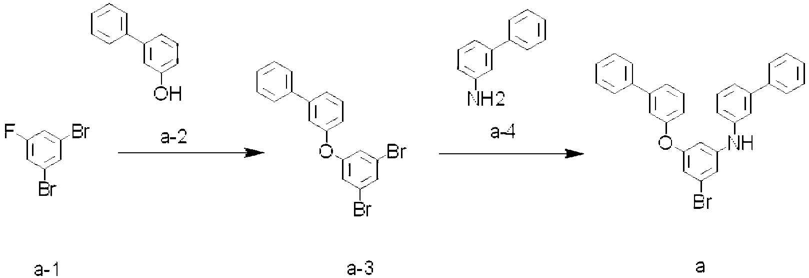

Intermediate a-1 (300 mmol), Intermediate a-2 (330 mmol), and K₂CO₃ (600 mmol) were added to a three-necked flask to Ar-substitution, 200 ml of N-methyl-2-pyrrolidone (NMP) was added and the flask was stirred at 150 °C for 24 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 243 mmol (81% yield) of the white solid. It was confirmed that Intermediate a-3 was obtained by confirming a molecular weight of 404 through FAB-MS measurement of an obtained purified material.

Successively, Intermediate a-3 (243 mmol), Intermediate a-4 (243 mmol), tBuONa (365 mmol), Pd(dba)₂ (20 mmol), and [(tBu)₃PH]BF₄ (40 mmol) were added to a three-necked flask to Ar-substitution, 1000 ml of toluene was added and the flask was stirred at 100 °C for 1 hour. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 146 mmol (60% yield) of the white solid. It was confirmed that Intermediate a was obtained by confirming a molecular weight of 492 through FAB-MS measurement of an obtained purified material.

### (Synthesis of Intermediate G-7-3)

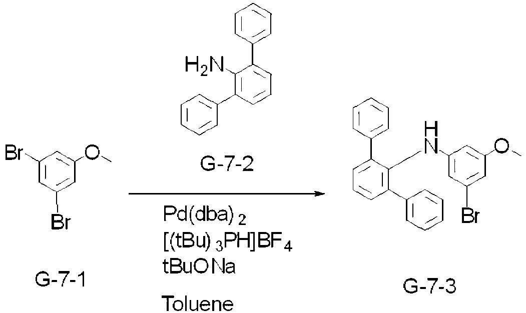

Intermediate G-7-1 (400 mmol), Intermediate G-7-2 (200 mmol), tBuONa (220 mmol), Pd(dba)₂ (30 mmol), and [(tBu)₃PH]BF₄ (60 mmol) were added to a three-necked flask to Ar-substitution, 1000 ml of toluene was added and the flask was stirred at 100 °C for 8 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 157 mmol (79% yield) of the white solid. It was confirmed that Intermediate G-7-3 was obtained by confirming a molecular weight of 430 through FAB-MS measurement of an obtained purified material.

### (Synthesis of Intermediate G-7-5)

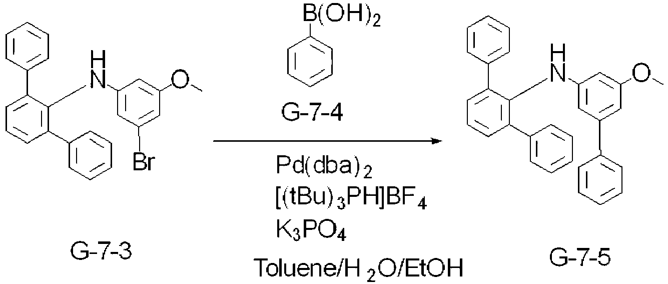

Intermediate G-7-3 (157 mmol), Intermediate G-7-4 (200 mmol), K₃PO₄ (220 mmol), Pd(dba)₂ (30 mmol), and [(tBu)₃PH]BF₄ (60 mmol) were added to a three-necked flask to Ar-substitution, 1000 ml of toluene, 20 ml of EtOH, and 20 ml of H₂O were added and the flask was stirred at 100 °C for 3 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 145 mmol (92% yield) of the white solid. It was confirmed that Intermediate G-7-5 was obtained by confirming a molecular weight of 428 through FAB-MS measurement of an obtained purified material.

### (Synthesis of Intermediate G-7-6)

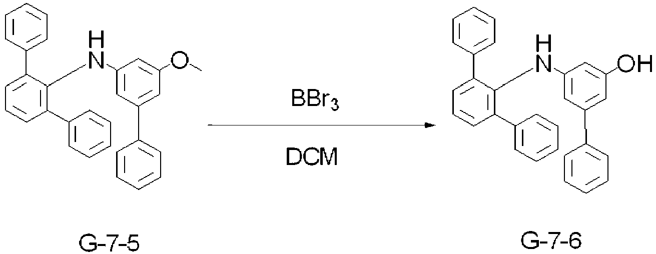

200 ml of dichloromethane (DCM) was added to Intermediate G-7-5 (145 mmol) in a three-necked flask, and the flask was immersed in an ice bath to make a temperature thereof about 0 °C. A solution in which 290 mmol of BBr₃ was dissolved in 100 ml of DCM was dropwise added, and the flask was stirred at room temperature for 12 hours. Water was added to the reaction system, the organic layer was extracted using DCM, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 120 mmol (83% yield) of the white solid. It was confirmed that Intermediate G-7-6 was obtained by confirming a molecular weight of 414 through FAB-MS measurement of an obtained purified material.

### (Synthesis of Intermediate G-7-8)

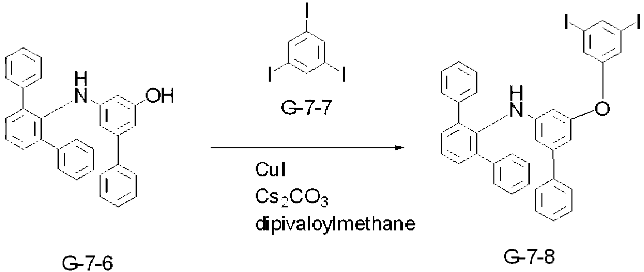

Intermediate G-7-6 (120 mmol), Intermediate G-7-7 (1200 mmol), Cs₂CO₃ (240 mmol), CuI (20 mmol), and dipivaloylmethane (20 mmol) were added to a three-necked flask to Ar-substitution, and the flask was stirred at 120 °C for 3 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 86 mmol (72% yield) of the white solid. It was confirmed that Intermediate G-7-8 was obtained by confirming a molecular weight of 741 through FAB-MS measurement of an obtained purified material.

### (Synthesis of Intermediate G-7-9)

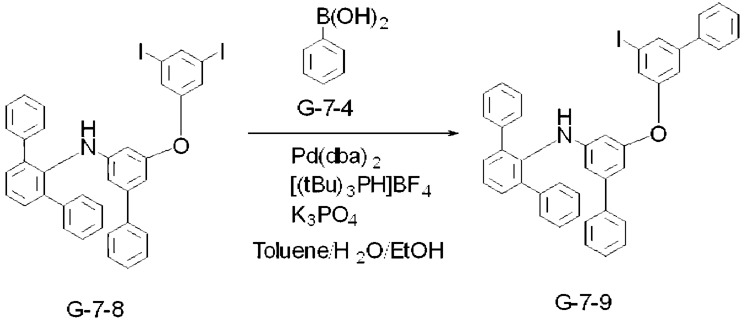

Intermediate G-7-8 (86 mmol), Intermediate G-7-4 (86 mmol), K₃PO₄ (240 mmol), Pd(dba)₂ (10 mmol), and [(tBu)₃PH]BF₄ (20 mmol) were added to a three-necked flask to Ar-substitution, 100 ml of toluene, 20 ml of EtOH and 20 ml of H₂O were added and the flask was stirred at 100 °C for 5 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 56 mmol (65% yield) of the white solid. It was confirmed that Intermediate G-7-9 was obtained by confirming a molecular weight of 692 through FAB-MS measurement of an obtained purified material.

### (Synthesis of Intermediate G-7-10)

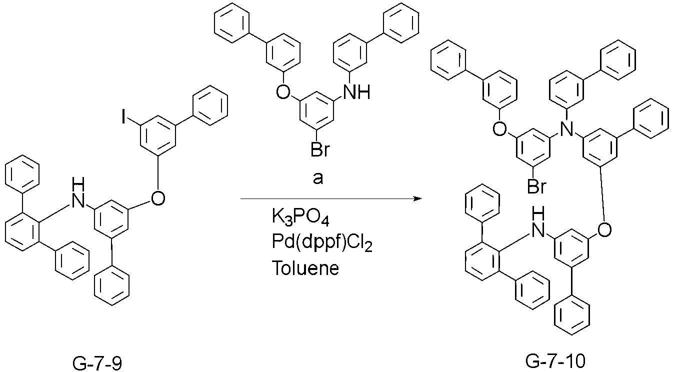

Intermediate G-7-9 (56 mmol), Intermediate a (56 mmol), tBuONa (112 mmol), K₃PO₄ (112 mmol), and Pd(dppf)Cl₂ (20 mmol) were added to a three-necked flask to Ar-substitution, 500 ml of toluene was added and the flask was stirred at 100 °C for 3 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 49 mmol (88% yield) of the white solid. It was confirmed that Intermediate G-7-10 was obtained by confirming a molecular weight of 1056 through FAB-MS measurement of an obtained purified material.

### (Synthesis of Intermediate G-7-11)

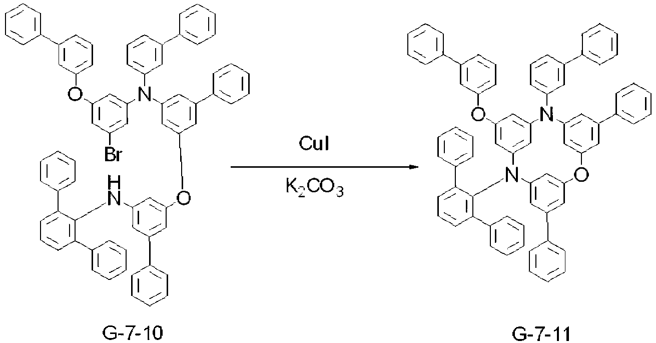

Intermediate G-7-10 (49 mmol), K₂CO₃ (490 mmol), CuI (49 mmol) and xylene (100 ml) were added to a three-necked flask to Ar-substitution, and the flask was stirred at 210 °C for 24 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 34 mmol (69% yield) of the white solid. It was confirmed that Intermediate G-7-11 was obtained by confirming a molecular weight of 975 through FAB-MS measurement of an obtained purified material.

### (Synthesis of Compound G-7)

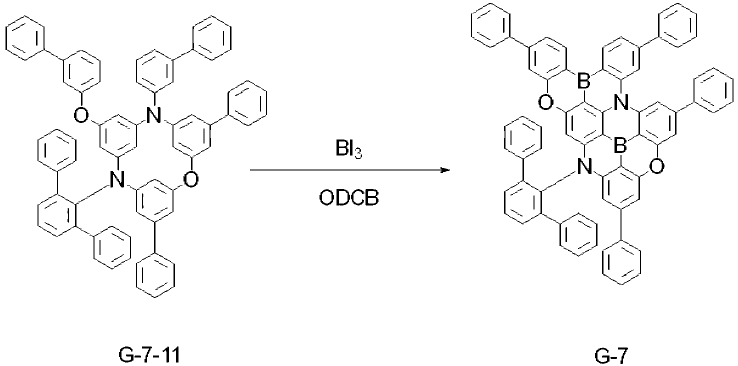

Intermediate G-7-11 (34 mmol) was added to a three-necked flask to Ar-substitution, 50 ml of ODCB was added and dissolved, BI₃ (132 mmol) was added and the flask was stirred at 140 °C for 6 hours. The reaction solution was dispersed and cleaned using a large amount of acetonitrile, and the solid was recovered by filtration. The obtained crude product was purified by silica gel column chromatography (a hexane/dichloromethane mixed solvent) and recrystallization (an ethanol/toluene mixed solvent) to obtain 14 mmol (41% yield) of the yellow solid. It was confirmed that Compound G-7 was obtained by confirming a molecular weight of 991 through FAB-MS measurement of an obtained purified material.

### (3) Synthesis of Compound C-21

For example, Condensed Polycyclic Compound C-21 according to an embodiment may be synthesized by the following reaction.

### (Synthesis of Intermediate b)

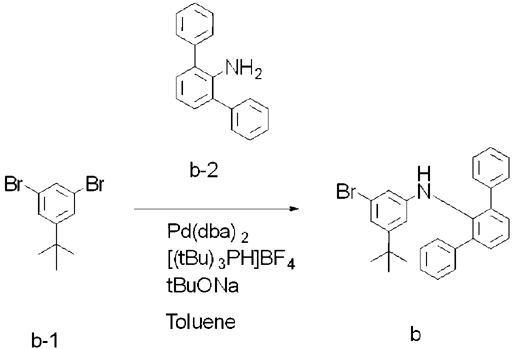

Intermediate b-1 (400 mmol), Intermediate b-2 (200 mmol), tBuONa (220 mmol), Pd(dba)₂ (30 mmol), and [(tBu)₃PH]BF₄ (60 mmol) were added to a three-necked flask to Ar-substitution, 1000 mL of toluene was added and the flask was stirred at 100 °C for 3 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 177 mmol (89% yield) of the white solid. It was confirmed that Intermediate b was obtained by confirming a molecular weight of 456 through FAB-MS measurement of an obtained purified material.

### (Synthesis of Intermediate C-21-3)

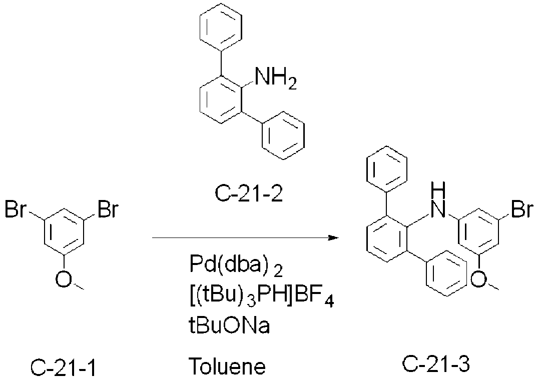

Intermediate C-21-1 (400 mmol), Intermediate C-21-2 (200 mmol), tBuONa (220 mmol), Pd(dba)₂ (30 mmol), and [(tBu)₃PH]BF₄ (60 mmol) were added to a three-necked flask to Ar-substitution, 1000 mL of toluene was added and the flask was stirred at 100 °C for 4 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 168 mmol (84% yield) of the white solid. It was confirmed that Intermediate C-21-3 was obtained by confirming a molecular weight of 430 through FAB-MS measurement of an obtained purified material.

### (Synthesis of Intermediate C-21-5)

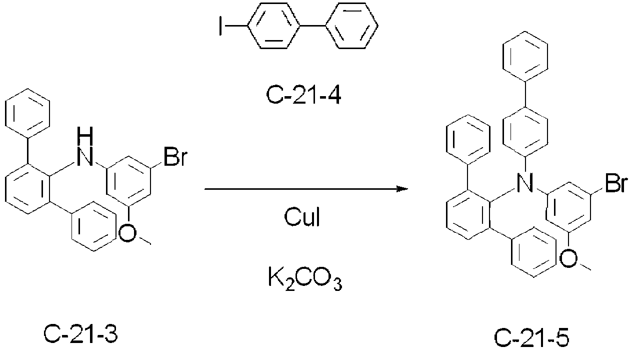

Intermediate C-21-3 (168 mmol), Intermediate C-21-4 (1680 mmol), K₂CO₃ (1176 mmol), CuI (168 mmol) and xylene (200 ml) were added to a three-necked flask to Ar-substitution, and the flask was stirred at 210 °C for 49 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 126 mmol (75% yield) of the white solid. It was confirmed that Intermediate C-21-5 was obtained by confirming a molecular weight of 583 through FAB-MS measurement of an obtained purified material.

### (Synthesis of Intermediate C-21-7)

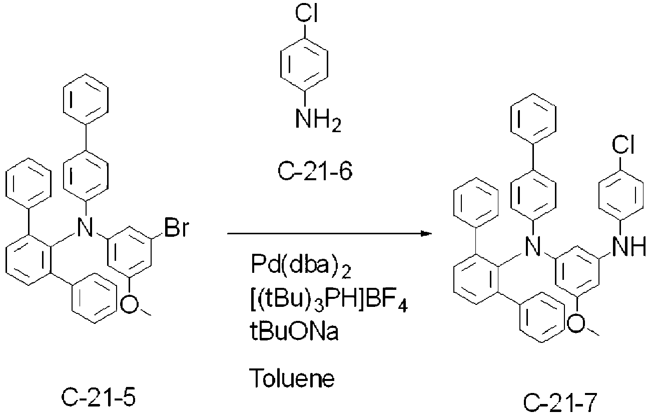

Intermediate C-21-5 (126 mmol), Intermediate C-21-6 (189 mmol), tBuONa (378 mmol), Pd(dba)₂ (20 mmol), and [(tBu)₃PH]BF₄ (40 mmol) were added to a three-necked flask to Ar-substitution, 500 mL of toluene was added and the flask was stirred at 100 °C for 2 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 101 mmol (80% yield) of the white solid. It was confirmed that Intermediate C-21-7 was obtained by confirming a molecular weight of 629 through FAB-MS measurement of an obtained purified material.

### (Synthesis of Intermediate C-21-9)

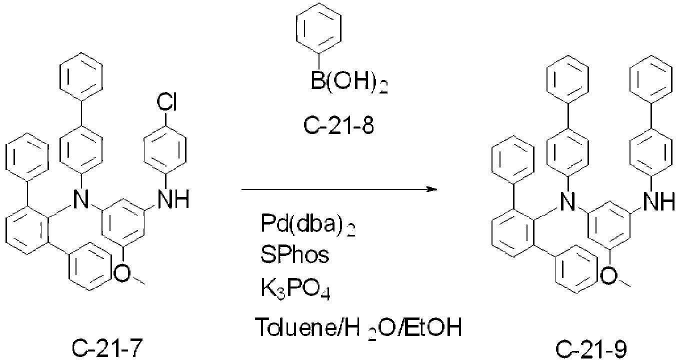

Intermediate C-21-7 (101 mmol), Intermediate C-21-8 (152 mmol), K₃PO₄ (303 mmol), Pd(dba)₂ (10 mmol), and SPhos (20 mmol) were added to a three-necked flask to Ar-substitution, 200 ml of toluene, 20 ml of EtOH and 20 ml of H₂O were added and the flask was stirred at 110 °C for 12 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 88 mmol (87% yield) of the white solid. It was confirmed that Intermediate C-21-9 was obtained by confirming a molecular weight of 671 through FAB-MS measurement of an obtained purified material.

### (Synthesis of Intermediate C-21-10)

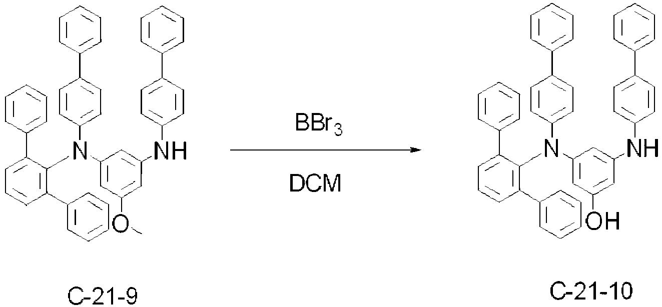

Intermediate C-21-9 (88 mmol) and 200 ml of dichloromethane (DCM) were added to a three-necked flask, and the flask was immersed in an ice bath to make a temperature thereof about 0 °C. A solution in which 166 mmol of BBr₃ was dissolved in 100 ml of DCM was dropwise added, and the flask was stirred at room temperature for 24 hours. Water was added to the reaction system, the organic layer was extracted using DCM, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 60 mmol (68% yield) of the white solid. It was confirmed that Intermediate C-21-10 was obtained by confirming a molecular weight of 657 through FAB-MS measurement of an obtained purified material.

### (Synthesis of Intermediate C-21-11)

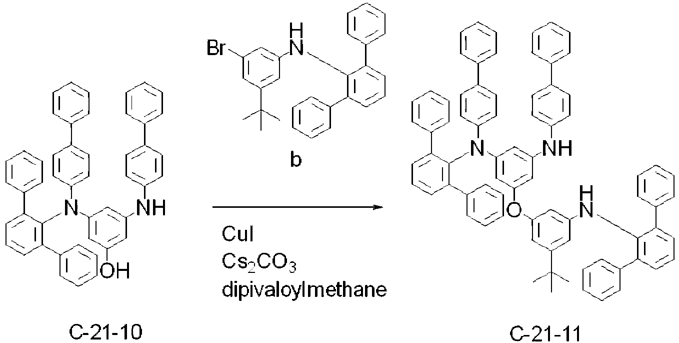

Intermediate C-21-10 (60 mmol), Intermediate b (60 mmol), Cs₂CO₃ (240 mmol), CuI (20 mmol), and dipivaloylmethane (20 mmol) were added to a three-necked flask to Ar-substitution, and the flask was stirred at 140 °C for 6 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 47 mmol (78% yield) of the white solid. It was confirmed that Intermediate C-21-11 was obtained by confirming a molecular weight of 1032 through FAB-MS measurement of an obtained purified material.

### (Synthesis of Intermediate C-21-13)

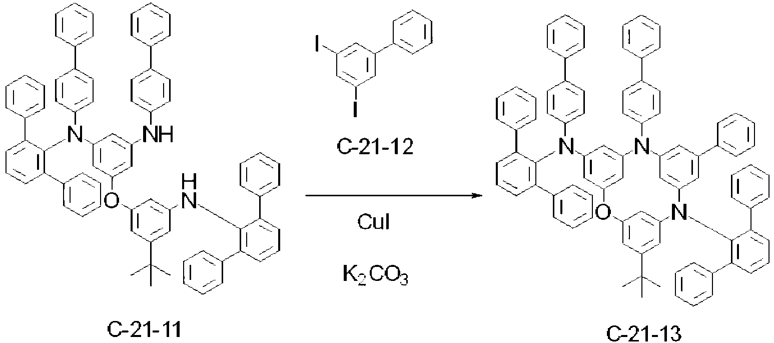

Intermediate C-21-11 (47 mmol), Intermediate C-21-12 (47 mmol), K₂CO₃ (329 mmol), CuI (47 mmol) and xylene (400 ml) were added to a three-necked flask to Ar-substitution, and the flask was stirred at 210 °C for 56 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 21 mmol (45% yield) of the white solid. It was confirmed that Intermediate C-21-13 was obtained by confirming a molecular weight of 1183 through FAB-MS measurement of an obtained purified material.

### (Synthesis of Compound C-21)

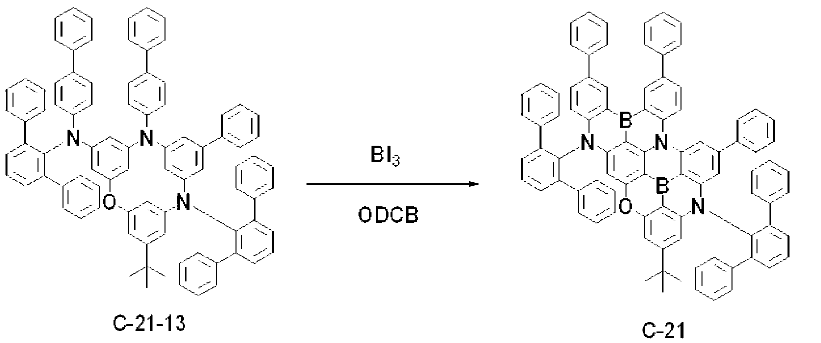

Intermediate C-21-13 (21 mmol) was added to a three-necked flask to Ar-substitution, 20 ml of ODCB was added and dissolved, BI₃ (84 mmol) was added and the flask was stirred at 140 °C for 6 hours. The reaction solution was dispersed and cleaned using a large amount of acetonitrile, and the solid was recovered by filtration. The obtained crude product was purified by silica gel column chromatography (a hexane/dichloromethane mixed solvent) and recrystallization (an ethanol/toluene mixed solvent) to obtain 7 mmol (33% yield) of the yellow solid. It was confirmed that Compound C-21 was obtained by confirming a molecular weight of 1198 through FAB-MS measurement of an obtained purified material.

### (4) Synthesis of Compound C-16

### (Synthesis of Intermediate C-16-3)

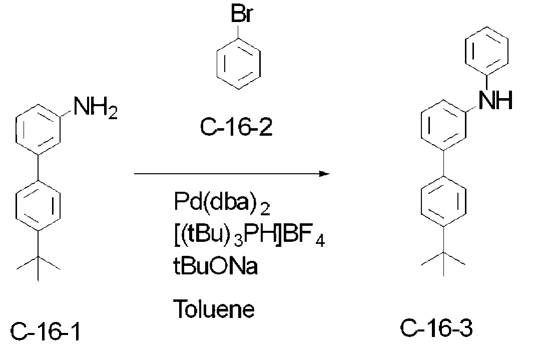

Intermediate C-16-1 (400 mmol), Intermediate C-16-2 (400 mmol), tBuONa (450 mmol), Pd(dba)₂ (40 mmol), and [(tBu)₃PH]BF₄ (80 mmol) were added to a three-necked flask to Ar-substitution, 1000 mL of toluene was added and the flask was stirred at 80 °C for 8 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 356 mmol (89% yield) of the white solid. It was confirmed that Intermediate C-16-3 was obtained by confirming a molecular weight of 301 through FAB-MS measurement of an obtained purified material.

### (Synthesis of Intermediate C-16-5)

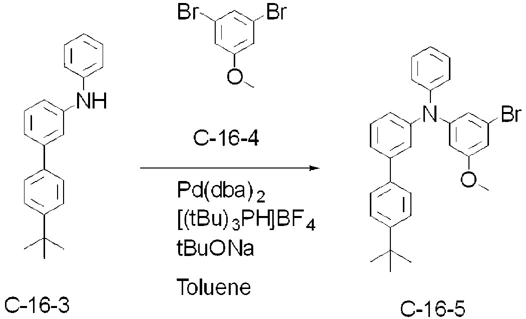

Intermediate C-16-3 (356 mmol), Intermediate C-16-4 (356 mmol), tBuONa (400 mmol), Pd(dba)₂ (36 mmol), and [(tBu)₃PH]BF₄ (72 mmol) were added to a three-necked flask to Ar-substitution, 1000 mL of toluene was added and the flask was stirred at 80 °C for 5 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 299 mmol (84% yield) of the white solid. It was confirmed that Intermediate C-16-5 was obtained by confirming a molecular weight of 486 through FAB-MS measurement of an obtained purified material.

### (Synthesis of Intermediate C-16-7)

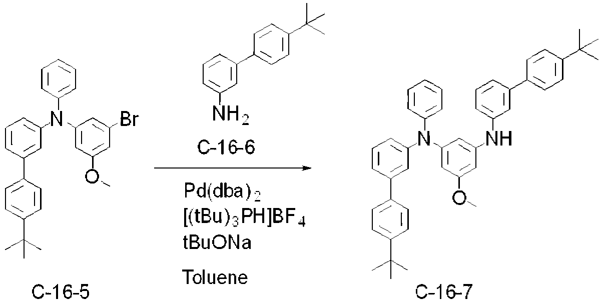

Intermediate C-16-5 (299 mmol), Intermediate C-16-6 (299 mmol), tBuONa (450 mmol), Pd(dba)₂ (29 mmol), and [(tBu)₃PH]BF₄ (58 mmol) were added to a three-necked flask to Ar-substitution, 1000 mL of toluene was added and the flask was stirred at 100 °C for 1 hour. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 280 mmol (94% yield) of the white solid. It was confirmed that Intermediate C-16-7 was obtained by confirming a molecular weight of 630 through FAB-MS measurement of an obtained purified material.

### (Synthesis of Intermediate C-16-8)

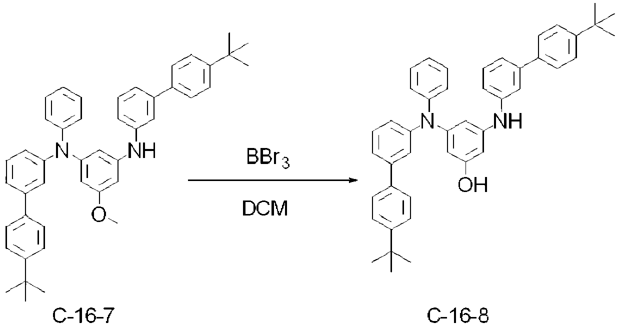

Intermediate C-16-7 (280 mmol) and 500 ml of dichloromethane (DCM) were added to a three-necked flask, and the flask was immersed in an ice bath to make a temperature thereof about 0 °C. A solution in which 420 mmol of BBr₃ was dissolved in 200 ml of DCM was dropwise added, and the flask was stirred at room temperature for 24 hours. Water was added to the reaction system, the organic layer was extracted using DCM, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 255 mmol (91% yield) of the white solid. It was confirmed that Intermediate C-16-8 was obtained by confirming a molecular weight of 617 through FAB-MS measurement of an obtained purified material.

### (Synthesis of Intermediate C-16-10)

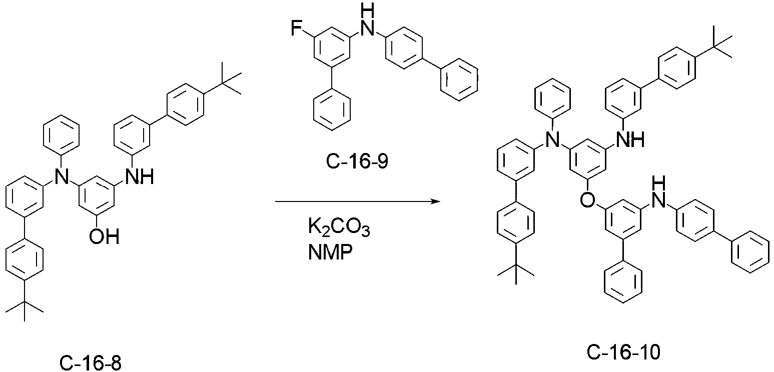

Intermediate C-16-8 (255 mmol), Intermediate C-16-9 (255 mmol), K₂CO₃ (350 mmol) and 200 mL of N-methyl-2-pyrrolidone (NMP) were added to a three-necked flask to Ar-substitution, and the flask was stirred at 150 °C for 30 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 124 mmol (49% yield) of the white solid. It was confirmed that Intermediate C-16-10 was obtained by confirming a molecular weight of 936 through FAB-MS measurement of an obtained purified material.

### (Synthesis of Intermediate C-16-12)

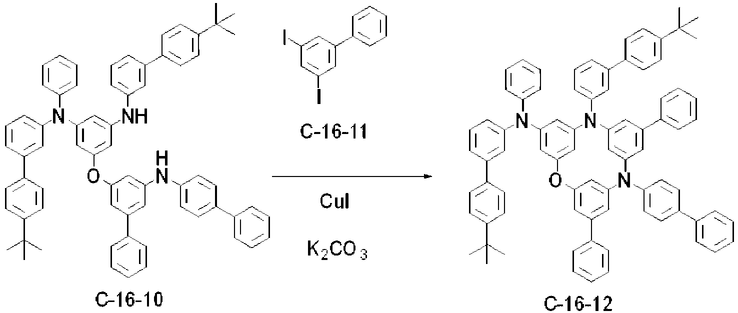

Intermediate C-16-10 (124 mmol), Intermediate C-16-11 (124 mmol), K₂CO₃ (329 mmol), CuI (47 mmol) and xylene (400 ml) were added to a three-necked flask to Ar-substitution, and the flask was stirred at 210 °C for 56 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 56 mmol (45% yield) of the white solid. It was confirmed that Intermediate C-16-12 was obtained by confirming a molecular weight of 1086 through FAB-MS measurement of an obtained purified material.

### (Synthesis of Compound C-16)

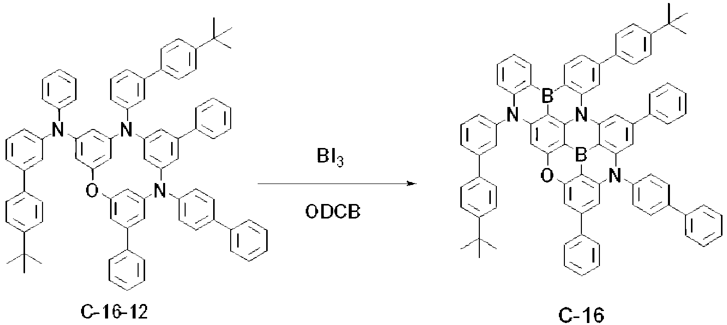

Intermediate C-16-12 (56 mmol) was added to a three-necked flask to Ar-substitution, 20 ml of ODCB was added and dissolved, BI₃ (224 mmol) was added and the flask was stirred at 140 °C for 3 hours. The reaction solution was dispersed and cleaned using a large amount of acetonitrile, and the solid was recovered by filtration. The obtained crude product was purified by silica gel column chromatography (a hexane/dichloromethane mixed solvent) and recrystallization (an ethanol/toluene mixed solvent) to obtain 14 mmol (25% yield) of the yellow solid. It was confirmed that Intermediate C-16 was obtained by confirming a molecular weight of 1102 through FAB-MS measurement of an obtained purified material.

### (5) Synthesis of Compound C-19

### (Synthesis of Intermediate C-19-3)

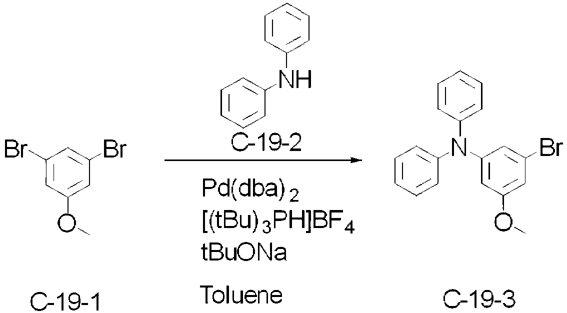

Intermediate C-19-1 (600 mmol), Intermediate C-19-2 (600 mmol), tBuONa (800 mmol), Pd(dba)₂ (60 mmol), and [(tBu)₃PH]BF₄ (120 mmol) were added to a three-necked flask to Ar-substitution, 2000 mL of toluene was added and the flask was stirred at 100 °C for 12 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 354 mmol (59% yield) of the white solid. It was confirmed that Intermediate C-19-3 was obtained by confirming a molecular weight of 354 through FAB-MS measurement of an obtained purified material.

### (Synthesis of Intermediate C-19-5)

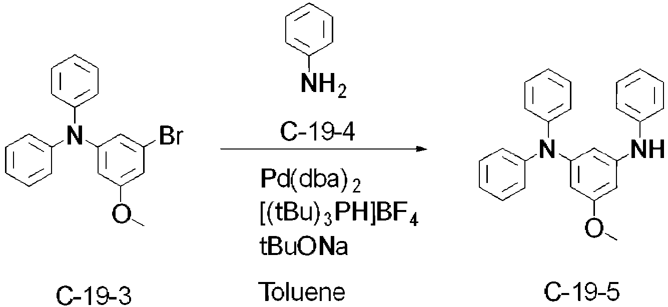

Intermediate C-19-3 (354 mmol), Intermediate C-19-4 (354 mmol), tBuONa (531 mmol), Pd(dba)₂ (36 mmol), and [(tBu)₃PH]BF₄ (72 mmol) were added to a three-necked flask to Ar-substitution, 1000 mL of toluene was added and the flask was stirred at 80 °C for 22 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 320 mmol (90% yield) of the white solid. It was confirmed that Intermediate C-19-5 was obtained by confirming a molecular weight of 366 through FAB-MS measurement of an obtained purified material.

### (Synthesis of Intermediate C-19-6)

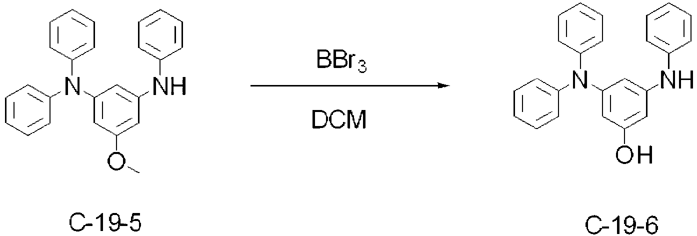

Intermediate C-19-5 (320 mmol) and 600 ml of dichloromethane (DCM) were added to a three-necked flask, and the flask was immersed in an ice bath to make a temperature thereof about 0 °C. A solution in which 480 mmol of BBr₃ was dissolved in 200 ml of DCM was dropwise added, and the flask was stirred at room temperature for 24 hours. Water was added to the reaction system, the organic layer was extracted using DCM, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 290 mmol (91% yield) of the white solid. It was confirmed that Intermediate C-19-6 was obtained by confirming a molecular weight of 352 through FAB-MS measurement of an obtained purified material.

### (Synthesis of Intermediate C-19-9)

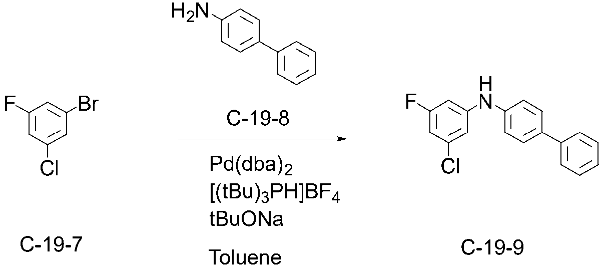

Intermediate C-19-7 (300 mmol), Intermediate C-19-8 (300 mmol), tBuONa (450 mmol), Pd(dba)₂ (30 mmol), and [(tBu)₃PH]BF₄ (60 mmol) were added to a three-necked flask to Ar-substitution, 1000 mL of toluene was added and the flask was stirred at 100 °C for 2 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 249 mmol (83% yield) of the white solid. It was confirmed that Intermediate C-19-9 was obtained by confirming a molecular weight of 298 through FAB-MS measurement of an obtained purified material.

### (Synthesis of Intermediate C-19-10)

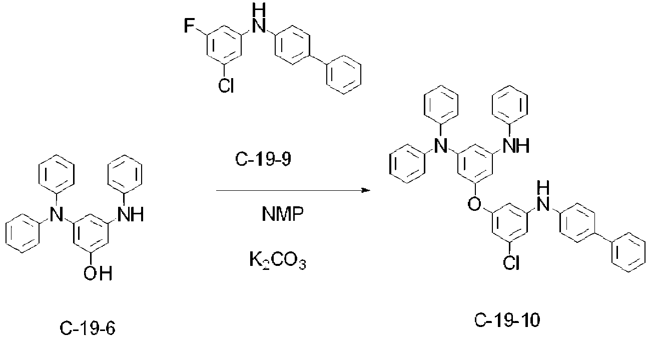

Intermediate C-19-6 (249 mmol), Intermediate C-19-9 (249 mmol), K₂CO₃ (747 mmol) and 200 mL of N-methyl-2-pyrrolidone (NMP) were added to a three-necked flask to Ar-substitution, and the flask was stirred at 150 °C for 22 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 211 mmol (85% yield) of the white solid. It was confirmed that Intermediate C-19-10 was obtained by confirming a molecular weight of 630 through FAB-MS measurement of an obtained purified material.

### (Synthesis of Intermediate C-19-12)

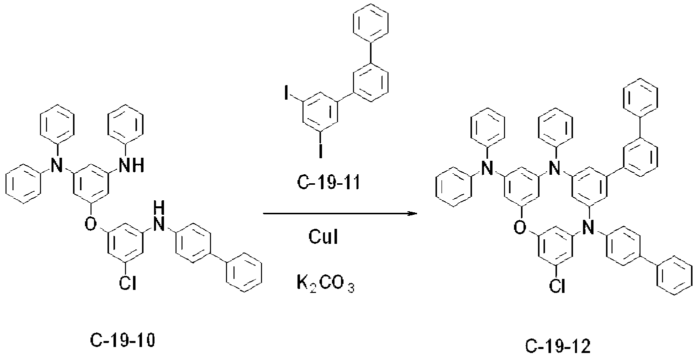

Intermediate C-19-10 (211 mmol), Intermediate C-19-11 (211 mmol), K₂CO₃ (1477 mmol), and CuI (422 mmol) were added to a three-necked flask to Ar-substitution, and the flask was stirred at 210 °C for 85 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 43 mmol (20% yield) of the white solid. It was confirmed that Intermediate C-19-12 was obtained by confirming a molecular weight of 856 through FAB-MS measurement of an obtained purified material.

### (Synthesis of Intermediate C-19-13)

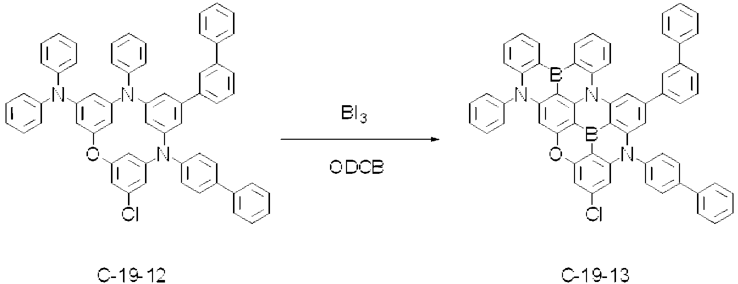

Intermediate C-19-12 (43 mmol) was added to a three-necked flask to Ar-substitution, 15 ml of ODCB was added and dissolved, BI₃ (172 mmol) was added and the flask was stirred at 140 °C for 2 hours. The reaction solution was dispersed and cleaned using a large amount of acetonitrile, and the solid was recovered by filtration. The obtained crude product was purified by silica gel column chromatography (a hexane/dichloromethane mixed solvent) and recrystallization (an ethanol/toluene mixed solvent) to obtain 20 mmol (47% yield) of the yellow solid. It was confirmed that Intermediate C-19-13 was obtained by confirming a molecular weight of 872 through FAB-MS measurement of an obtained purified material.

### (Synthesis of Compound C-19)

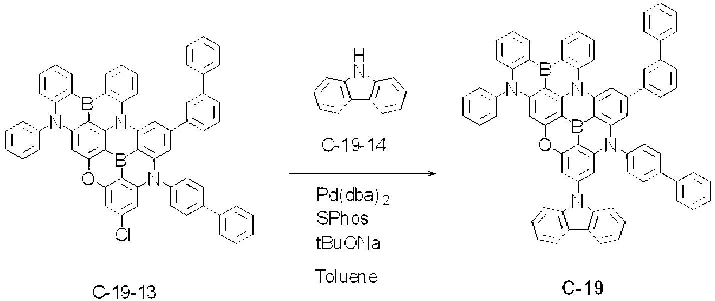

Intermediate C-19-13 (20 mmol), Intermediate C-19-14 (30 mmol), tBuONa (45 mmol), Pd(dba)₂ (5 mmol), and SPhos (10 mmol) were added to a three-necked flask to Ar-substitution, 100 ml of toluene was added and the flask was stirred at 100 °C for 6 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 12 mmol (60% yield) of the yellow solid. It was confirmed that Compound C-19 was obtained by confirming a molecular weight of 1003 through FAB-MS measurement of an obtained purified material.

### (6) Synthesis of Compound I-3

### (Synthesis of Intermediate I-3-3)

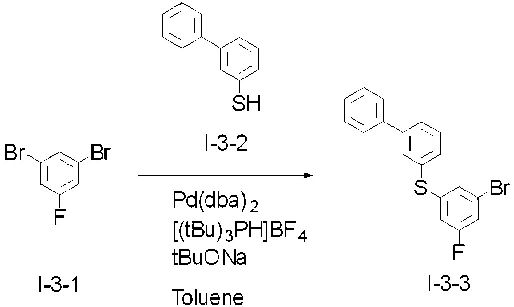

Intermediate I-3-1 (600 mmol), Intermediate I-3-2 (600 mmol), tBuONa (800 mmol), Pd(dba)₂ (60 mmol), and [(tBu)₃PH]BF₄ (120 mmol) were added to a three-necked flask to Ar-substitution, 2000 mL of toluene was added and the flask was stirred at 100 °C for 8 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 390 mmol (65% yield) of the white solid. It was confirmed that Intermediate I-3-3 was obtained by confirming a molecular weight of 359 through FAB-MS measurement of an obtained purified material.

### (Synthesis of Intermediate I-3-5)

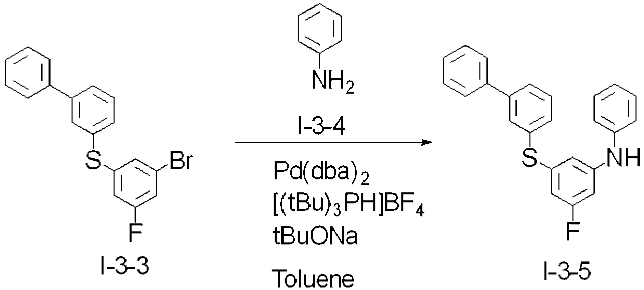

Intermediate 1-3-3 (359 mmol), Intermediate I-3-4 (394 mmol), tBuONa (539 mmol), Pd(dba)₂ (36 mmol), and [(tBu)₃PH]BF₄ (72 mmol) were added to a three-necked flask to Ar-substitution, 1000 mL of toluene was added and the flask was stirred at 80 °C for 18 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 309 mmol (86% yield) of the white solid. It was confirmed that Intermediate I-3-5 was obtained by confirming a molecular weight of 371 through FAB-MS measurement of an obtained purified material.

### (Synthesis of Intermediate 1-3-8)

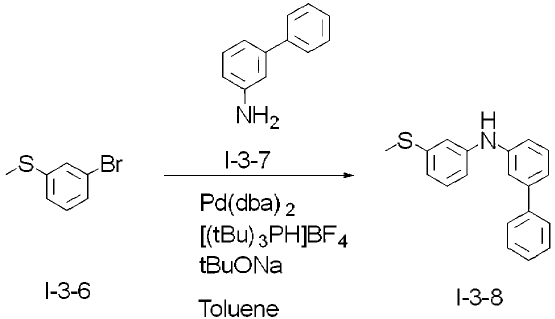

Intermediate 1-3-6 (1000 mmol), Intermediate I-3-7 (1000 mmol), tBuONa (1200 mmol), Pd(dba)₂ (100 mmol), and [(tBu)₃PH]BF₄ (200 mmol) were added to a three-necked flask to Ar-substitution, 2000 mL of toluene was added and the flask was stirred at 100 °C for 6 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 800 mmol (80% yield) of the white solid. It was confirmed that Intermediate I-3-8 was obtained by confirming a molecular weight of 291 through FAB-MS measurement of an obtained purified material.

### (Synthesis of Intermediate I-3-9)

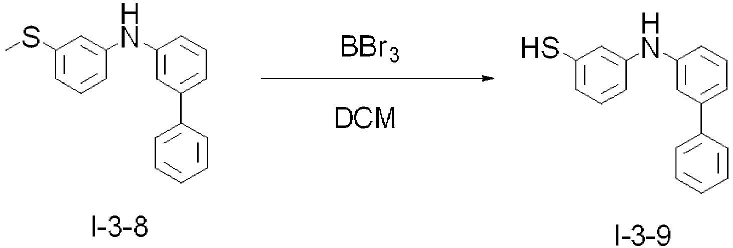

Intermediates 1-3-8 (800 mmol) and 600 ml of dichloromethane (DCM) were added to a three-necked flask to Ar-substitution, and 1000 ml of DCM was added and cooled to 0 °C using ice water. A BBr₃ solution adjusted to 1 M was dropwise added to the reaction solution for 1 hour using a dropping funnel, and the flask was stirred at room temperature for 24 hours. Water was added to the reaction system, the organic layer was extracted using DCM, and the solvent was distilled and removed by drying over magnesium sulfate. The obtained crude product was purified by silica gel column chromatography (a hexane/DCM mixed solvent) to obtain 655 mmol (81% yield) of the white solid. It was confirmed that Intermediate 1-3-9 was obtained by confirming a molecular weight of 277 through FAB-MS measurement of an obtained purified material.

### (Synthesis of Intermediate 1-3-10)

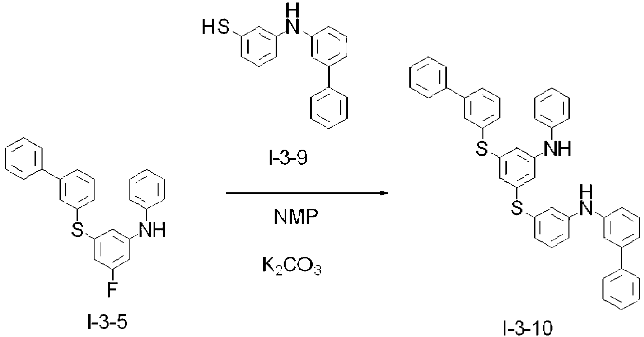

Intermediate 1-3-5 (309 mmol), Intermediate I-3-9 (309 mmol), K₂CO₃ (464 mmol) and 500 mL of N-methyl-2-pyrrolidone (NMP) were added to a three-necked flask to Ar-substitution, and the flask was stirred at 150 °C for 24 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 244 mmol (79% yield) of the white solid. It was confirmed that Intermediate I-3-10 was obtained by confirming a molecular weight of 629 through FAB-MS measurement of an obtained purified material.

### (Synthesis of Intermediate I-3-12)

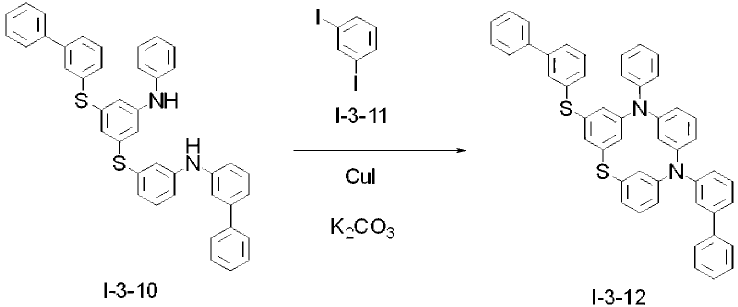

Intermediate I-3-10 (244 mmol), Intermediate I-3-11 (244 mmol), K₂CO₃ (1708 mmol) and 488 mL of CuI were added to a three-necked flask to Ar-substitution, and the flask was stirred at 210 °C for 60 hours. Water was added to the reaction system, the organic layer was extracted using toluene, and the solvent was distilled and removed by drying over magnesium sulfate. The obtained crude product was purified by silica gel column chromatography (a hexane/toluene mixed solvent) and recrystallization (an ethanol/toluene mixed solvent) to obtain 52 mmol (21% yield) of the white solid. It was confirmed that Intermediate 1-3-12 was obtained by confirming a molecular weight of 703 through FAB-MS measurement of an obtained purified material.

### (Synthesis of Compound 1-3)

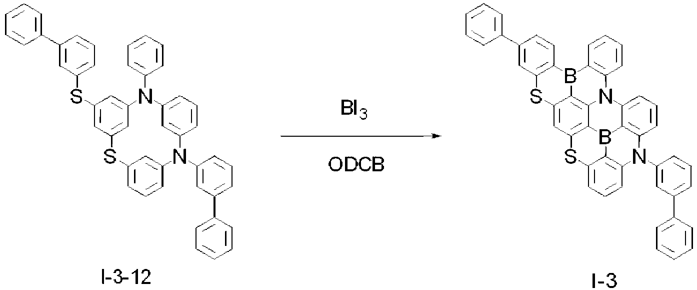

Intermediate 1-3-12 (52 mmol) was added to a three-necked flask to Ar-substitution, 20 ml of ODCB was added and dissolved, BI₃ (208 mmol) was added and the flask was stirred at 140 °C for 6 hours. The reaction solution was dispersed and cleaned using a large amount of acetonitrile, and the solid was recovered by filtration. The obtained crude product was purified by silica gel column chromatography (a hexane/dichloromethane mixed solvent) and recrystallization (an ethanol/toluene mixed solvent) to obtain 15 mmol (29% yield) of the yellow solid. It was confirmed that Compound I-3 was obtained by confirming a molecular weight of 719 through FAB-MS measurement of an obtained purified material.

### 2. Manufacturing and Evaluation of Light-emitting element

A light-emitting element according to an embodiment including a condensed polycyclic compound according to an embodiment in a light-emitting layer was manufactured. The light-emitting elements according to Examples 1 to 6 were manufactured by using the condensed polycyclic compounds of Compounds B-11, G-7, C-21, C-16, C-19, and 1-3, which were Example Compounds previously described. Comparative Examples 1 to 5 correspond to the light-emitting elements manufactured by using Comparative Example Compounds X-1 to X-5 as dopant materials of the light-emitting layers.

### Example Compounds

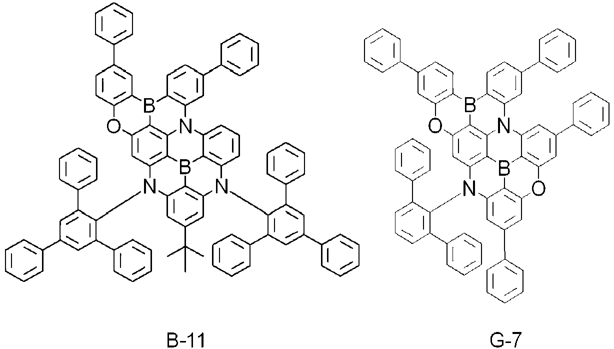

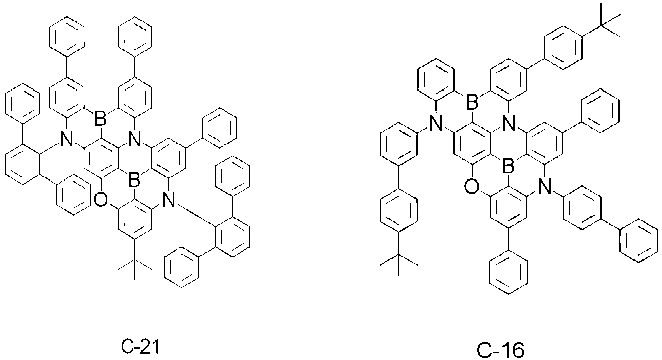

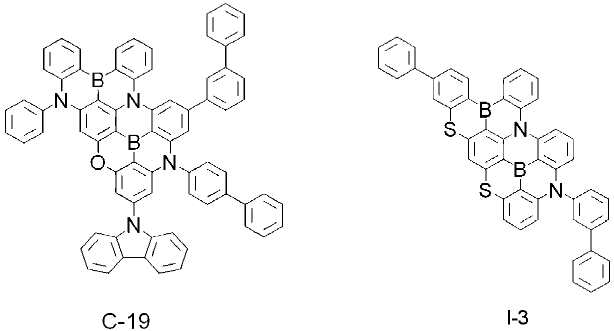

### Comparative Example Compounds

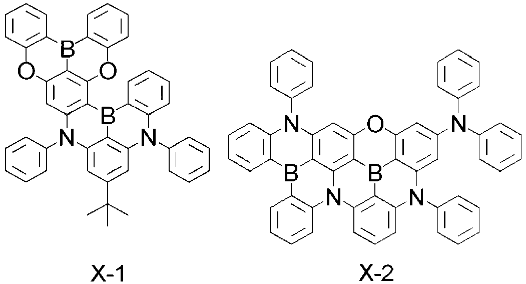

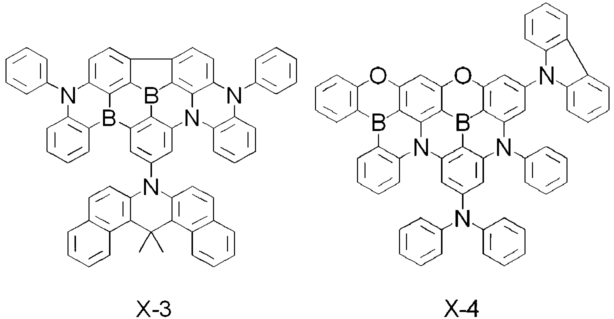

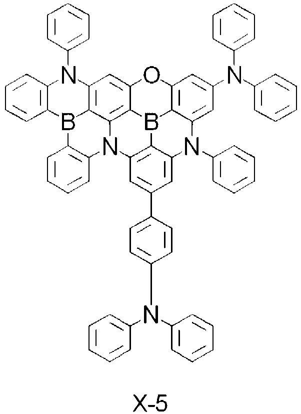

### (Manufacturing of Light-emitting element)

A first electrode having a thickness of about 150 nm was formed of ITO, and a hole injection layer having a thickness of about 10 nm was formed of dipyrazino[2,3-f: 2',3'-h] quinoxaline-2,3,6,7,10,11-hexacarbonitrile (HATCN) on the first electrode. A hole transport layer having a thickness of 40 nm was formed, on the hole injection layer, of N,N'-di(1-naphthyl)-N,N'-diphenyl-(1,1"-biphenyl)-4,4"-diamine (NPD), and an auxiliary light-emitting layer having a thickness of about 5 nm was formed of 1,3-bis(N-carbazolyl)benzene (mCP) on the hole transport layer. A light-emitting layer which has a thickness of about 20 nm, and in which 3,3'-di(9H-carbazol-9-yl)-1,1'-biphenyl (mCBP) was doped with about 1% of Example Compound or Comparative Example Compound was formed on the auxiliary light-emitting layer, and an electron transport layer having a thickness of about 30 nm was formed of 2,2',2"-(1,3,5-benzinetriyl)-tris(1-phenyl-1-H-benzimidazole) (TPBi) on the light-emitting layer. An electron injection layer having a thickness of about 0.5 nm was formed of LiF on the electron transport layer, and a second electrode having a thickness of about 300 nm was formed of Al on the electron injection layer. Each layer was formed under a vacuum atmosphere in a deposition process.

The compounds according to Examples and Comparative Examples used in manufacturing the light-emitting element are as follows: The materials below are well-known materials, and the commercial products were purified through sublimation, and used for manufacturing the elements.

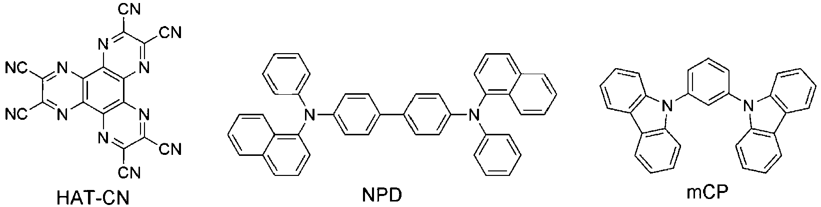

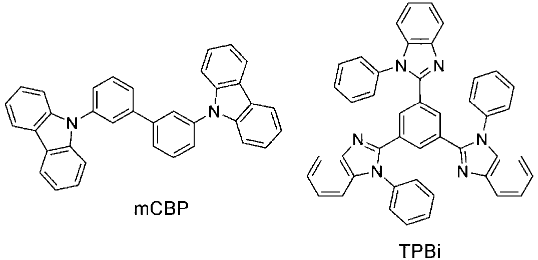

### (Evaluation of Physical Properties of Example Compounds and Comparative Example Compounds)

The data in Table 1 shows evaluation of physical properties of Example Compounds, Compound B-11, G-7, C-21, C-16, C-19 and I-3, and Comparative Example Compounds X-1 to X-5. Table 1 shows fluorescence quantum yields and luminous wavelengths (λ_{film}) in deposition films of Example Compounds and Comparative Example Compounds.

A fluorescence luminous spectrum was measured by using JASCO V-670 spectrometer for evaluation of luminous characteristics, and generating a 20 wt% doped film through deposition on a quartz glass by using PPF as a matrix. The fluorescence quantum yield was measured by using a JASCOILF-835 integrating sphere system. The results were tabulated in Table 1.

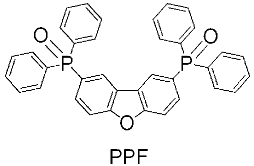

**Table 1**

| Compound | λ_{film} (nm) | Fluorescence quantum yield (%) |
|---|---|---|
| Compound B-11 | 460 | 85 |
| Compound G-7 | 456 | 88 |
| Compound C-21 | 458 | 79 |
| Compound C-16 | 458 | 77 |
| Compound C-19 | 454 | 84 |
| Compound I-3 | 463 | 80 |
| Comparative Example Compound X-1 | 455 | 75 |
| Comparative Example Compound X-2 | 445 | 63 |
| Comparative Example Compound X-3 | 446 | 46 |
| Comparative Example Compound X-4 | 440 | 56 |
| Comparative Example Compound X-5 | 457 | 67 |

The results in Table 1 indicate that Example Compounds have greater fluorescence quantum yields than Comparative Example Compounds. Accordingly, it may be expected that when applied to the light-emitting element, Example Compounds may show higher luminous efficiencies in a blue light wavelength region than Comparative Example Compounds.

### (Evaluation of Light-emitting element Characteristics)

Table 2 includes the evaluation results of light-emitting elements according to Examples 1 to 6, and Comparative Examples 1 to 5. Table 2 shows maximum luminous wavelengths (λₘₐₓ), maximum values of external quantum efficiencies (EQEₘₐₓ), and relative lifespans (LT₅₀) of the manufactured light-emitting element. A voltage and a current density of the light-emitting element was measured by using a source meter (Keithley Instrument, 2400 series), and luminance and external quantum efficiency were measured by using C9920-12, which is an external quantum yield measurement device of Hamamatsu Photonics. In addition, the relative lifespan is expressed by evaluating luminance half-time at an initial luminance of about 100 cd/m². The relative lifespan is relatively expressed with respect to a result of Comparative Example 1.

**Table 2**

| Classification | Dopant | λₘₐₓ (nm) | EQEₘₐₓ (%) | LT₅₀ (%) |
|---|---|---|---|---|
| Example 1 | Compound B-11 | 461 | 20 | 130 |
| Example 2 | Compound G-7 | 458 | 25 | 124 |
| Example 3 | Compound C-21 | 460 | 23 | 111 |
| Example 4 | Compound C-16 | 460 | 21 | 109 |
| Example 5 | Compound C-19 | 453 | 26 | 116 |
| Example 6 | Compound I-3 | 464 | 27 | 105 |
| Comparative Example 1 | Comparative Example Compound X-1 | 458 | 16 | 100 |
| Comparative Example 2 | Comparative Example Compound X-2 | 447 | 14 | 78 |
| Comparative Example 3 | Comparative Example Compound X-3 | 448 | 17 | 34 |
| Comparative Example 4 | Comparative Example Compound X-4 | 442 | 15 | 12 |
| Comparative Example 5 | Comparative Example Compound X-5 | 459 | 19 | 68 |

The results of Table 2 indicate that Examples of the light-emitting elements using the condensed polycyclic compound according to an embodiment of the inventive concept as a light-emitting material show more improved luminous efficiency and lifespan characteristics than Comparative Examples. Each of the Example Compounds includes the first and second condensed cores including a boron-centered condensed skeleton. The first condensed core may include a structure in which six rings are condensed around the first boron atom, and the second condensed core may include a structure in which five rings are condensed around the second boron atom. In the Example Compounds, the first condensed core and the second condensed core may be connected to each other so as to share one benzene ring and one nitrogen atom to form a condensed ring having ten rings. Since the Example Compounds have a structure in which the first condensed core and the second condensed core are combined through a specific connection structure, a small full width of half maximum and stokes-shift characteristics may be shown, and high luminous quantum efficiency may be shown. Accordingly, the Example Compounds may exhibit improved thermally activated delayed fluorescence characteristics, and when the Example Compounds are applied to the light-emitting element, high luminous efficiency and long lifespan may be performed. The light-emitting element according to an embodiment may include the condensed polycyclic compound according to an embodiment as a light-emitting dopant of a thermally activated delayed fluorescence (TADF) light-emitting element to perform high luminous efficiency in the blue light wavelength region.

It may be confirmed that all of the Comparative Example Compounds has a structure including two boron atoms in the condensed polycyclic compound, but when applied to the light-emitting element, compared with Example Compounds, all of luminous efficiency and lifespan characteristics of the element are deteriorated.

Comparative Example Compound X-1 included in Comparative Example 1 has a condensed structure different from those of the Example Compounds. As previously described, the Example Compounds include the first condensed core in which all ortho position carbons around a central boron atom are connected through a heteroatom, but Comparative Example Compound X-1 does not include such a skeleton. Accordingly, the lowest unoccupied molecular orbital (LUMO) of Comparative Example Compound X-1 is skewed to an oxygen-boron-oxygen (OBO) centered upper skeleton, which is an accepter portion. Accordingly, in Comparative Example Compound X-1, structural relaxation increases in an excited state to deteriorate molecular stability, and when Comparative Example Compound X-1 is applied to the light-emitting element, luminous efficiency and element lifespan of the light-emitting element are deteriorated. However, the Example Compounds may suppress the structural relaxation in the excited state more than a typical compound to be highly stable when applied to the element.

Comparative Example Compounds X-2, X-4, and X-5 included in Comparative Example 2, 4, and 5 have similar condensed structures to those of Example Compounds, but show more deteriorated element lifespan and efficiency characteristics than the Example Compounds, when applied to the light-emitting element. Since in Comparative Example Compounds X-2, X-4, and X-5, when R¹³ has a diphenylamine group or a carbazole group, R¹⁰ is a hydrogen atom, or includes a diphenylamine group, stability is relatively deteriorated when applied to the element due to a shallow highest occupied molecular orbital (HOMO) level. According to the inventive concept, stability of the Example Compound may be achieved, in a case in which in the condensed polycyclic compound, when R¹³ is a diphenylamine group or a carbazole group, (1) R¹⁰ is not a hydrogen atom or (2) R¹⁰ does not include a diphenylamine group.

Comparative Example Compound X-3, included in Comparative Example 3, has a condensed structure different from those of the Example Compounds. As previously described, the Example Compounds include the first condensed core in which all ortho position carbons around the central boron atom are connected through a heteroatom, but Comparative Example Compound X-3 does not include such a skeleton carbon structure. Comparative Example Compound X-3 has a structure in which the ortho position carbons around the boron atom are connected through a direct linkage. Since a bonding field of the direct linkage are significantly different from oxygen (O), nitrogen (N) and sulfur (S), material stability is deteriorated due to great molecular distortion. In the condensed polycyclic compound according to the inventive concept, the heteroatom connecting the ortho position carbons around the boron atom is composed of only oxygen (O), nitrogen (N) and sulfur (S) to suppress the molecular distortion and to improve material stability.

A light-emitting element according to an embodiment may show improved element characteristics such as high efficiency and long lifespan.

A condensed polycyclic compound according to an embodiment may be included in a light-emitting layer of a light-emitting element to contribute high efficiency and long lifespan of the light-emitting element.

A display device according to an embodiment may exhibit excellent display quality.

This description is made with reference to various embodiments of the inventive concept, but those skilled in the art or those of ordinary skill in the relevant technical field may understand that various modifications and changes may be made to the inventive concept within the scope not departing from the technology scope of the inventive concept described in the claims to be described later.

Therefore, the technical scope of the inventive concept is not limited to the contents described in the detailed description of the specification, but should be determined by the claims.

## Claims

1. A condensed polycyclic compound represented by Formula 1: 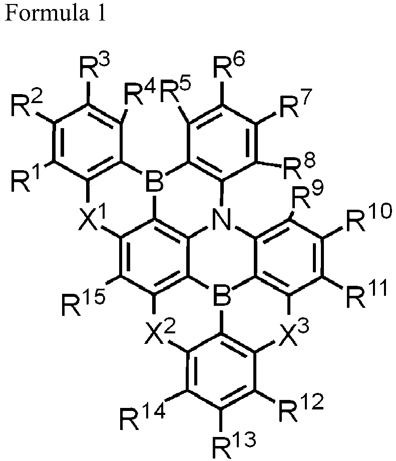 where:
X¹ to X³ are each independently O, S or NAr¹,
wherein Ar₁ is a saturated or unsaturated aryl group having a ring-forming carbon number of 6 to 30, or a saturated or unsaturated heteroaryl group having a ring-forming carbon number of 2 to 30,
R¹ to R¹⁵ are each independently a hydrogen atom, a deuterium atom, a halogen atom, a cyano group, a nitro group, a saturated or unsaturated amine group, a saturated or unsaturated alkyl group having a carbon number of 1 to 20, a saturated or unsaturated aryl group having a ring-forming carbon number of 6 to 30, or a saturated or unsaturated heteroaryl group having a ring-forming carbon number of 2 to 30,
provided that, when R¹³ is a diphenylamine group or a carbazole group:
R¹⁰ is not a hydrogen atom; or
R¹⁰ does not include a diphenylamine group.

2. The condensed polycyclic compound of claim 1, wherein the condensed polycyclic compound represented by Formula 1 is represented by any one of Formula 2-1 to Formula 2-4: 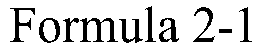 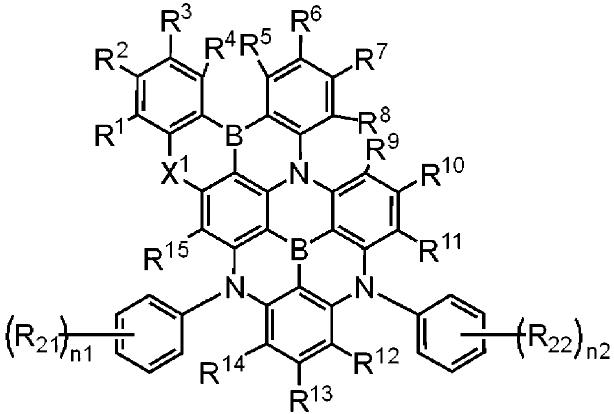 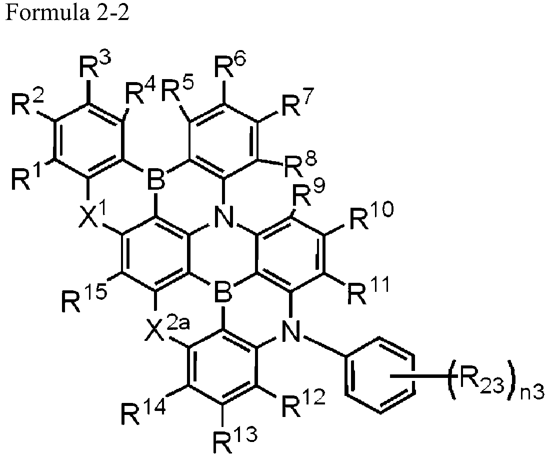 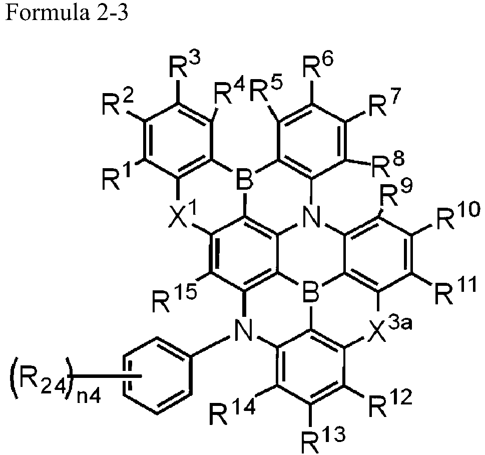 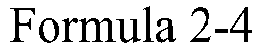 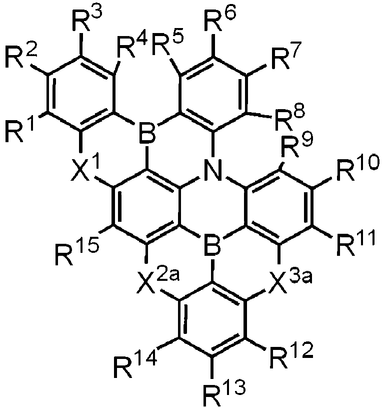
X^{2a} and X^{3a} are each independently O or S,
R²¹ to R²⁴ are each independently a hydrogen atom, a deuterium atom, a halogen atom, a cyano group, a nitro group, a saturated or unsaturated amine group, a saturated or unsaturated alkyl group having a carbon number of 1 to 20, a saturated or unsaturated aryl group having a ring-forming carbon number of 6 to 30, or a saturated or unsaturated heteroaryl group having a ring-forming carbon number of 2 to 30,
n1 to n4 are each independently an integer of 0 to 5, and
X¹ and R¹ to R¹⁵ are the same as defined in Formula 1.

3. The condensed polycyclic compound of claim 1, wherein the condensed polycyclic compound represented by Formula 1 is represented by any one of Formula 3-1 to Formula 3-4: 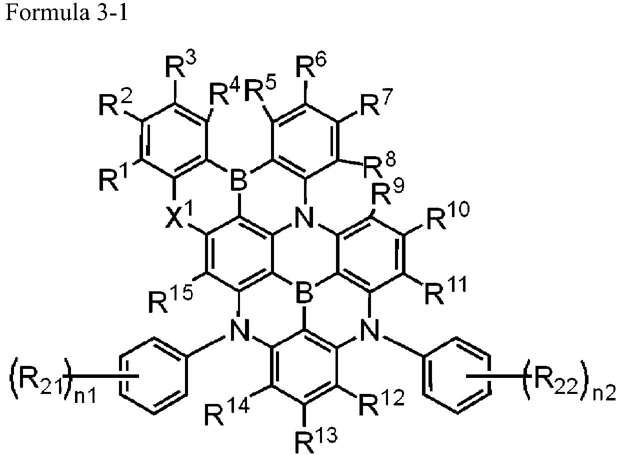 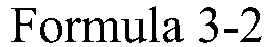 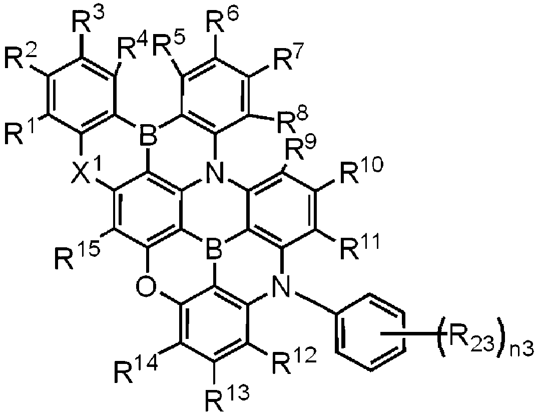 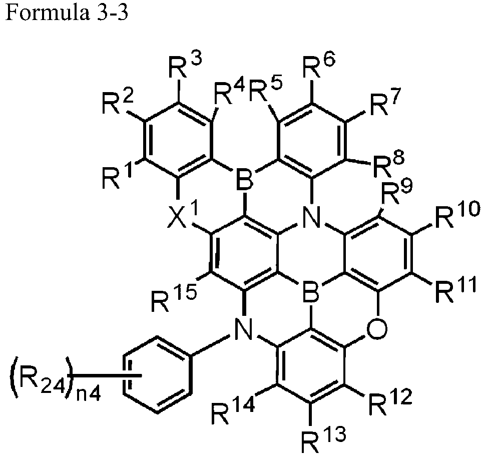 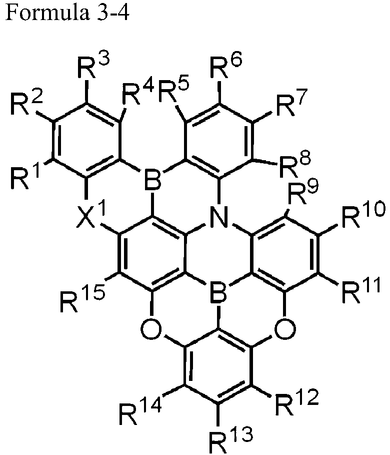
R²¹ to R²⁴ are each independently a hydrogen atom, a deuterium atom, a halogen atom, a cyano group, a nitro group, a saturated or unsaturated amine group, a saturated or unsaturated alkyl group having a carbon number of 1 to 20, a saturated or unsaturated aryl group having a ring-forming carbon number of 6 to 30, or a saturated or unsaturated heteroaryl group having a ring-forming carbon number of 2 to 30,
n1 to n4 are each independently an integer of 0 to 5,
in Formula 3-2,
when R¹³ is a diphenylamine group or a carbazole group,
(1) R¹⁰ is an unsubstituted alkyl group having a carbon number of 1 to 20, or
(2) R¹⁰ is an unsubstituted aryl group having a ring-forming carbon number of 6 to 20, and
X¹ and R¹ to R¹⁵ are the same as defined in Formula 1.

4. The condensed polycyclic compound of claim 1, wherein the condensed polycyclic compound represented by Formula 1 is represented by any one of Formula 4-1 to Formula 4-4: 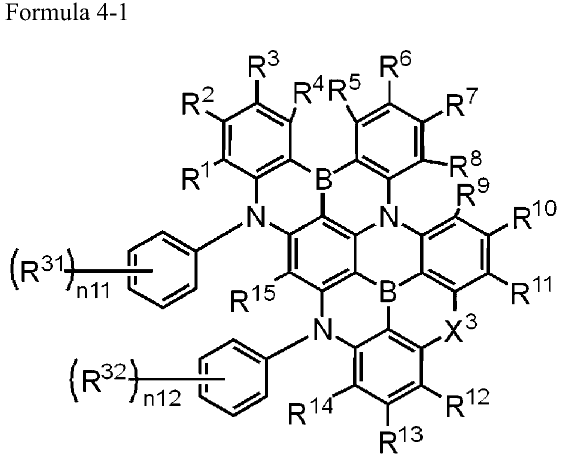 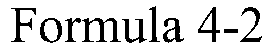 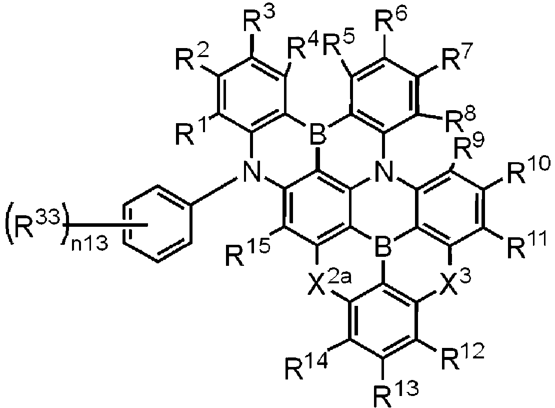 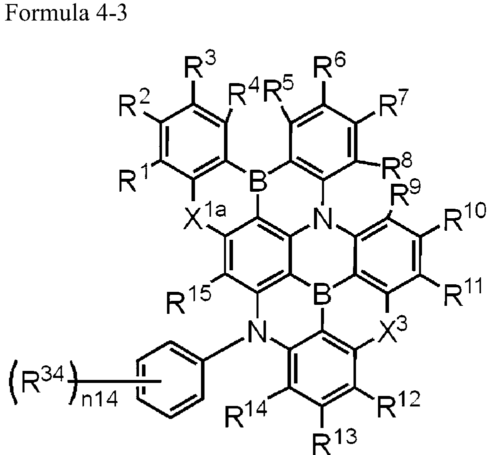 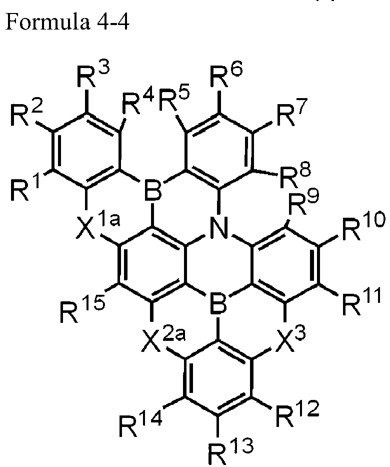
X^{1a} and X^{2a} are each independently O or S,
R³¹ to R³⁴ are each independently a hydrogen atom, a deuterium atom, a halogen atom, a cyano group, a nitro group, a saturated or unsaturated amine group, a saturated or unsaturated alkyl group having a carbon number of 1 to 20, a saturated or unsaturated aryl group having a ring-forming carbon number of 6 to 30, or a saturated or unsaturated heteroaryl group having a ring-forming carbon number of 2 to 30,
n11 to n14 are each independently an integer of 0 to 5, and
X³, and R¹ to R¹⁵ are the same as defined in Formula 1.

5. The condensed polycyclic compound of claim 1, wherein the condensed polycyclic compound represented by Formula 1 above is represented by Formula 5: 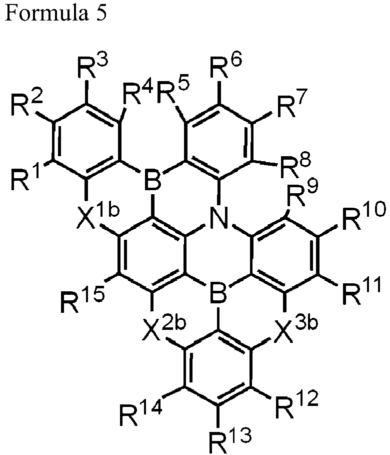
X^{1b}, X²⁶ and X³⁶ are independently O, S, NAr², Formula 6-1 or Formula 6-2, and at least one of X^{1b}, X²⁶ and X³⁶ is represented by Formula 6-1 or Formula 6-2,
Ar² is a saturated or unsaturated aryl group having a ring-forming carbon number of 6 to 30, or a saturated or unsaturated heteroaryl group having a ring-forming carbon number of 2 to 30, and
R¹ to R¹⁵ are the same as defined in Formula 1: 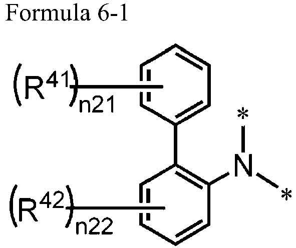 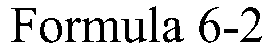 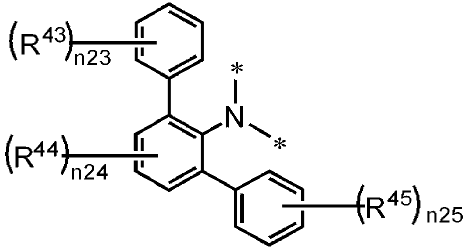
R⁴¹ to R¹⁵ are each independently a hydrogen atom, a deuterium atom, a halogen atom, a cyano group, a nitro group, a saturated or unsaturated amine group, a saturated or unsaturated alkyl group having a carbon number of 1 to 20, a saturated or unsaturated aryl group having a ring-forming carbon number of 6 to 30, or a saturated or unsaturated heteroaryl group having a ring-forming carbon number of 2 to 30,
n21, n23 and n25 are each independently an integer of 0 to 5,
n22 is an integer of 0 to 4,
n24 is an integer of 0 to 3, and
-* is a position connected to Formula 5.

6. The condensed polycyclic compound of any one of claims 1 to 4, wherein X¹ to X³ above are each independently O or NAr³, and
Ar³ is a saturated or unsaturated aryl group having a ring-forming carbon number of 6 to 30.

7. The condensed polycyclic compound of claim 1, wherein in Formula 1,
when R¹³ is a diphenylamine group or a carbazole group, R¹⁰ is a saturated or unsaturated alkyl group having a carbon number of 1 to 20, a saturated or unsaturated aryl group having a ring-forming carbon number of 6 to 30, or a saturated or unsaturated heteroaryl group having a carbon number of 2 to 30, and
when R¹⁰ is substituted, a substituent is a deuterium atom, a cyano group, an unsubstituted alkyl group having a carbon number of 1 to 10, an unsubstituted aryl group having a carbon number of 6 to 15, or an unsubstituted heteroaryl group having a carbon number of 2 to 15.

8. The condensed polycyclic compound of claim 1, wherein the condensed polycyclic compound group represented by Formula 1 comprises at least one of compounds of Compound Group 1:

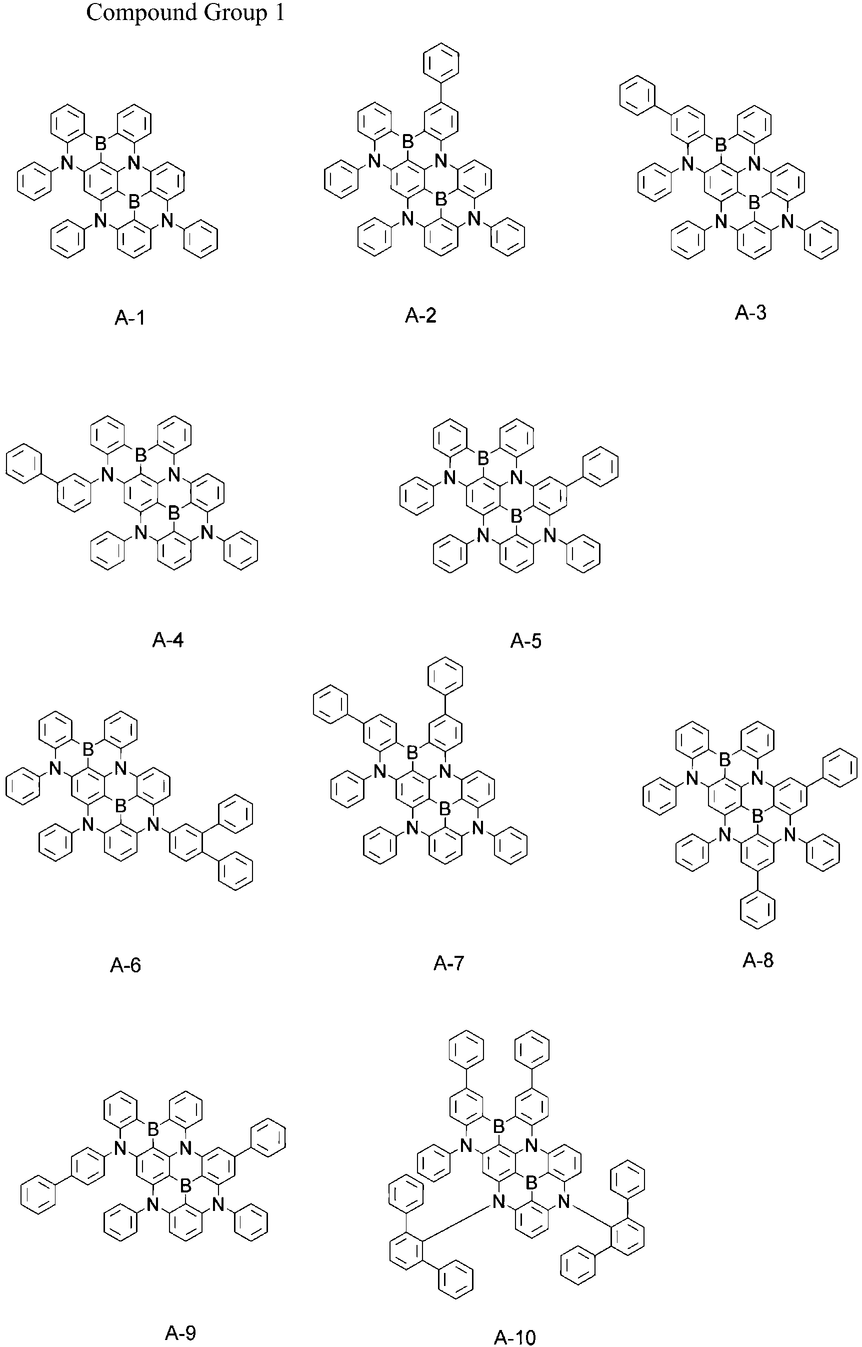

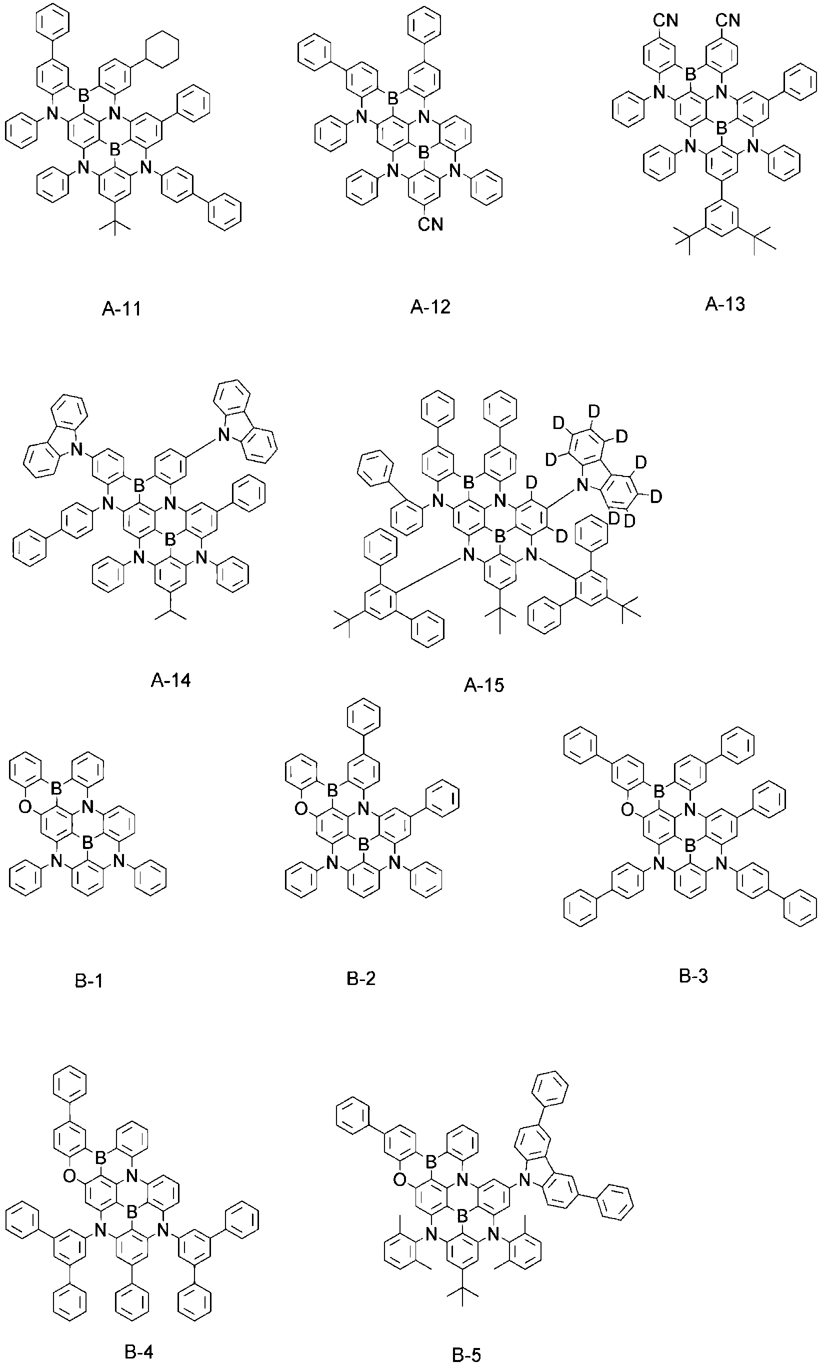

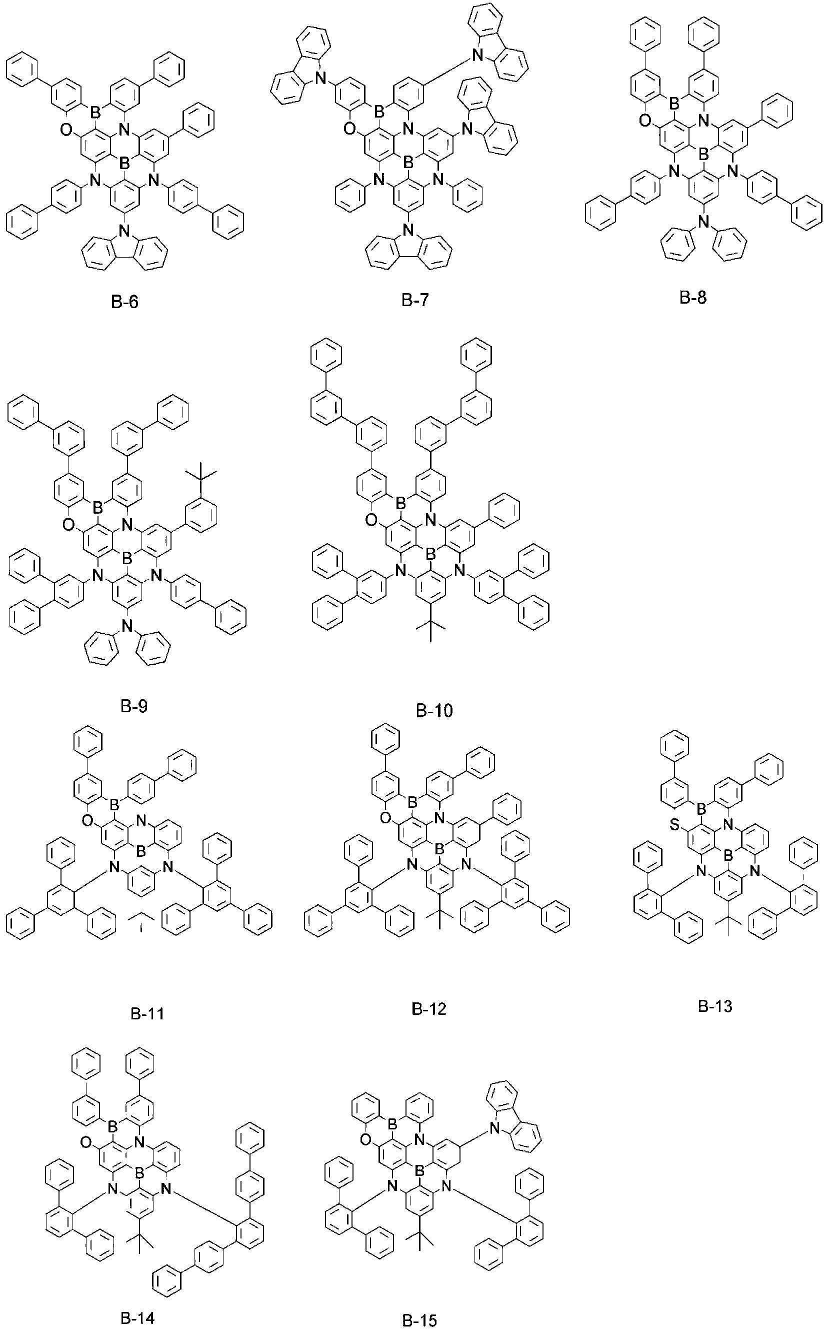

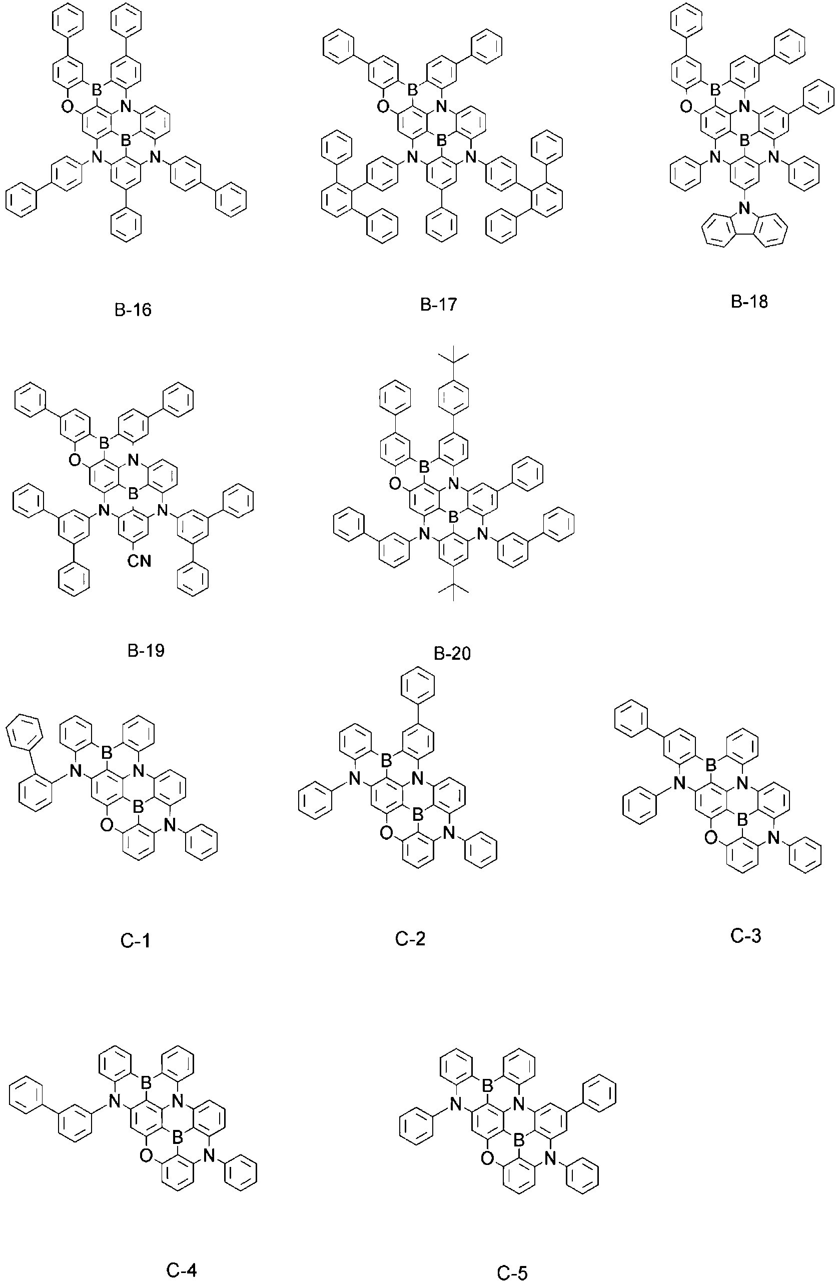

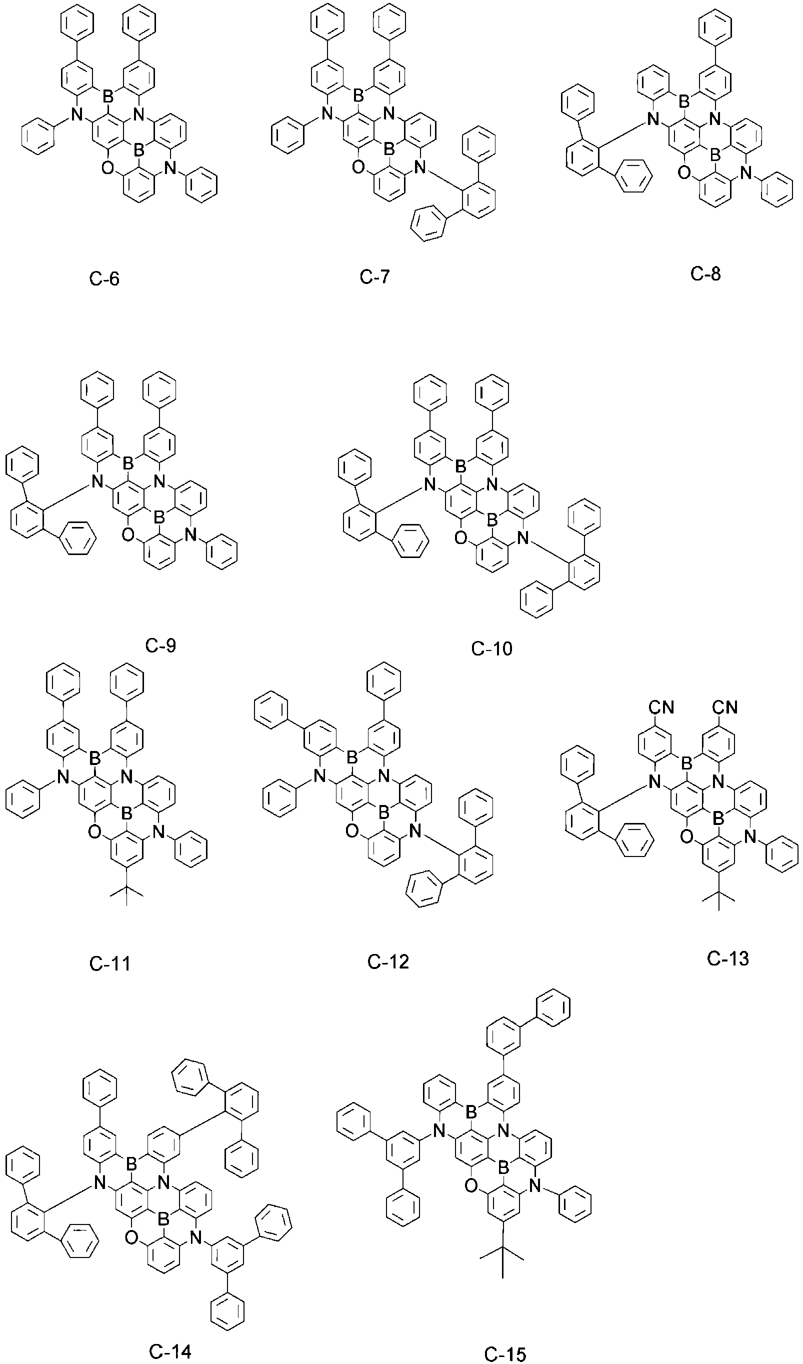

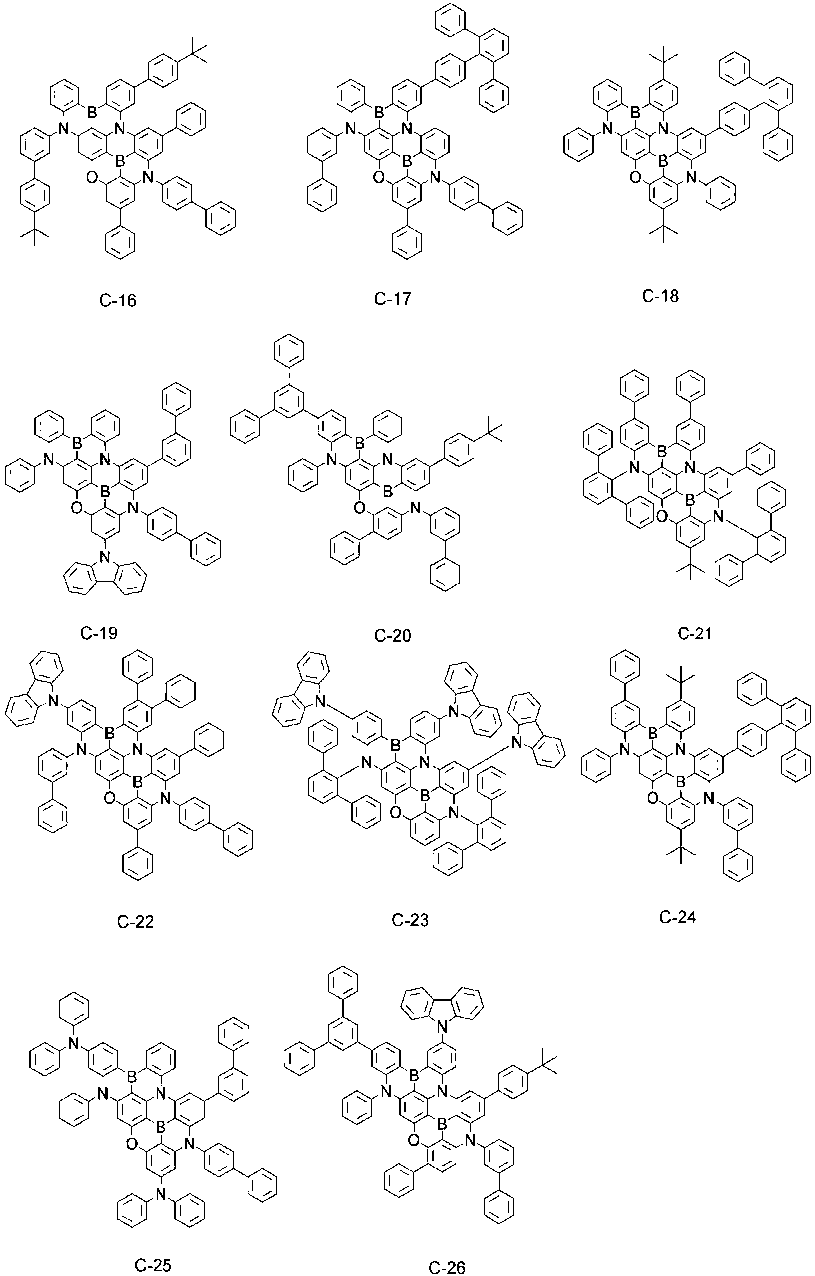

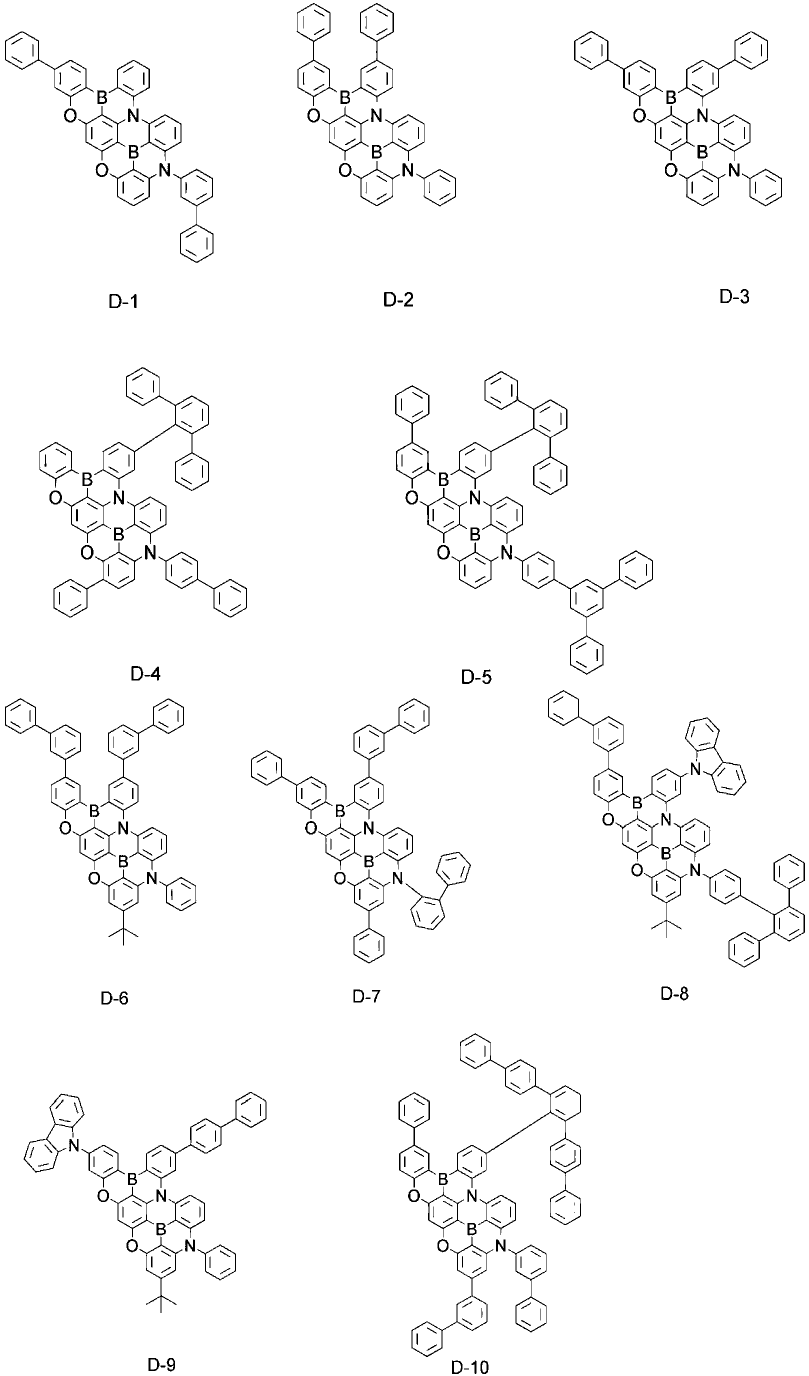

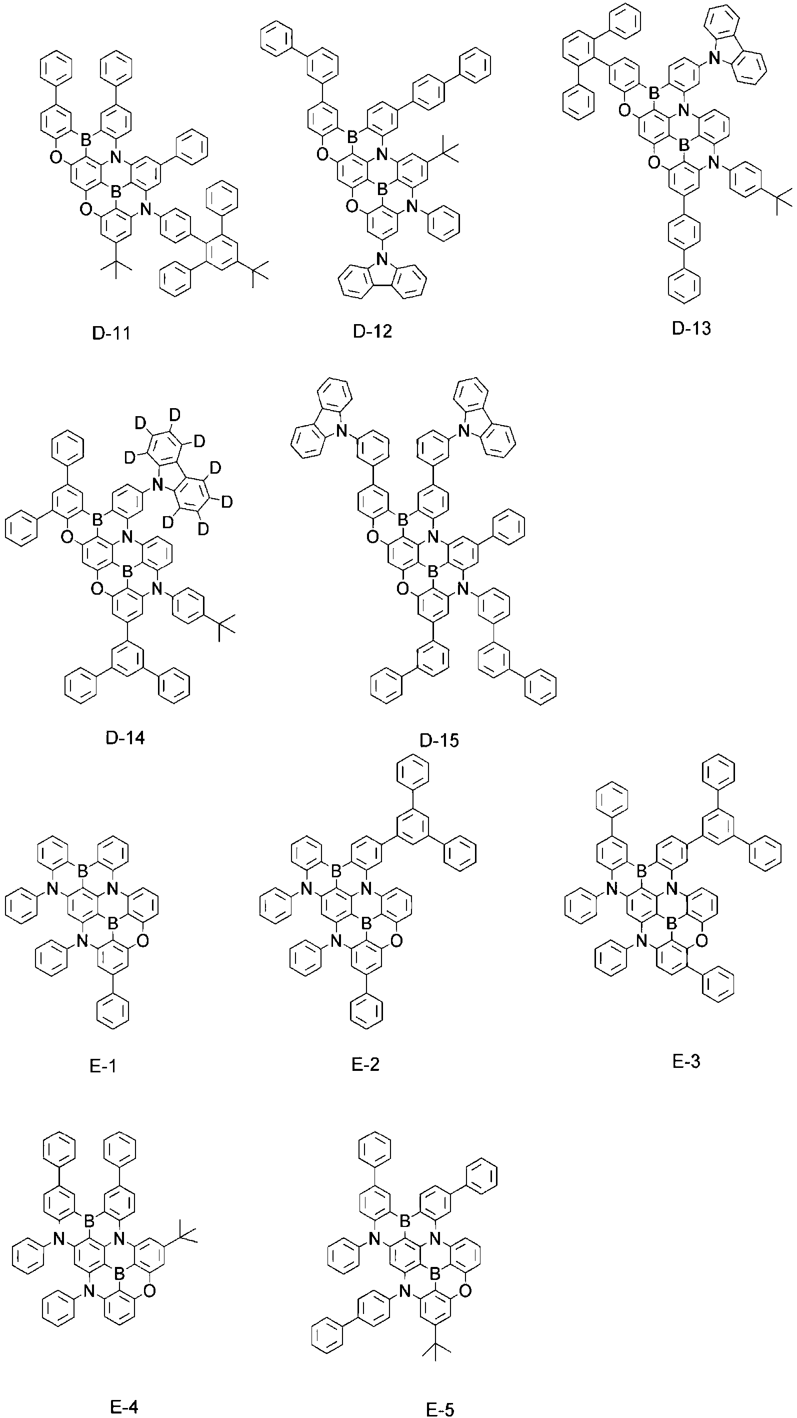

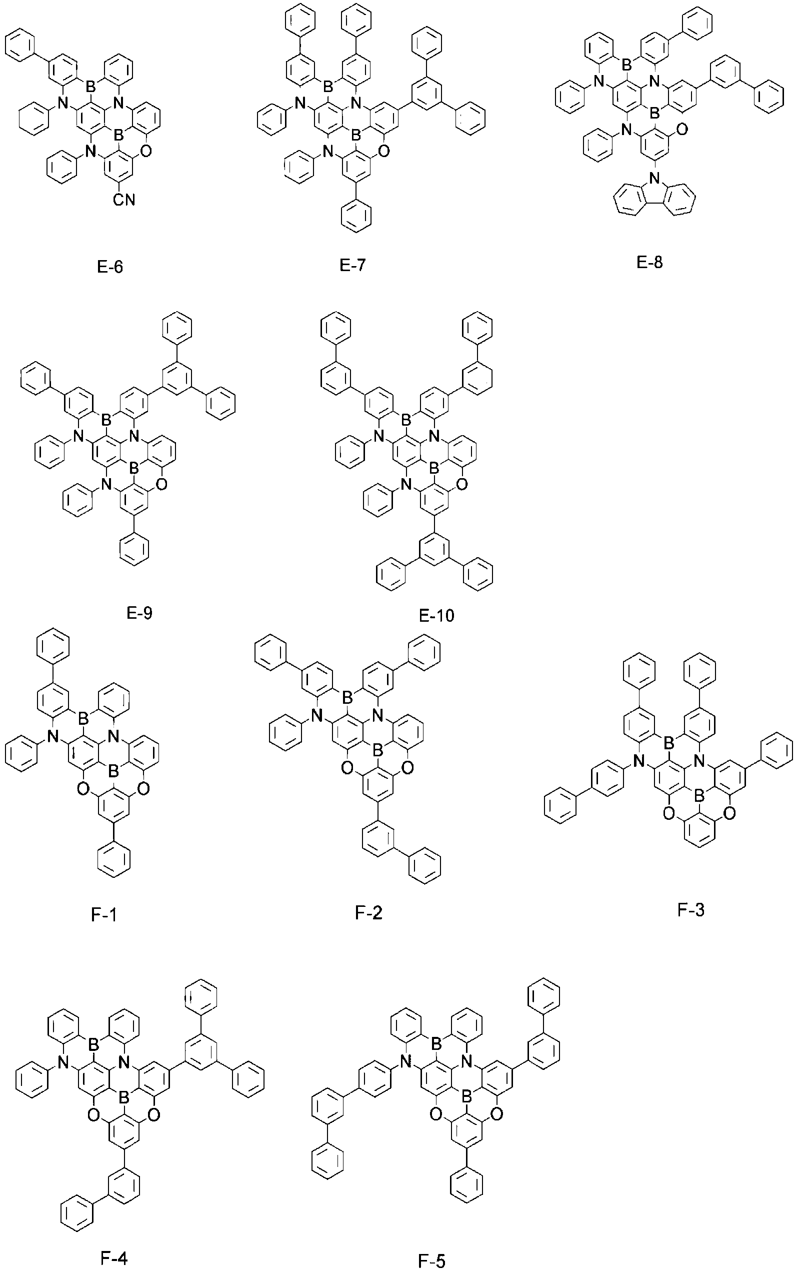

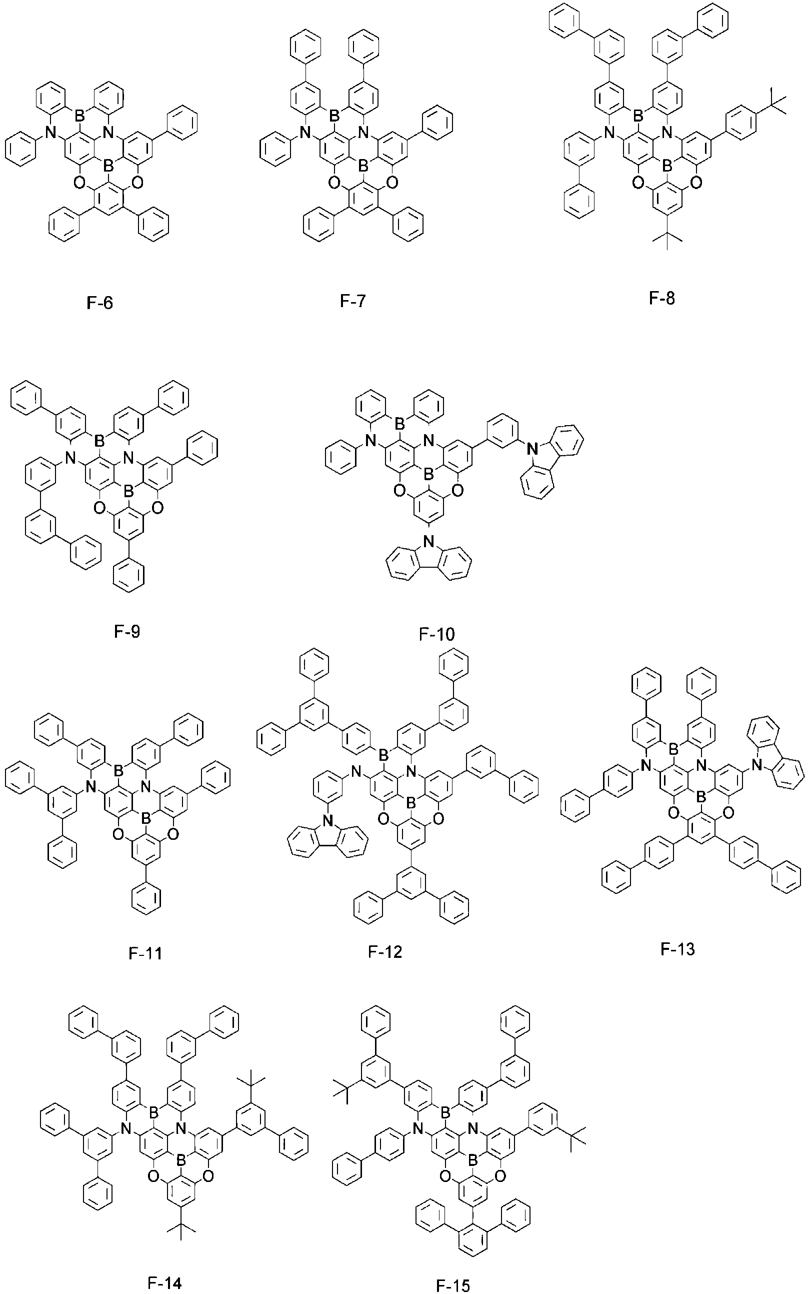

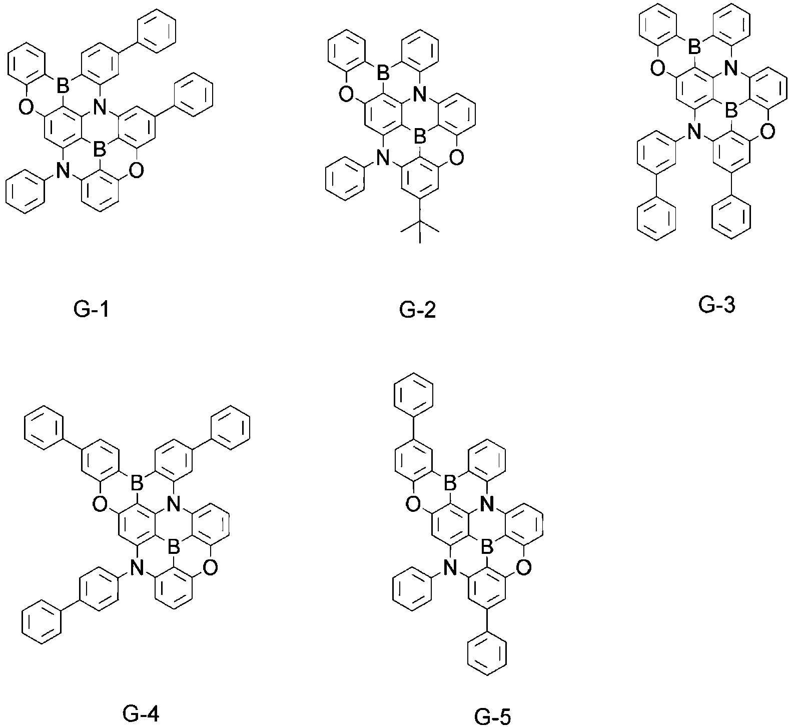

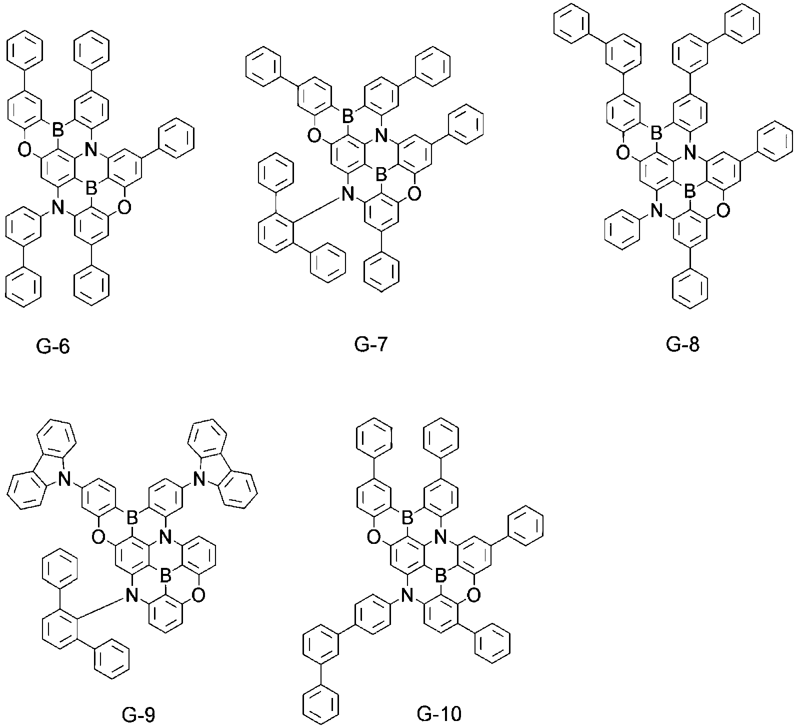

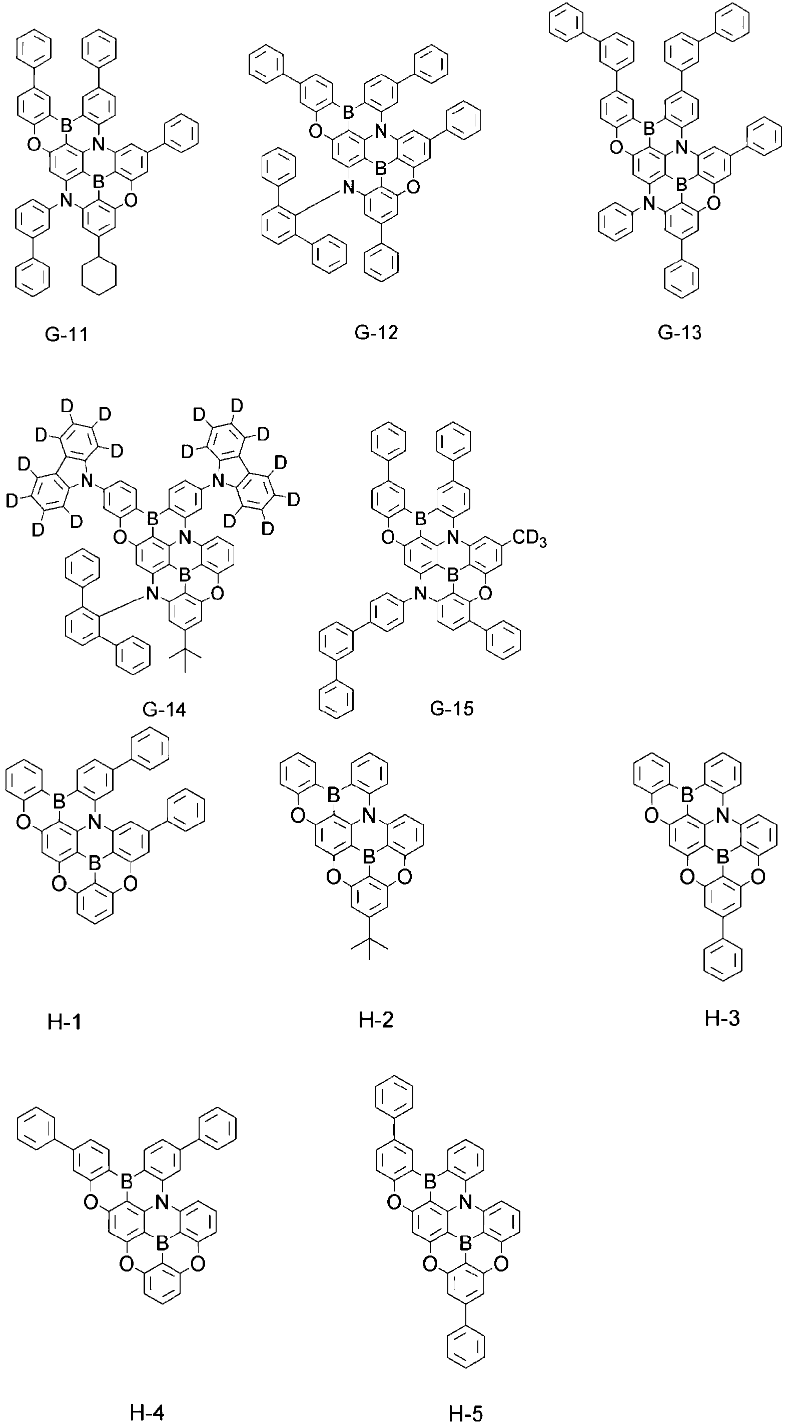

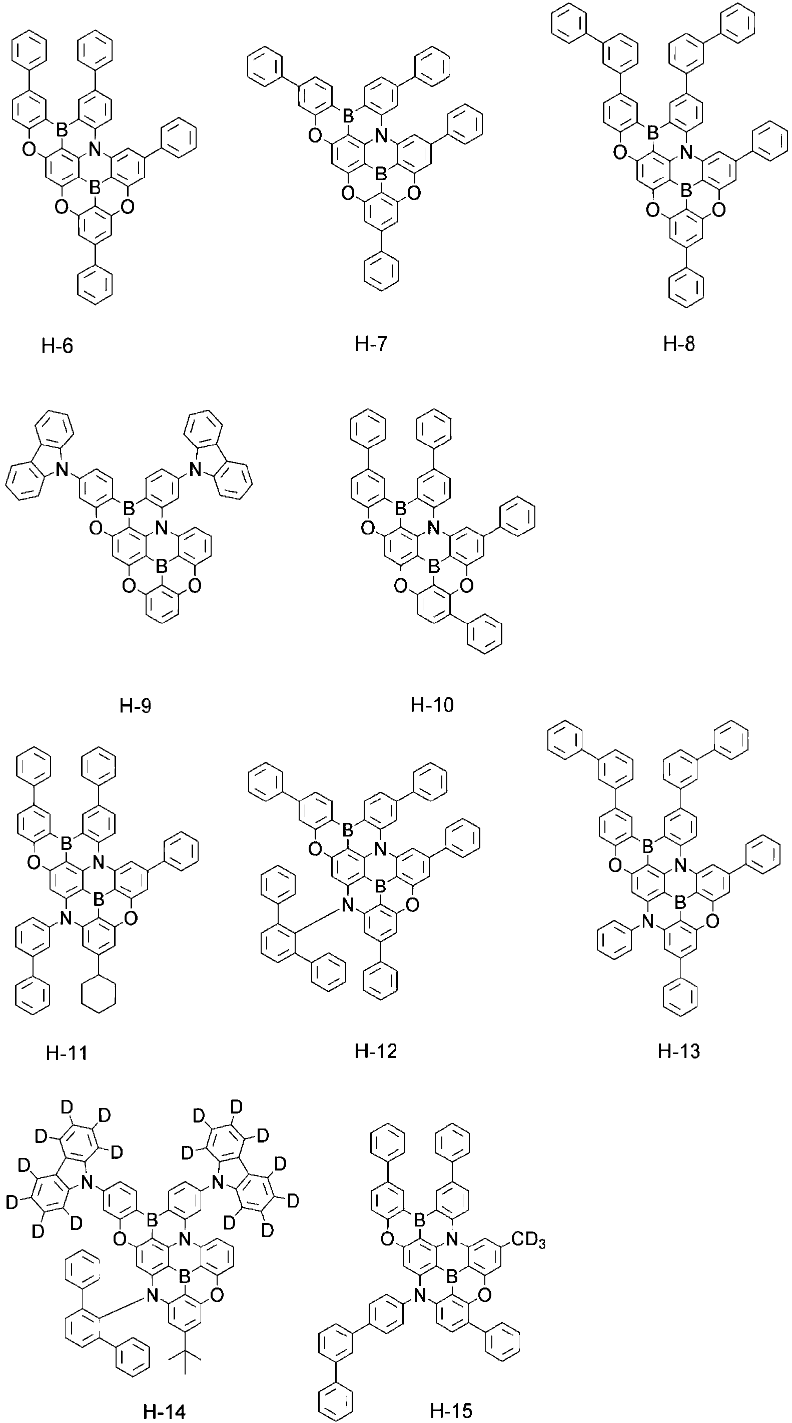

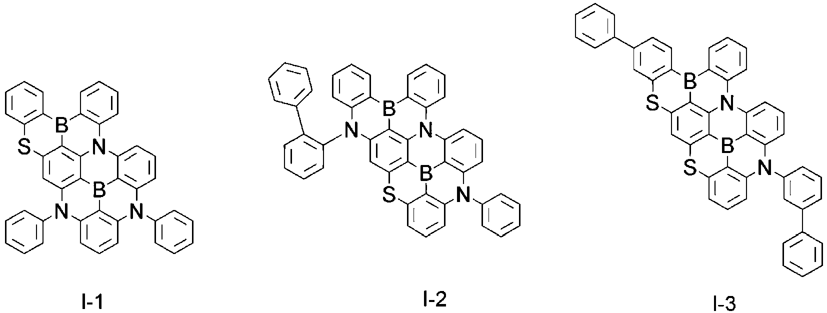

9. A light-emitting element comprising:
a first electrode;
a second electrode disposed on the first electrode; and
a light-emitting layer disposed between the first electrode and the second electrode, the light-emitting layer comprising the condensed polycyclic compound according to any one of claims 1 to 8 as a first compound.

10. The light-emitting element of claim 9, wherein the light-emitting layer comprises a host and a dopant, and
the dopant comprises the first compound.

11. The light-emitting element of claim 9 or claim 10, wherein the light-emitting layer further comprises at least one of a second compound represented by Formula HT-1, a third compound represented by Formula ET-1, or a fourth compound represented by Formula D-1: 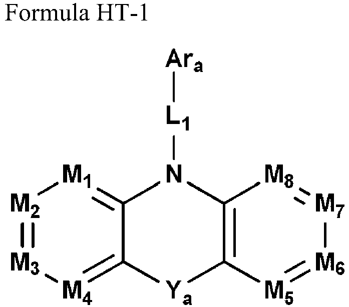
M₁ to M₈ are each independently N or CR₅₁,
L₁ is a direct linkage, a saturated or unsaturated arylene group having a ring-forming carbon number of 6 to 30, or a saturated or unsaturated heteroarylene group having a ring-forming carbon number of 2 to 30,
Yₐ is a direct linkage, CR₅₂R₅₃, or SiR₅₄R₅₅,
Arₐ is a saturated or unsaturated aryl group having a ring-forming carbon number of 6 to 30, or a saturated or unsaturated heteroaryl group having a ring-forming carbon number of 2 to 30, and
R₅₁ to R₅₅ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having a carbon number of 1 to 20, a substituted or unsubstituted alkenyl group having a carbon number of 2 to 20, a substituted or unsubstituted aryl group having a ring-forming carbon number of 6 to 60, or a substituted or unsubstituted heteroaryl group having a ring-forming carbon number of 2 to 60, or combined with an adjacent group to form a ring, 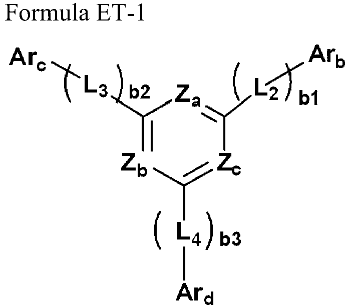
at least one of Zₐ to Z_{c} is N, and the rest thereof is CR₅₆,
R₅₆ is a hydrogen atom, a deuterium atom, a substituted or unsubstituted alkyl group having a carbon number of 1 to 20, a substituted or unsubstituted aryl group having a ring-forming carbon number of 6 to 60, or a substituted or unsubstituted heteroaryl group having a ring-forming carbon number of 2 to 60,
b1 to b3 are each independently an integer of 0 to 10,
Ar_{b} to Ar_{d} are each independently a hydrogen atom, a deuterium atom, a substituted or unsubstituted alkyl group having a carbon number of 1 to 20, a substituted or unsubstituted aryl group having a ring-forming carbon number of 6 to 30, or a substituted or unsubstituted heteroaryl group having a ring-forming carbon number of 2 to 30, and
L₂ to L₄ are each independently a direct linkage, a substituted or unsubstituted arylene group having a ring-forming carbon number of 6 to 30, or a substituted or unsubstituted heteroarylene group having a ring-forming carbon number of 2 to 30, 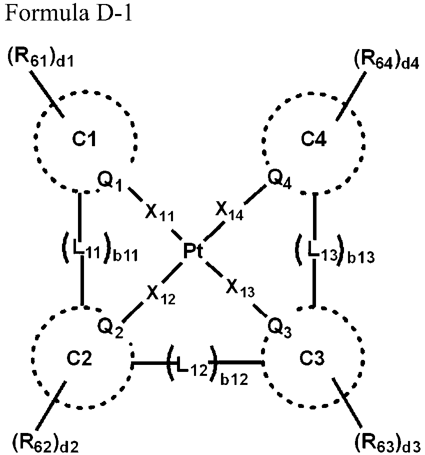
Q₁ to Q₄ are each independently C or N,
C1 to C4 are each independently a hydrocarbon ring having a ring-forming carbon number of 5 to 30, a substituted or unsubstituted aryl group having a ring-forming carbon number of 6 to 30, or a substituted or unsubstituted heterocycle having a ring-forming carbon number of 2 to 30,
X₁₁ to X₁₄ are each independently a direct linkage or *-O-*,
L₁₁ to L₁₃ are each independently a direct linkage, *-O-*, *-S-*, 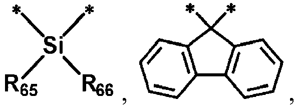 a substituted or unsubstituted divalent alkyl group having a carbon number of 1 to 20, a substituted or unsubstituted arylene group having a ring-forming carbon number of 6 to 30, or a substituted or unsubstituted heteroarylene group having a ring-forming carbon number of 2 to 30,
b11 to b13 are each independently 0 or 1, and
R₆₁ to R₆₆ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having a carbon number of 1 to 20, a substituted or unsubstituted alkenyl group having a carbon number of 2 to 20, a substituted or unsubstituted aryl group having a ring-forming carbon number of 6 to 60, or a substituted or unsubstituted heteroaryl group having a ring-forming carbon number of 2 to 60, and
d1 to d4 are each independently an integer of 0 to 4.

12. An electronic device comprising:
a base layer;
a circuit layer disposed on the base layer; and
a display element layer disposed on the circuit layer, and including the light-emitting element according to any one of claims 9 to 11.

13. The electronic device of claim 12, wherein the light-emitting element further comprises a capping layer disposed on the second electrode, and
the capping layer has a refractive index equal to or greater than about 1.6 with respect to light having a wavelength range of about 550 nm to about 660 nm.

14. The electronic device of claim 12 or claim 13, further comprising an optical control layer disposed on the display element layer, and including a quantum dot,
wherein the light-emitting element emits first light,
the optical control layer includes:
a first optical control portion including a first quantum dot converting first light to second light in a longer wavelength region than the first light;
a second optical control portion including a second quantum dot converting the first light to third light in a longer wavelength region than the first light and the second light; and
a third optical control portion configured to transmit the first light, optionally further comprising a color filter layer disposed on the optical control layer,
wherein the color filter layer includes:
a first filter configured to transmit the second light;
a second filter configured to transmit the third light; and
a third filter configured to transmit the first light.

15. The electronic device of any one of claims 12 to 14, wherein the electronic device is selected from a large display device such as a television, a monitor and an exterior billboard, and a small-and-medium display device such as a personal computer, a notebook computer, a personal digital terminal, a display device for a vehicle, a game console, a portable electronic device, or a camera.
